(19) **Europäisches Patentamt / European Patent Office / Office européen des brevets**

(11) **EP 4 478 616 A1**

(12) **EUROPEAN PATENT APPLICATION**
published in accordance with Art. 153(4) EPC

(43) Date of publication:
**18.12.2024 Bulletin 2024/51**

(21) Application number: **23749634.4**

(22) Date of filing: **26.01.2023**

(51) International Patent Classification (IPC):
**H03M 13/27** (2006.01)    **H03M 13/19** (2006.01)
**H04L 1/00** (2006.01)

(52) Cooperative Patent Classification (CPC):
**H03M 13/19; H03M 13/27; H04L 1/00**

(86) International application number:
**PCT/JP2023/002351**

(87) International publication number:
**WO 2023/149318 (10.08.2023 Gazette 2023/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.02.2022 JP 2022016936**

(71) Applicant: **Sony Group Corporation**
**Tokyo 108-0075 (JP)**

(72) Inventors:
• **SHINOHARA Yuji**
**Tokyo 108-0075 (JP)**
• **YAMAMOTO Makiko**
**Tokyo 108-0075 (JP)**

(74) Representative: **2SPL Patentanwälte PartG mbB**
**Landaubogen 3**
**81373 München (DE)**

(54) **TRANSMISSION DEVICE, TRANSMISSION METHOD, RECEPTION DEVICE, AND RECEPTION METHOD**

(57)    The present technology relates to a transmission device, a transmission method, a reception device, and a reception method capable of reliably achieving preferable communication quality in data transfer using LDPC codes.

Groupwise interleaving interleaves an LDPC code having a code length N of 17280 bits for each unit of 360-bit bit groups of 0 to 47. Groupwise deinterleaving restores an arrangement of the groupwise-interleaved LDPC code to an original arrangement. For example, the present technology is applicable to data transfer using LDPC codes or the like.

**FIG.127**

EP 4 478 616 A1

**Description**

[Technical Field]

The present technology relates to a transmission device, a transmission method, a reception device, and a reception method, and particularly to a transmission device, a transmission method, a reception device, and a reception method capable of reliably achieving preferable communication quality in data transfer using LDPC codes, for example.

[Background Art]

LDPC (Low Density Parity Check) codes have a high error correction capability, and, in recent years, are widely adopted for transmission systems including digital broadcasting, such as DVB (Digital Video Broadcasting)-S.2, DVB-T.2, and DVB-C.2 for Europe and others, and ATSC (Advanced Television Systems Committee) 3.0 and the like for the U.S. and others, for example (e.g., see NPL 1).

Recent studies have been gradually revealed that LDPC codes provide performance closer to the Shannon limit as code lengths increase, similarly to turbo codes and the like. Moreover, LDPC codes each exhibit such a property that a minimum distance is proportional to a code length. Accordingly, LDPC codes offer further advantages such as a preferable block error probability characteristic and substantially no occurrence of what is generally called an error floor phenomenon which is observed in decoding characteristics of turbo codes and the like.

[Citation List]

[Non Patent Literature]

[NPL 1]
ATSC Standard: Physical Layer Protocol (A/322), 7 September 2016

[Summary]

[Technical Problem]

For example, data transfer using LDPC codes designates LDPC codes as symbols (symbolizes LDPC codes) for quadrature modulation (digital modulation) such as QPSK (Quadrature Phase Shift Keying), and transmits the symbols mapped at signal points of the quadrature modulation.

Data transfer using the foregoing LDPC codes has gradually become widespread throughout the world, and reliable achievement of preferable communication (transfer) quality is demanded.

The present technology has been developed in consideration of the abovementioned circumstances, and reliably achieves preferable communication quality in data transfer using LDPC codes.

[Solution to Problem]

A transmission device/method according to the present technology includes an encoding unit/step that performs LDPC encoding on the basis of a check matrix for an LDPC code having a code length N of 17280 bits and a code rate r of 14/16, a groupwise interleaving unit/step that performs groupwise interleaving for interleaving the LDPC code for each unit of a 360-bit bit group, and a mapping unit/step that maps the LDPC code at any one of 16 signal points of a 2D-NUC (Non-Uniform Constellation) of 16QAM for each unit of four bits. On an assumption that a (i + 1)th bit group from a head of the LDPC code is a bit group i, the groupwise interleaving interleaves an arrangement of bit groups of 0 to 47 of the LDPC code having 17280 bits into an arrangement of

3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27,
the LDPC code contains an information bit and a parity bit, the check matrix contains an information matrix portion corresponding to the information bit and a parity matrix portion corresponding to the parity bit, the information matrix portion is represented in a form of a check matrix initial value table, and the check matrix initial value table includes a table indicating a position of an element 1 in the information matrix portion for each set of 360 columns, and indicates
337 376 447 504 551 864 872 975 1136 1225 1254 1271 1429 1478 1870 2122
58 121 163 365 515 534 855 889 1083 1122 1190 1448 1476 1635 1691 1954
247 342 395 454 479 665 674 1033 1041 1198 1300 1484 1680 1941 2096 2121

80 487 500 513 661 970 1038 1095 1109 1133 1416 1545 1696 1992 2051 2089

32 101 205 413 568 712 714 944 1329 1669 1703 1826

1904 1908 2014 2097

142 201 491 838 860 954 960 965 997 1027 1225 1488 1502 1521 1737 1804

453 1184 1542

10 781 1709

497 903 1546

1080 1640 1861

1198 1616 1817

771 978 2089

369 1079 1348

980 1788 1987

1495 1900 2015

27 540 1070

200 1771 1962

863 988 1329

674 1321 2152

807 1458 1727

844 867 1628

227 546 1027

408 926 1413

361 982 2087

1247 1288 1392

1051 1070 1281

325 452 467

1116 1672 1833

21 236 1267

504 856 2123

398 775 1912

1056 1529 1701

143 930 1186

553 1029 1040

303 653 1308

877 992 1174

1083 1134 1355

298 404 709

970 1272 1799

296 1017 1873

105 780 1418

682 1247 1867.

In a transmission device/method according to the present technology, LDPC encoding is performed on the basis of a check matrix for an LDPC code having a code length N of 17280 bits and a code rate r of 14/16, and groupwise interleaving for interleaving the LDPC code for each unit of a 360-bit bit group is performed. Further, the LDPC code is mapped at any one of 16 signal points of a 2D-NUC (Non-Uniform Constellation) of 16QAM for each unit of four bits. On an assumption that a (i + 1)th bit group from a head of the LDPC code is a bit group i, the groupwise interleaving interleaves an arrangement of bit groups of 0 to 47 of the LDPC code having 17280 bits into an arrangement of

3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27.

The LDPC code contains an information bit and a parity bit, the check matrix contains an information matrix portion corresponding to the information bit and a parity matrix portion corresponding to the parity bit, the information matrix portion is represented in a form of a check matrix initial value table, and the check matrix initial value table includes a table indicating a position of an element 1 in the information matrix portion for each set of 360 columns, and indicates

337 376 447 504 551 864 872 975 1136 1225 1254 1271 1429 1478 1870 2122

58 121 163 365 515 534 855 889 1083 1122 1190 1448 1476 1635 1691 1954

247 342 395 454 479 665 674 1033 1041 1198 1300 1484 1680 1941 2096 2121

80 487 500 513 661 970 1038 1095 1109 1133 1416 1545 1696 1992 2051 2089

32 101 205 413 568 712 714 944 1329 1669 1703 1826 1904 1908 2014 2097
142 201 491 838 860 954 960 965 997 1027 1225 1488 1502 1521 1737 1804
453 1184 1542
10 781 1709
497 903 1546
1080 1640 1861
1198 1616 1817
771 978 2089
369 1079 1348
980 1788 1987
1495 1900 2015
27 540 1070
200 1771 1962
863 988 1329
674 1321 2152
807 1458 1727
844 867 1628
227 546 1027
408 926 1413
361 982 2087
1247 1288 1392
1051 1070 1281
325 452 467
1116 1672 1833
21 236 1267
504 856 2123
398 775 1912
1056 1529 1701
143 930 1186
553 1029 1040
303 653 1308
877 992 1174
1083 1134 1355
298 404 709
970 1272 1799
296 1017 1873
105 780 1418
682 1247 1867.

A reception device/method according to the present technology includes a groupwise deinterleaving unit/step that performs groupwise deinterleaving for restoring an arrangement of an LDPC code obtained from data transmitted by a transmission method and groupwise-interleaved to an original arrangement. The transmission method includes an encoding step of performing LDPC encoding on the basis of a check matrix for the LDPC code having a code length N of 17280 bits and a code rate r of 14/16, a groupwise interleaving step of performing groupwise interleaving for interleaving the LDPC code for each unit of a 360-bit bit group, and a mapping step of mapping the LDPC code at any one of 16 signal points of a 2D-NUC (Non-Uniform Constellation) of 16QAM for each unit of four bits. On an assumption that a (i + 1)th bit group from a head of the LDPC code is a bit group i, the groupwise interleaving interleaves an arrangement of bit groups of 0 to 47 of the LDPC code having 17280 bits into an arrangement of

3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27,
the LDPC code contains an information bit and a parity bit, the check matrix contains an information matrix portion corresponding to the information bit and a parity matrix portion corresponding to the parity bit, the information matrix portion is represented in a form of a check matrix initial value table, and the check matrix initial value table includes a table indicating a position of an element 1 in the information matrix portion for each set of 360 columns, and indicates

337 376 447 504 551 864 872 975 1136 1225 1254 1271 1429 1478 1870 2122
58 121 163 365 515 534 855 889 1083 1122 1190 1448 1476 1635 1691 1954
247 342 395 454 479 665 674 1033 1041 1198 1300 1484 1680 1941 2096 2121

80 487 500 513 661 970 1038 1095 1109 1133 1416 1545 1696 1992 2051 2089
32 101 205 413 568 712 714 944 1329 1669 1703 1826 1904 1908 2014 2097
142 201 491 838 860 954 960 965 997 1027 1225 1488 1502 1521 1737 1804
453 1184 1542
10 781 1709
497 903 1546
1080 1640 1861
1198 1616 1817
771 978 2089
369 1079 1348
980 1788 1987
1495 1900 2015
27 540 1070
200 1771 1962
863 988 1329
674 1321 2152
807 1458 1727
844 867 1628
227 546 1027
408 926 1413
361 982 2087
1247 1288 1392
1051 1070 1281
325 452 467
1116 1672 1833
21 236 1267
504 856 2123
398 775 1912
1056 1529 1701
143 930 1186
553 1029 1040
303 653 1308
877 992 1174
1083 1134 1355
298 404 709
970 1272 1799
296 1017 1873
105 780 1418
682 1247 1867.

The reception device according to the present technology performs groupwise deinterleaving for restoring the arrangement of the LDPC code which is obtained from data transmitted by the transmission method of the present technology and is groupwise-interleaved, to the original arrangement.

Note that the transmission device and the reception device may each be an independent device, or an internal block constituting one device.

[Brief Description of Drawings]

[FIG. 1]

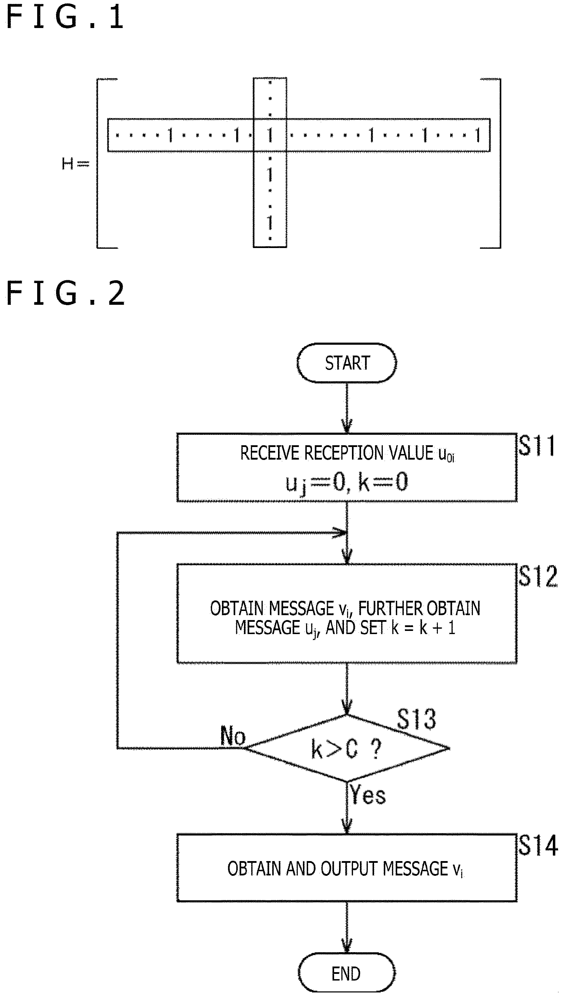

FIG. 1 is a diagram explaining a check matrix H for an LDPC code.
[FIG. 2]
FIG. 2 is a flowchart illustrating procedures for decoding an LDPC code.
[FIG. 3]

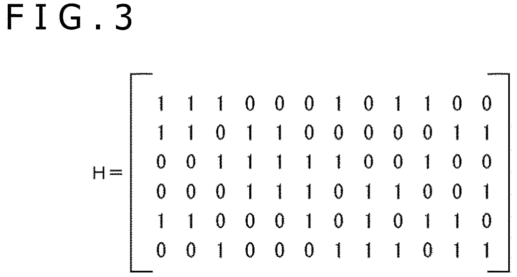

FIG. 3 is a diagram illustrating an example of a check matrix for an LDPC code.
[FIG. 4]

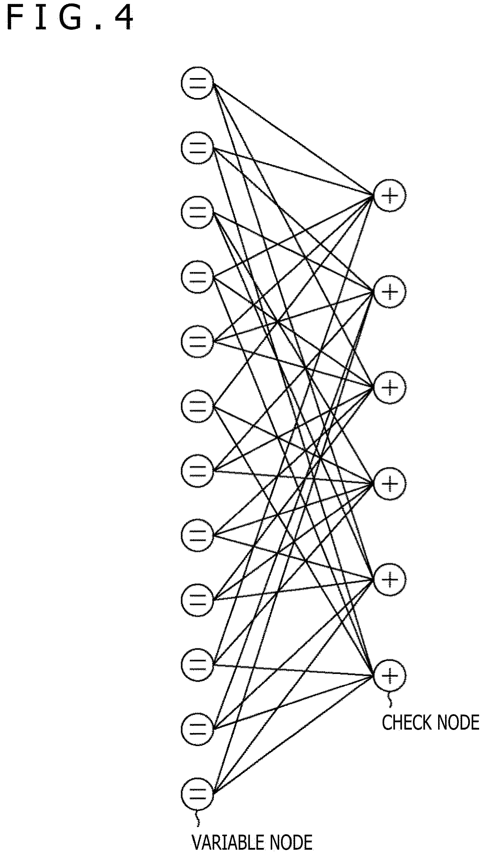

FIG. 4 is a diagram illustrating an example of a Tanner graph of a check matrix.

[FIG. 5]

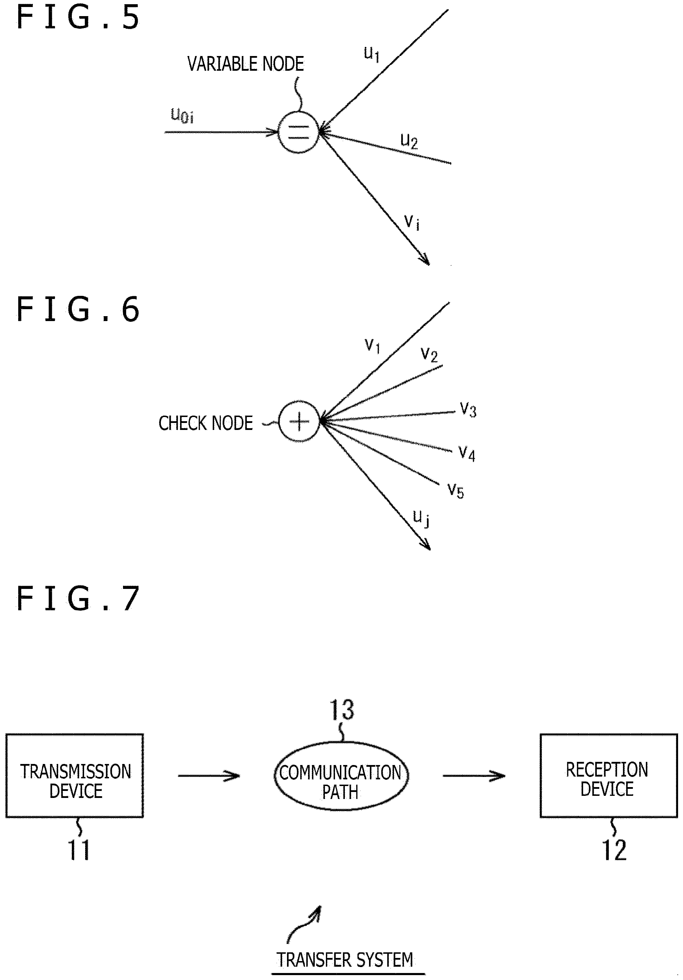

FIG. 5 is a diagram illustrating an example of a variable node.
[FIG. 6]
FIG. 6 is a diagram illustrating an example of a check node.
[FIG. 7]
FIG. 7 is a diagram illustrating a configuration example of a transfer system according to one embodiment to which the present technology is applied.
[FIG. 8]

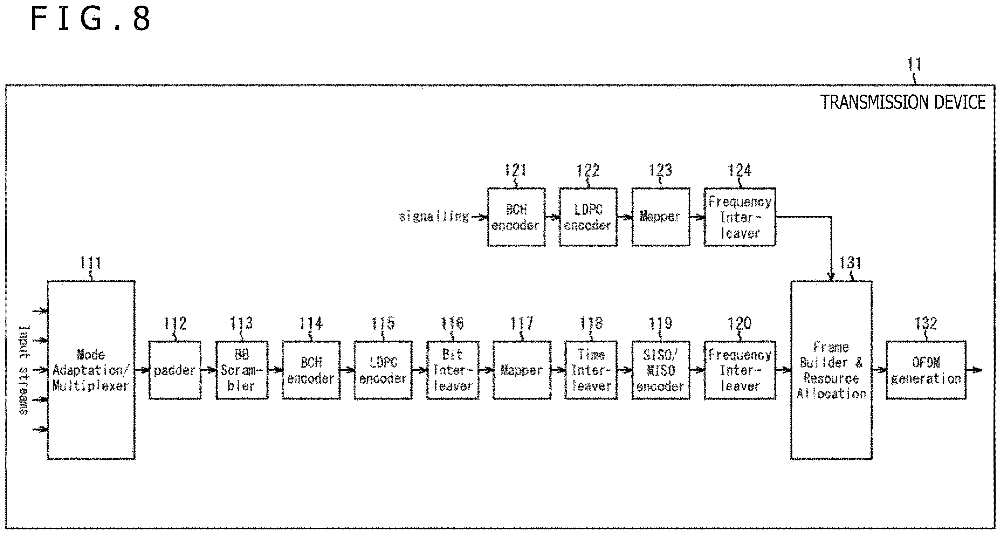

FIG. 8 is a block diagram illustrating a configuration example of a transmission device 11.
[FIG. 9]

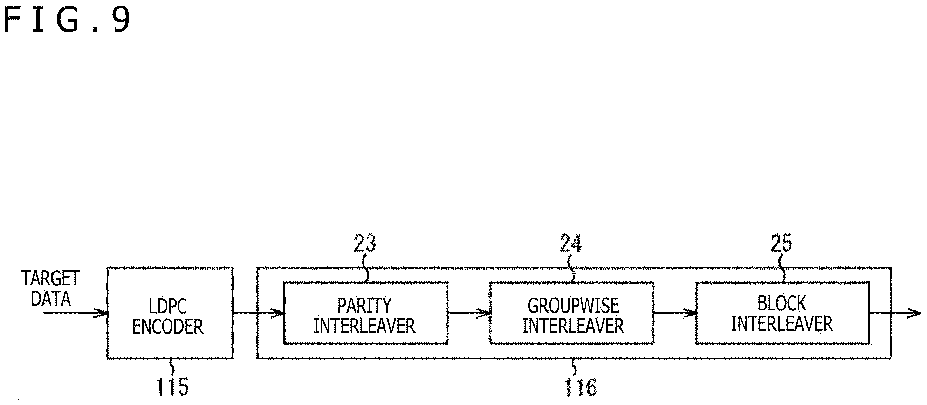

FIG. 9 is a block diagram illustrating a configuration example of a bit interleaver 116.
[FIG. 10]

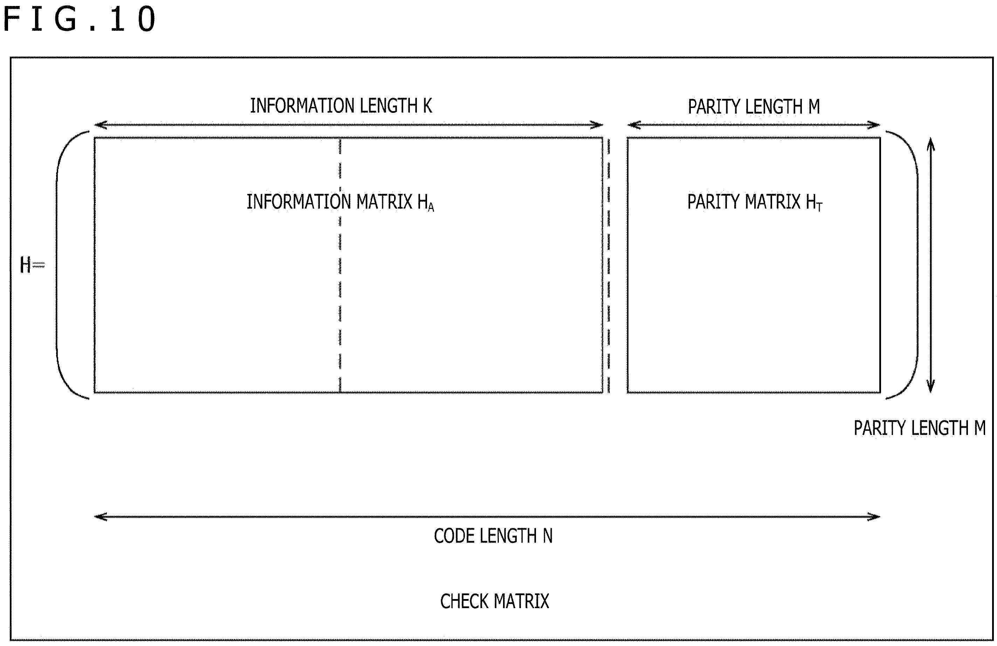

FIG. 10 is a diagram illustrating an example of a check matrix.
[FIG. 11]

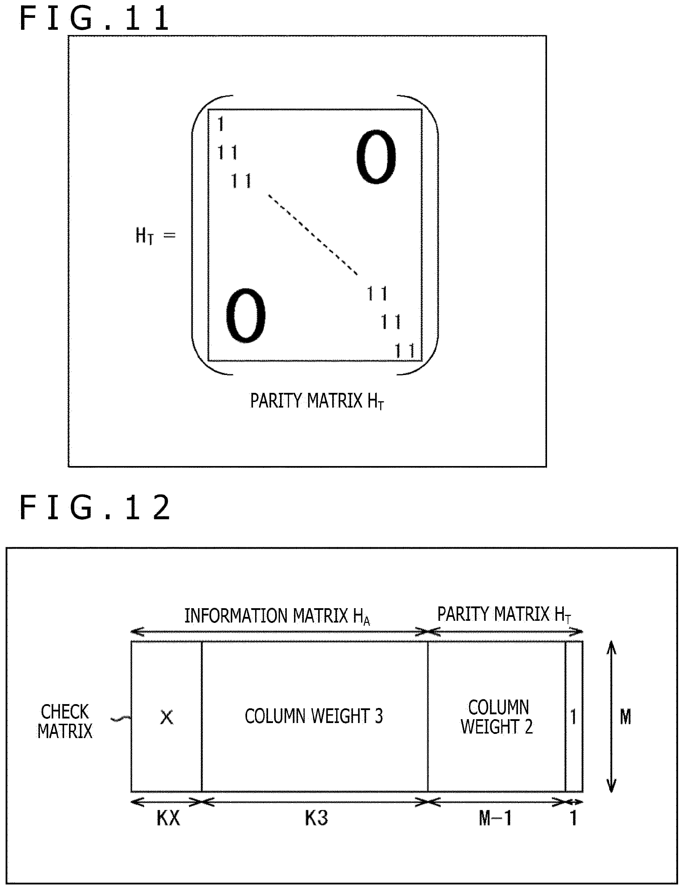

FIG. 11 is a diagram illustrating an example of a parity matrix.
[FIG. 12]
FIG. 12 is a diagram explaining a check matrix for an LDPC code specified in standards of DVB-T.2.
[FIG. 13]

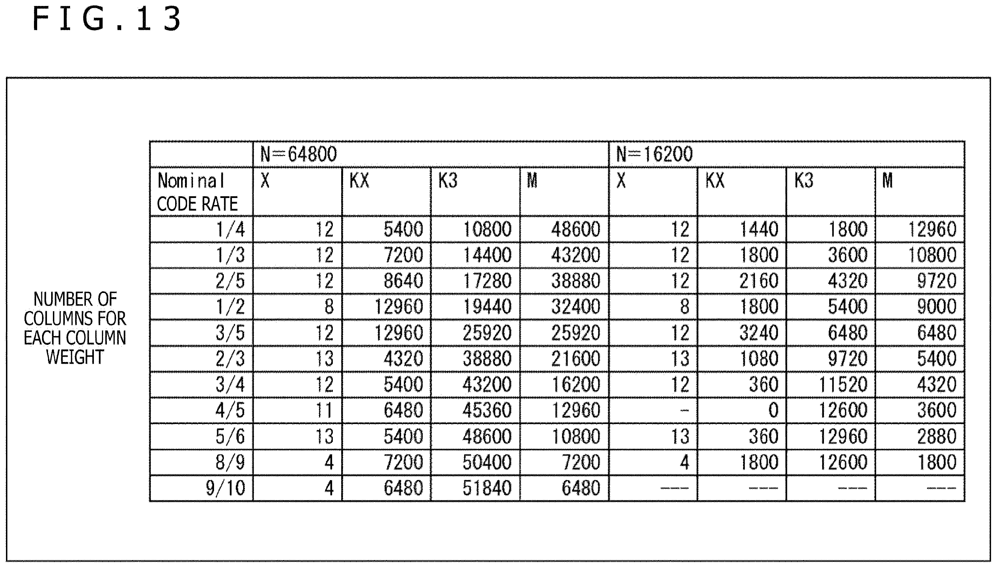

FIG. 13 is a diagram explaining the check matrix for the LDPC code specified in standards of DVB-T.2.
[FIG. 14]

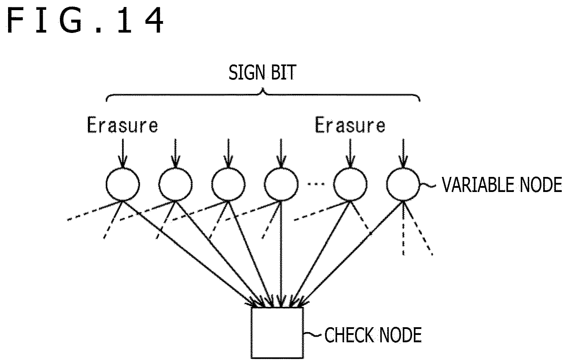

FIG. 14 is a diagram illustrating an example of a Tanner graph for LDPC code decoding.
[FIG. 15]

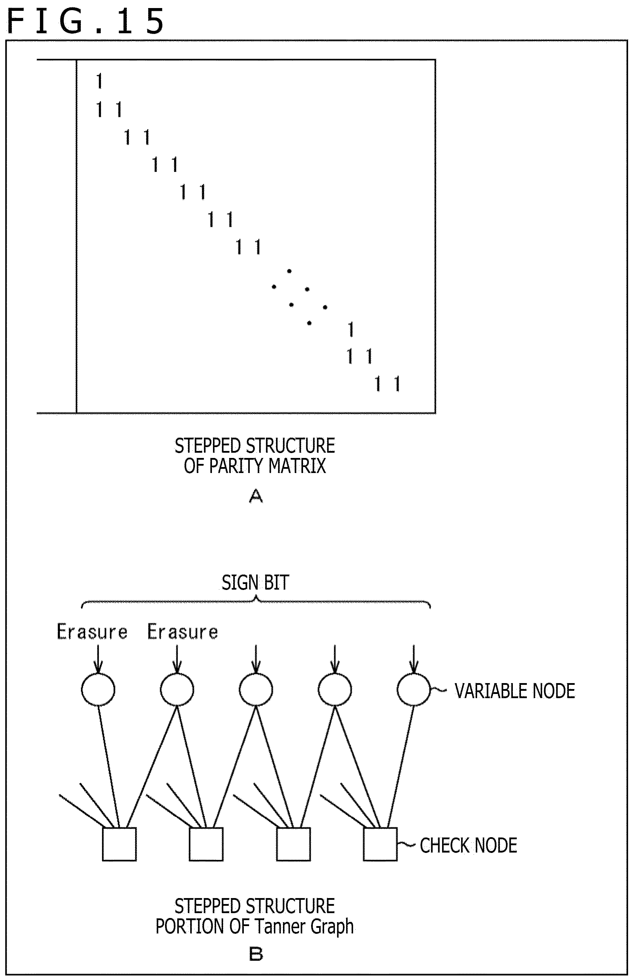

FIG. 15 is a diagram illustrating examples of a parity matrix $H_T$ having a stepped structure and a Tanner graph corresponding to the parity matrix $H_T$.
[FIG. 16]

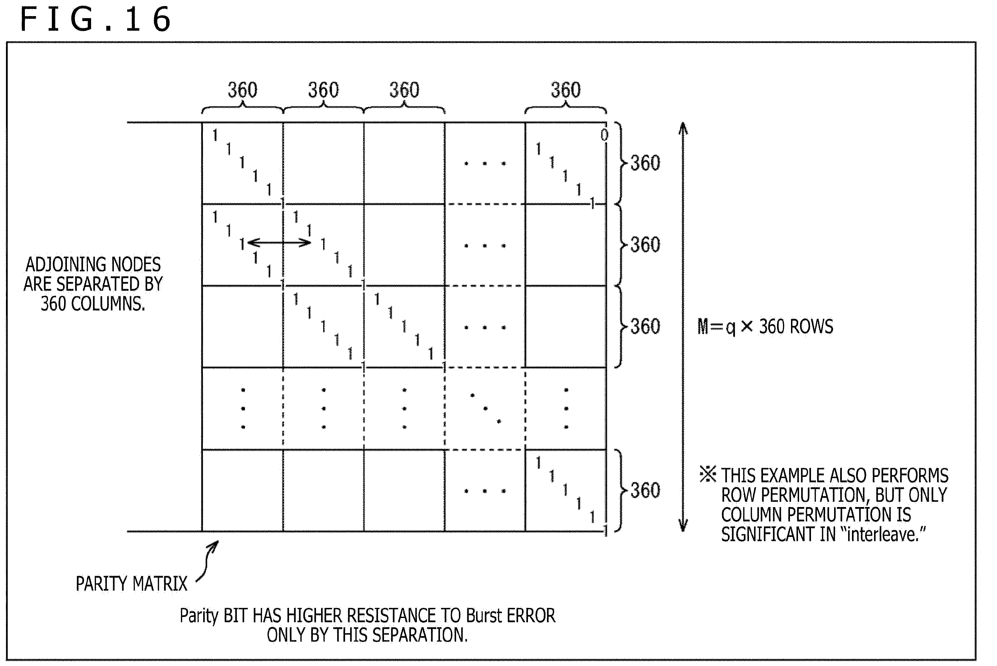

FIG. 16 is a diagram illustrating a parity matrix $H_T$ of a check matrix H corresponding to an LDPC code obtained after parity interleaving.
[FIG. 17]

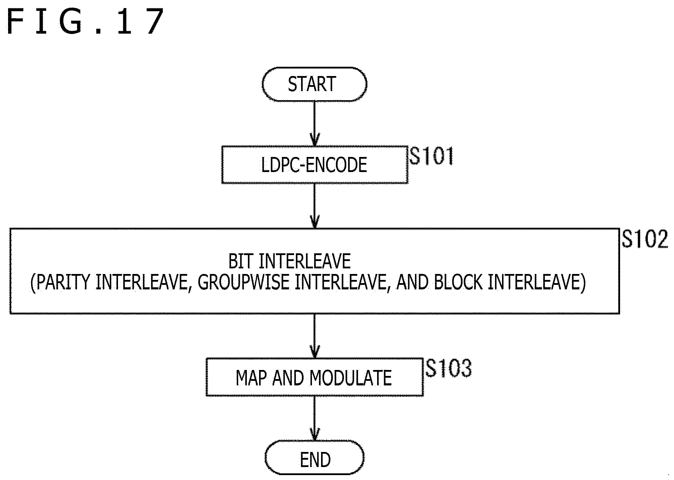

FIG. 17 is a flowchart explaining an example of a process performed by the bit interleaver 116 and a mapper 117.
[FIG. 18]

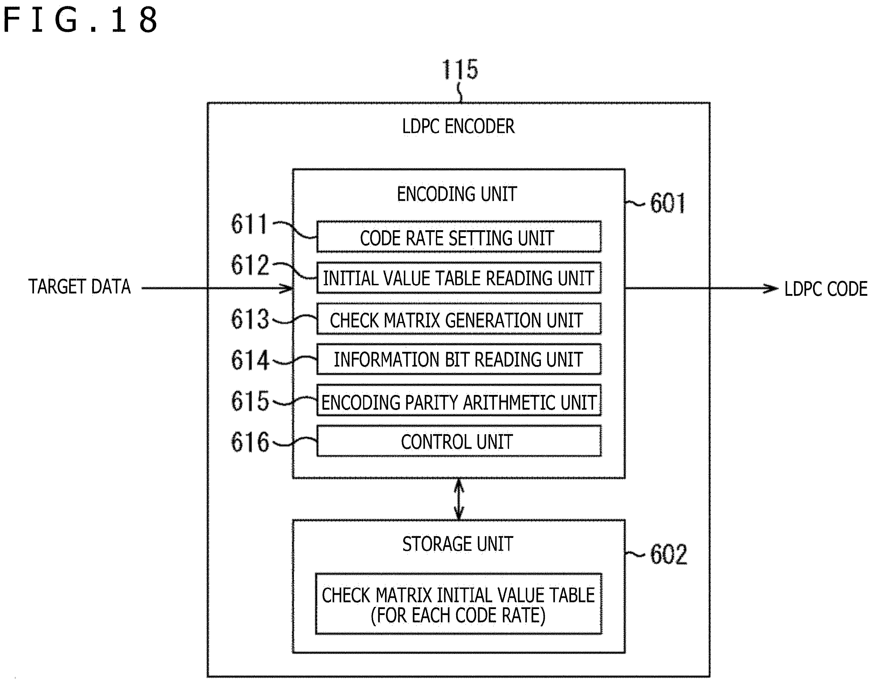

FIG. 18 is a block diagram illustrating a configuration example of an LDPC encoder 115.
[FIG. 19]

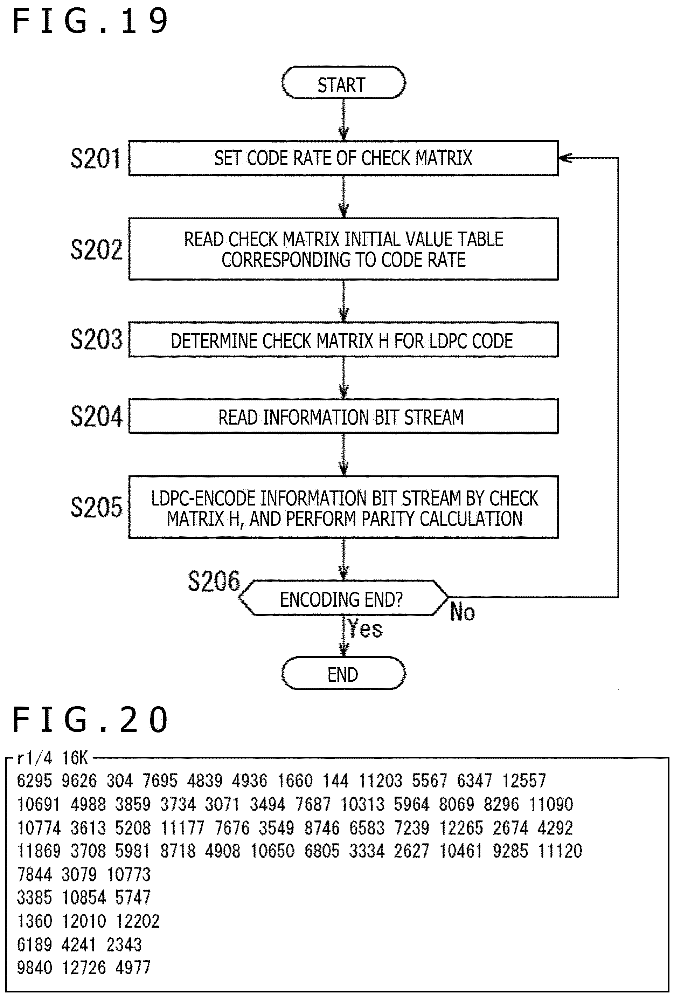

FIG. 19 is a flowchart explaining an example of a process performed by the LDPC encoder 115.
[FIG. 20]
FIG. 20 is a diagram illustrating an example of a check matrix initial value table for a code rate of 1/4 and a code length of 16200.
[FIG. 21]

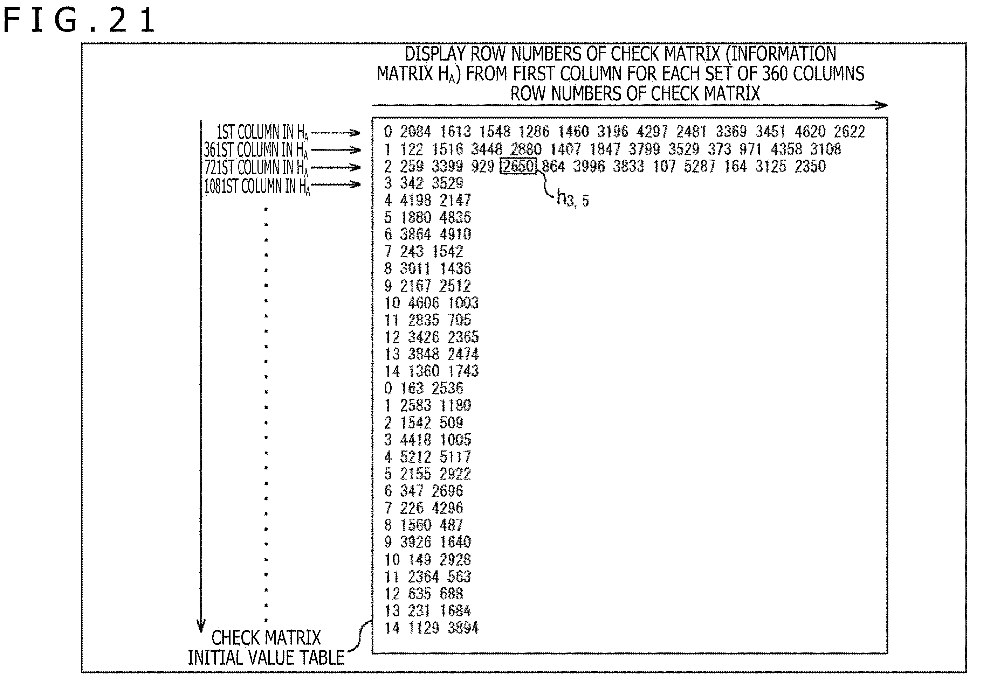

FIG. 21 is a diagram explaining a method for obtaining a check matrix H from a check matrix initial value table.
[FIG. 22]

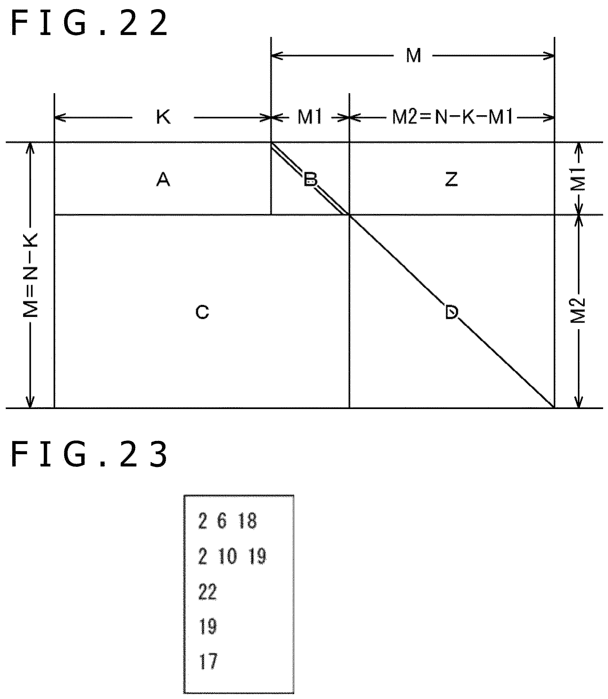

FIG. 22 is a diagram illustrating a structure of a check matrix.
[FIG. 23]
FIG. 23 is a diagram illustrating an example of a check matrix initial value table.
[FIG. 24]

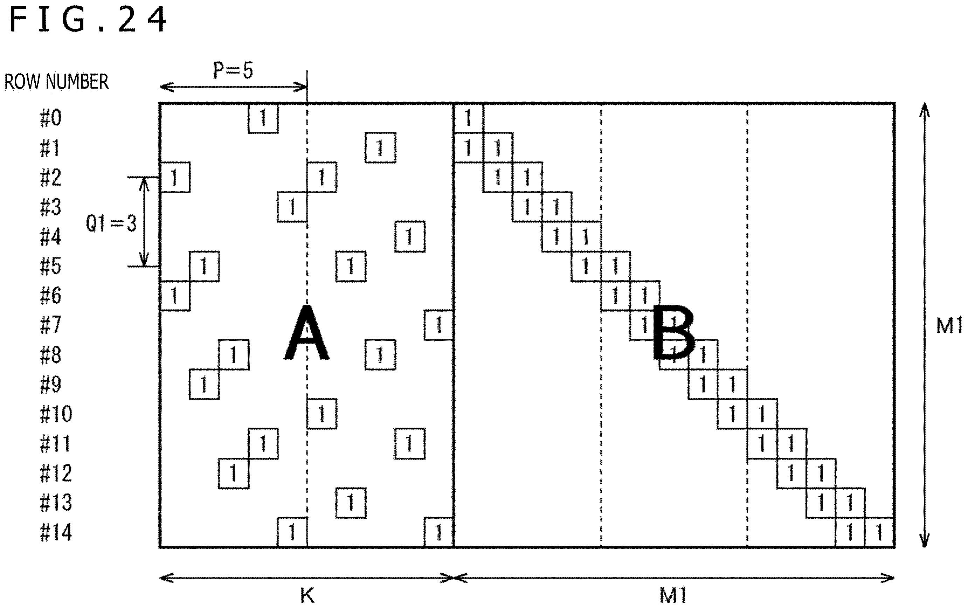

FIG. 24 is a diagram explaining an A matrix generated from the check matrix initial value table.
[FIG. 25]

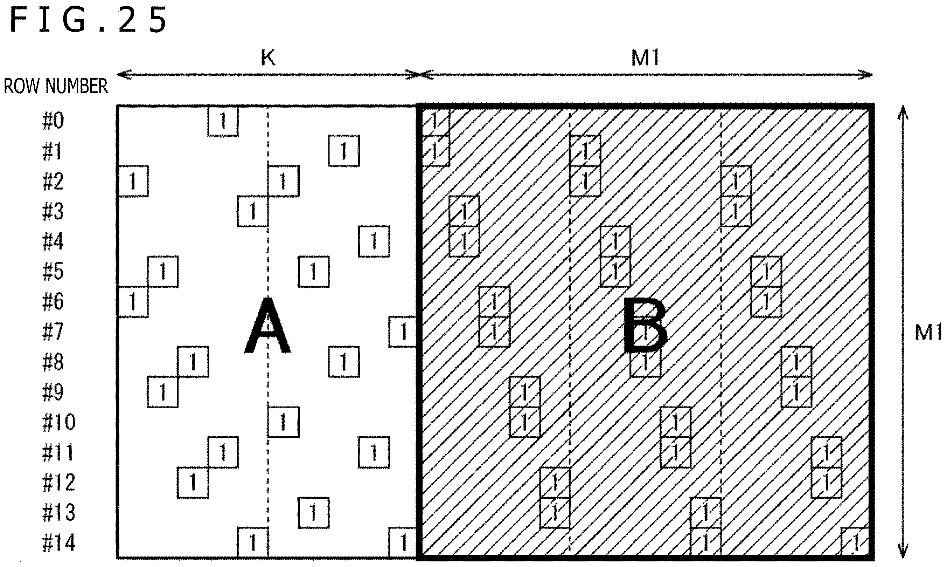

FIG. 25 is a diagram explaining parity interleaving of a B matrix.
[FIG. 26]

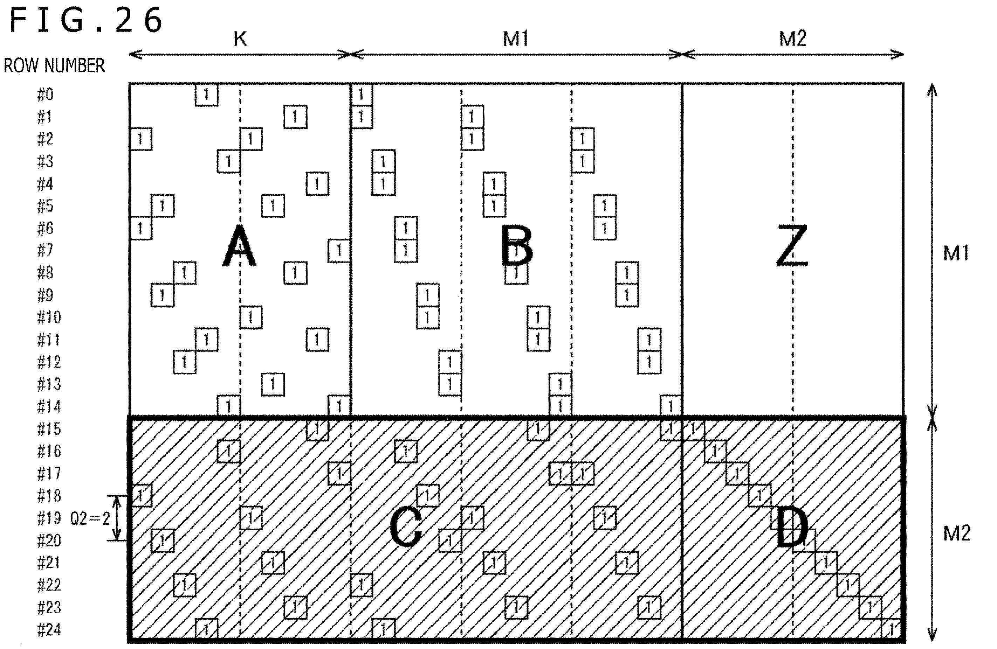

FIG. 26 is a diagram explaining a C matrix generated from the check matrix initial value table.
[FIG. 27]

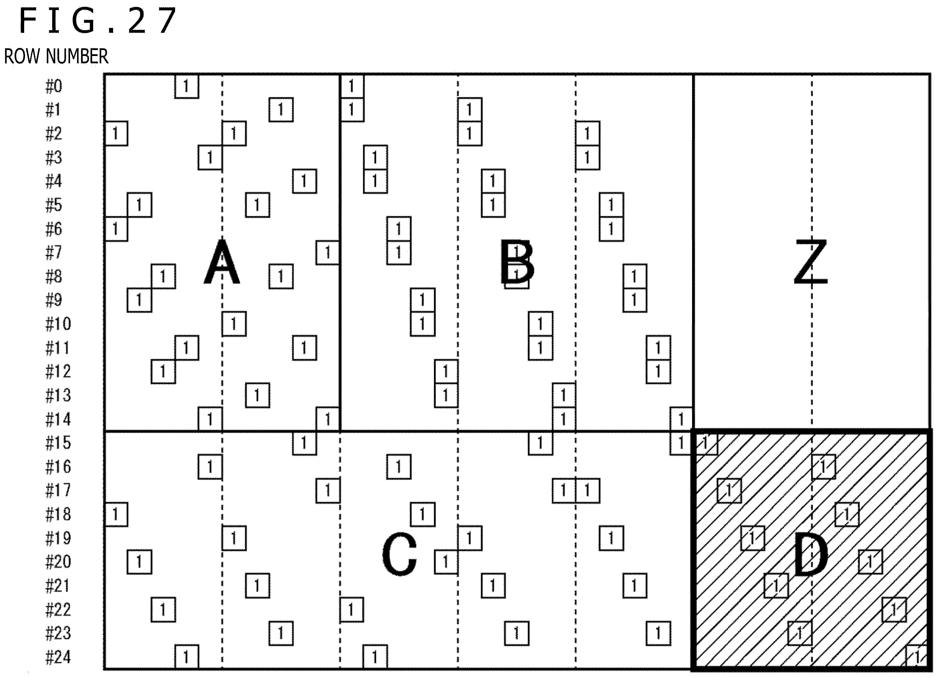

FIG. 27 is a diagram explaining parity interleaving of a D matrix.
[FIG. 28]

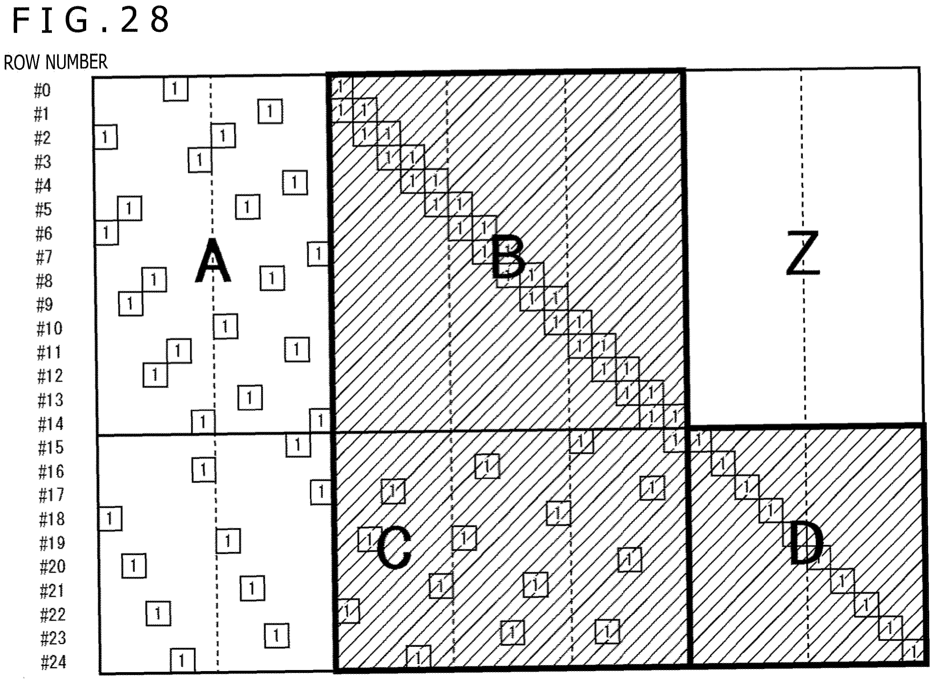

FIG. 28 is a diagram illustrating a check matrix obtained by applying thereto column permutation as parity deinterleaving for restoring a parity-interleaved check matrix to an original state.
[FIG. 29]

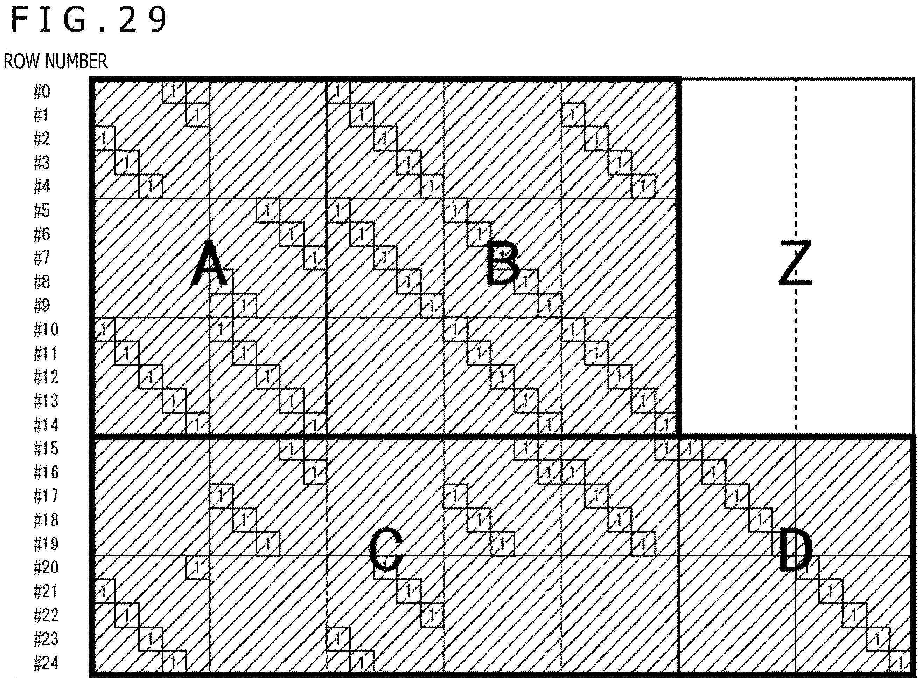

FIG. 29 is a diagram illustrating a transformed check matrix obtained by applying row permutation to a check matrix.
[FIG. 30]

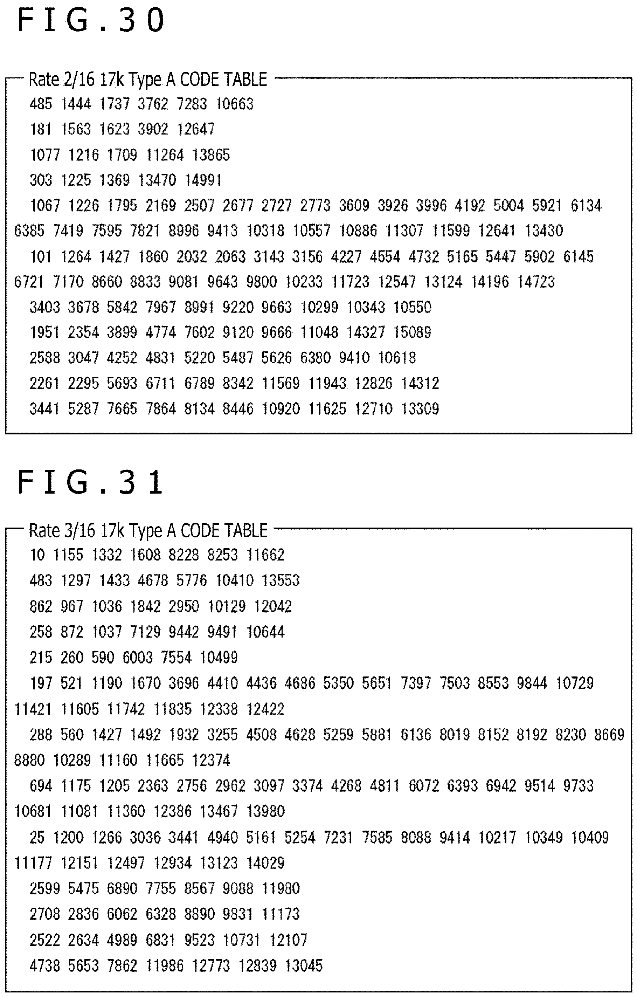

FIG. 30 is a diagram illustrating an example of a check matrix initial value table of a type A code having N = 17280 bits and r = 2/16.

[FIG. 31]
FIG. 31 is a diagram illustrating an example of a check matrix initial value table of a type A code having N = 17280 bits and r = 3/16.

[FIG. 32]

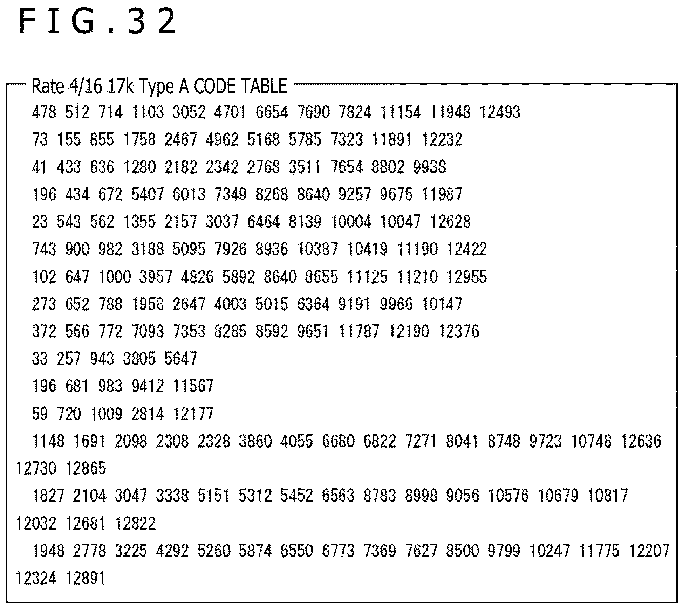

FIG. 32 is a diagram illustrating an example of a check matrix initial value table of a type A code having N = 17280 bits and r = 4/16.

[FIG. 33]

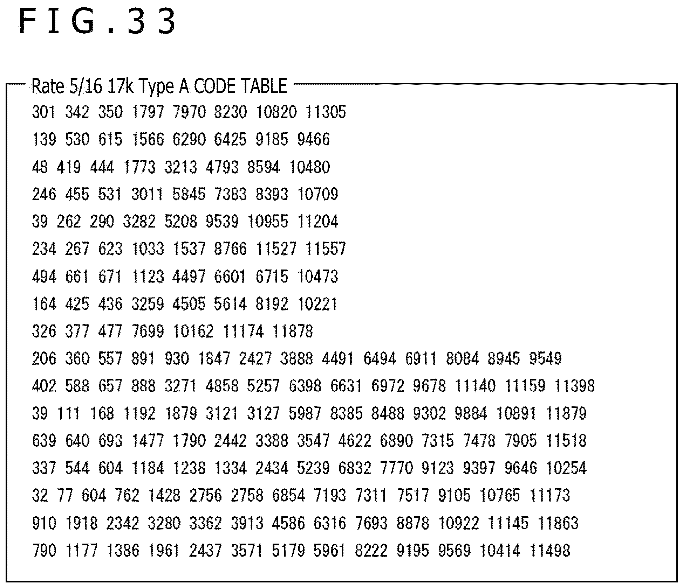

FIG. 33 is a diagram illustrating an example of a check matrix initial value table of a type A code having N = 17280 bits and r = 5/16.

[FIG. 34]

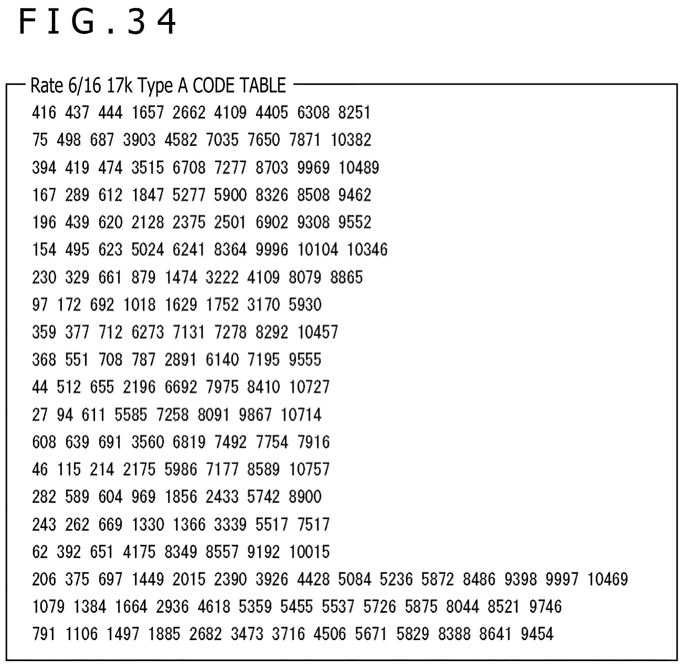

FIG. 34 is a diagram illustrating an example of a check matrix initial value table of a type A code having N = 17280 bits and r = 6/16.

[FIG. 35]

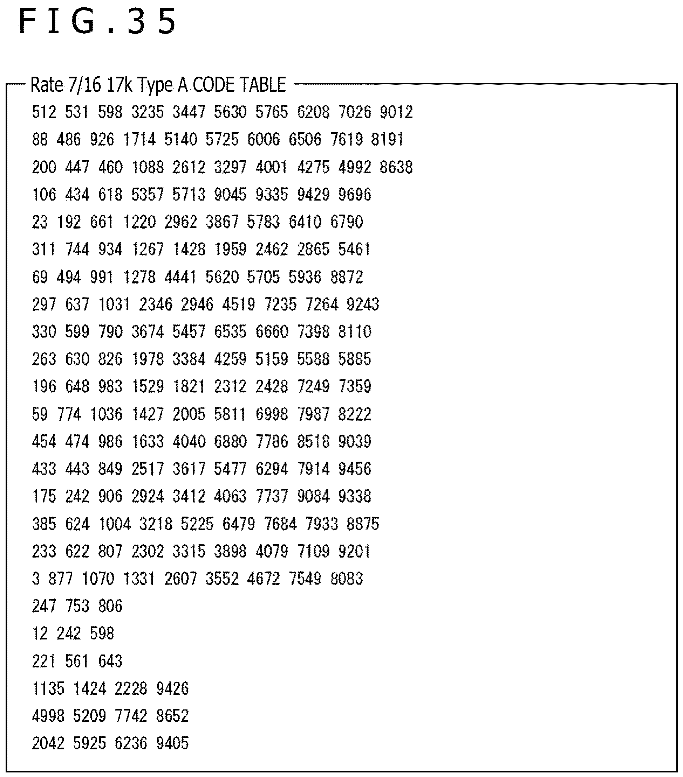

FIG. 35 is a diagram illustrating an example of a check matrix initial value table of a type A code having N = 17280 bits and r = 7/16.

[FIG. 36]

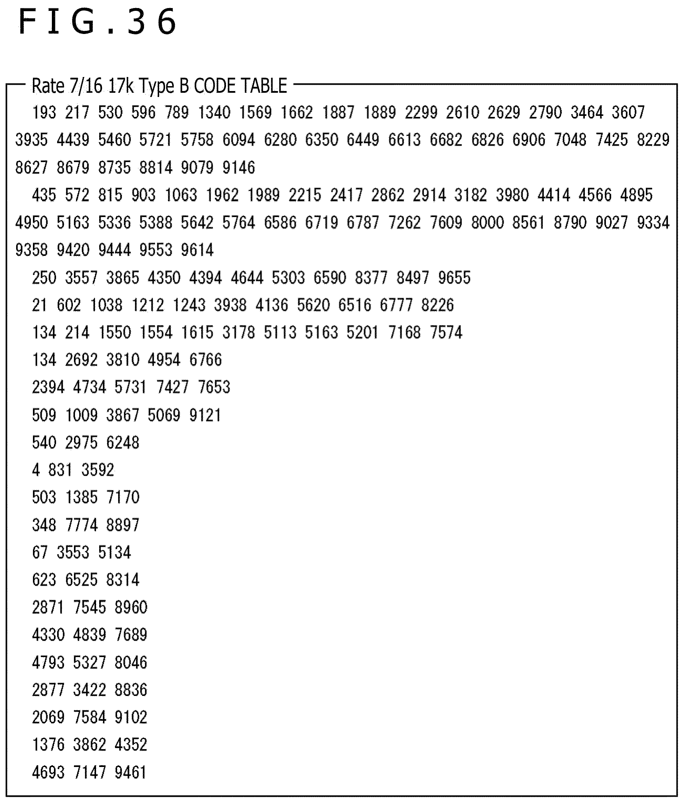

FIG. 36 is a diagram illustrating an example of a check matrix initial value table of a type B code having N = 17280 bits and r = 7/16.

[FIG. 37]

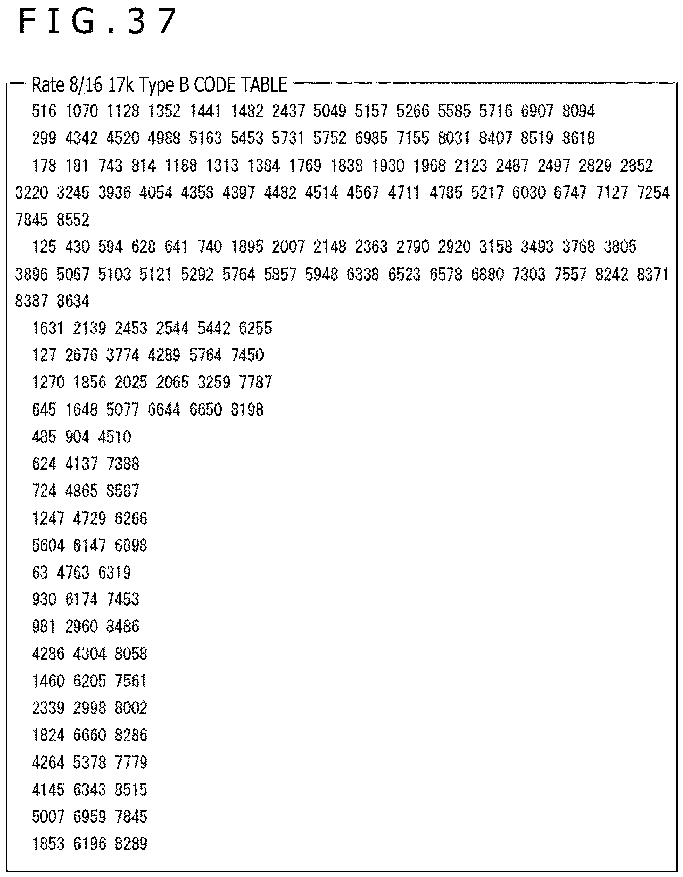

FIG. 37 is a diagram illustrating an example of a check matrix initial value table of a type B code having N = 17280 bits and r = 8/16.

[FIG. 38]

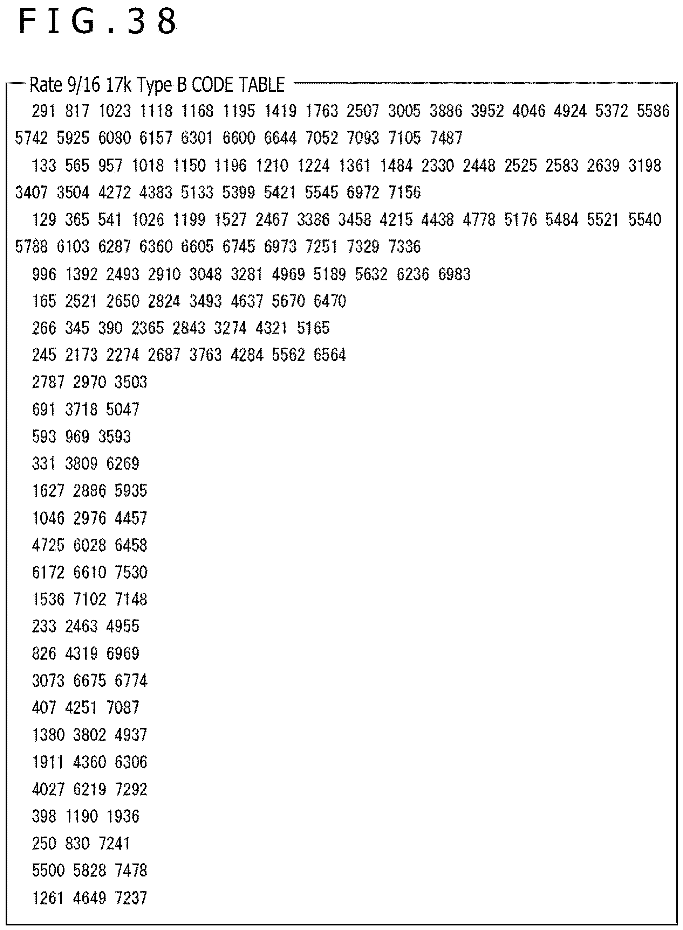

FIG. 38 is a diagram illustrating an example of a check matrix initial value table of a type B code having N = 17280 bits and r = 9/16.

[FIG. 39]

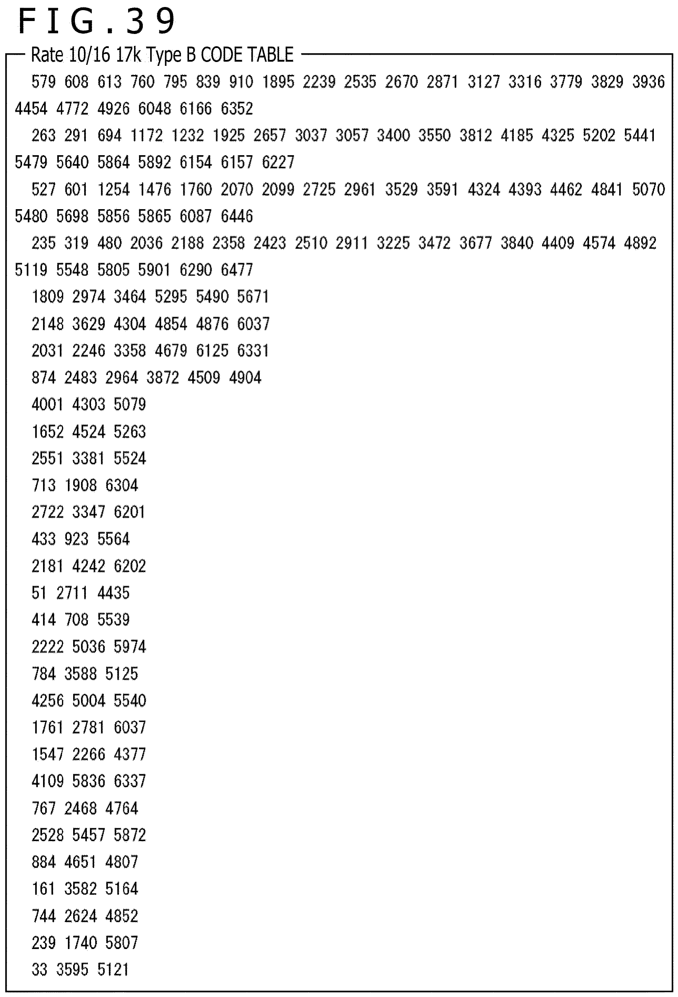

FIG. 39 is a diagram illustrating an example of a check matrix initial value table of a type B code having N = 17280 bits and r = 10/16.

[FIG. 40]

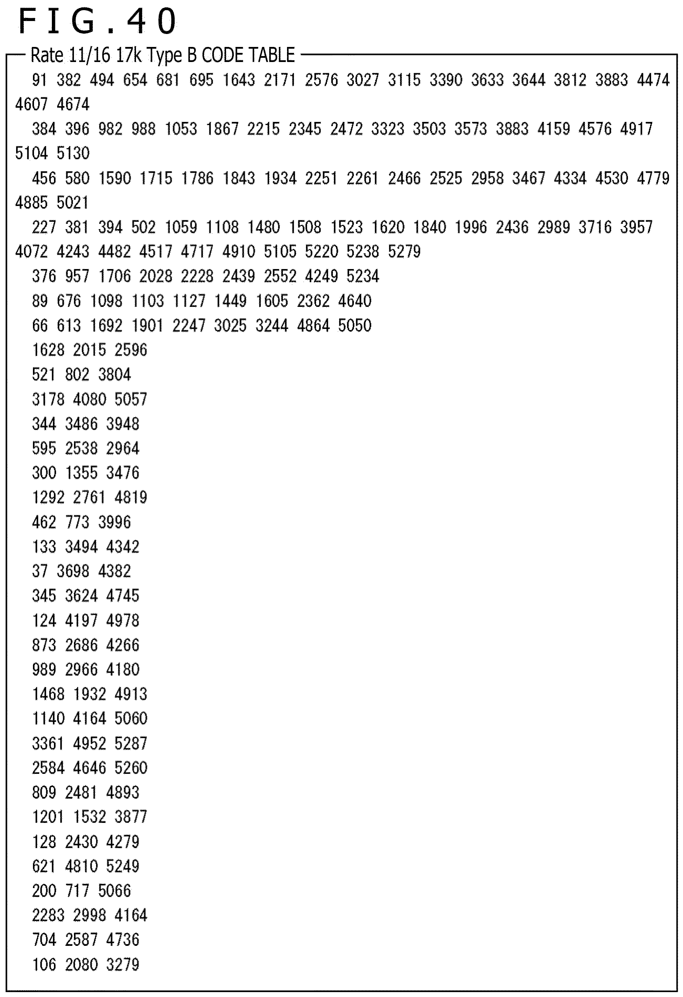

FIG. 40 is a diagram illustrating an example of a check matrix initial value table of a type B code having N = 17280 bits and r = 11/16.

[FIG. 41]

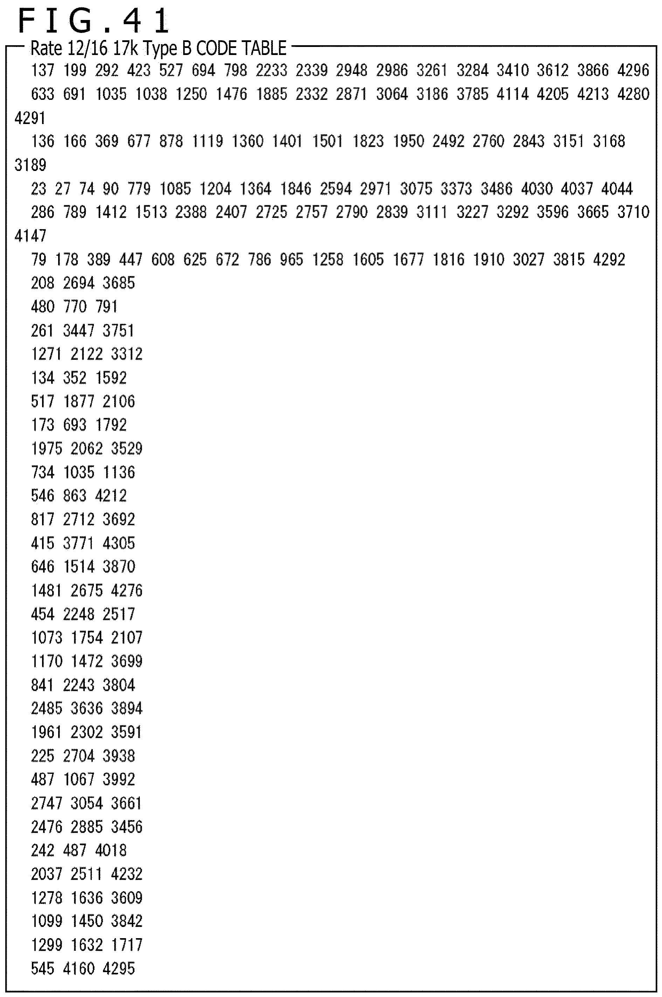

FIG. 41 is a diagram illustrating an example of a check matrix initial value table of a type B code having N = 17280 bits and r = 12/16.

[FIG. 42]

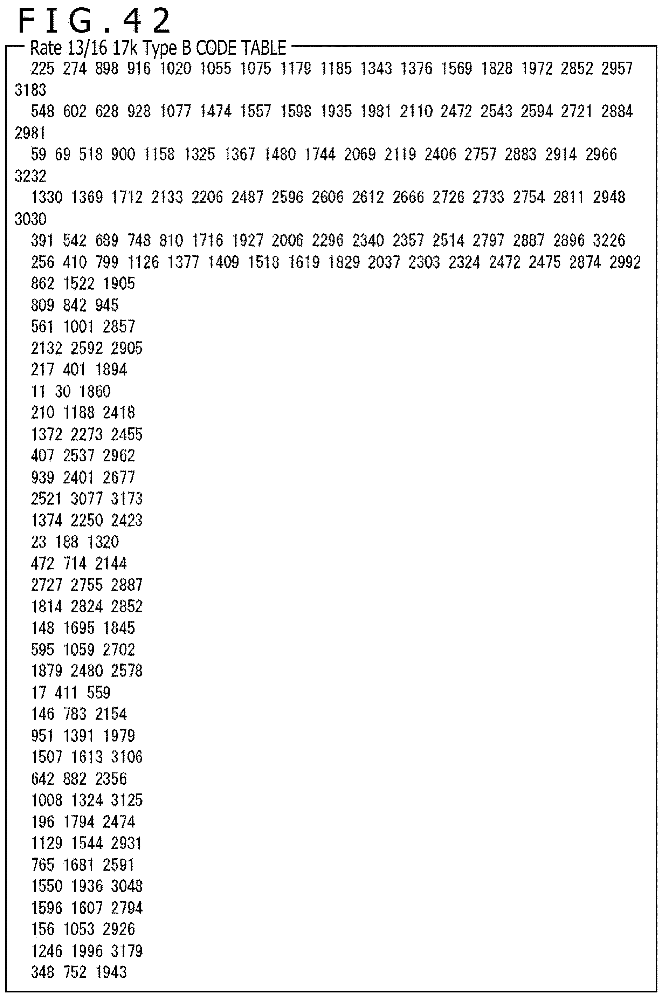

FIG. 42 is a diagram illustrating an example of a check matrix initial value table of a type B code having N = 17280 bits and r = 13/16.

[FIG. 43]

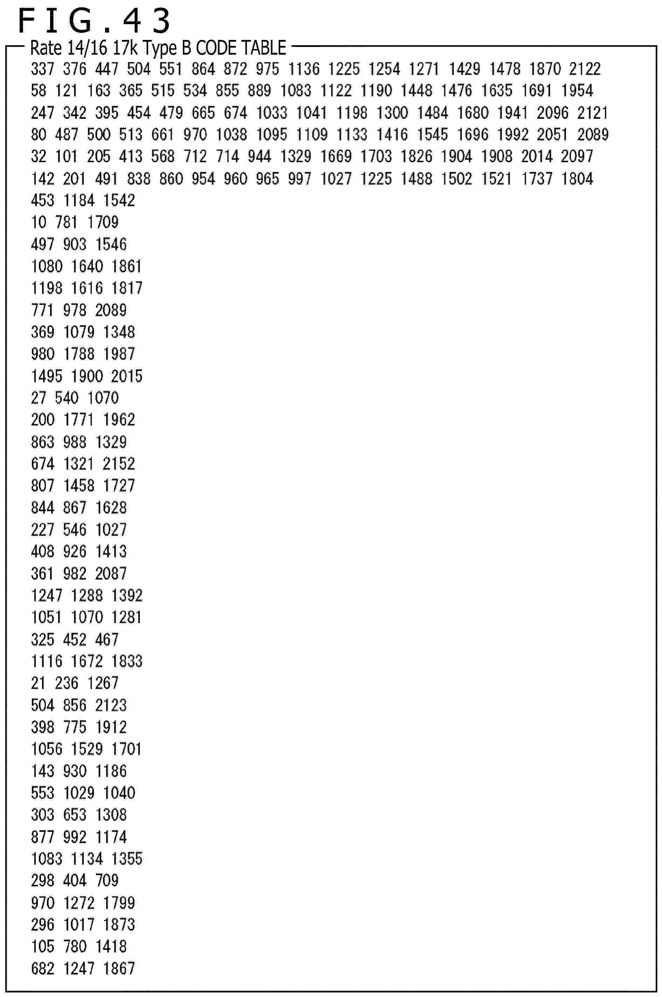

FIG. 43 is a diagram illustrating an example of a check matrix initial value table of a type B code having N = 17280 bits and r = 14/16.

[FIG. 44]

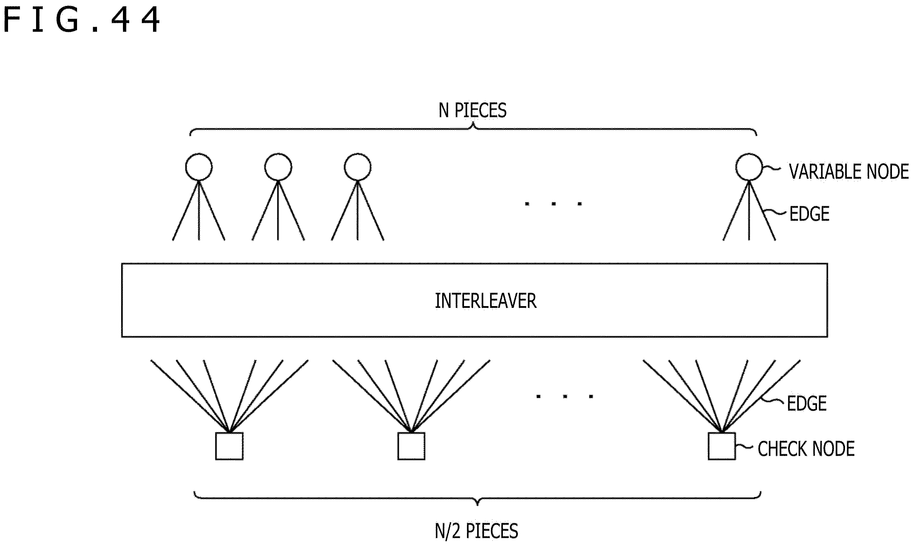

FIG. 44 is a diagram illustrating an example of a Tanner graph of an ensemble of a degree sequence having a column weight of 3 and a row weight of 6.

[FIG. 45]

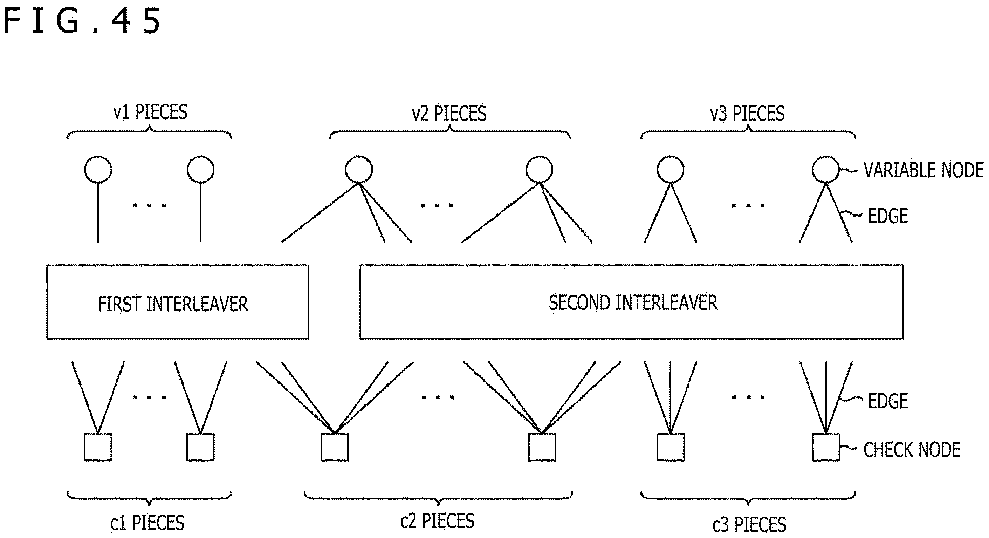

FIG. 45 is a diagram illustrating an example of a Tanner graph of a multi-edge type ensemble.

[FIG. 46]

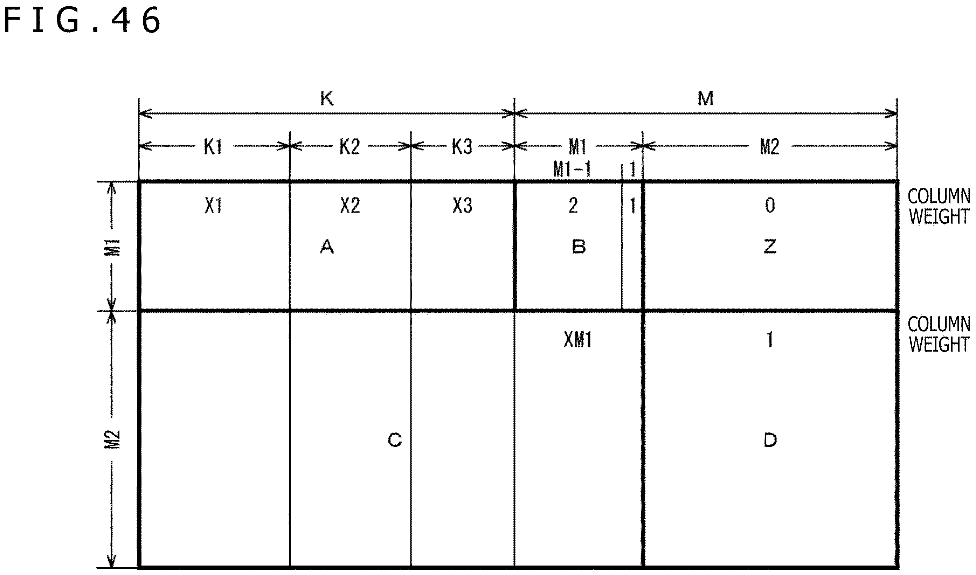

FIG. 46 is a diagram explaining a check matrix for a type A system.

[FIG. 47]

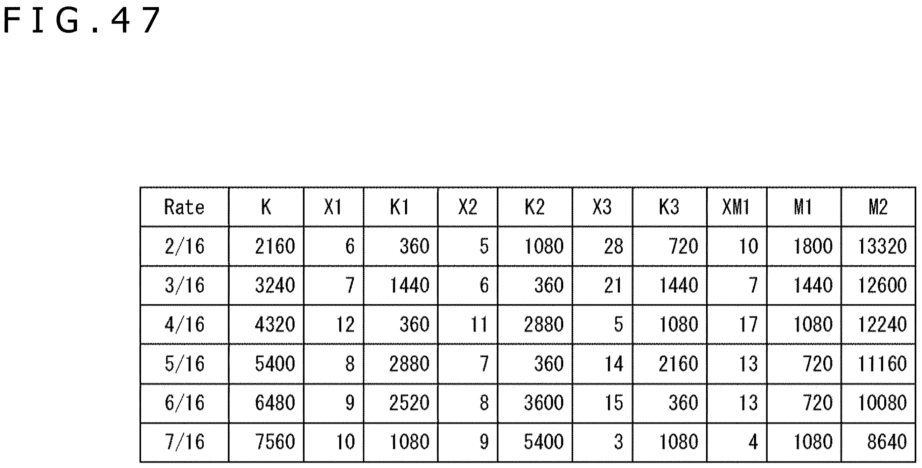

FIG. 47 is a diagram explaining check matrixes for the type A system.

[FIG. 48]

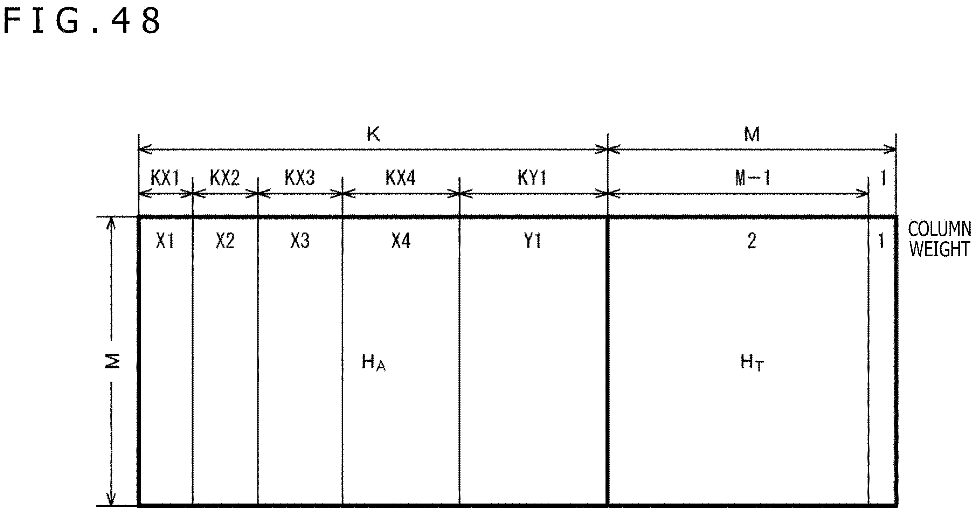

FIG. 48 is a diagram explaining a check matrix for a type B system.

[FIG. 49]

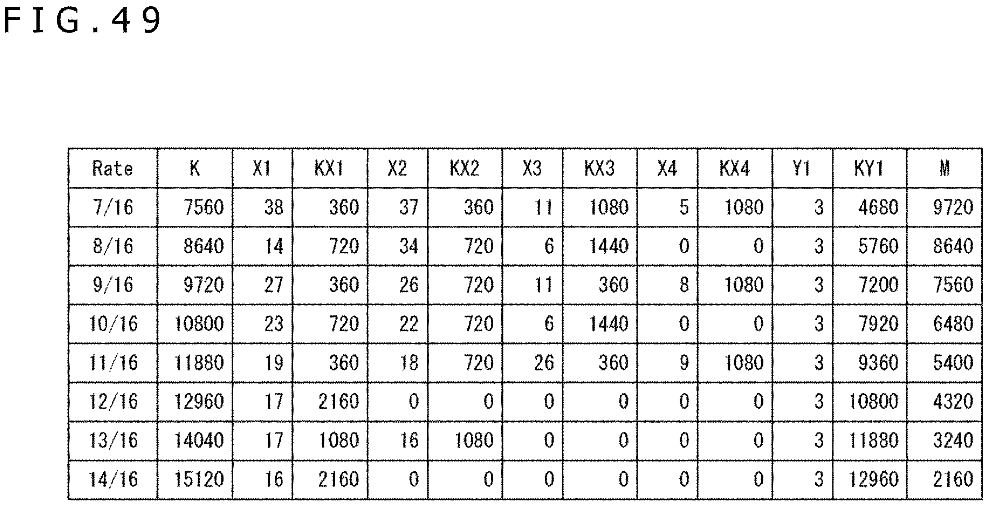

FIG. 49 is a diagram explaining check matrixes for the type B system.

[FIG. 50]

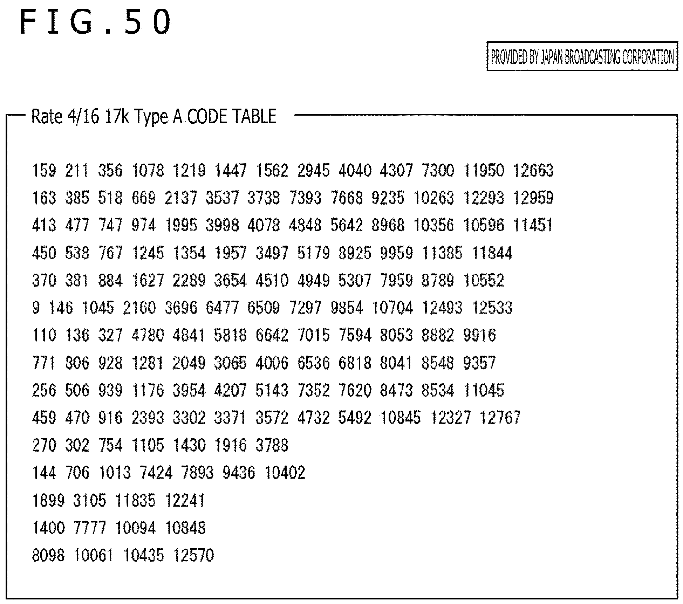

FIG. 50 is a diagram illustrating a check matrix initial value table for a new type A code having N = 17280 bits and r = 4/16.

[FIG. 51]

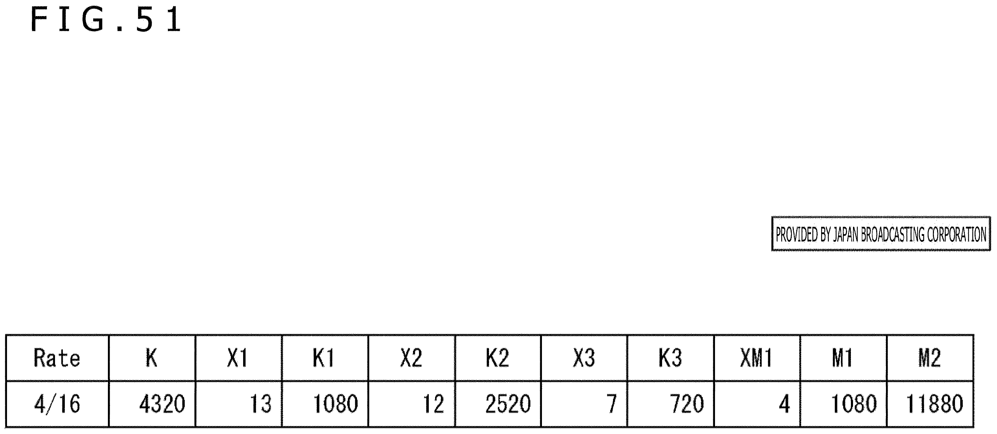

FIG. 51 is a diagram illustrating parameters of a check matrix H for the new type A code having r = 4/16.

[FIG. 52]

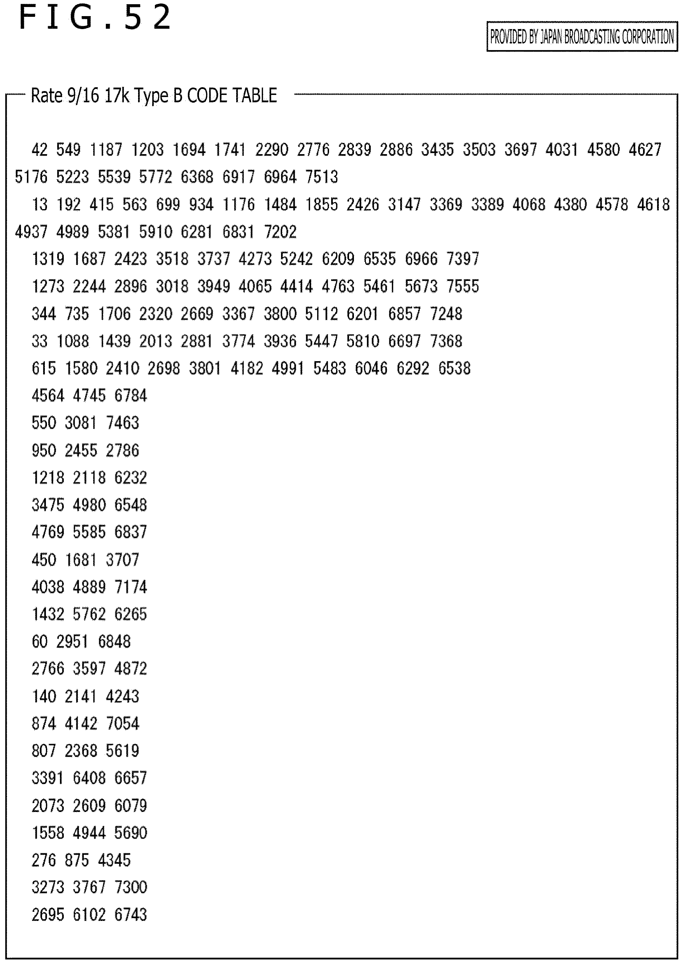

FIG. 52 is a diagram illustrating a check matrix initial value table for a new type B code having N = 17280 bits and r = 9/16.

[FIG. 53]

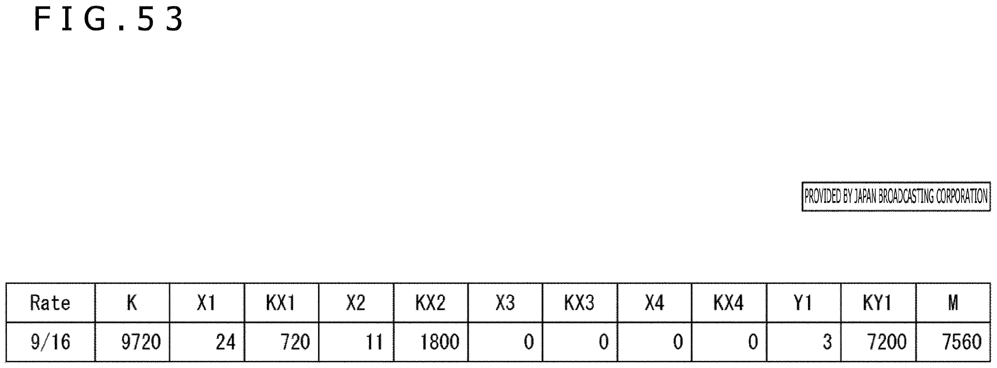

FIG. 53 is a diagram illustrating parameters of a check matrix H for the new type B code having r = 9/16.

[FIG. 54]

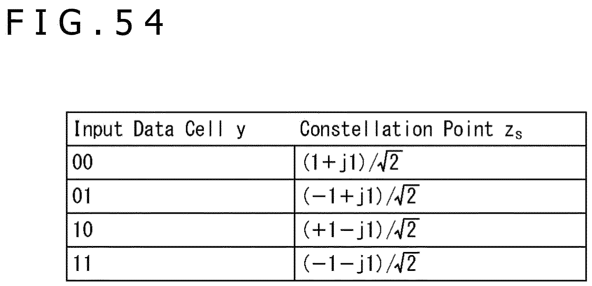

FIG. 54 is a diagram illustrating an example of coordinates of signal points of a UC in a case where QPSK is adopted as a modulation system.

[FIG. 55]

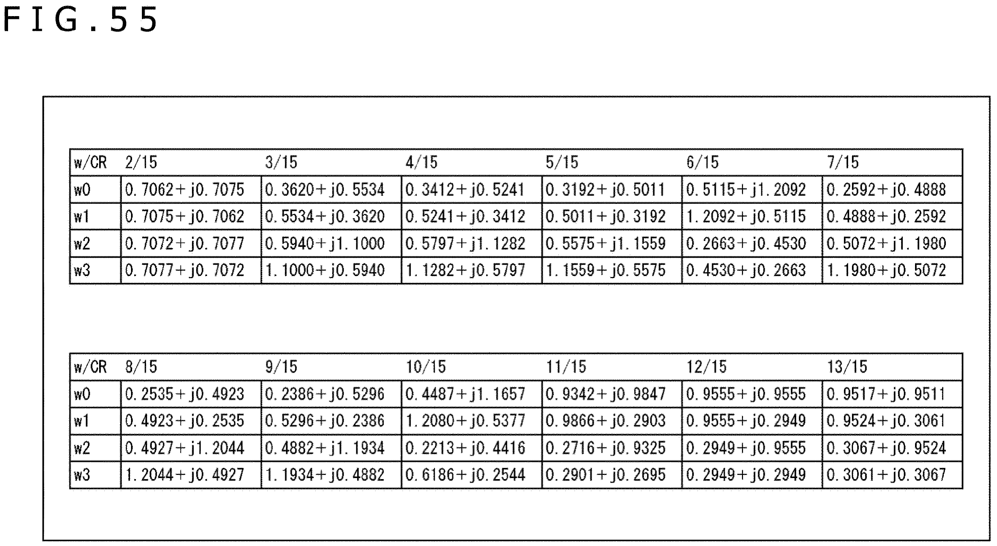

FIG. 55 is a diagram illustrating an example of coordinates of signal points of 2D-NUCs in a case where 16QAM is adopted as a modulation system.

[FIG. 56]

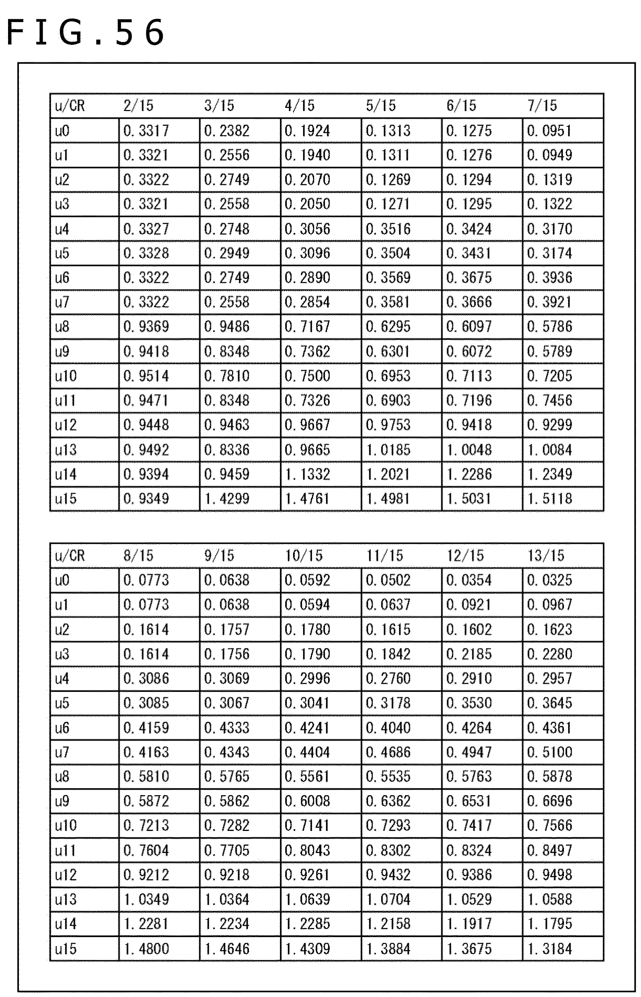

FIG. 56 is a diagram illustrating an example of coordinates of signal points of 1D-NUCs in a case where 1024QAM is adopted as a modulation system.

[FIG. 57]

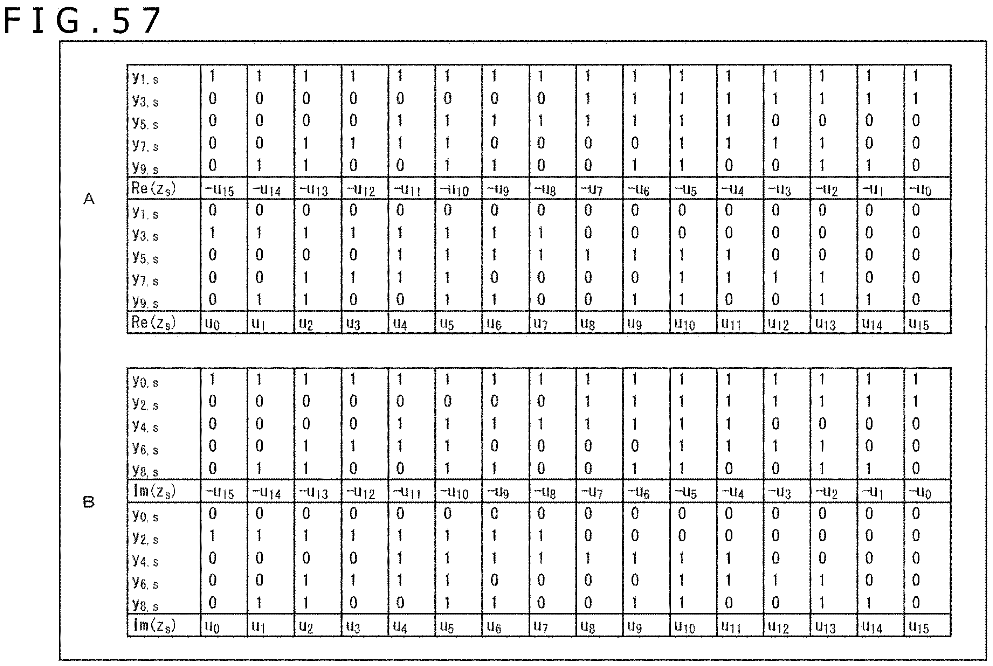

FIG. 57 is a diagram illustrating a relation between a symbol y of 1024QAM and a position vector u.

[FIG. 58]

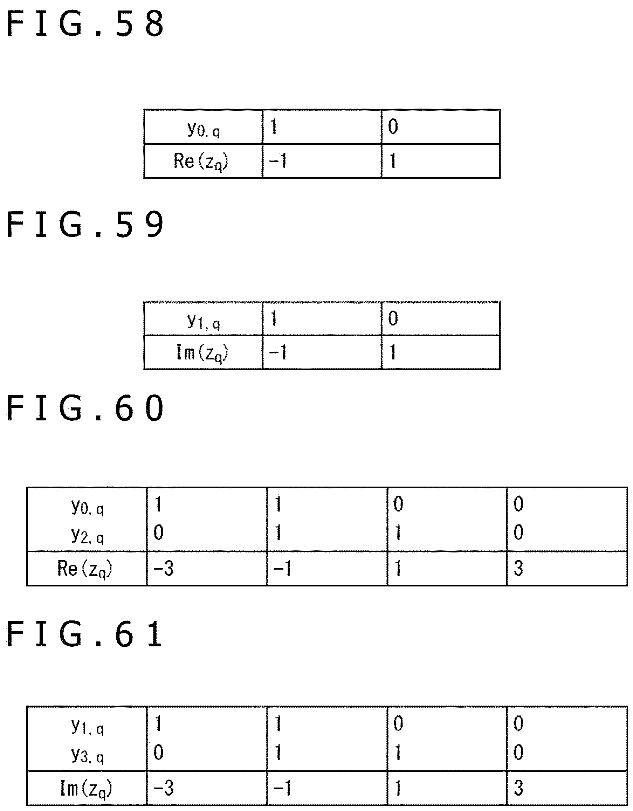

FIG. 58 is a diagram illustrating an example of a coordinate $z_q$ of a signal point of a QPSK-UC.

[FIG. 59]

FIG. 59 is a diagram illustrating an example of the coordinate $z_q$ of the signal point of the QPSK-UC.

[FIG. 60]

FIG. 60 is a diagram illustrating an example of a coordinate $z_q$ of a signal point of a 16QAM-UC.

[FIG. 61]

FIG. 61 is a diagram illustrating an example of the coordinate $z_q$ of the signal point of the 16QAM-UC.

[FIG. 62]

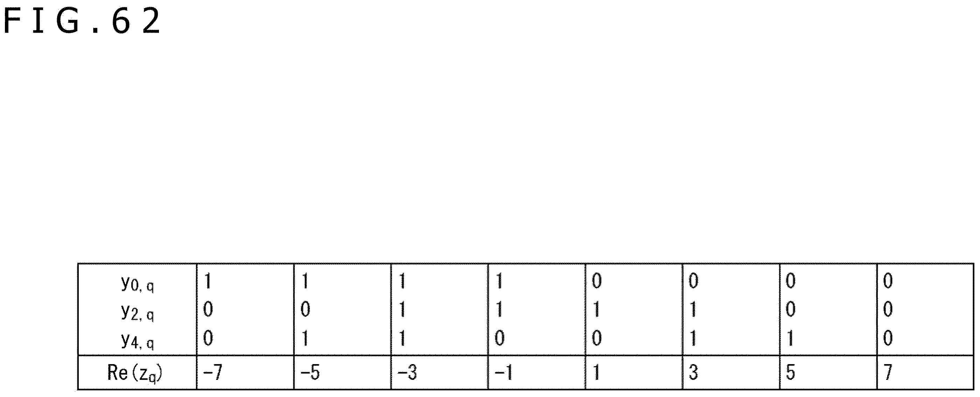

FIG. 62 is a diagram illustrating an example of a coordinate $z_q$ of a signal point of a 64QAM-UC.

[FIG. 63]

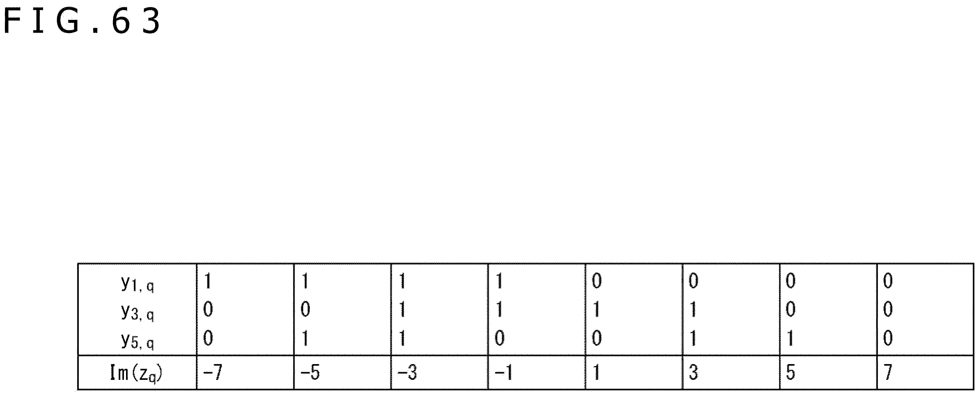

FIG. 63 is a diagram illustrating an example of the coordinate $z_q$ of the signal point of the 64QAM-UC.

[FIG. 64]

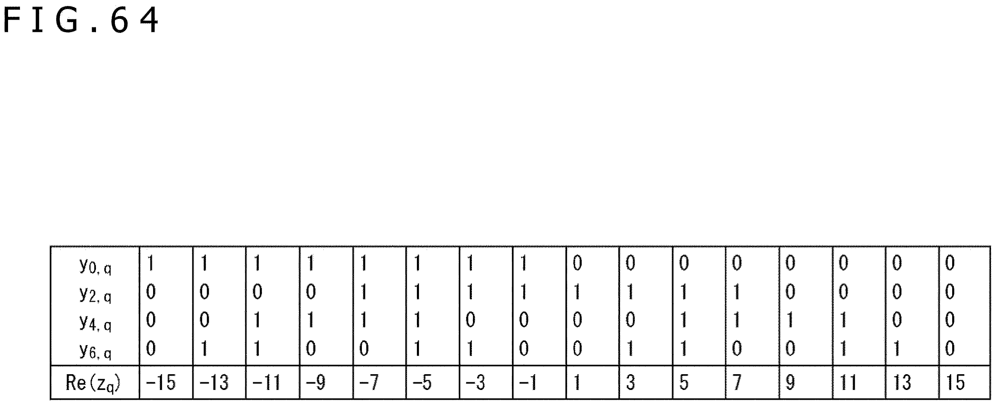

FIG. 64 is a diagram illustrating an example of a coordinate $z_q$ of a signal point of a 256QAM-UC.

[FIG. 65]

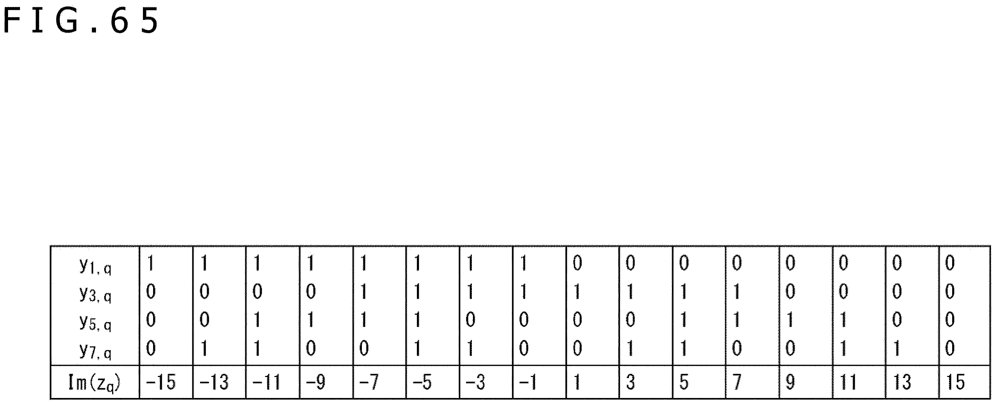

FIG. 65 is a diagram illustrating an example of the coordinate $z_q$ of the signal point of the 256QAM-UC.

[FIG. 66]

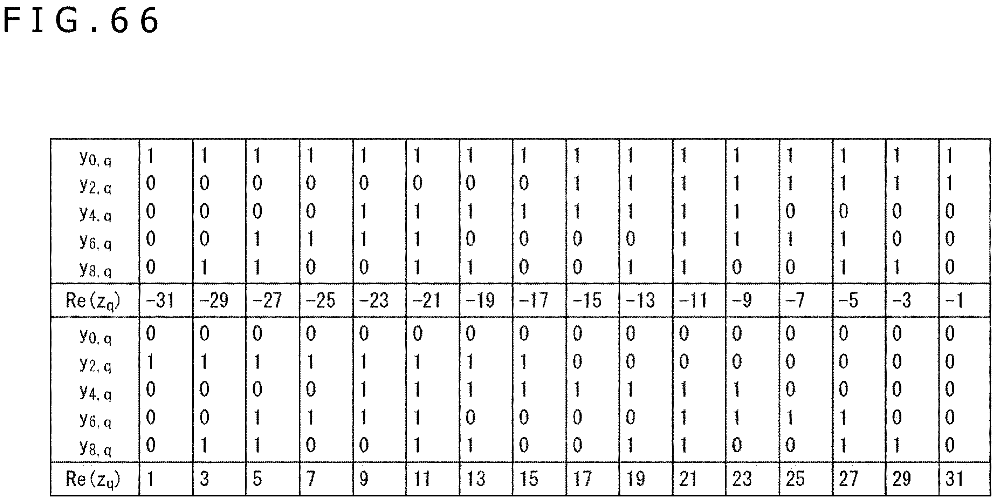

FIG. 66 is a diagram illustrating an example of a coordinate $z_q$ of a signal point of a 1024QAM-UC.

[FIG. 67]

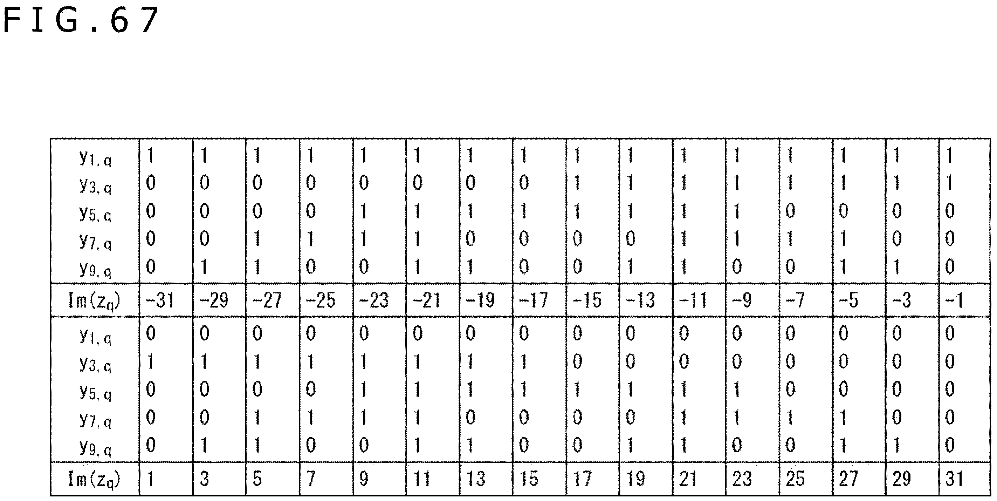

FIG. 67 is a diagram illustrating an example of the coordinate $z_q$ of the signal point of the 1024QAM-UC.

[FIG. 68]

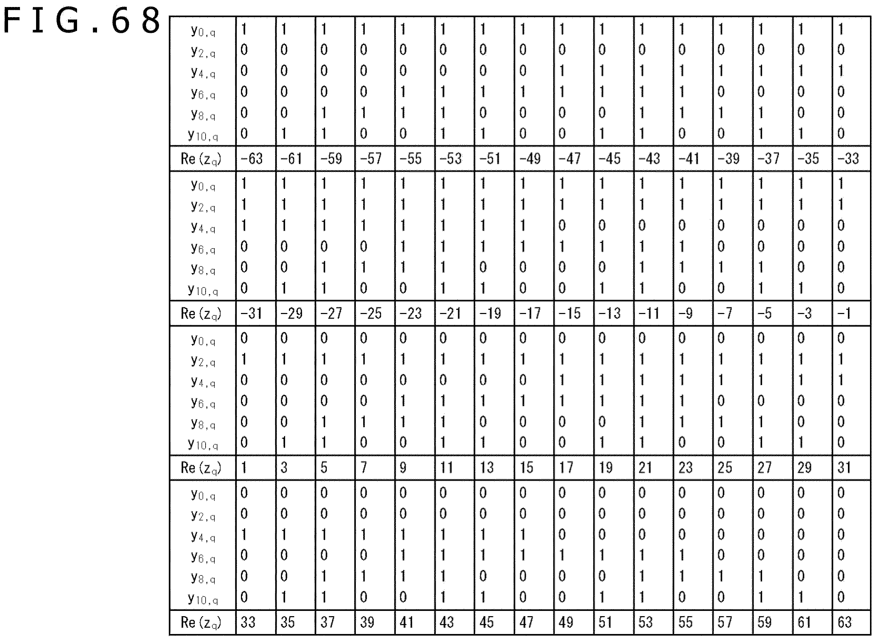

FIG. 68 is a diagram illustrating an example of a coordinate $z_q$ of a signal point of a 4096QAM-UC.

[FIG. 69]

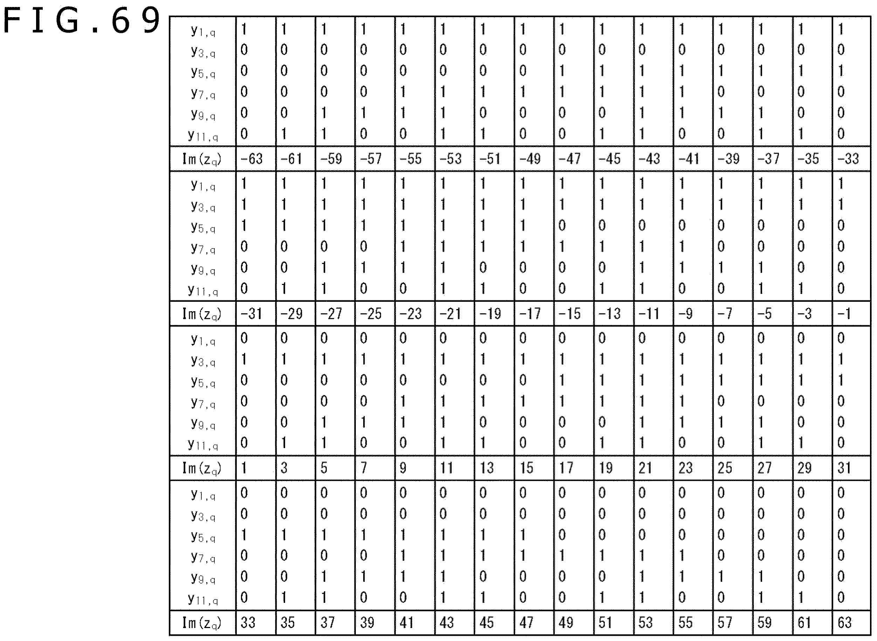

FIG. 69 is a diagram illustrating an example of the coordinate $z_q$ of the signal point of the 4096QAM-UC.

[FIG. 70]

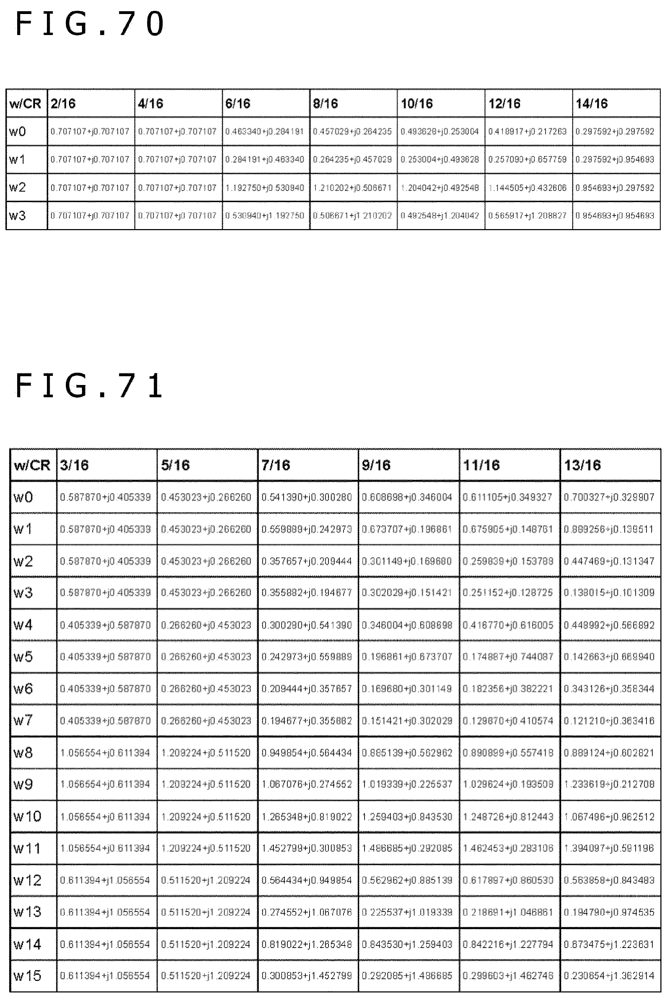

FIG. 70 is a diagram illustrating an example of coordinates $z_s$ of signal points of 16QAM-2D-NUCs.

[FIG. 71]

FIG. 71 is a diagram illustrating an example of coordinates $z_s$ of signal points of 64QAM-2D-NUCs.

[FIG. 72]

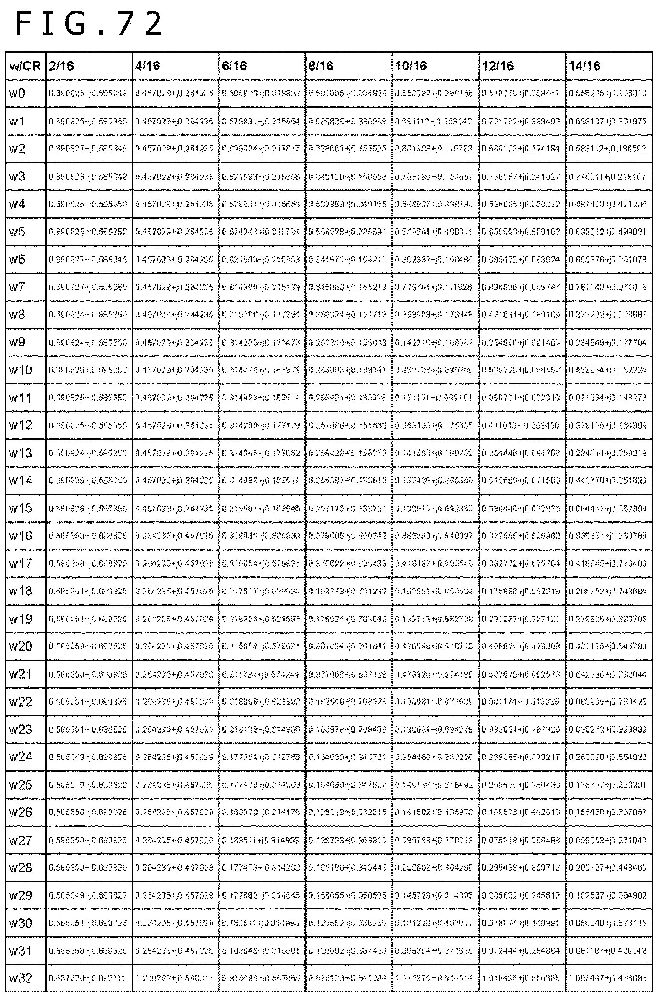

FIG. 72 is a diagram illustrating an example of coordinates $z_s$ of signal points of 256QAM-2D-NUCs.

[FIG. 73]

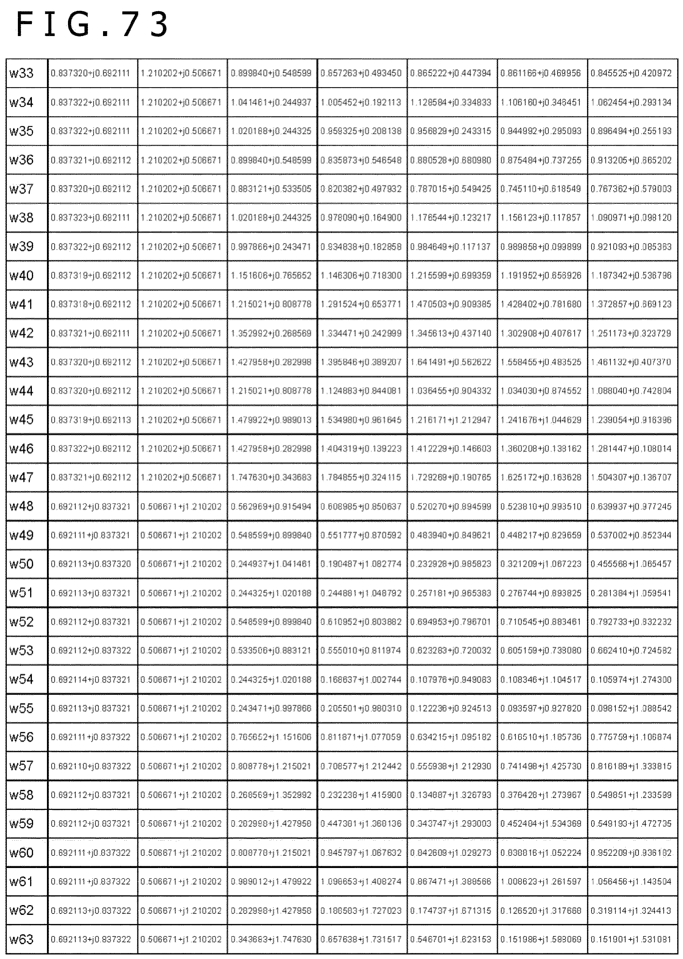

FIG. 73 is a diagram illustrating an example of coordinates $z_s$ of signal points of the 256QAM-2D-NUCs.

[FIG. 74]

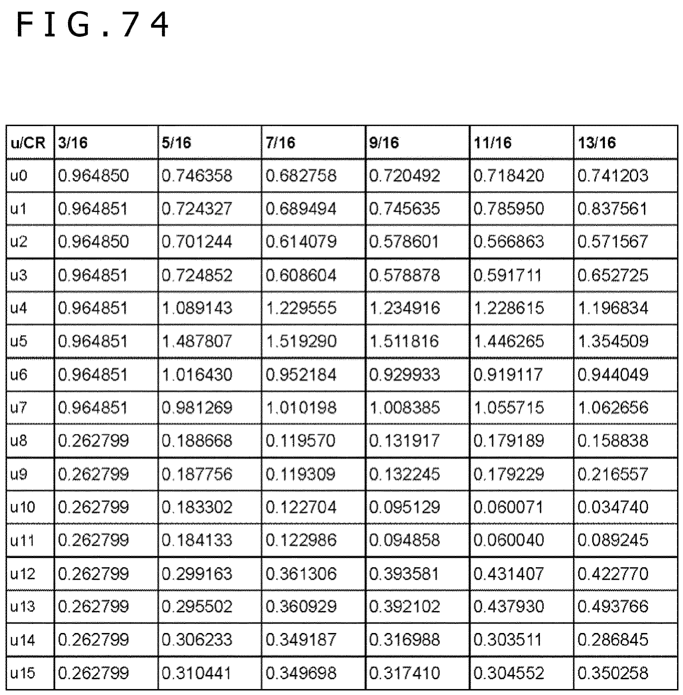

FIG. 74 is a diagram illustrating an example of coordinates $z_s$ of signal points of 1024QAM-1D-NUCs.

[FIG. 75]

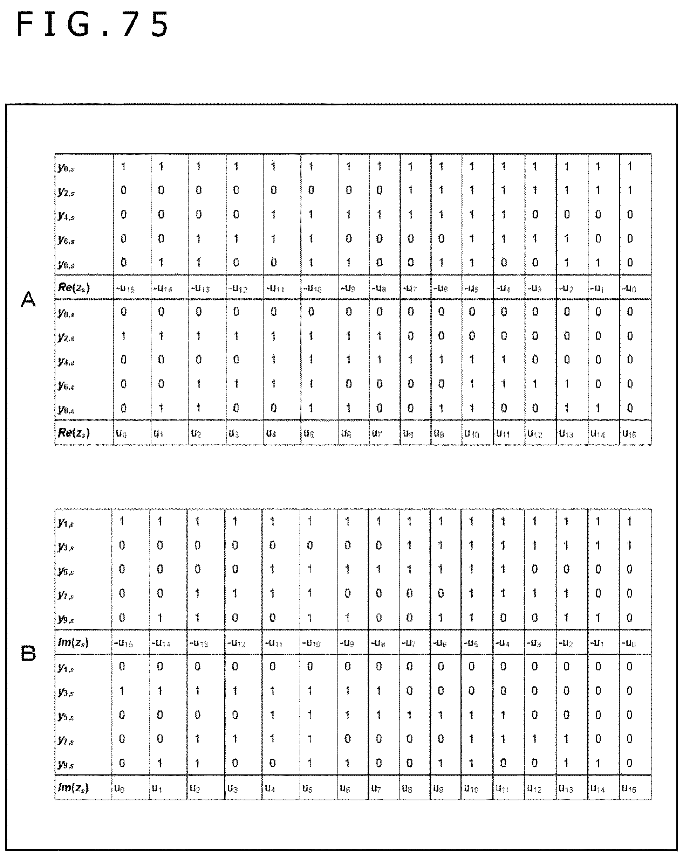

FIG. 75 is a diagram illustrating a relation between a symbol y of 1024QAM and a position vector u.

[FIG. 76]

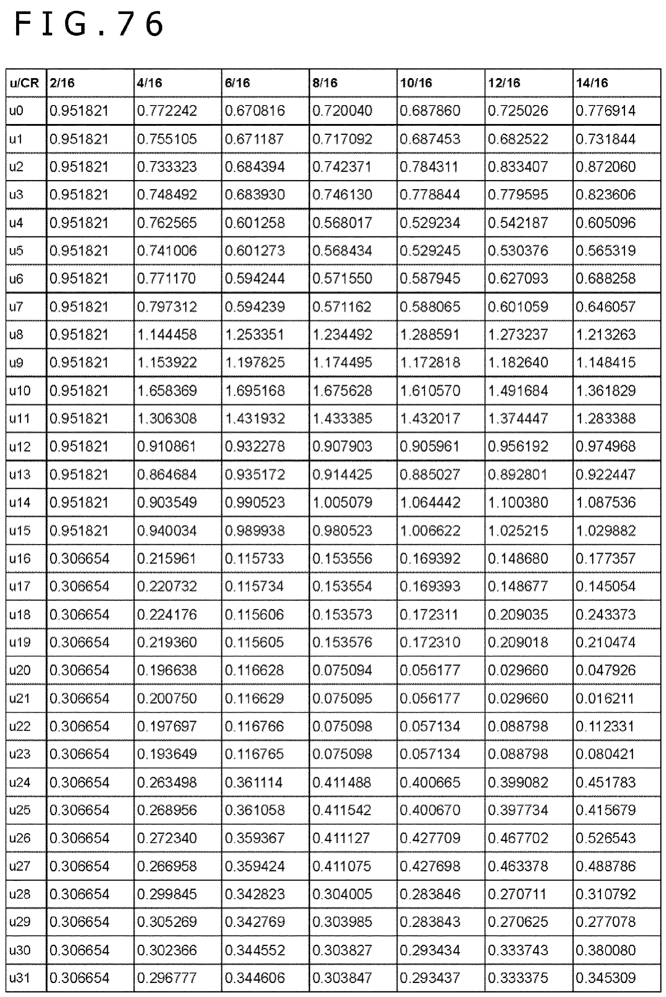

FIG. 76 is a diagram illustrating an example of coordinates $z_s$ of signal points of 4096QAM-1D-NUCs.

[FIG. 77]

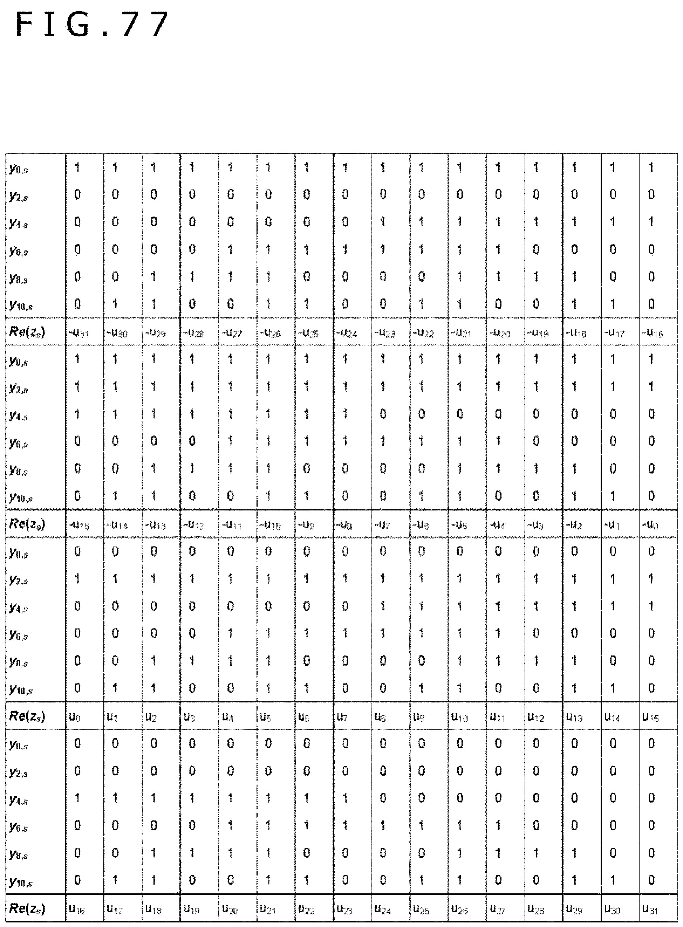

FIG. 77 is a diagram illustrating a relation between a symbol y of 4096QAM and a position vector u.

[FIG. 78]

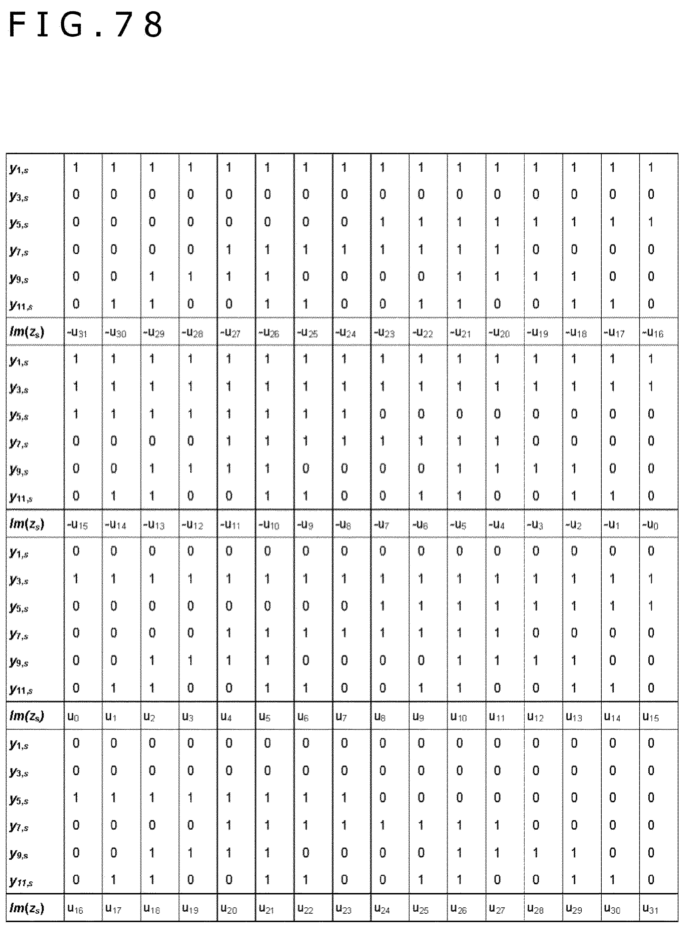

FIG. 78 is a diagram illustrating a relation between the symbol y of 4096QAM and the position vector u.

[FIG. 79]

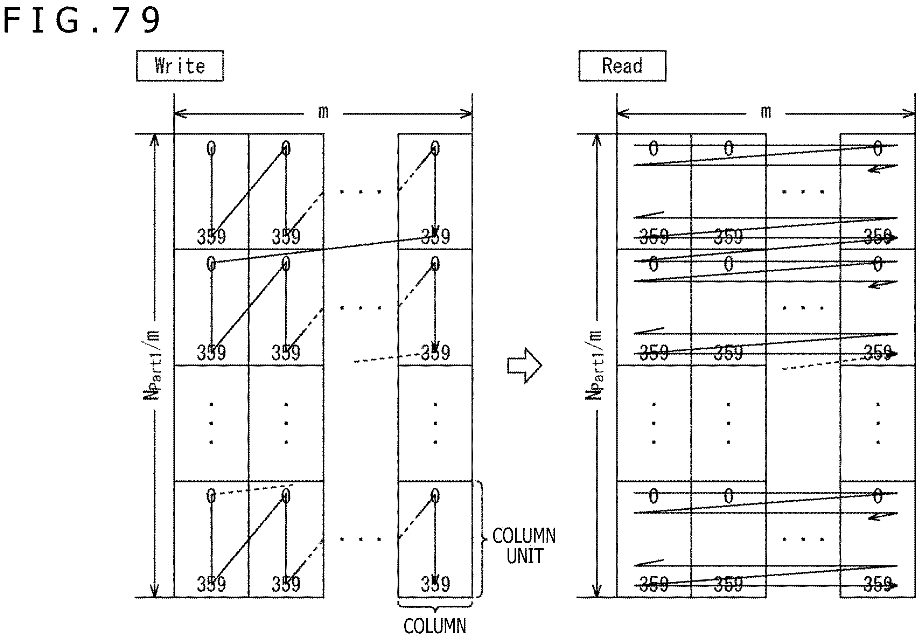

FIG. 79 is a diagram explaining block interleaving performed by a block interleaver 25.

[FIG. 80]

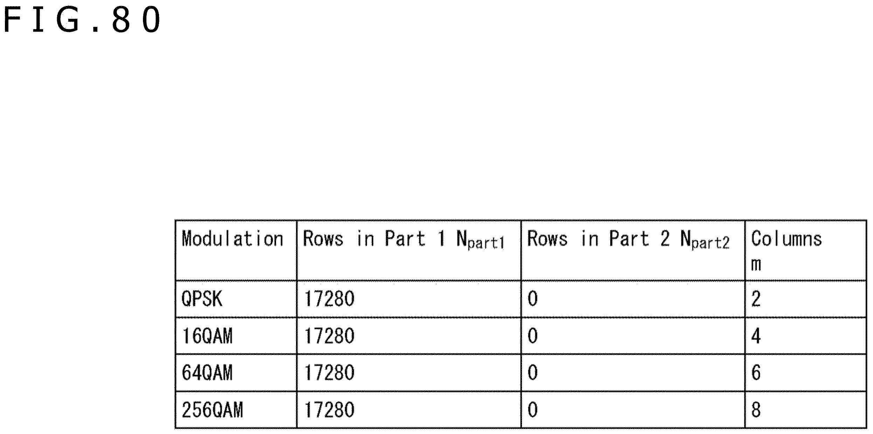

FIG. 80 is a diagram explaining the block interleaving performed by the block interleaver 25.

[FIG. 81]

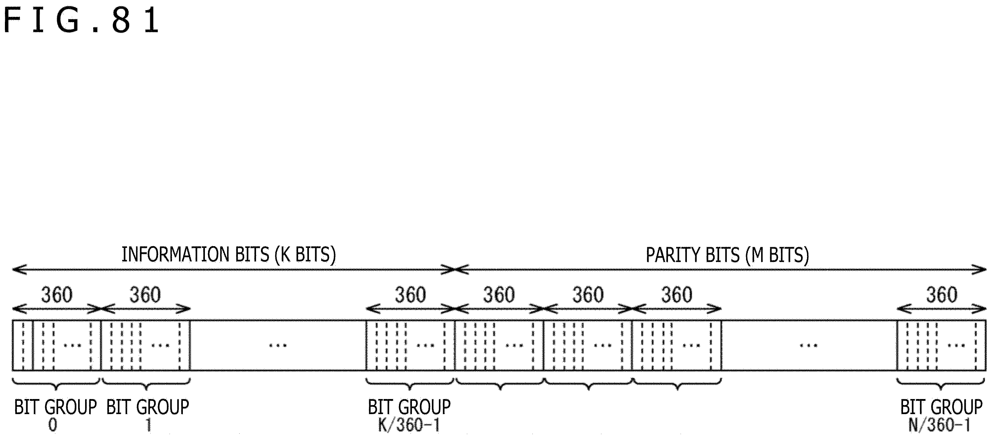

FIG. 81 is a diagram explaining groupwise interleaving performed by a groupwise interleaver 24.

[FIG. 82]

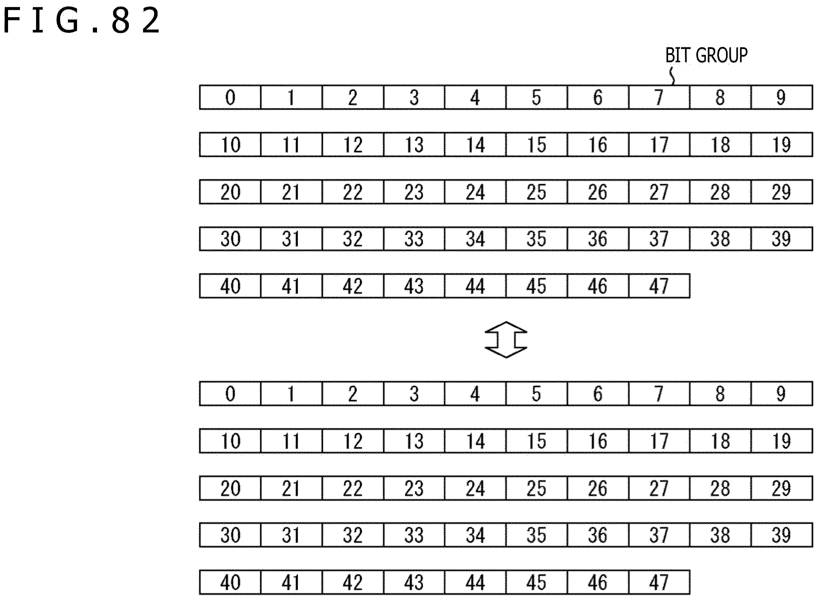

FIG. 82 is a diagram illustrating a first example of a GW pattern for an LDPC code having a code length N of 17280 bits.

[FIG. 83]

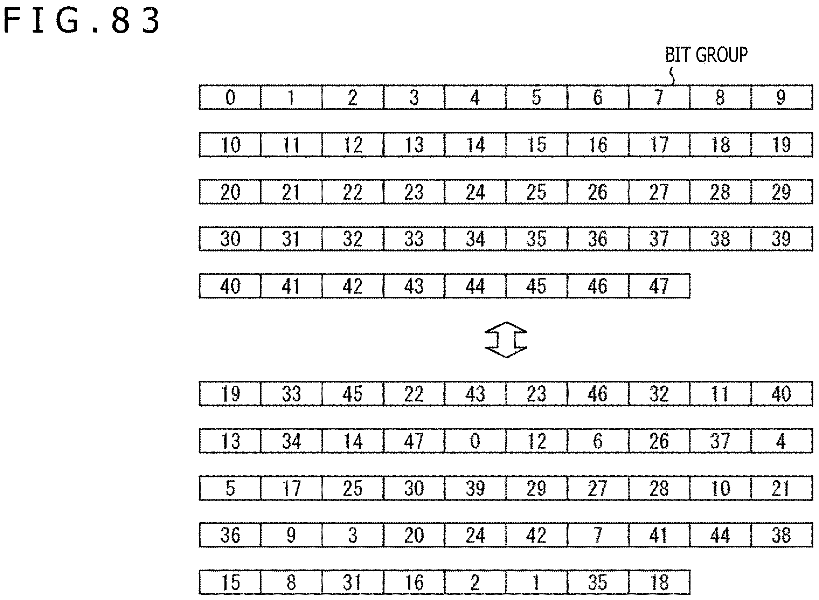

FIG. 83 is a diagram illustrating a second example of the GW pattern for the LDPC code having the code length N of 17280 bits.

[FIG. 84]

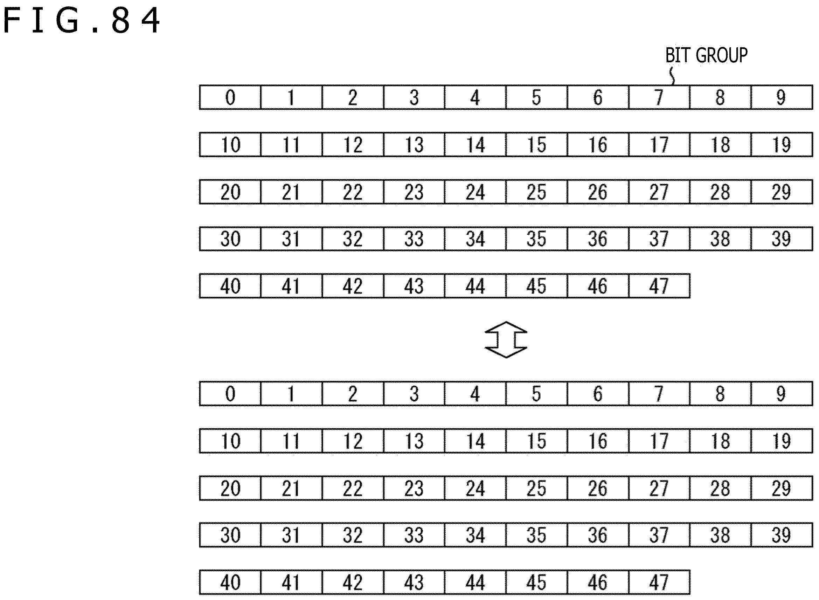

FIG. 84 is a diagram illustrating a third example of the GW pattern for the LDPC code having the code length N of 17280 bits.

[FIG. 85]

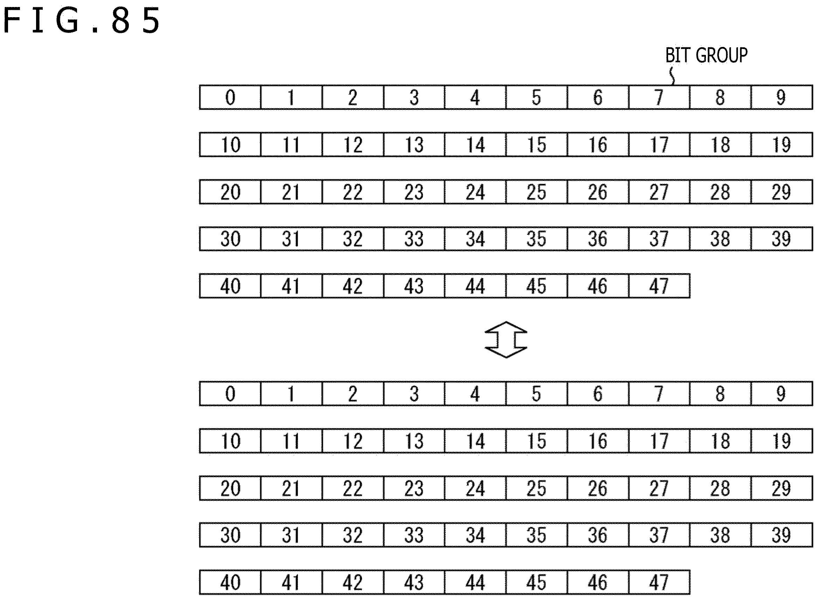

FIG. 85 is a diagram illustrating a fourth example of the GW pattern for the LDPC code having the code length N of 17280 bits.

[FIG. 86]

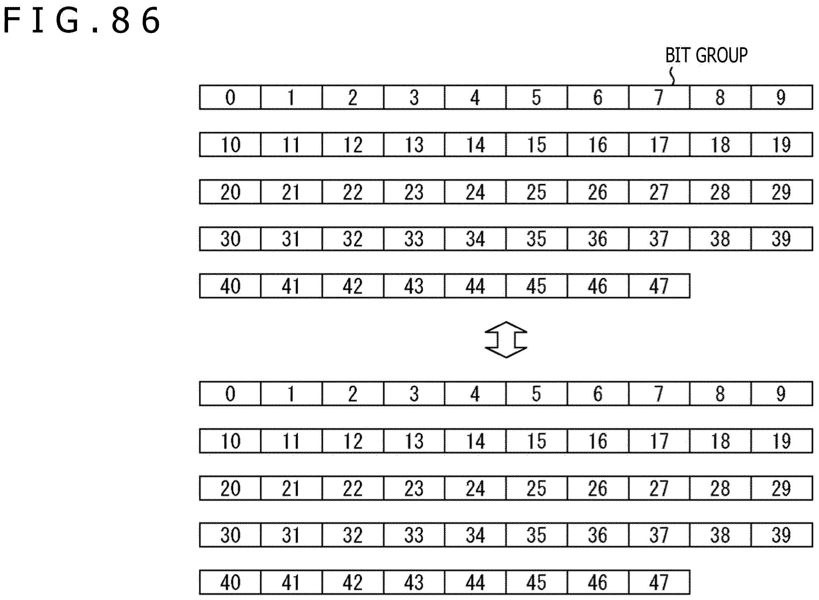

FIG. 86 is a diagram illustrating a fifth example of the GW pattern for the LDPC code having the code length N of 17280 bits.

[FIG. 87]

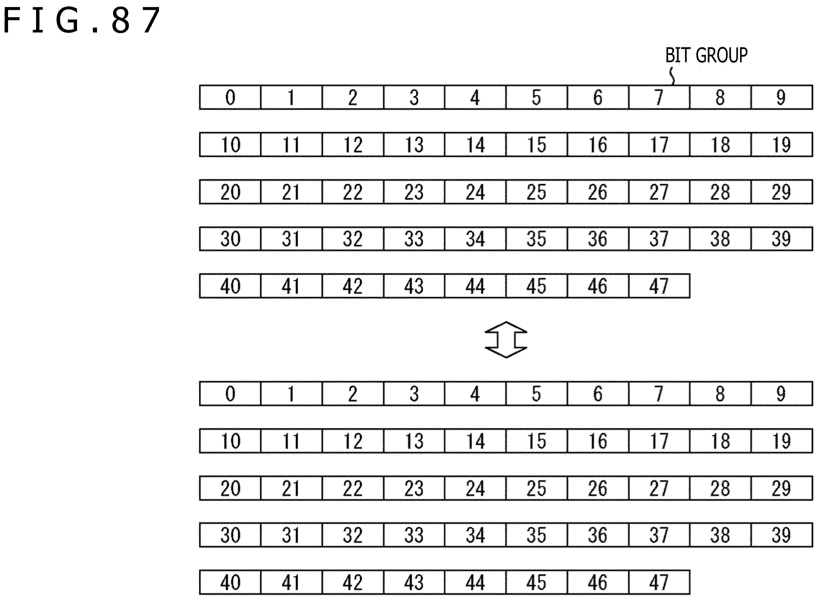

FIG. 87 is a diagram illustrating a sixth example of the GW pattern for the LDPC code having the code length N of 17280 bits.

[FIG. 88]

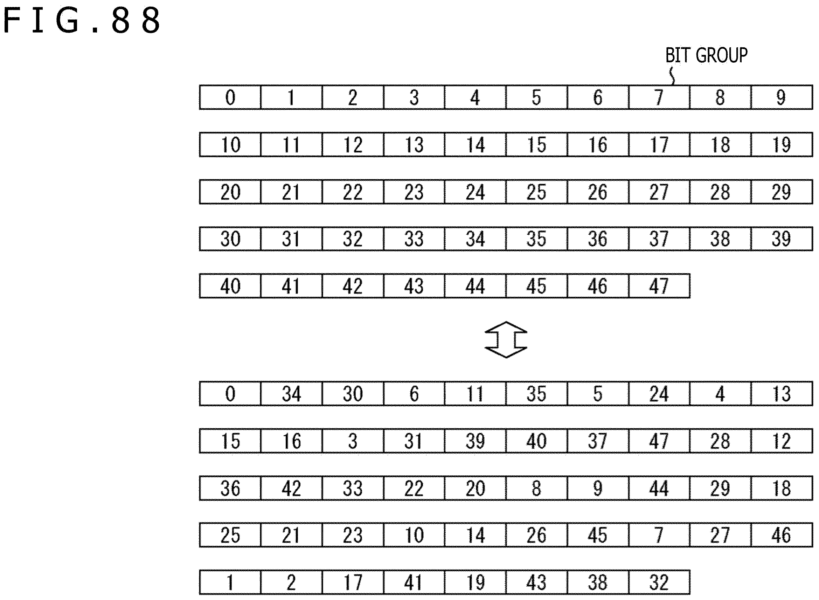

FIG. 88 is a diagram illustrating a seventh example of the GW pattern for the LDPC code having the code length N of 17280 bits.

[FIG. 89]

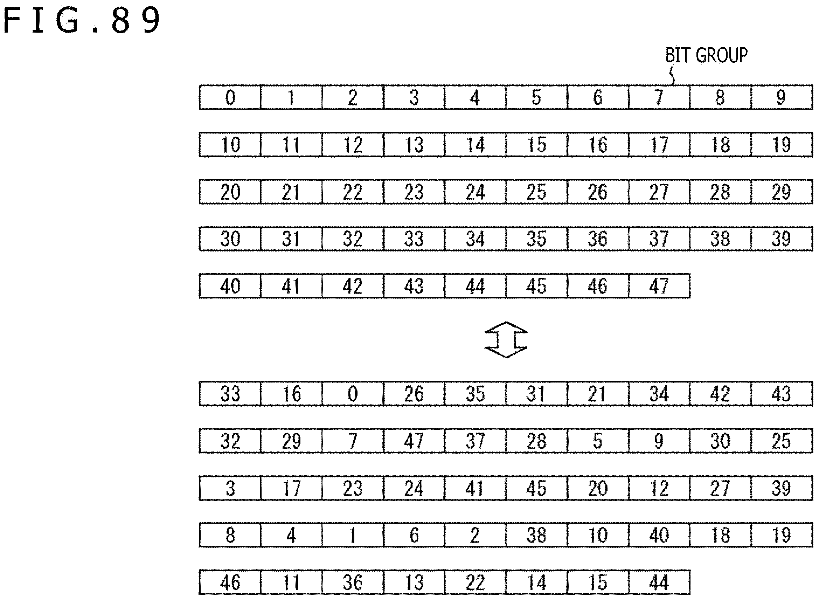

FIG. 89 is a diagram illustrating an eighth example of the GW pattern for the LDPC code having the code length N of 17280 bits.

[FIG. 90]

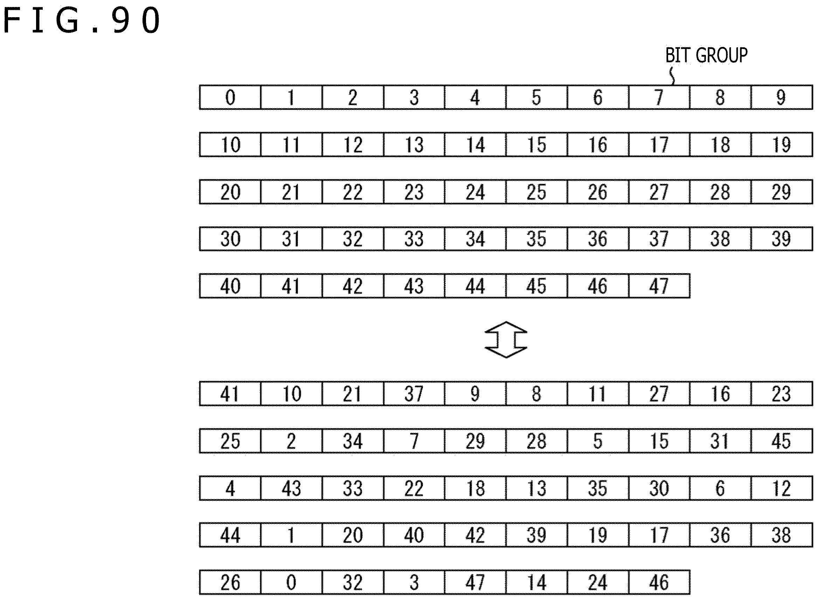

FIG. 90 is a diagram illustrating a ninth example of the GW pattern for the LDPC code having the code length N of 17280 bits.

[FIG. 91]

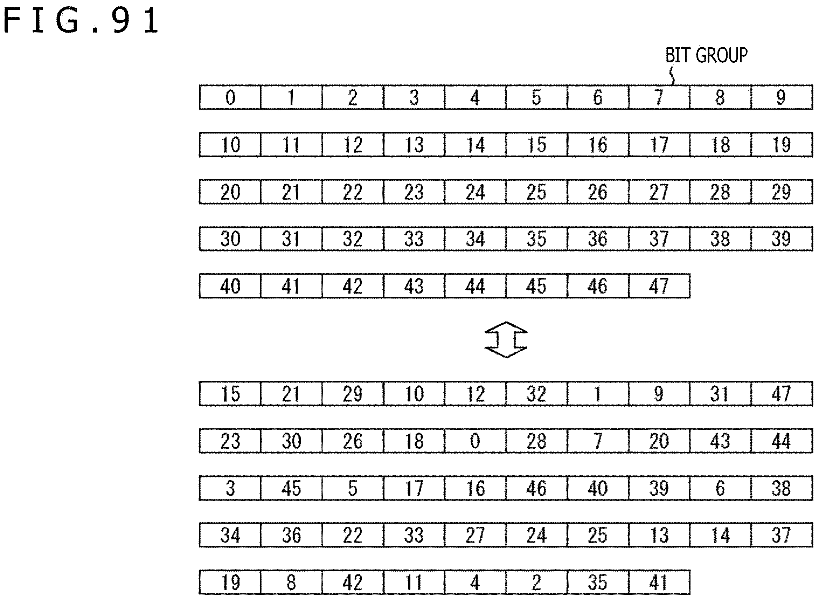

FIG. 91 is a diagram illustrating a tenth example of the GW pattern for the LDPC code having the code length N of 17280 bits.

[FIG. 92]

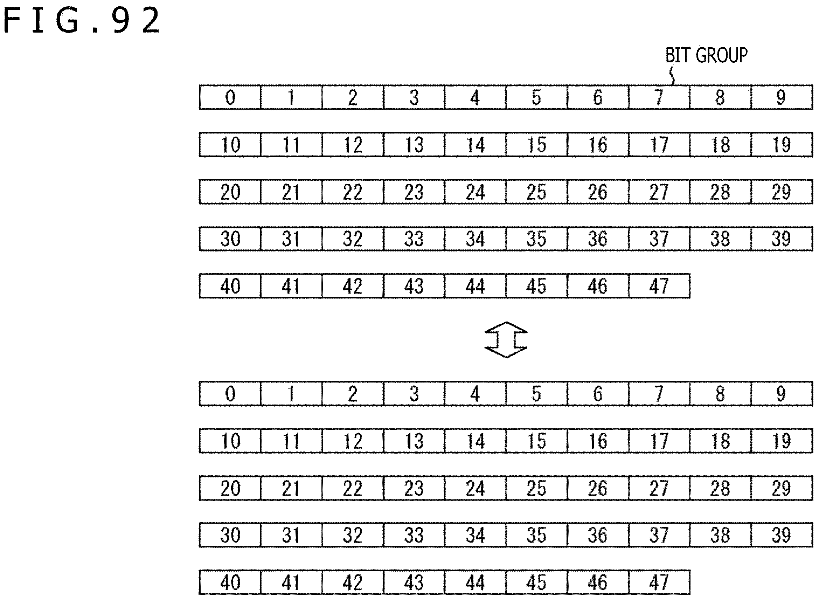

FIG. 92 is a diagram illustrating an eleventh example of the GW pattern for the LDPC code having the code length N of 17280 bits.

[FIG. 93]

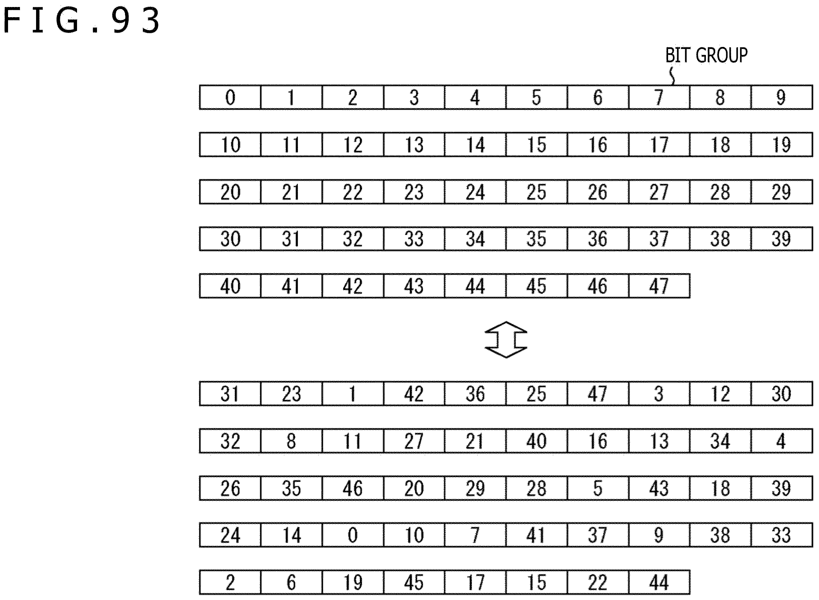

FIG. 93 is a diagram illustrating a twelfth example of the GW pattern for the LDPC code having the code length N of 17280 bits.

[FIG. 94]

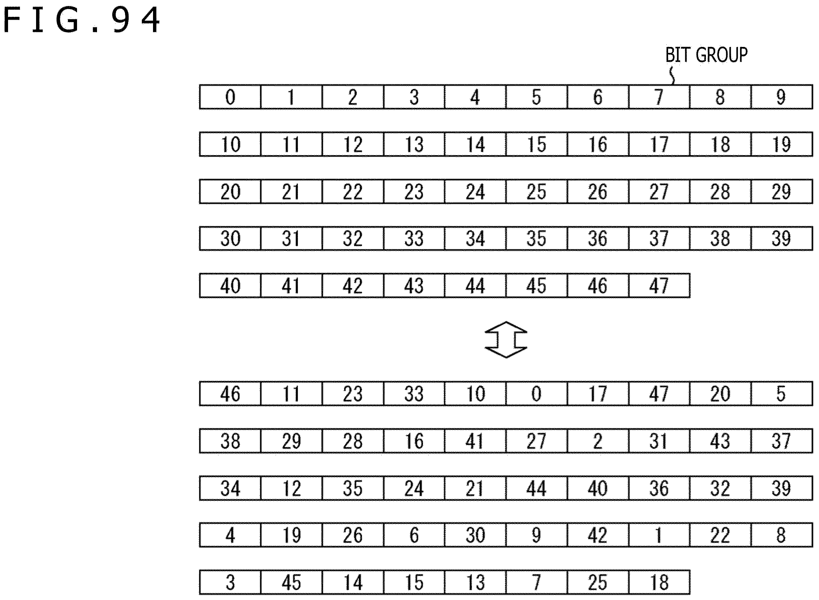

FIG. 94 is a diagram illustrating a thirteenth example of the GW pattern for the LDPC code having the code length N of 17280 bits.

[FIG. 95]

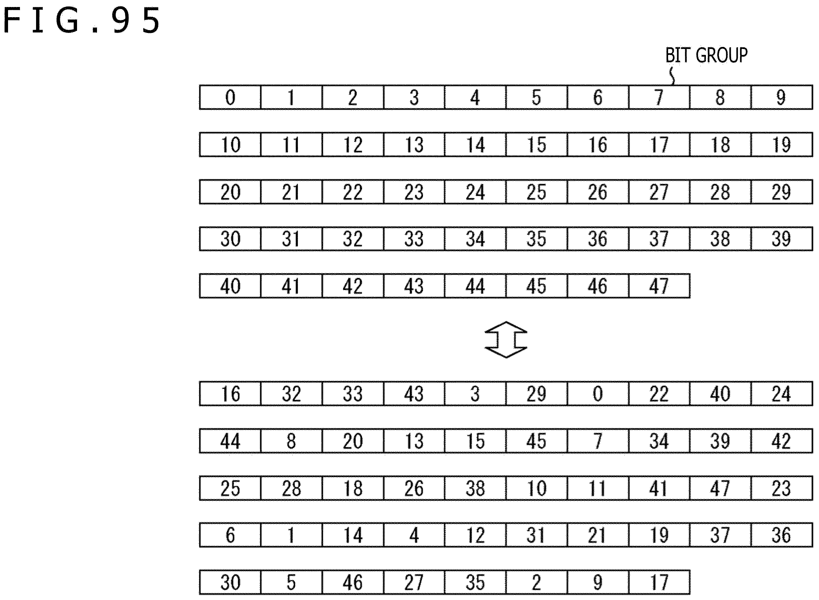

FIG. 95 is a diagram illustrating a fourteenth example of the GW pattern for the LDPC code having the code length N of 17280 bits.

[FIG. 96]

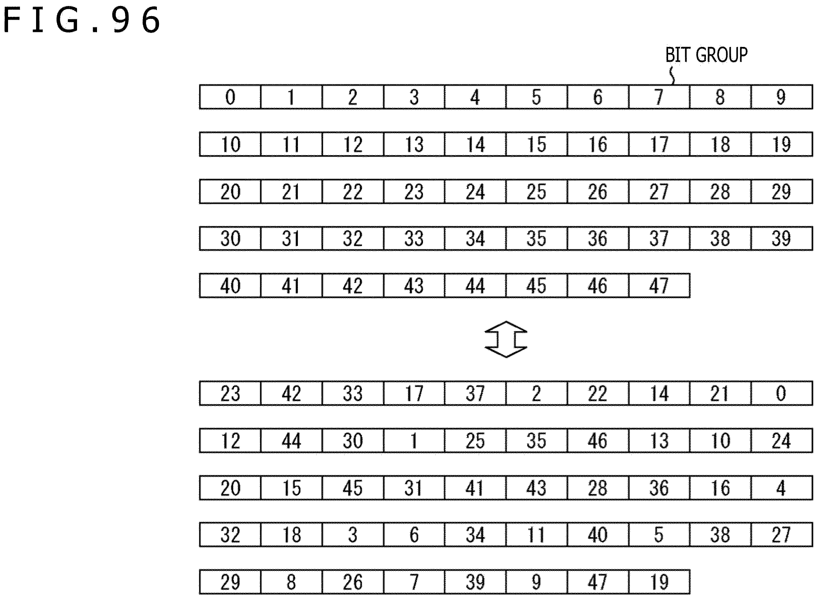

FIG. 96 is a diagram illustrating a fifteenth example of the GW pattern for the LDPC code having the code length N of 17280 bits.

[FIG. 97]

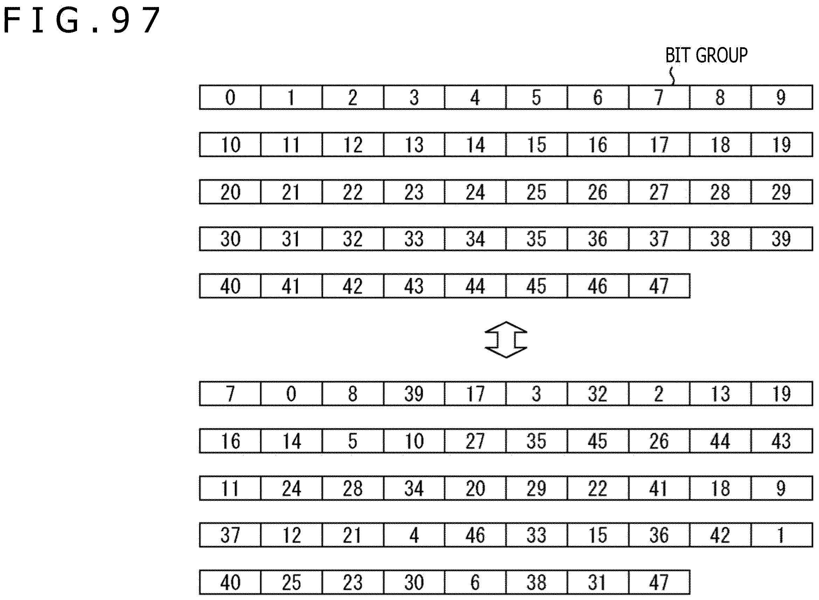

FIG. 97 is a diagram illustrating a sixteenth example of the GW pattern for the LDPC code having the code length N of 17280 bits.

[FIG. 98]

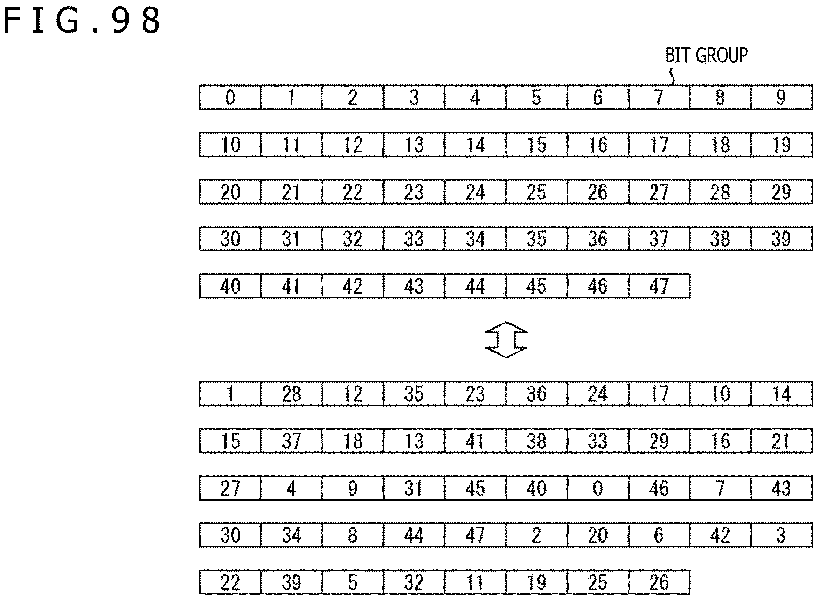

FIG. 98 is a diagram illustrating a seventeenth example of the GW pattern for the LDPC code having the code length N of 17280 bits.

[FIG. 99]

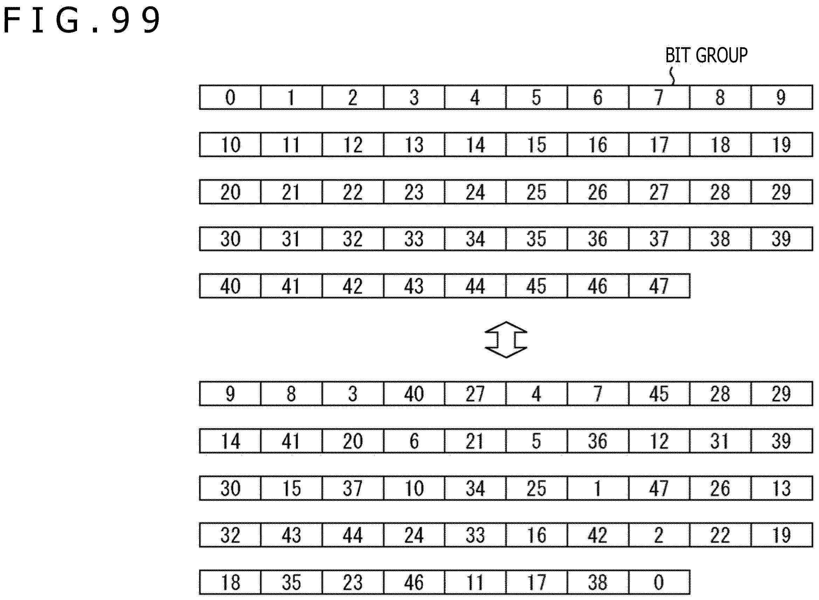

FIG. 99 is a diagram illustrating an eighteenth example of the GW pattern for the LDPC code having the code length N of 17280 bits.

[FIG. 100]

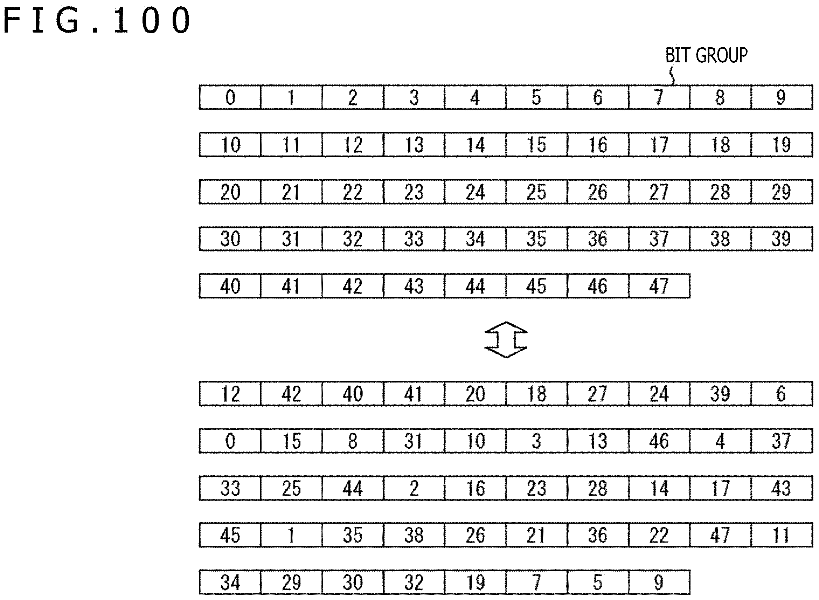

FIG. 100 is a diagram illustrating a nineteenth example of the GW pattern for the LDPC code having the code length N of 17280 bits.
[FIG. 101]

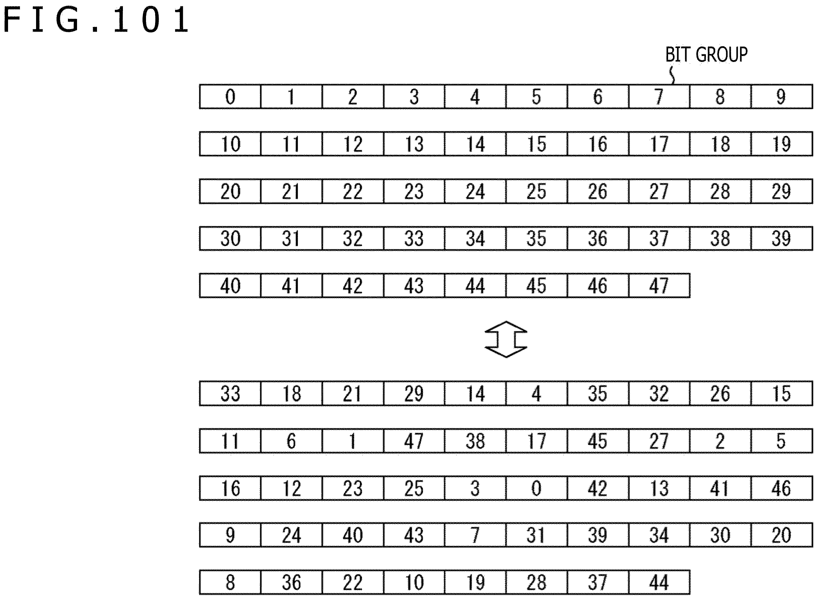

FIG. 101 is a diagram illustrating a twentieth example of the GW pattern for the LDPC code having the code length N of 17280 bits.
[FIG. 102]

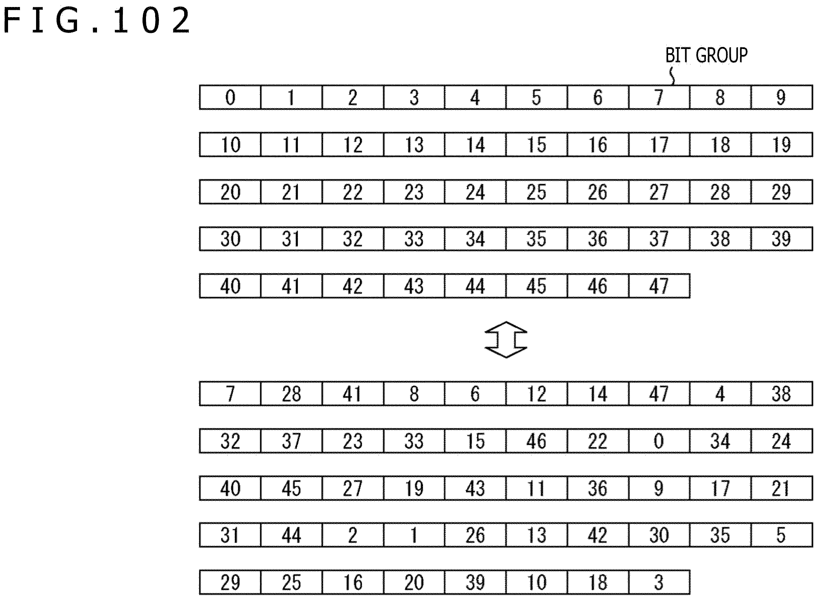

FIG. 102 is a diagram illustrating a twenty-first example of the GW pattern for the LDPC code having the code length N of 17280 bits.
[FIG. 103]

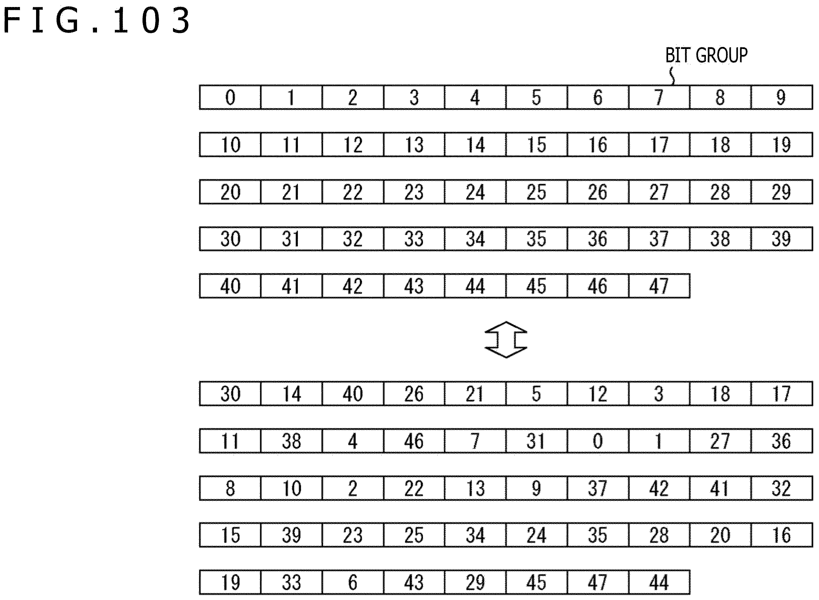

FIG. 103 is a diagram illustrating a twenty-second example of the GW pattern for the LDPC code having the code length N of 17280 bits.
[FIG. 104]

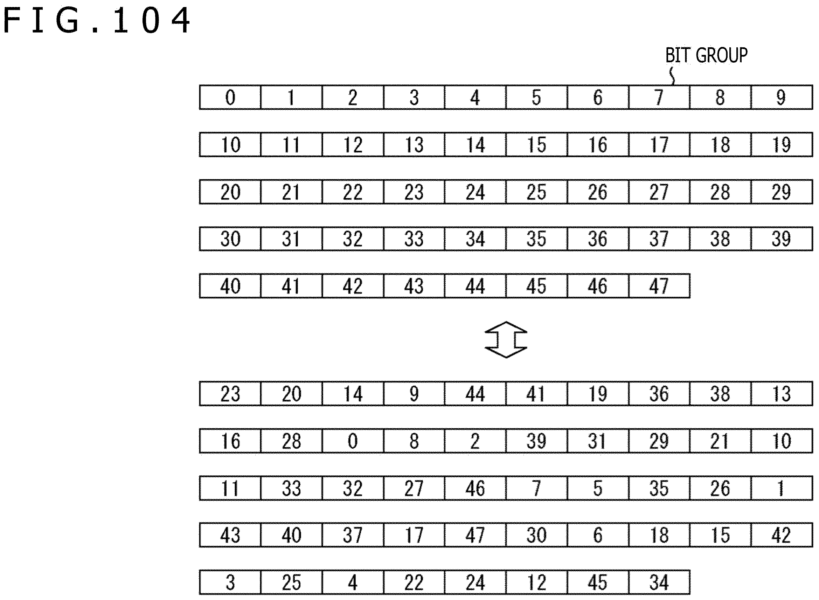

FIG. 104 is a diagram illustrating a twenty-third example of the GW pattern for the LDPC code having the code length N of 17280 bits.
[FIG. 105]

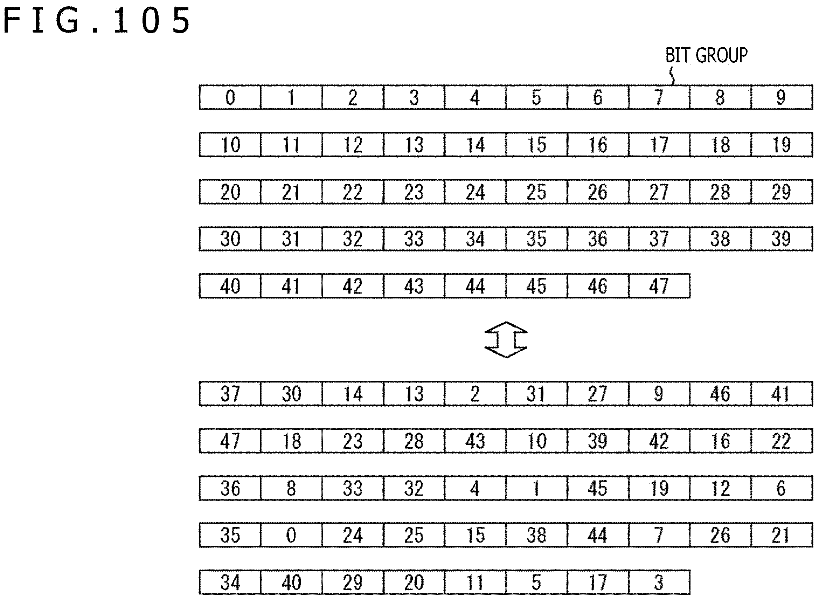

FIG. 105 is a diagram illustrating a twenty-fourth example of the GW pattern for the LDPC code having the code length N of 17280 bits.
[FIG. 106]

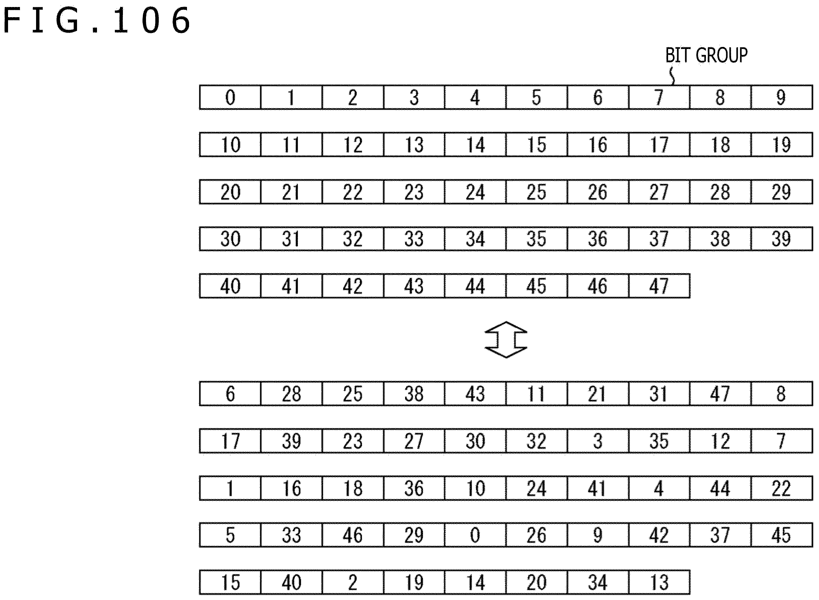

FIG. 106 is a diagram illustrating a twenty-fifth example of the GW pattern for the LDPC code having the code length N of 17280 bits.
[FIG. 107]

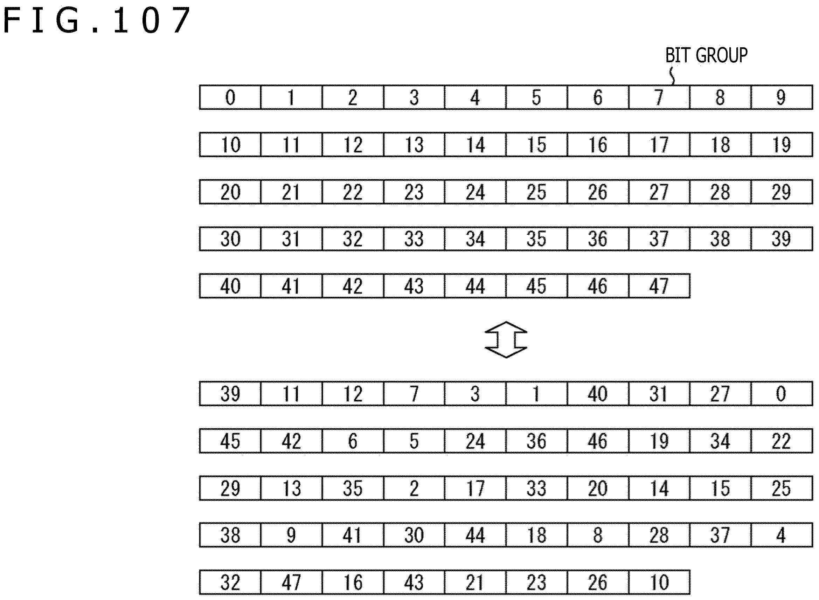

FIG. 107 is a diagram illustrating a twenty-sixth example of the GW pattern for the LDPC code having the code length N of 17280 bits.
[FIG. 108]

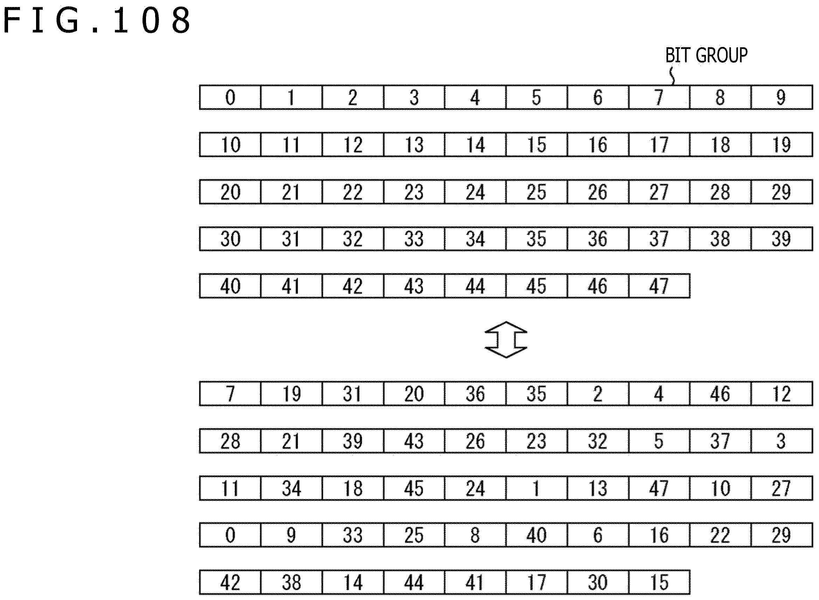

FIG. 108 is a diagram illustrating a twenty-seventh example of the GW pattern for the LDPC code having the code length N of 17280 bits.
[FIG. 109]

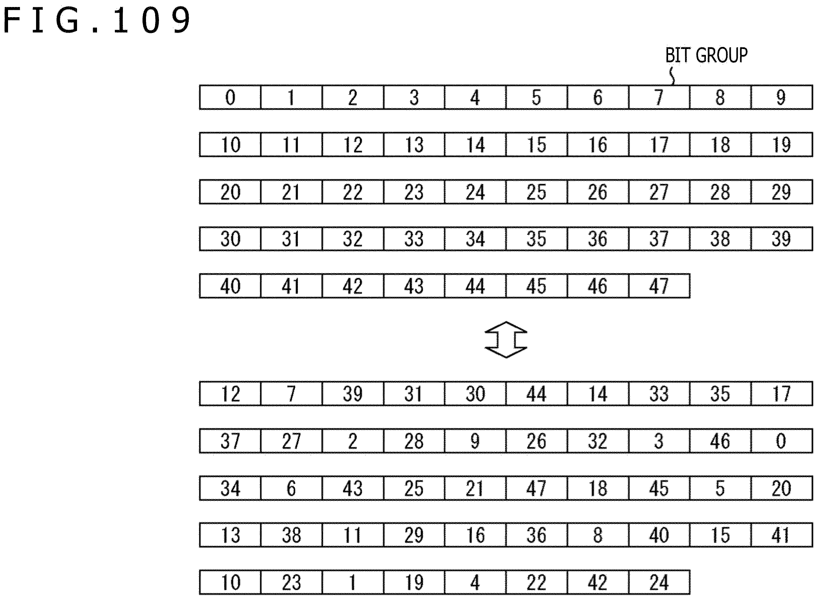

FIG. 109 is a diagram illustrating a twenty-eighth example of the GW pattern for the LDPC code having the code length N of 17280 bits.
[FIG. 110]

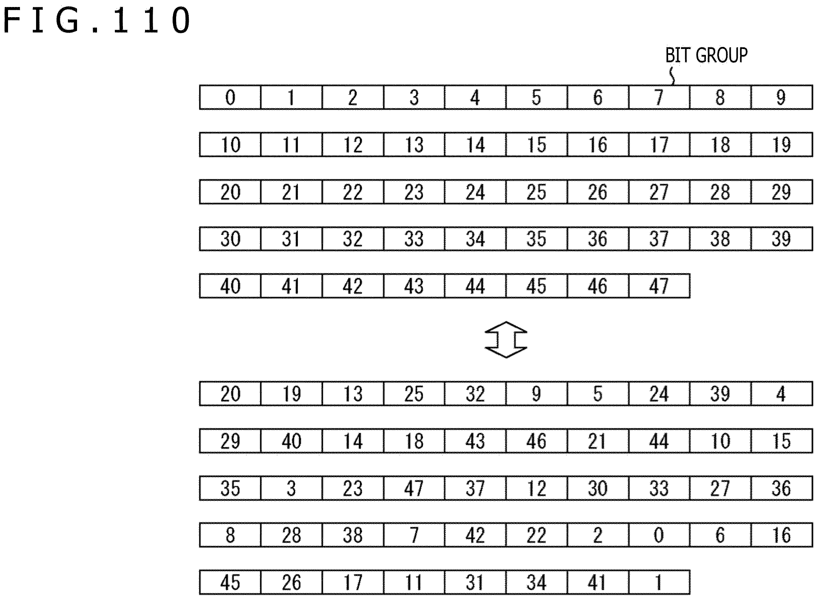

FIG. 110 is a diagram illustrating a twenty-ninth example of the GW pattern for the LDPC code having the code length N of 17280 bits.
[FIG. 111]

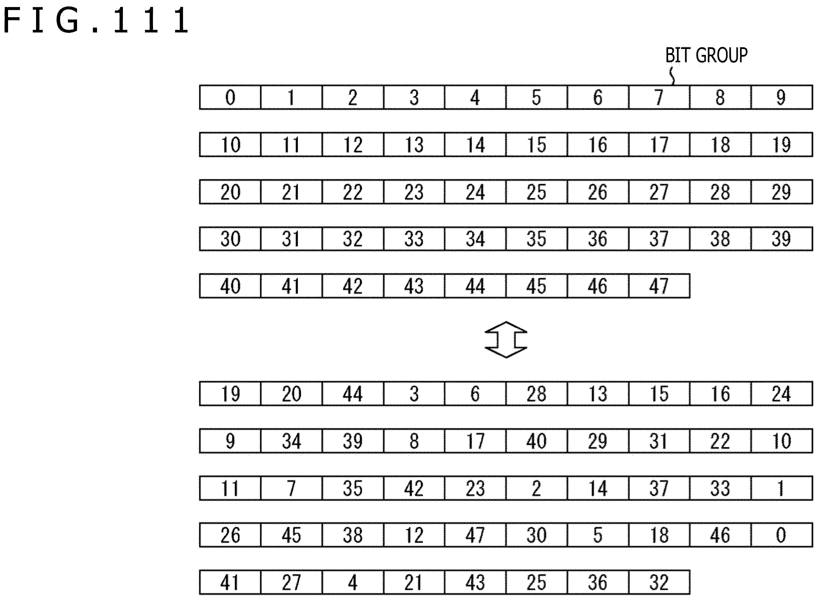

FIG. 111 is a diagram illustrating a thirtieth example of the GW pattern for the LDPC code having the code length N of 17280 bits.
[FIG. 112]

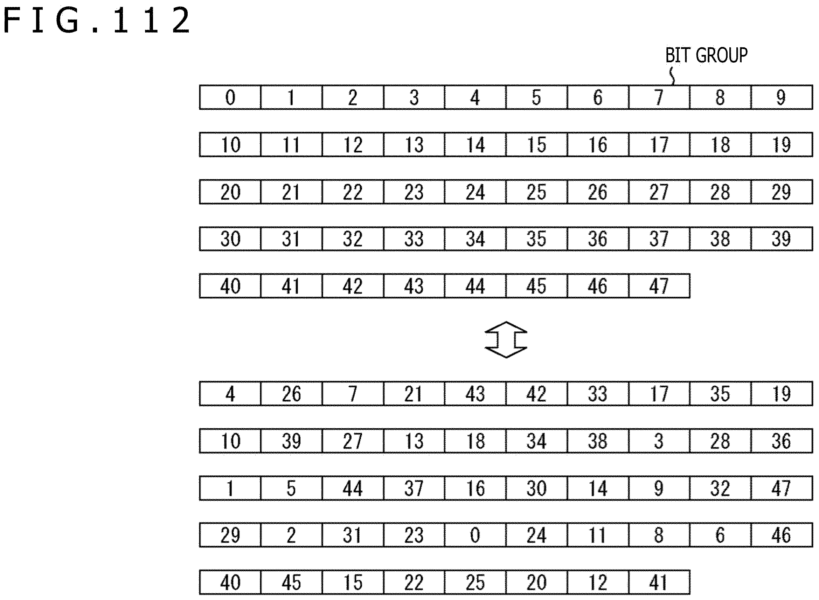

FIG. 112 is a diagram illustrating a thirty-first example of the GW pattern for the LDPC code having the code length N of 17280 bits.
[FIG. 113]

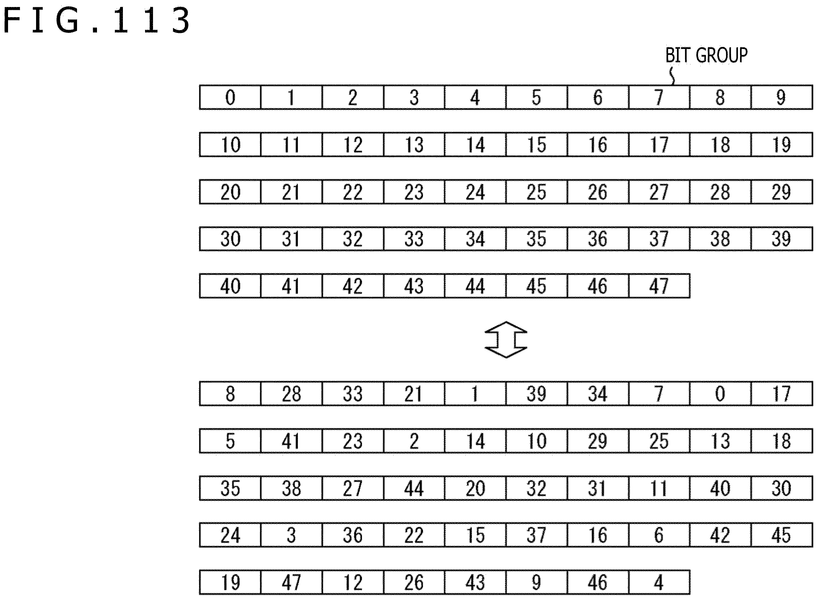

FIG. 113 is a diagram illustrating a thirty-second example of the GW pattern for the LDPC code having the code length N of 17280 bits.
[FIG. 114]

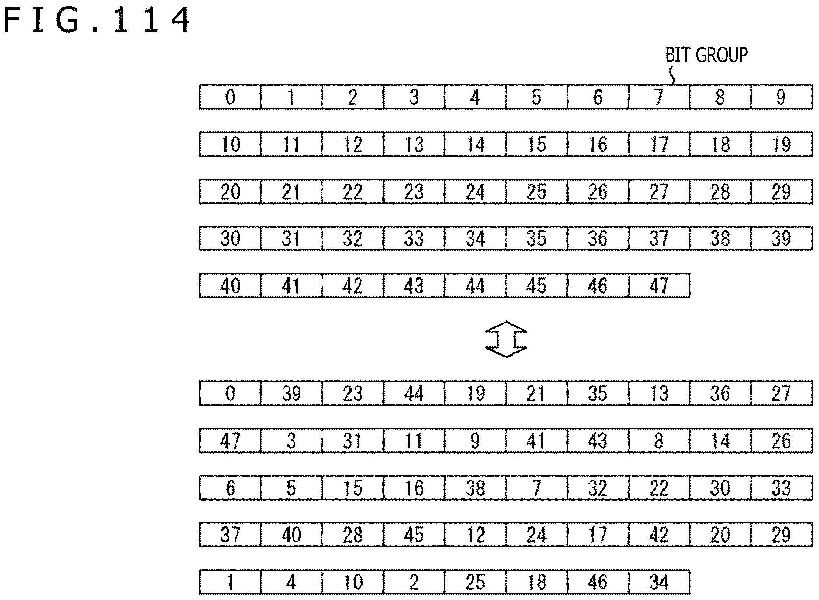

FIG. 114 is a diagram illustrating a thirty-third example of the GW pattern for the LDPC code having the code length N of 17280 bits.
[FIG. 115]

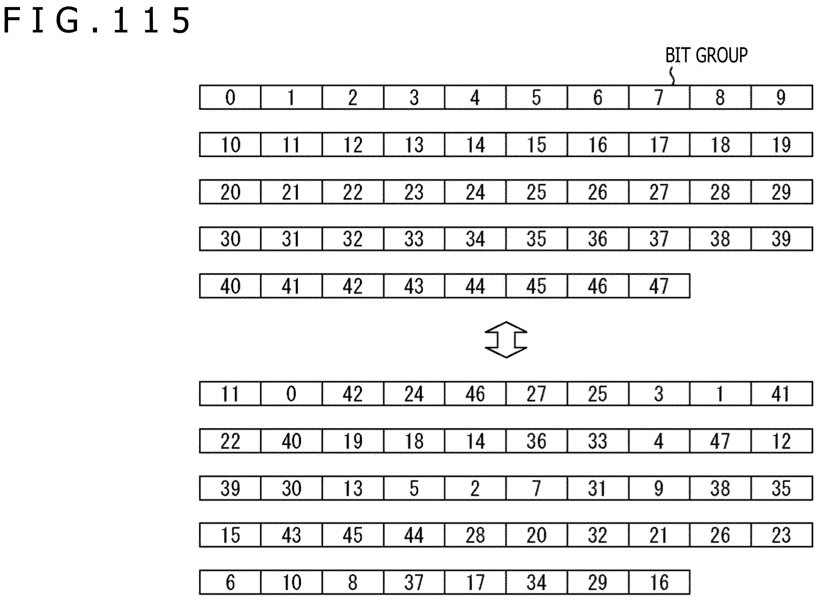

FIG. 115 is a diagram illustrating a thirty-fourth example of the GW pattern for the LDPC code having the code length N of 17280 bits.
[FIG. 116]

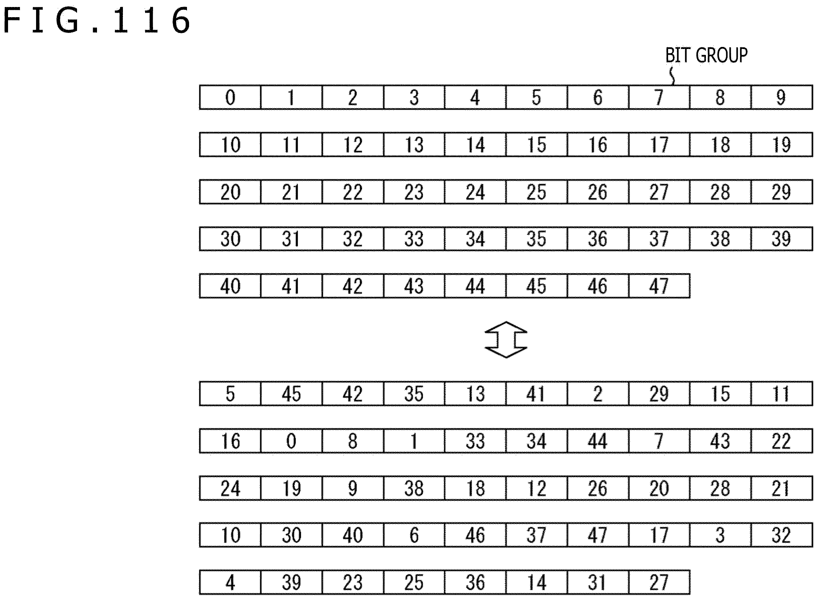

FIG. 116 is a diagram illustrating a thirty-fifth example of the GW pattern for the LDPC code having the code length N of 17280 bits.
[FIG. 117]

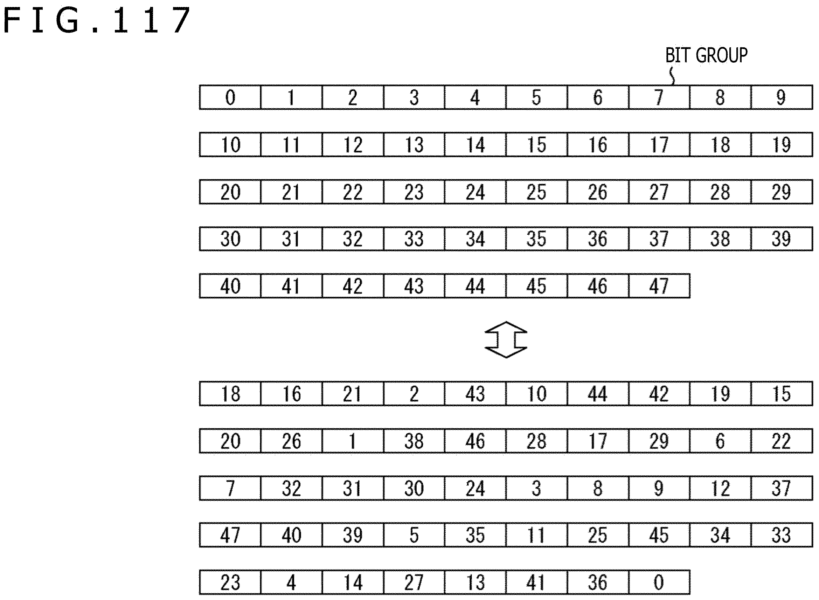

FIG. 117 is a diagram illustrating a thirty-sixth example of the GW pattern for the LDPC code having the code length N of 17280 bits.
[FIG. 118]

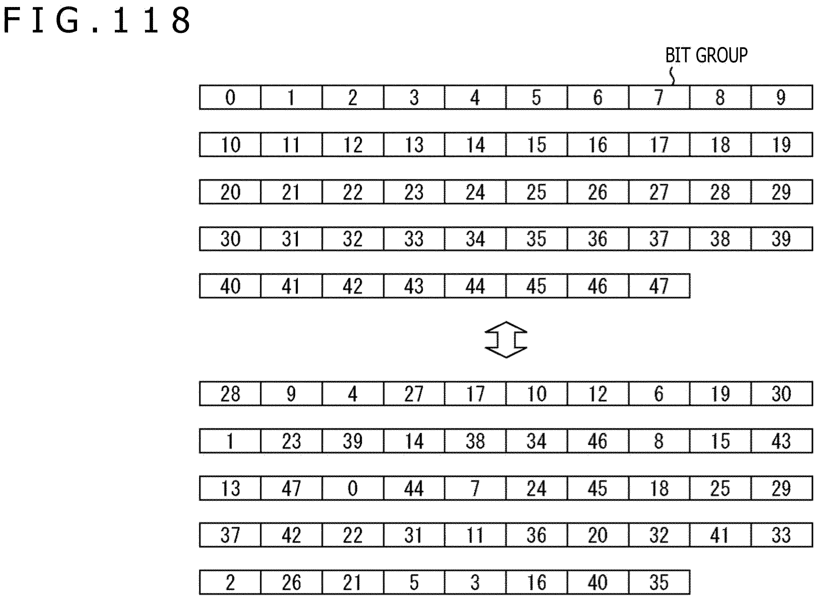

FIG. 118 is a diagram illustrating a thirty-seventh example of the GW pattern for the LDPC code having the code length N of 17280 bits.
[FIG. 119]

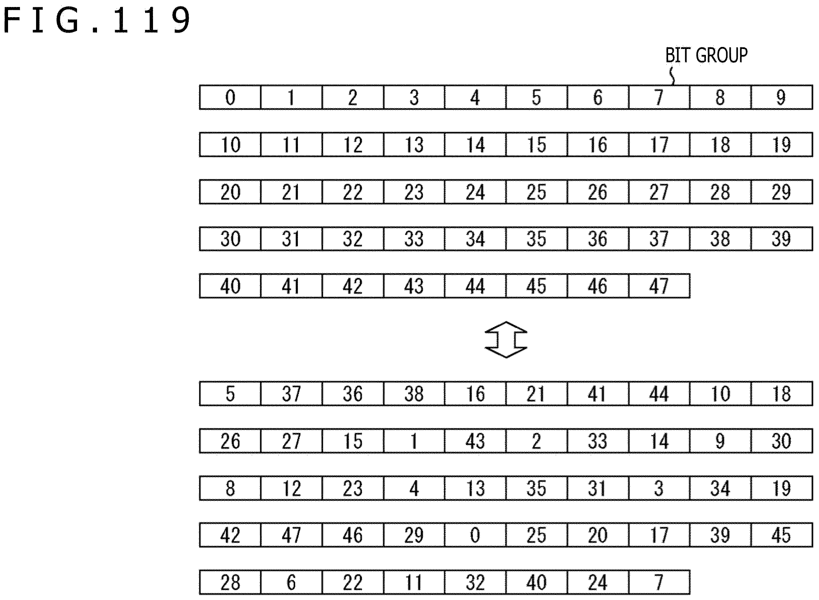

FIG. 119 is a diagram illustrating a thirty-eighth example of the GW pattern for the LDPC code having the code length N of 17280 bits.

[FIG. 120]

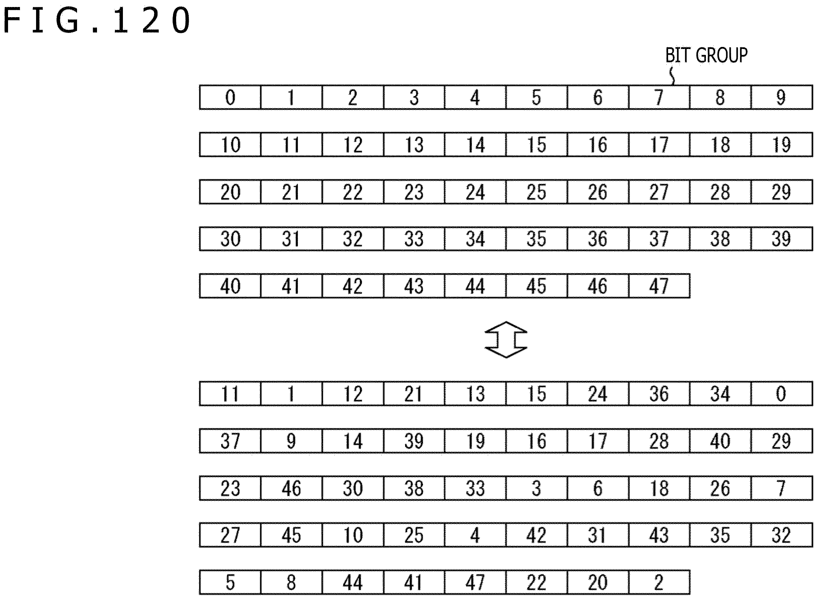

FIG. 120 is a diagram illustrating a thirty-ninth example of the GW pattern for the LDPC code having the code length N of 17280 bits.

[FIG. 121]

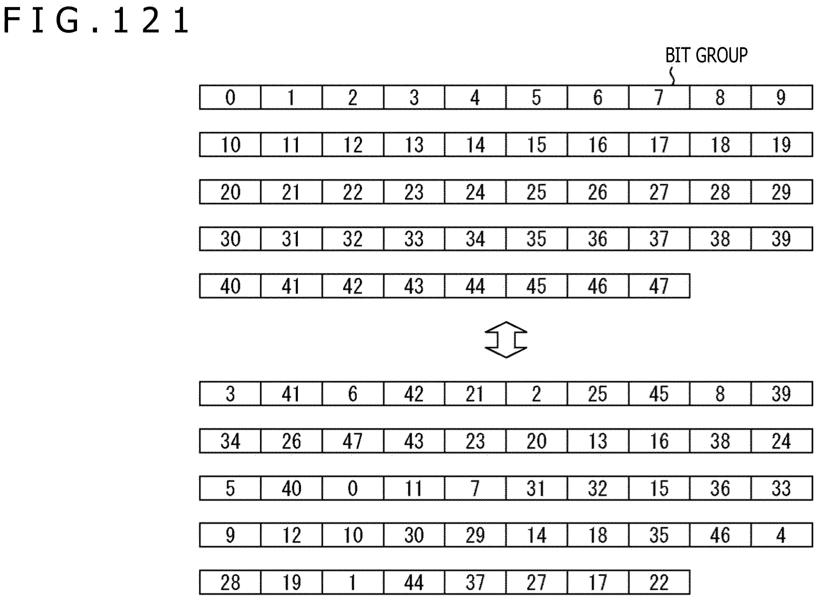

FIG. 121 is a diagram illustrating a fortieth example of the GW pattern for the LDPC code having the code length N of 17280 bits.

[FIG. 122]

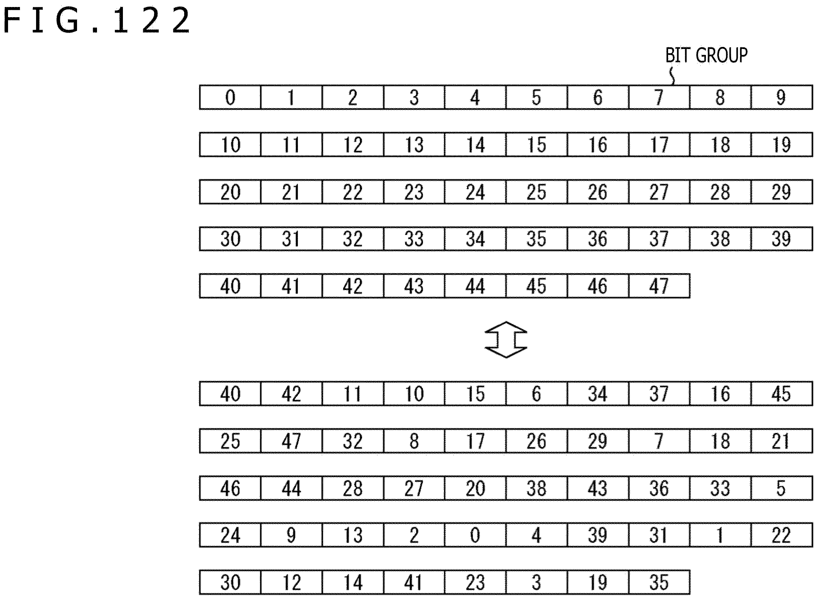

FIG. 122 is a diagram illustrating a forty-first example of the GW pattern for the LDPC code having the code length N of 17280 bits.

[FIG. 123]

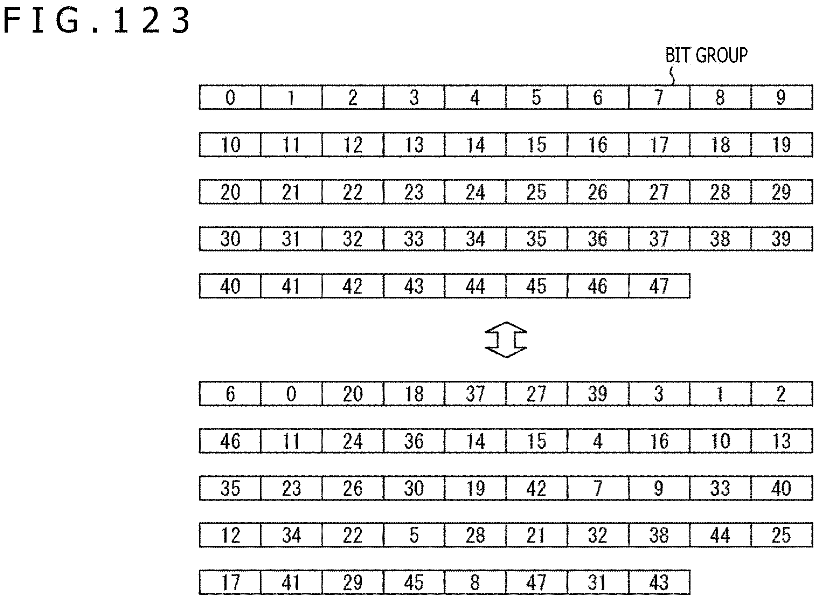

FIG. 123 is a diagram illustrating a forty-second example of the GW pattern for the LDPC code having the code length N of 17280 bits.

[FIG. 124]

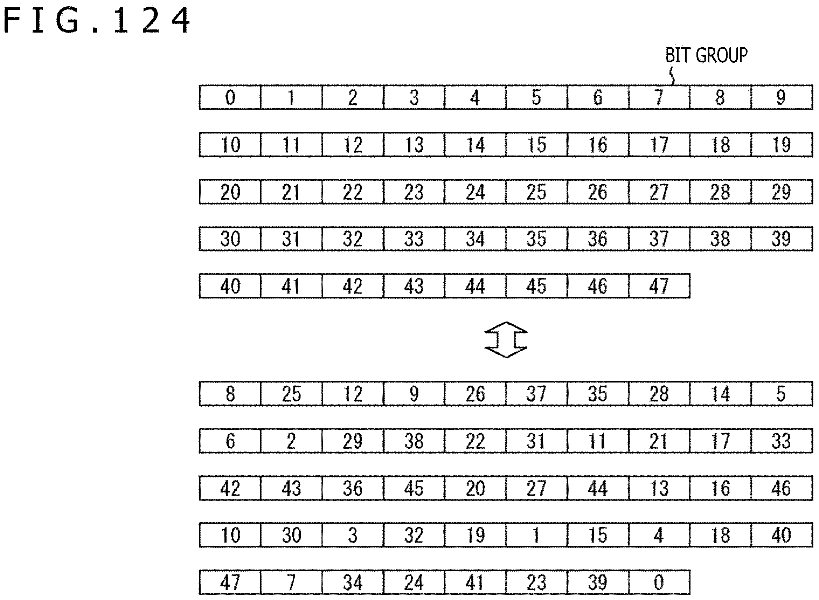

FIG. 124 is a diagram illustrating a forty-third example of the GW pattern for the LDPC code having the code length N of 17280 bits.

[FIG. 125]

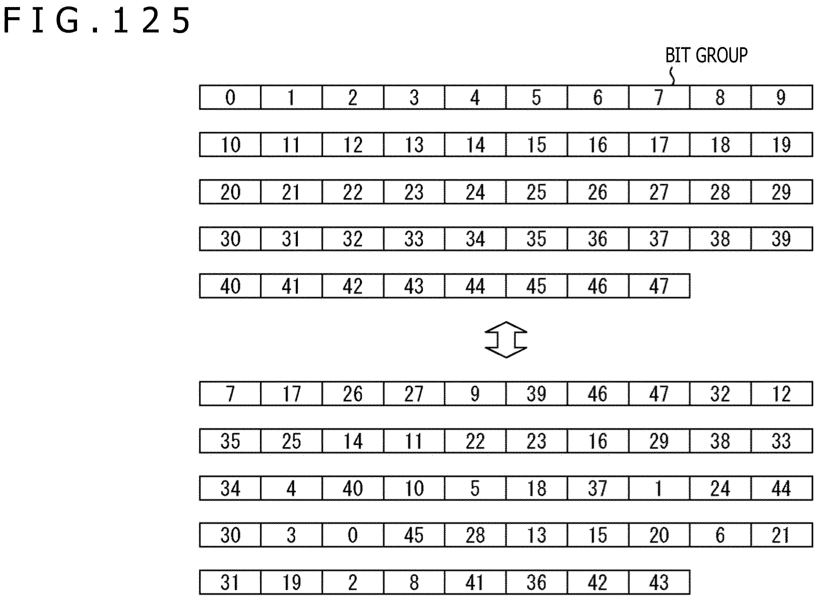

FIG. 125 is a diagram illustrating a forty-fourth example of the GW pattern for the LDPC code having the code length N of 17280 bits.

[FIG. 126]

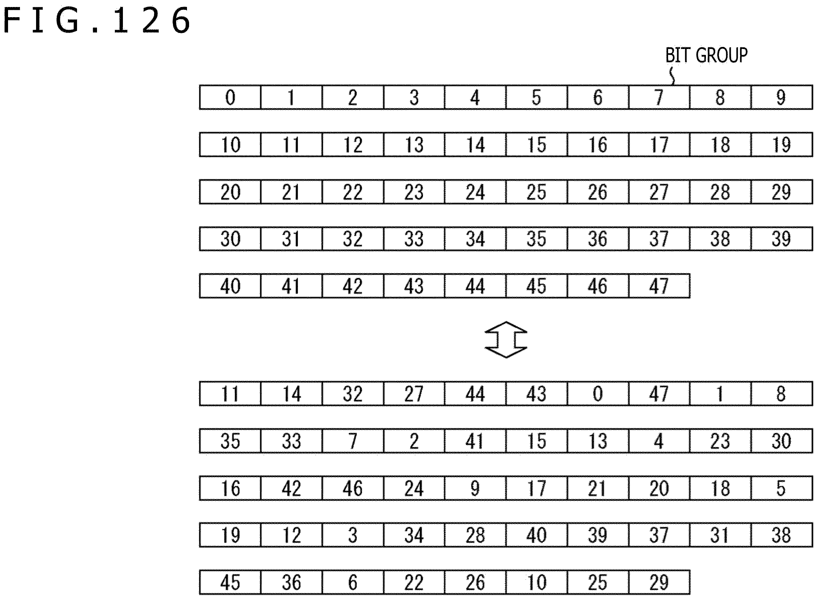

FIG. 126 is a diagram illustrating a forty-fifth example of the GW pattern for the LDPC code having the code length N of 17280 bits.

[FIG. 127]

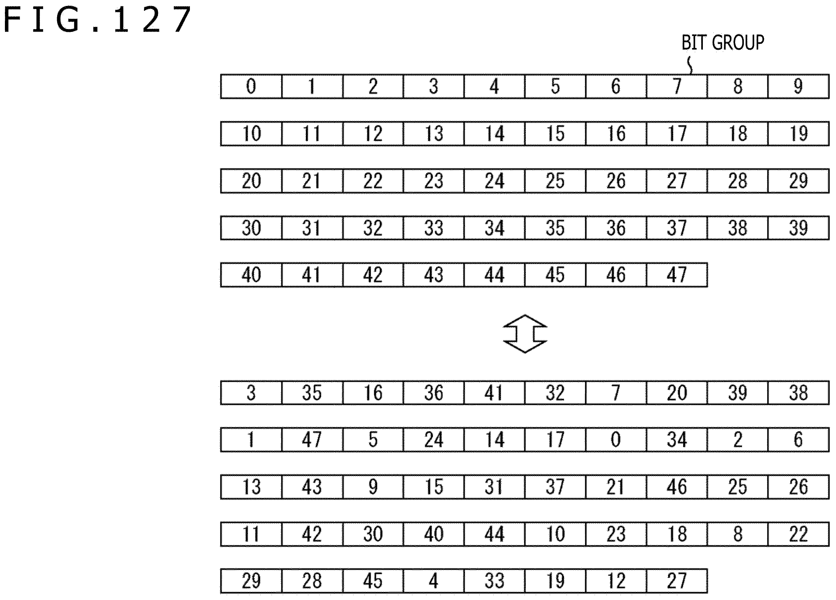

FIG. 127 is a diagram illustrating a forty-sixth example of the GW pattern for the LDPC code having the code length N of 17280 bits.

[FIG. 128]

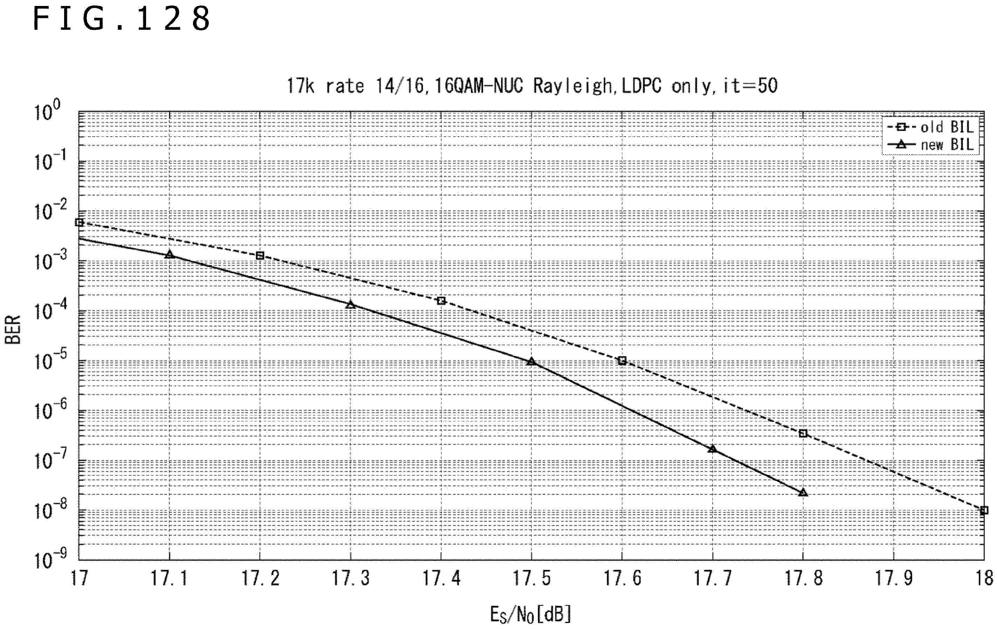

FIG. 128 is a diagram illustrating a BER simulation result of a combination of a type B code having a code length N of 17280 bits and r of 14/16, 16QAM, a 16QAM-2D-NUC, and a new GW pattern.

[FIG. 129]

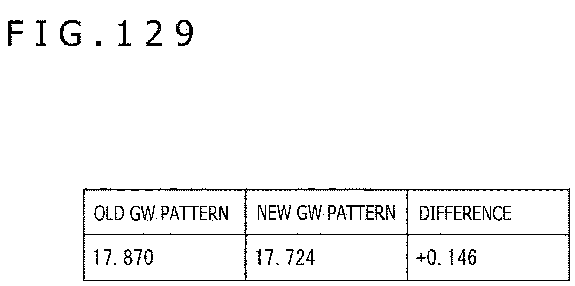

FIG. 129 is a diagram illustrating necessary CNR simulation results of combinations of the type B code having the code length N of 17280 bits and r of 14/16, the 16QAM, the 16QAM-2D-NUC, and the new GW pattern.

[FIG. 130]

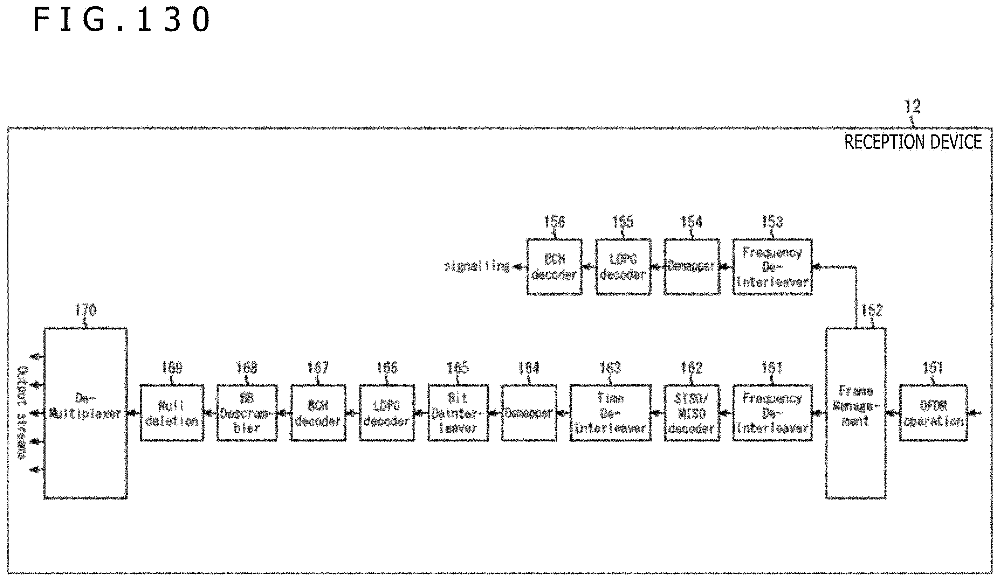

FIG. 130 is a block diagram illustrating a configuration example of a reception device 12.

[FIG. 131]

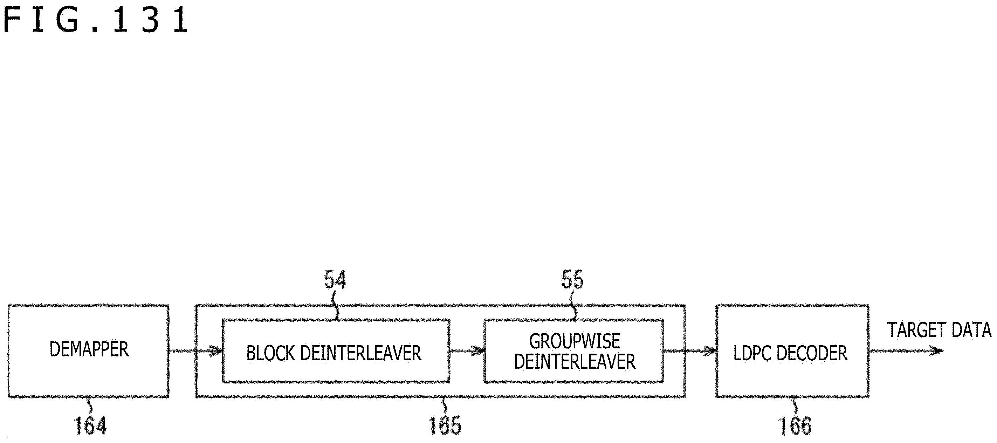

FIG. 131 is a block diagram illustrating a configuration example of a bit deinterleaver 165.

[FIG. 132]

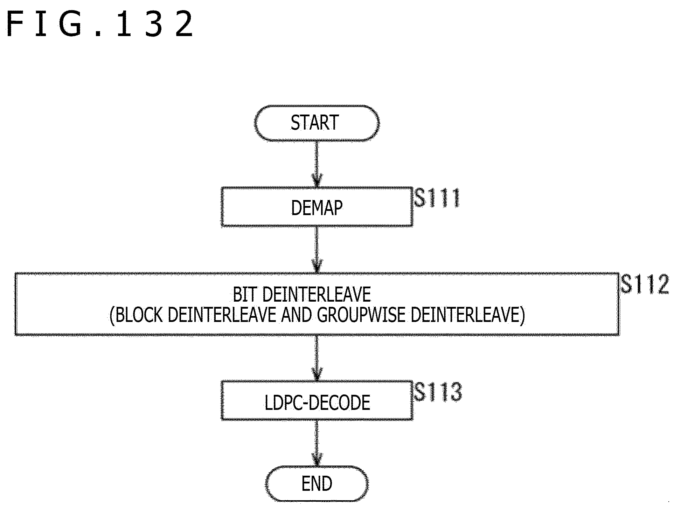

FIG. 132 is a flowchart explaining an example of a process performed by a demapper 164, the bit deinterleaver 165, and an LDPC decoder 166.

[FIG. 133]

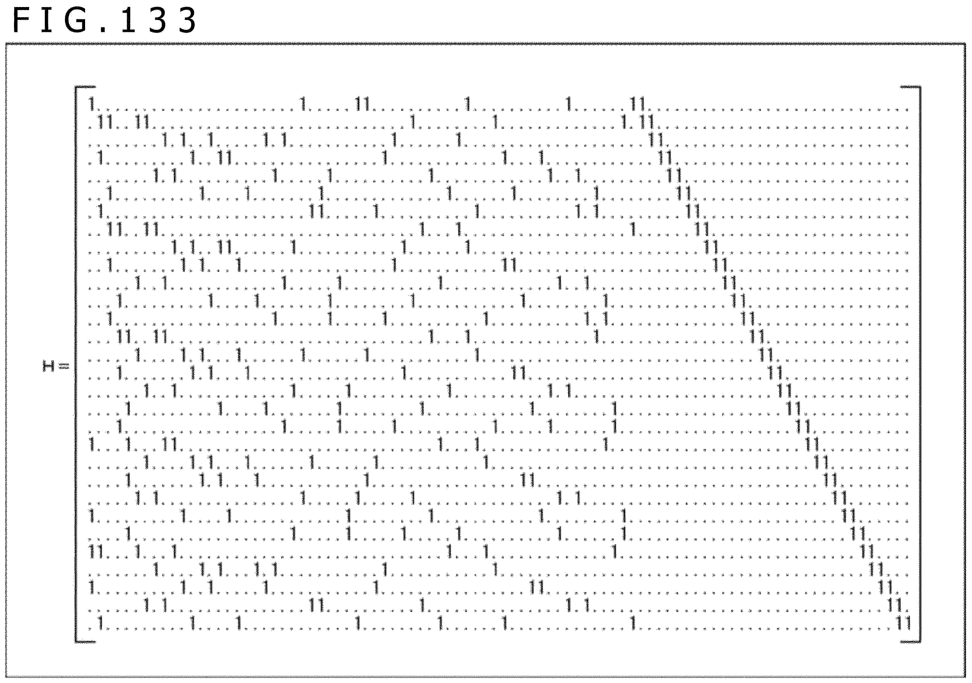

FIG. 133 is a diagram illustrating an example of a check matrix for an LDPC code.

[FIG. 134]

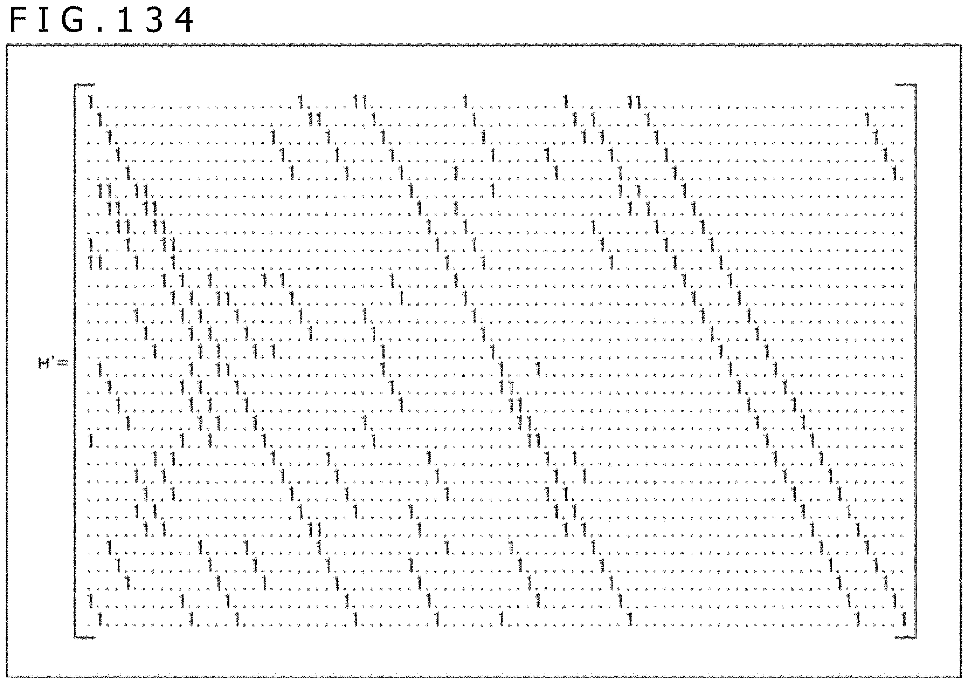

FIG. 134 is a diagram illustrating an example of a matrix (transformed check matrix) obtained by applying row permutation and column permutation to a check matrix.

[FIG. 135]

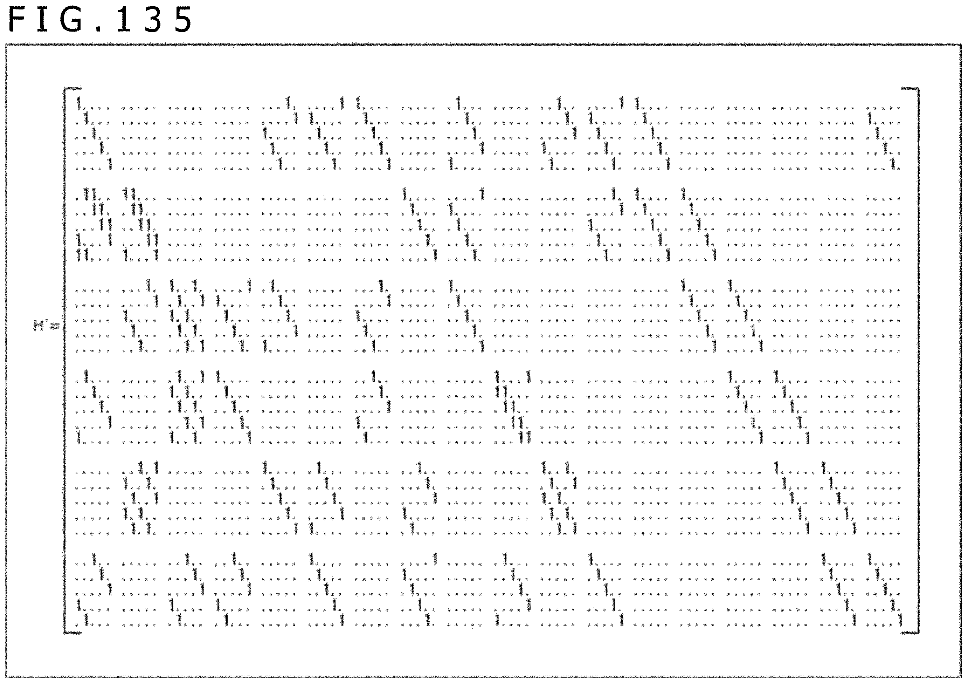

FIG. 135 is a diagram illustrating an example of a transformed check matrix divided into $5 \times 5$ units.

[FIG. 136]

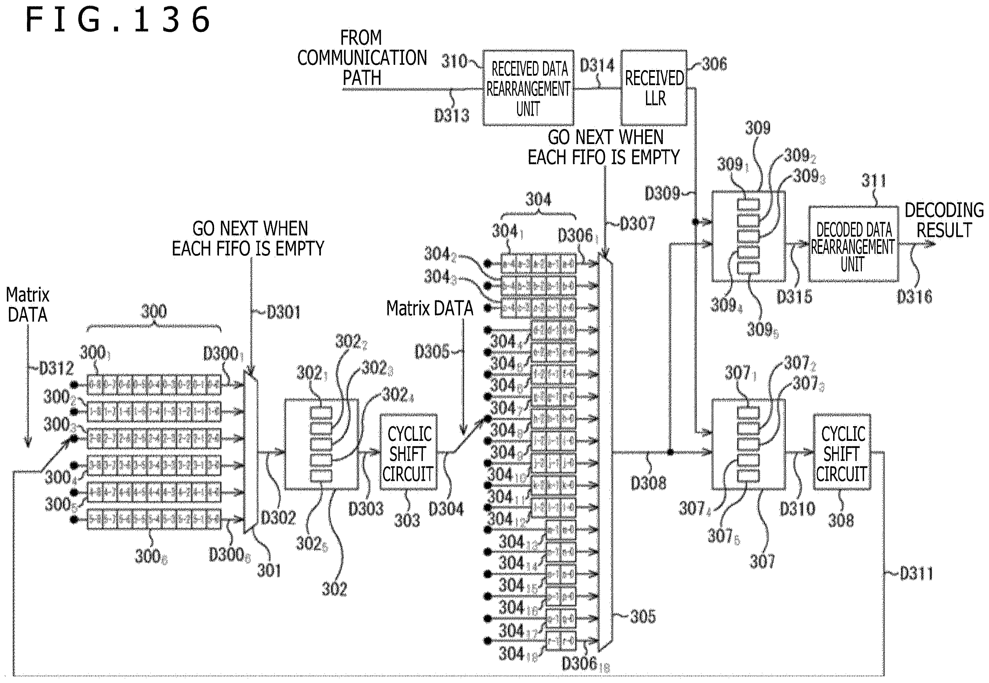

FIG. 136 is a block diagram illustrating a configuration example of a decoding device which collectively performs P operations of node operation.

[FIG. 137]

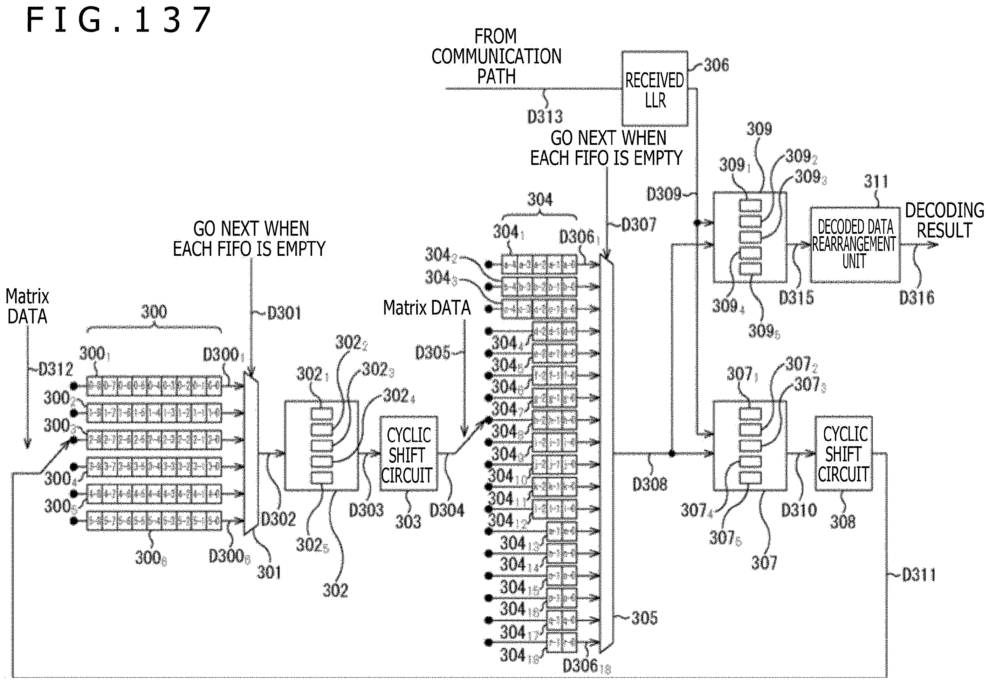

FIG. 137 is a block diagram illustrating a configuration example of the LDPC decoder 166.

[FIG. 138]

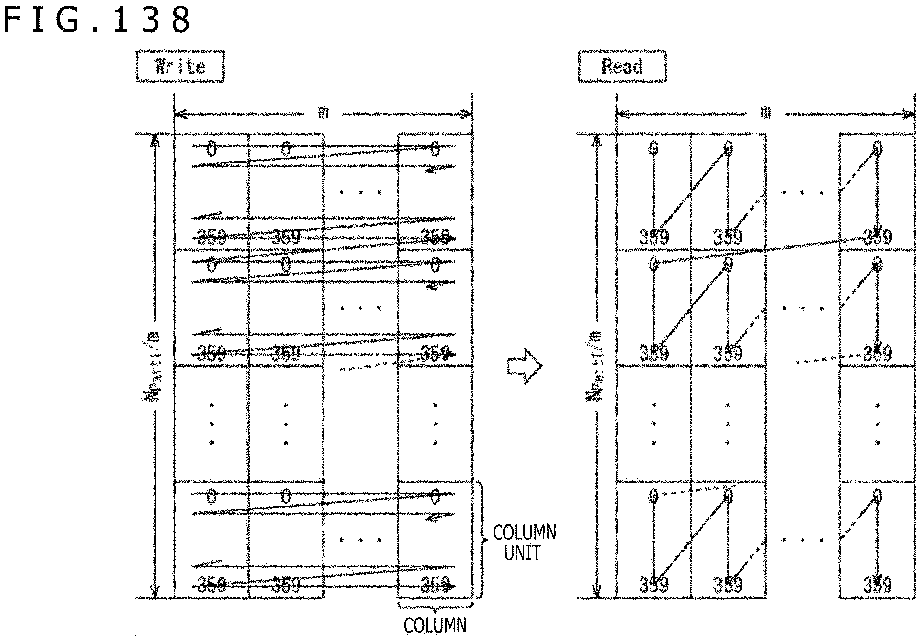

FIG. 138 is a diagram explaining block deinterleaving performed by a block deinterleaver 54.

[FIG. 139]

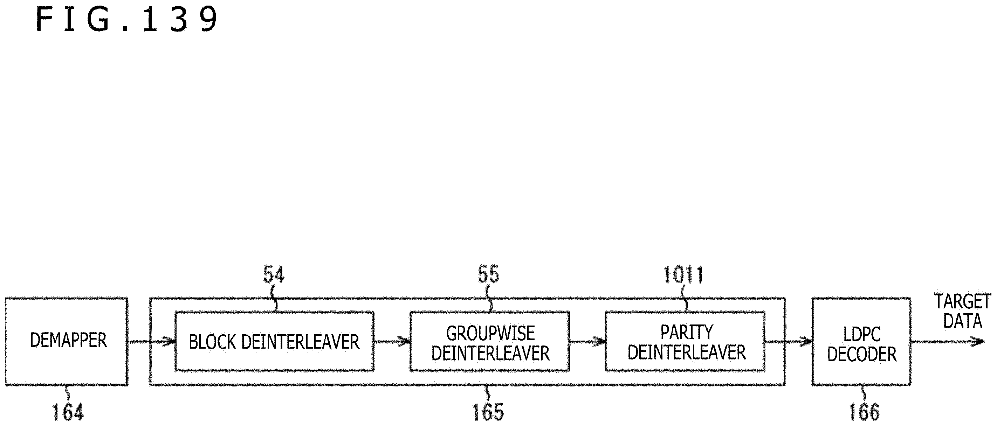

FIG. 139 is a block diagram illustrating another configuration example of the bit deinterleaver 165.

[FIG. 140]

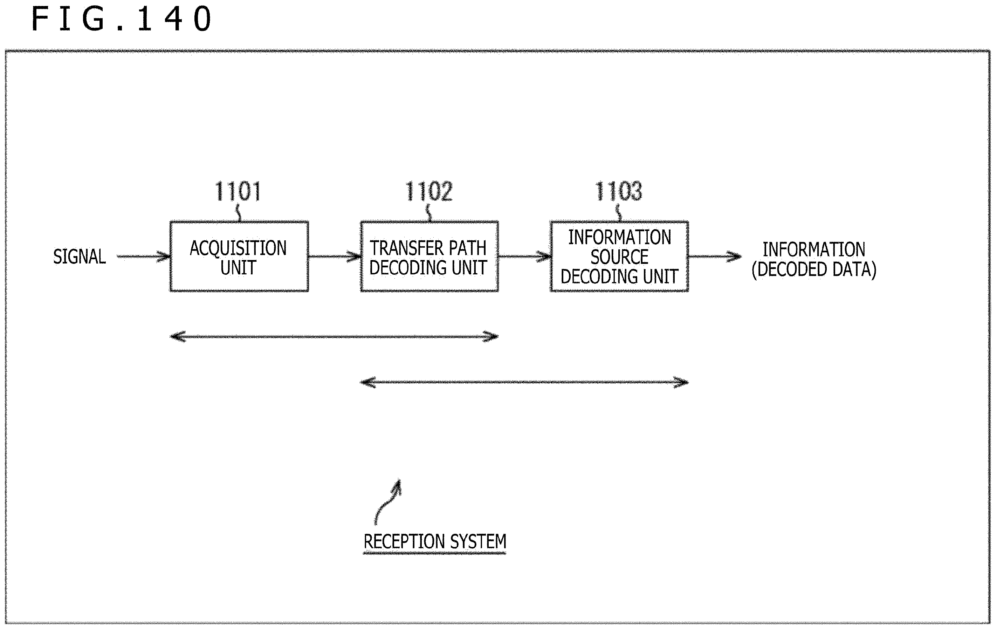

FIG. 140 is a block diagram depicting a first configuration example of a reception system to which the reception device 12 is applicable.

[FIG. 141]

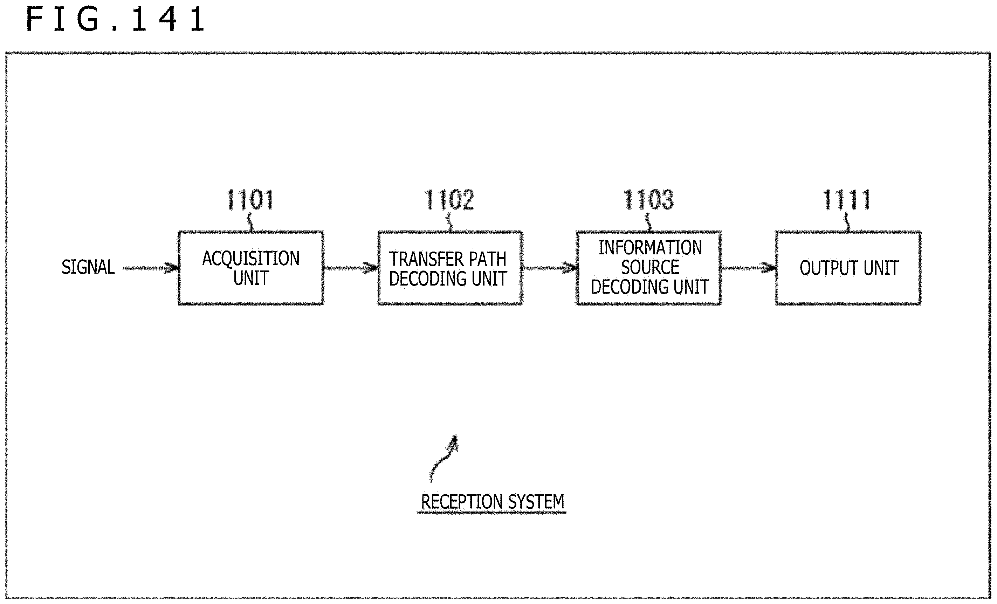

FIG. 141 is a block diagram depicting a second configuration example of the reception system to which the reception device 12 is applicable.

[FIG. 142]

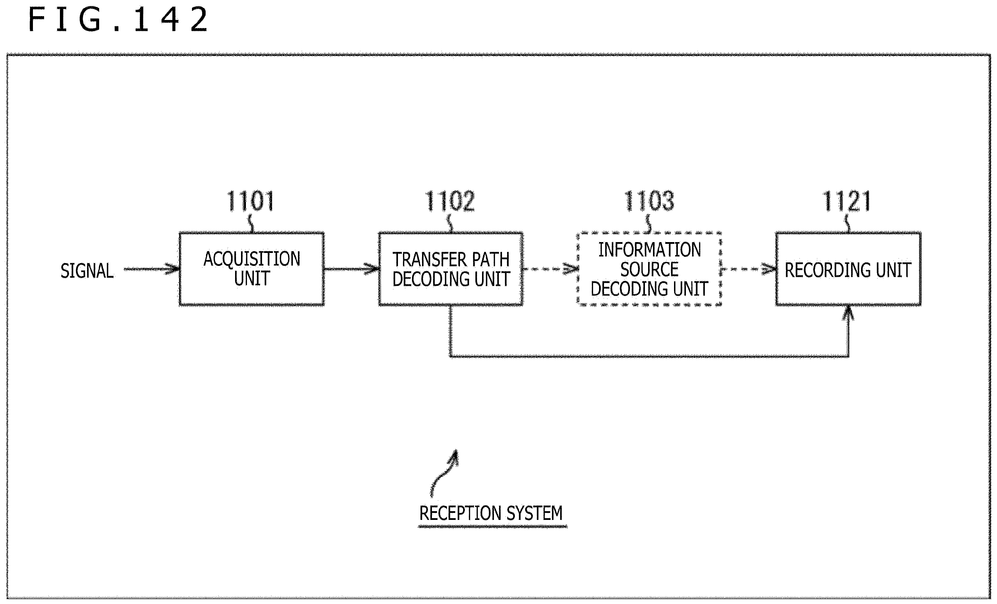

FIG. 142 is a block diagram depicting a third configuration example of the reception system to which the reception device 12 is applicable.

[FIG. 143]

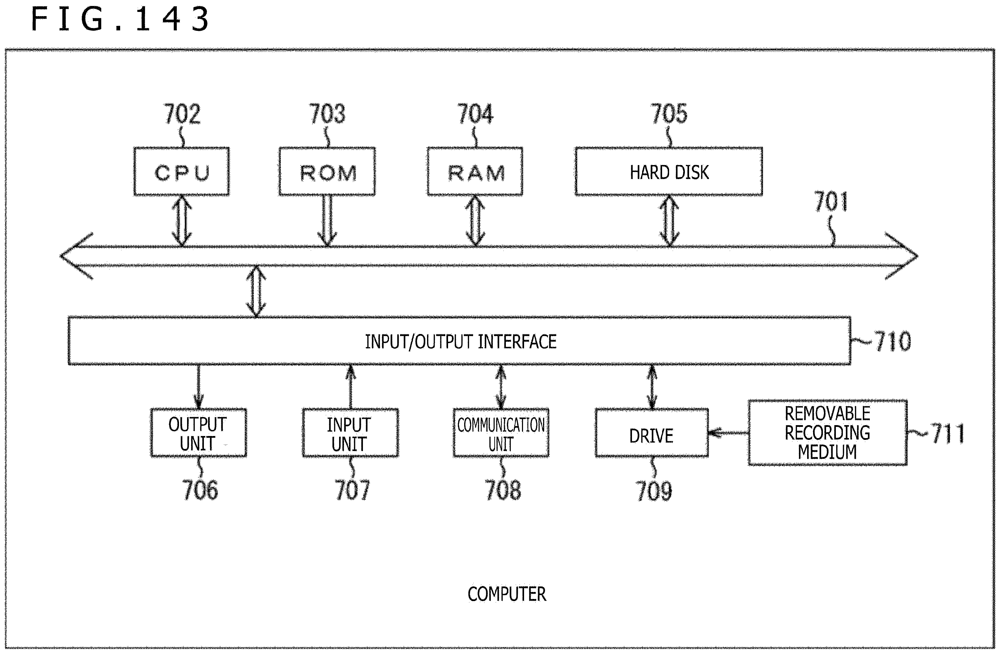

FIG. 143 is a block diagram illustrating a configuration example of a computer according to one embodiment to which the present technology is applied.

[Description of Embodiment]

LDPC codes will be touched upon before describing hereinafter an embodiment of the present technology.

<LDPC code>

Note that LDPC codes are linear codes, and are not necessarily required to be constituted by binary codes. However, it is assumed in this description that LDPC codes are constituted by binary codes.

The greatest characteristic of LDPC codes lies in a point that a check matrix (parity check matrix) defining the LDPC codes is a sparse matrix. The sparse matrix herein is such a matrix which has an extremely small number of elements "1" in the matrix (most elements in the matrix are 0).

FIG. 1 is a diagram illustrating an example of a check matrix H for an LDPC code.

According to the check matrix H in FIG. 1, a weight for each column (column weight) (the number of elements "1") (weight) is "3," while a weight for each row (row weight) is "6."

For encoding with LDPC codes (LDPC encoding), a generator matrix G is generated on the basis of the check matrix H, and the generated generator matrix G is multiplied by binary information bits to generate a code word (LDPC code), for example.

Specifically, an encoding device which performs LDPC encoding initially calculates the generator matrix G expressed as an equation $GH^T = 0$ in a relation with a transposed matrix $H^T$ of the check matrix H. In a case where the generator matrix G is a $K \times N$ matrix herein, the encoding device multiplies the generator matrix G by a bit string (vector u) of information bits having K bits, to generate a code word $c (= uG)$ having N bits. This code word (LDPC code) generated by the encoding device is received on the reception side via a predetermined communication path.

LDPC codes can be decoded by a message passing algorithm which is an algorithm proposed by Gallager and called probabilistic decoding. This algorithm includes a variable node (also called a message node) and a check node, and can be achieved by belief propagation on what is generally called a Tanner graph. Note herein that each of the variable node and the check node will hereinafter also simply be referred to as a node where appropriate.

FIG. 2 is a flowchart illustrating procedures for decoding an LDPC code.

Note that a real number value (received LLR) corresponding to an ith sign bit of an LDPC code (one code word) received on the reception side and indicating likelihood of "0" of the value by an expression of a log likelihood ratio (log likelihood ratio) will hereinafter also be referred to as a reception value $u_{0i}$ where appropriate. It is further assumed that a message output from the check node is $u_j$, and that a message output from the variable node is $v_i$.

As illustrated in FIG. 2, first, for decoding the LDPC code, the LDPC code is received in step S11. In this step, a message (check node message) $u_j$ is initialized into "0," and a variable k which is an integer as a counter of a repetitive process is initialized into "0." Thereafter, the process proceeds to step S12. In step S12, operation represented in equation (1) (variable node operation) is performed on the basis of a reception value $u_{0i}$ obtained by receiving the LDPC code, to calculate a message (variable node message) $v_i$. Moreover, operation represented in equation (2) (check node operation) is performed on the basis of the message $v_i$ to calculate a message $u_j$.

[Math. 1]

$$v_i = u_{0i} + \sum_{j=1}^{d_v - 1} u_j \qquad \cdots \quad (1)$$

[Math. 2]

$$\tanh\left(\frac{u_j}{2}\right) = \prod_{i=1}^{d_c-1} \tanh\left(\frac{v_i}{2}\right) \quad \cdots \quad (2)$$

In this case, $d_v$ and $d_c$ in equations (1) and (2) are parameters as any selectable values indicating the number of elements "1" in a vertical direction (column) and a horizontal direction (row) of the check matrix H, respectively. For example, in a case of an LDPC code corresponding to the check matrix H having a column weight of 3 and a row weight of 6 ((3,6) LDPC code) as illustrated in FIG. 1, $d_v$ = 3 and $d_c$ = 6 hold.

Note that each operation range of the variable node operation in equation (1) and the check node operation in (2) is set to 1 to $d_v$ - 1 or 1 to $d_c$ - 1 because a message input from an edge intending to output a message (a line connecting the variable node and the check node) is not designated as an operation target. Moreover, the check node operation in equation (2) is practically performed by creating beforehand a table of a function $R(v_1,v_2)$ represented in equation (3) and defined by one output for two inputs $v_1$ and $v_2$, and successively (recursively) using the created table as represented in equation (4).

[Math. 3]

$$x = 2\tanh^{-1}\{\tanh(v_1/2)\tanh(v_2/2)\} = R(v_1, v_2) \quad \cdots \quad (3)$$

[Math. 4]

$$u_j = R(v_1, R(v_2, R(v_3, \cdots R(v_{d_c-2}, v_{d_c-1})))) \quad \cdots \quad (4)$$

In step S12, the variable k is further incremented by "1," and the process proceeds to step S13. In step S13, it is determined whether or not the variable k is larger than a predetermined number of times C of repetitive decoding. In a case where the variable k is not determined to be larger than C in step S13, the process returns to step S12. Thereafter, similar processing is repeated.

Meanwhile, in a case where the variable k is determined to be larger than C in step S13, the process proceeds to step S14. In this step, the message $v_i$ as a decoding result finally output is obtained by performing an operation represented in equation (5) and is output, and the decoding process of the LDPC code ends.

[Math. 5]

$$v_i = u_{0i} + \sum_{j=1}^{d_v} u_j \quad \cdots \quad (5)$$

Unlike the variable node operation in equation (1), the operation in equation (5) herein is performed using the messages $u_j$ from all the edges connected to the variable node.

FIG. 3 is a diagram illustrating an example of a check matrix H for a (3, 6) LDPC code (code rate: 1/2, code length: 12).

As in FIG. 1, the check matrix H in FIG. 3 has a column weight of 3 and a row weight of 6.

FIG. 4 is a diagram illustrating a Tannar graph of the check matrix H in FIG. 3.

In this example illustrated in FIG. 4, each of nodes expressed as a plus sign "+" is a check node, while each of nodes expressed as an equal sign "=" is a variable node. The check nodes and the variable nodes correspond to rows and columns of the check matrix H, respectively. Each of lines connecting the check nodes and the variable nodes constitutes an edge, and corresponds to an element "1" in the check matrix.

Specifically, in a case where an element in the jth row and the ith column of the check matrix is 1, the ith variable node ("=" node) from the top and the jth check node ("+" node) from the top in FIG. 4 are connected to each other by the edge. Each of the edges indicates that a sign bit corresponding to the variable node has a constraint condition corresponding to the check node.

In a sum product algorithm as a decoding method for LDPC codes, the variable node operation and the check node operation are repeatedly performed.

FIG. 5 is a diagram illustrating variable node operation performed at a variable node.

At the variable node, a message $v_i$ corresponding to the edge as a calculation target is obtained by the variable node operation in equation (1) using a reception value $u_{0i}$ and messages $u_1$ and $u_2$ received from the rest of the edges connected to the variable node. Messages corresponding to the other edges are similarly obtained.

FIG. 6 is a diagram illustrating check node operation performed at a check node.

The check node operation in equation (2) herein can be rewritten into equation (6) by use of a relation indicated by an equation $a \times b = \exp\{\ln(|a|) + \ln(|b|)\} \times \text{sign}(a) \times \text{sign}(b)$. Note that sign(x) is 1 at the time of $x \geq 0$, and is -1 at the time of $x < 0$.

[Math. 6]

$$
\begin{aligned}
u_j &= 2\tanh^{-1}\left(\prod_{i=1}^{d_c-1} \tanh\left(\frac{v_i}{2}\right)\right) \\
&= 2\tanh^{-1}\left[\exp\left\{\sum_{i=1}^{d_c-1} \ln\left(\left|\tanh\left(\frac{v_i}{2}\right)\right|\right)\right\} \times \prod_{i=1}^{d_c-1} \text{sign}\left(\tanh\left(\frac{v_i}{2}\right)\right)\right] \\
&= 2\tanh^{-1}\left[\exp\left\{-\left(\sum_{i=1}^{d_c-1} -\ln\left(\tanh\left(\frac{|v_i|}{2}\right)\right)\right)\right\}\right] \times \prod_{i=1}^{d_c-1} \text{sign}(v_i)
\end{aligned}
$$

$$\cdots \quad (6)$$

If a function $\phi(x)$ is defined as an equation $\phi(x) = \ln(\tanh(x/2))$ at the time of $x \geq 0$, an equation $\phi^{-1}(x) = 2\tanh^{-1}(e^{-x})$ holds. Accordingly, equation (6) can be transformed into equation (7).

[Math. 7]

$$
u_j = \phi^{-1}\left(\sum_{i=1}^{d_c-1} \phi(|v_i|)\right) \times \prod_{i=1}^{d_c-1} \text{sign}(v_i) \qquad \cdots \quad (7)
$$

At the check node, the check node operation in equation (2) is performed according to equation (7).

Specifically, at the check node, a message $u_j$ corresponding to an edge as a calculation target is obtained by the check node operation in equation (7) using messages $v_1$, $v_2$, $v_3$, $v_4$, and $v_5$ received from the rest of the edges connected to the check node as illustrated in FIG. 6. Messages corresponding to the other edges are similarly obtained.

Note that the function $\phi(x)$ in equation (7) can be expressed as an equation $\phi(x) = \ln((e^x + 1)/(e^x - 1))$. When $x > 0$, $\phi(x) = \phi^{-1}(x)$ holds. For implementing the functions $\phi(x)$ and $\phi^{-1}(x)$ in hardware, these functions may be implemented using LUT (Look Up Table) in a certain case. In this case, both the functions use the same LUT.

<Configuration example of transfer system to which present technology is applied>

FIG. 7 is a diagram illustrating a configuration example of a transfer system according to one embodiment to which the present technology is applied (the term "system" refers to a logical set of multiple devices, and these devices of respective configurations may be either contained in an identical housing, or not contained in the same housing.)

The transfer system in FIG. 7 includes a transmission device 11 and a reception device 12.

For example, the transmission device 11 transmits (broadcasts) (transfers) programs for television broadcasting and the like. Specifically, for example, the transmission device 11 encodes target data corresponding to a transmission target, such as image data and audio data as programs, into LDPC codes, for example, and transmits the LDPC codes via a communication path 13, such as a satellite line, a ground wave, and a cable (wired circuit).

The reception device 12 receives LDPC codes transmitted from the transmission device 11 via the communication path 13, decodes the LDPC codes into target data, and outputs the target data.

It is known that LDPC codes used in the transfer system in FIG. 7 herein achieve extremely high performance in an AWGN (Additive White Gaussian Noise) communication path.

Meanwhile, these codes may cause burst errors and erasure in the communication path 13. For example, particularly in a case where the communication path 13 is a ground wave, power of a specific symbol in an OFDM (Orthogonal Frequency Division Multiplexing) system becomes 0 (i.e., causes erasure) in some cases according to a delay of an echo (a path other than a main path) in such a multipath environment where a D/U (Desired to Undesired Ratio) becomes 0 dB (power of Undesired = echo is equivalent to power of Desired = main path).

Moreover, in a flutter (a communication path to which an echo having no delay and multiplied by a doppler frequency is added), power of entire symbols may also become 0 (causes erasure) in an OFDM at a specific time according to the doppler frequency in the case where the D/U is 0 dB.

Further, burst errors may be caused by a wiring situation on the reception device 12 side from a reception unit (not illustrated) receiving signals from the transmission device 11, such as an antenna, to the reception device 12, or by instability of a power source of the reception device 12.

Meanwhile, for LDPC code decoding, the variable node operation in equation (1) which adds a sign bit (reception value $u_{0i}$ thereof) of an LDPC code is performed for a column of the check matrix H, and also for a variable node corresponding to the sign bit of the LDPC code as illustrated in FIG. 5. Accordingly, when an error is caused in the sign bit used for the variable node operation, accuracy of an obtained message deteriorates.

In addition, for LDPC decoding, the check node operation in equation (7) is performed for a check node with use of a message obtained from variable nodes connected to this check node. Accordingly, if there are a larger number of check nodes each connected to multiple variable nodes (sign bits of an LDPC code corresponding to the variable nodes) simultaneously causing errors (including erasure), decoding performance deteriorates.

Specifically, for example, when two or more variable nodes connected to a check node simultaneously cause erasure, this check node returns a message indicating an equal probability of values of 0 and 1 to all the variable nodes. In this case, the check node returning the message of the equal probability does not contribute to one decoding process (one set of the variable node operation and the check node operation). Accordingly, the decoding process is required to be repeated a large number of times. As a result, decoding performance deteriorates, and further, power consumption of the reception device 12 decoding LDPC codes increases.

Accordingly, the transfer system in FIG. 7 is enabled to improve tolerance for burst errors and erasure while maintaining performance in an AWGN communication path (AWGN channel).

<Configuration example of transmission device 11>

FIG. 8 is a block diagram illustrating a configuration example of the transmission device 11 in FIG. 7.

In the transmission device 11, one or more input streams constituting target data are supplied to a mode adaptation and multiplexer (Mode Adaptation/Multiplexer) 111.

The mode adaptation and multiplexer 111 performs mode selection and, as necessary, processing such as multiplexing of one or more input streams supplied to the mode adaptation and multiplexer 111, and supplies data thus obtained to a padder 112.

The padder 112 performs necessary zero padding (null insertion) for the data received from the mode adaptation and multiplexer 111, and supplies data thus obtained to a BB scrambler 113.

The BB scrambler 113 applies BB scrambling (BaseBand Scrambling) to the data received from the padder 112, and supplies data thus obtained to a BCH encoder 114.

The BCH encoder 114 performs BCH-encoding for the data received from the BB scrambler 113, and supplies data thus obtained to an LDPC encoder 115 as LDPC target data corresponding to a target for LDPC encoding.

The LDPC encoder (encoding unit) 115 performs LDPC encoding for the LDPC target data received from the BCH encoder 114, according to a check matrix including a parity matrix which is a part corresponding to parity bits of an LDPC code and has a stepped (dual diagonal) structure, or other check matrixes, for example, and outputs an LDPC code containing the LDPC target data as information bits.

Specifically, for example, the LDPC encoder 115 performs LDPC encoding for encoding the LDPC target data into an LDPC code specified in predetermined standards such as DVB-S.2, DVB-T.2, DVB-C.2, and ATSC3.0 (an LDPC code corresponding to a check matrix specified in these standards), or into other types of LDPC codes, and outputs the LDPC code thus obtained.

The LDPC code specified in such standards as DVB-S.2 and ATSC3.0 herein is an IRA (Irregular Repeat Accumulate) code. A parity matrix (a part or the whole thereof) included in the check matrix for the LDPC code has a stepped structure. The parity matrix and the stepped structure will be described below. Moreover, the IRA code is described in "Irregular Repeat-Accumulate Codes," H. Jin, A. Khandekar, and R. J. McEliece, in Proceedings of 2nd International Symposium on Turbo codes and Related Topics, pp. 1-8, Sept. 2000, for example.

The LDPC code output from the LDPC encoder 115 is supplied to a bit interleaver 116.

The bit interleaver 116 performs below-described bit-interleaving on the LDPC code received from the LDPC encoder 115, and supplies the bit-interleaved LDPC code to a mapper 117.

The mapper 117 maps the LDPC code received from the bit interleaver 116, at signal points each indicating one symbol of quadrature modulation, in units of a sign bit having one or more bits of the LDPC code (in units of a symbol), to achieve quadrature modulation (multilevel modulation).

Specifically, the mapper 117 achieves quadrature modulation by mapping the LDPC code received from the bit interleaver 116, at signal points that are determined by a modulation system achieving quadrature modulation of the LDPC code and that are on a constellation which is an IQ plane defined by an I-axis indicating an I component in the same phase as that of a carrier wave and a Q-axis indicating a Q component orthogonal to the carrier wave.

In a case where the number of signal points on the constellation used by the modulation system of quadrature modulation adopted by the mapper 117 is $2^m$, an m-bit sign bit of the LDPC code is designated as a symbol (one symbol), and the LDPC code received from the bit interleaver 116 is mapped by the mapper 117 in units of the symbol at signal points that are included in the $2^m$ signal points and that each indicate the symbol.

For example, the modulation system of quadrature modulation adopted by the mapper 117 is a modulation system specified in such standards as DVB-S.2 and ATSC3.0, or other modulation systems such as BPSK (Binary Phase Shift Keying), QPSK (Quadrature Phase Shift Keying), 8PSK (Phase-Shift Keying), 16APSK (Amplitude Phase-Shift Keying), 32APSK, 16QAM (Quadrature Amplitude Modulation), 16QAM, 64QAM, 256QAM, 1024QAM, 4096QAM, and 4PAM (Pulse Amplitude Modulation). Which modulation system is adopted by the mapper 117 to achieve quadrature modulation is set beforehand according to operation performed by an operator of the transmission device 11 or the like, for example.

The data obtained as a result of the processing by the mapper 117 (a mapping result of the symbols mapped at signal points) is supplied to a time interleaver 118.

The time interleaver 118 performs time-interleaving (interleaving in a time direction) for the data received from the mapper 117, in units of the symbol, and supplies data thus obtained to an SISO/MISO (Single Input Single Output/Multiple Input Single Output) encoder 119.

The SISO/MISO encoder 119 applies space-time encoding to the data received from the time interleaver 118, and supplies resultant data to a frequency interleaver 120.

The frequency interleaver 120 performs frequency-interleaving (interleaving in a frequency direction) for the data received from the SISO/MISO encoder 119, in units of the symbol, and supplies resultant data to a frame builder and resource allocation unit (Frame Builder & Resource Allocation) 131.

Meanwhile, for example, control data for transfer control (signalling), such as BB signaling (Base Band Signalling) (BB Header), is supplied to the BCH encoder 121.

The BCH encoder 121 performs BCH encoding for the control data supplied thereto, similarly to the BCH encoder 114, and supplies data thus obtained to an LDPC encoder 122.

The LDPC encoder 122 performs LDPC encoding for the data received from the BCH encoder 121, as LDPC target data, similarly to the LDPC encoder 115, and supplies an LDPC code thus obtained to a mapper 123.

Similarly to the mapper 117, the mapper 123 maps the LDPC code received from the LDPC encoder 122, at signal points each indicating one symbol of quadrature modulation, in units of the sign bit having one or more bits of the LDPC code (in units of the symbol), to achieve quadrature modulation, and supplies data thus obtained to a frequency interleaver 124.

Similarly to the frequency interleaver 120, the frequency interleaver 124 performs frequency interleaving for the data received from the mapper 123, in units of the symbol, and supplies resultant data to the frame builder and resource allocation unit 131.

The frame builder and resource allocation unit 131 inserts pilot symbols into necessary positions of the data (symbols) received from the frequency interleavers 120 and 124, and constructs a frame including a predetermined number of symbols (e.g., PL (Physical Layer) frame, T2 frame, C2 frame, etc.), from data (symbols) thus obtained, and supplies the constructed frame to an OFDM generation unit (OFDM generation) 132.

The OFDM generation unit 132 generates an OFDM signal from the frame received from the frame builder and resource allocation unit 131, as a signal corresponding to this frame, and transmits the generated OFDM signal via the communication path 13 (FIG. 7).

Note that some of the blocks illustrated in FIG. 8, such as the time interleaver 118, the SISO/MISO encoder 119, the frequency interleaver 120, and the frequency interleaver 124, for example, may be eliminated from the configuration of the transmission device 11.

<Configuration example of bit interleaver 116>

FIG. 9 is a block diagram illustrating a configuration example of the bit interleaver 116 in FIG. 8.

The bit interleaver 116 has a function of interleaving data, and includes a parity interleaver 23, a groupwise interleaver 24, and a block interleaver 25.

The parity interleaver 23 performs parity interleaving for interleaving parity bits of an LDPC code received from the LDPC encoder 115 into positions of other parity bits, and supplies the parity-interleaved LDPC code to the groupwise interleaver 24.

The groupwise interleaver 24 performs groupwise interleaving for the LDPC code received from the parity interleaver 23, and supplies the groupwise-interleaved LDPC code to the block interleaver 25.

In the groupwise interleaving carried out herein, the LDPC code received from the parity interleaver 23 is interleaved in units of a bit group having 360 bits of one division formed by dividing one LDPC code into 360-bit units each equivalent to a parallel factor P described below from the head of the LDPC code.

The groupwise interleaving thus performed improves an error rate in comparison with a case of not performing the groupwise interleaving. As a result, preferable communication quality is reliably achievable in data transfer.

The block interleaver 25 performs block interleaving for demultiplexing the LDPC code received from the groupwise interleaver 24, to symbolize one LDPC code into an m-bit symbol corresponding to a unit for mapping, for example, and supplies the symbolized LDPC code to the mapper 117 (FIG. 8).

In the block interleaving performed herein, for example, the LDPC code received from the groupwise interleaver 24 is written in a column (vertical) direction and read in a row (horizontal) direction to and from a storage region where the same number of columns as the number of bits m of each symbol are arranged in the row direction. Each of these columns is a storage region for storing a predetermined number of bits in the column direction. In this manner, the LDPC code is symbolized into an m-bit symbol.

<Check matrix for LDPC codes>

FIG. 10 is a diagram illustrating an example of a check matrix H used for LDPC encoding by the LDPC encoder 115 in FIG. 8.

The check matrix H has an LDGM (Low-Density Generation Matrix) structure, and can be represented, using an information matrix $H_A$ at a portion corresponding to information bits and a parity matrix $H_T$ corresponding to parity bits in sign bits of the LDPC code, as an equation $H = [H_A|H_T]$ (a matrix which has elements of the information matrix $H_A$ as left elements and has elements of the parity matrix $H_T$ as right elements).

The number of bits of information bits and the number of bits of parity bits in sign bits of one LDPC code (one code word) will be referred to herein as an information length K and a parity length M, respectively. In addition, the number of bits of sign bits of one (one code word) LDPC code will be referred to as a code length N (= K + M) .

An information length K and a parity length M for an LDPC code having a certain code length N are determined according to a code rate. Moreover, the check matrix H is a matrix of M rows × N columns (a matrix having M rows and N columns). Further, the information matrix $H_A$ is an M × K matrix, while the parity matrix $H_T$ is an M × M matrix.

FIG. 11 is a diagram illustrating an example of the parity matrix $H_T$ of the check matrix H used for LDPC encoding by the LDPC encoder 115 in FIG. 8.

For example, the parity matrix $H_T$ adopted for the check matrix H used for LDPC encoding by the LDPC encoder 115 may be similar to a parity matrix $H_T$ of a check matrix H for an LDPC code specified in such standards as DVB-T.2.

The parity matrix $H_T$ of the check matrix H for the LDPC code specified in such standards as DVB-T.2 is a matrix having a stepped structure where elements 1 are arranged in a shape similar to, so to speak, steps (lower bidiagonal matrix) as illustrated in FIG. 11. The parity matrix $H_T$ has a row weight of 1 for the first row and has a row weight of 2 for all the rest of the rows. In addition, the parity matrix $H_T$ has a column weight of 1 for the last one column and has a column weight of 2 for all the rest of the columns.

As described above, the LDPC code corresponding to the check matrix H which contains the parity matrix $H_T$ having a stepped structure can easily be generated by use of this check matrix H.

Specifically, the LDPC code (one code word) is expressed as a row vector c, while a column vector obtained by transposing this row vector is expressed as $c^T$. In addition, an information bit part in the row vector c as the LDPC code is expressed as a row vector A, while a parity bit part is expressed as a row vector T.

In this case, the row vector c can be represented, using the row vector A as the information bits and the row vector T as the parity bits, as an equation c = [A|T] (a row vector having elements of the row vector A as left elements and having elements of the row vector T as right elements).

The check matrix H and the row vector c = [A|T] as the LDPC code are each required to meet an equation $Hc^T = 0$. In a case where the parity matrix $H_T$ of the check matrix $H = [H_A|H_T]$ has the stepped structure illustrated in FIG. 11, the row vector T as the parity bits constituting the row vector c = [A|T] meeting this equation $Hc^T = 0$ can be obtained sequentially (in order) by converting the elements in the respective rows into 0 from the element in the first row of the column vector $Hc^T$ under the equation $Hc^T = 0$.

FIG. 12 is a diagram explaining the check matrix H for an LDPC code specified in such standards as DVB-T.2.

In the check matrix H for the LDPC code specified in such standards as DVB-T.2, each of KX columns from the first column has a column weight of X, each of subsequent K3 columns has a column weight of 3, each of subsequent (M - 1) columns has a column weight of 2, and the final one column has a column weight of 1.

Note herein that the sum of KX, K3, (M - 1), and 1 is equal to the code length N.

FIG. 13 is a diagram illustrating the numbers of columns of KX, K3, and M as well as a column weight X for each code rate r of the LDPC code specified in such standards as DVB-T.2.

LDPC codes having code lengths N of 64800 bits and 16200 bits are specified in such standards as DVB-T.2.

In addition, for the LDPC code having the code length N of 64800 bits, 11 code rates (nominal rates) of 1/4, 1/3, 2/5, 1/2, 3/5, 2/3, 3/4, 4/5, 5/6, 8/9, and 9/10 are specified. For the LDPC code having the code length N of 16200 bits, ten code rates of 1/4, 1/3, 2/5, 1/2, 3/5, 2/3, 3/4, 4/5, 5/6, and 8/9 are specified.

Note herein that the code length N of 64800 bits will hereinafter also be referred to as 64k bits, and that the code length N of 16200 bits will hereinafter also be referred to as 16k bits.

LDPC codes have such a tendency that a sign bit corresponding to a column given a larger column weight in a check matrix H has a lower error rate.

According to the check matrix H specified in such standards as DVB-T.2 as illustrated in FIGS. 12 and 13, a column closer to the head side (left side) tends to have a large column weight. Accordingly, for LDPC codes corresponding to this check matrix H, a sign bit closer to the head is more tolerant for errors (has higher resistance to errors), and a sign bit closer to the end tends to be less tolerant for errors.

<Parity interleaving>

Parity interleaving performed by the parity interleaver 23 in FIG. 9 will be explained with reference to FIGS. 14 to 16.

FIG. 14 is a diagram illustrating an example of a Tanner graph (a part thereof) of a check matrix for an LDPC code.

When multiple, such as two, variable nodes (sign bits corresponding to the variable nodes) connected to a check node simultaneously cause errors such as erasure, this check node returns a message indicating an equal probability of values of 0 and 1 to all variable nodes connected to this check node as illustrated in FIG. 14. Accordingly, if multiple variable nodes connected to the same check node simultaneously cause erasure or the like, decoding performance deteriorates.

Meanwhile, similarly to LDPC codes specified in such standards as DVB-T.2, for example, an LDPC code output from the LDPC encoder 115 in FIG. 8 is an IRA code, and a parity matrix $H_T$ of a check matrix H has a stepped structure as illustrated in FIG. 11.

FIG. 15 is a diagram illustrating examples of a parity matrix $H_T$ having a stepped structure as illustrated in FIG. 11 and a Tanner graph corresponding to this parity matrix $H_T$.

A of FIG. 15 illustrates an example of the parity matrix $H_T$ having a stepped structure, while B of FIG. 15 illustrates a Tanner graph corresponding to the parity matrix $H_T$ in A of FIG. 15.

In the parity matrix $H_T$ having the stepped structure, elements 1 are adjacent to each other in each row (except for the first row). Accordingly, in the Tanner graph of the parity matrix $H_T$, two adjoining variable nodes corresponding to the column of the two adjoining elements each having a value of 1 in the parity matrix $H_T$ are connected to the same check node.

Accordingly, if parity bits corresponding to the foregoing two adjoining variable nodes simultaneously cause errors as a result of burst errors, erasure, or the like, a check node connected to the two variable nodes (variable nodes requiring a message by using parity bits) corresponding to the two parity bits causing errors returns a message indicating an equal probability of values of 0 and 1 to the variable nodes connected to this check node. Accordingly, decoding performance deteriorates. In addition, if a burst length (the number of bits of parity bits successively causing errors) increases, the number of check nodes returning the message of the equal probability increases. As a result, decoding performance further deteriorates.

In view of this, the parity interleaver 23 (FIG. 9) performs parity interleaving for interleaving parity bits of an LDPC code received from the LDPC encoder 115 into positions of other parity bits, in order to prevent the deterioration of decoding performance described above.

FIG. 16 is a diagram illustrating a parity matrix $H_T$ of a check matrix H corresponding to an LDPC code parity-interleaved by the parity interleaver 23 in FIG. 9.

Here, an information matrix $H_A$ of the check matrix H corresponding to the LDPC code output from the LDPC encoder 115 has a cyclic structure similarly to an information matrix of a check matrix H corresponding to LDPC codes specified in such standards as DVB-T.2.

The cyclic structure refers to such a structure where a certain column agrees with a cyclically shifted different column. For example, this structure includes such a structure where a position of 1 in each row of each of P columns is located at a position of the initial column included in these P columns and cyclically shifted in a column direction by a predetermined value, such as a value proportional to a value q obtained by dividing a parity length M. The P columns in the cyclic structure will hereinafter be referred to as a parallel factor where appropriate.

As explained with reference to FIGS. 12 and 13, LDPC codes specified in such standards as DVB-T.2 include two types, i.e., a LDPC code having a code length N of 64800 bits and a LDPC code having a code length N of 16200 bits. For both the two types of LDPC codes, the parallel factor P is designated as 360 which is one of divisors of the parity length M except for 1 and M.

Moreover, the parity length M is determined as a value other than prime numbers and represented as an equation $M = q \times P = q \times 360$ by use of a value q variable according to a code rate. Accordingly, similarly to the parallel factor P, the value q is also a different value included in divisors of the parity length M and other than 1 and M, and is obtained by dividing the parity length M by the parallel factor P (the product of P and q as divisors of the parity length M is equivalent to the parity length M).

As described above, assuming that an information length is K, that an integer of 0 or larger but smaller than P is x, and that an integer of 0 or larger but smaller than q is y, the parity interleaver 23 interleaves a (K + qx + y + 1)th sign bit in sign bits of an N-bit LDPC code into a position of a (K + Py + x + 1)th sign bit to achieve parity interleaving.

The (K + qx + y + 1)th sign bit and the (K + Py + x + 1)th sign bit are each a (K + 1)th or later sign bit, and hence correspond to a parity bit. Accordingly, positions of the parity bits of the LDPC code are shifted by parity interleaving.

According to such parity interleaving, variable nodes (parity bits corresponding thereto) that can be connected to the same check node are separated from each other by the parallel factor P, i.e., 360 bits herein. Accordingly, in a case where a burst length is shorter than 360 bits, such a situation where multiple variable nodes connected to the same check node simultaneously cause errors is avoidable. As a result, it is possible to improve tolerance for burst errors.

Note that the LDPC code obtained by the parity interleaving which interleaves the (K + qx + y + 1)th sign bit into the position of the (K + Py + x + 1)th sign bit agrees with an LDPC code corresponding to a check matrix (hereinafter also referred to as a transformed check matrix) obtained by column permutation which permutates a (K + qx + xy + 1)th column in the original check matrix H with a (K + Py + x + 1)th column.

Moreover, as illustrated in FIG. 16, a pseudo cyclic structure designating P columns (360 columns in FIG. 16) as a unit appears in the parity matrix of the transformed check matrix.

The pseudo cyclic structure herein refers to a structure which is cyclic except for a part of the structure.

A transformed check matrix obtained by performing column permutation corresponding to parity interleaving for a check matrix for LDPC codes specified in such standards as DVB-T.2 lacks only one element 1 (has an element 0) at a portion of 360 rows × 360 columns at an upper right corner of the transformed check matrix (a shift matrix described below). In this aspect, this transformed check matrix has what is generally called a pseudo cyclic structure instead of a (complete) cyclic structure.

For example, a transformed check matrix for a check matrix for LDPC codes output from the LDPC encoder 115 has a pseudo cyclic structure similarly to a transformed check matrix for a check matrix for LDPC codes specified in such standards as DVB-T.2.

Note that the transformed check matrix in FIG. 16 is a matrix obtained by applying permutation of rows (row permutation) to the original check matrix H to constitute the transformed check matrix by constituent matrixes described below as well as the column permutation corresponding to parity interleaving.

FIG. 17 is a flowchart explaining a process performed by the LDPC encoder 115, the bit interleaver 116, and the mapper 117 in FIG. 8.

The LDPC encoder 115 waits for supply of LDPC target data from the BCH encoder 114. In step S101, the LDPC encoder 115 encodes the LDPC target data into an LDPC code on the basis of a check matrix, and supplies the obtained LDPC code to the bit interleaver 116. Thereafter, the process proceeds to step S102.

In step S102, the bit interleaver 116 performs bit interleaving for the LDPC code received from the LDPC encoder 115, and supplies symbols obtained by this bit interleaving to the mapper 117. Thereafter, the process proceeds to step S103.

Specifically, in step S102, the parity interleaver 23 in the bit interleaver 116 (FIG. 9) performs parity interleaving for the LDPC code received from the LDPC encoder 115, and supplies the parity-interleaved LDPC code to the groupwise interleaver 24.

The groupwise interleaver 24 performs groupwise interleaving for the LDPC code received from the parity interleaver 23, and supplies the LDPC code to the block interleaver 25.

The block interleaver 25 performs block interleaving for the LDPC code groupwise-interleaved by the groupwise interleaver 24, and supplies m-bit symbols thus obtained to the mapper 117.

In step S103, the mapper 117 maps each of the symbols received from the block interleaver 25 at any one of $2^m$ signal points determined by a modulation system of quadrature modulation carried out by the mapper 117, to achieve quadrature modulation, and supplies data thus obtained to the time interleaver 118.

Parity interleaving and groupwise interleaving performed in the manner described above can improve an error rate of errors caused in a case of transmitting multiple sign bits of an LDPC code as one symbol.

While the parity interleaver 23 as a block performing parity interleaving and the groupwise interleaver 24 as a block performing groupwise interleaving are separately configured in this example illustrated in FIG. 9 for convenience of explanation, the parity interleaver 23 and the groupwise interleaver 24 can be integrally formed.

Specifically, both parity interleaving and groupwise interleaving are achievable by writing and reading of sign bits to and from a memory, and can be represented as a matrix which transforms addresses for writing sign bits (writing addresses) into addresses for reading sign bits (reading addresses).

Accordingly, the LDPC code as a result of parity interleaving and subsequent groupwise interleaving after parity interleaving is derivable by transforming sign bits by a matrix obtained by multiplying a matrix representing parity interleaving and a matrix representing groupwise interleaving.

Moreover, the block interleaver 25 may also be integrally formed with the parity interleaver 23 and the groupwise interleaver 24.

Specifically, block interleaving performed by the block interleaver 25 can also be represented by the matrix which transforms the writing addresses of the memory storing the LDPC code into the reading addresses.

Accordingly, parity interleaving, groupwise interleaving, and block interleaving can collectively be achieved by a matrix obtained by multiplying a matrix representing parity interleaving, a matrix representing groupwise interleaving, and a matrix representing block interleaving.

Note that either one of or both parity interleaving and groupwise interleaving may be omitted.

<Configuration example of LDPC encoder 115>

FIG. 18 is a block diagram illustrating a configuration example of the LDPC encoder 115 in FIG. 8.

Note that the LDPC encoder 122 in FIG. 8 is configured in a similar manner.

As described with reference to FIGS. 12 and 13, two types of code lengths N, i.e., 64800 bits and 16200 bits, are specified as LDPC codes under such standards as DVB-T.2.

In addition, for the LDPC code having the code length N of 64800 bits, 11 code rates of 1/4, 1/3, 2/5, 1/2, 3/5, 2/3, 3/4, 4/5, 5/6, 8/9, and 9/10 are specified. For the LDPC code having the code length N of 16200 bits, ten code rates of 1/4, 1/3, 2/5, 1/2, 3/5, 2/3, 3/4, 4/5, 5/6, and 8/9 are specified (FIGS. 12 and 13) .

For example, the LDPC encoder 115 is capable of achieving encoding (error correcting encoding) using LDPC codes at respective code rates for the code lengths N of 64800 bits and 16200 bits as described above, on the basis of a check matrix H prepared for each code length N and for each code rate.

Moreover, the LDPC encoder 115 is capable of achieving LDPC encoding on the basis of a check matrix H for an LDPC code having any code length N such as 17280 bits or other code lengths and any code rate r such as 2/16, 3/16, 4/16, 5/16, 6/16, 7/16, 8/16, 9/16, 10/16, 11/16, 12/16, 13/16, and 14/16 or other rates.

The LDPC encoder 115 includes an encoding unit 601 and a storage unit 602.

The encoding unit 601 includes a code rate setting unit 611, an initial value table reading unit 612, a check matrix generation unit 613, an information bit reading unit 614, an encoding parity arithmetic unit 615, and a control unit 616, and is configured to perform LDPC encoding for LDPC target data supplied to the LDPC encoder 115, and supply an LDPC code thus obtained to the bit interleaver 116 (FIG. 8).

Specifically, for example, the code rate setting unit 611 sets a code length N and a code rate r of the LDPC code and other identification information for identifying the LDPC code, according to operation performed by an operator, for example.

The initial value table reading unit 612 reads from the storage unit 602 a check matrix initial value table which will be described below and indicates a check matrix for the LDPC code identified by the identification information set by the code rate setting unit 611.

The check matrix generation unit 613 generates a check matrix H on the basis of the check matrix initial value table read by the initial value table reading unit 612, and stores this table in the storage unit 602. For example, the check matrix generation unit 613 generates the check matrix H by arranging elements 1 of an information matrix $H_A$, which corresponds to an information length K (= code length N - parity length M) corresponding to the code length N and the code rate r set by the code rate setting unit 611, in a cycle of 360 columns (parallel factor P) in a column direction, and stores the generated check matrix H in the storage unit 602.

The information bit reading unit 614 reads (extracts) information bits of the information length K from the LDPC target data supplied to the LDPC encoder 115.

The encoding parity arithmetic unit 615 reads from the storage unit 602 the check matrix H generated by the check matrix generation unit 613, and calculates, using the check matrix H, parity bits corresponding to information bits read by the information bit reading unit 614, on the basis of a predetermined formula, to generate a code word (LDPC code).

The control unit 616 controls respective blocks constituting the encoding unit 601.

For example, the storage unit 602 stores multiple check matrix initial value tables corresponding to multiple code rates and the like illustrated in FIGS. 12 and 13 for each of the code lengths N such as 64800 bits and 16200 bits, check matrix initial value tables corresponding to respective code rates of 2/16, 3/16, 4/16, 5/16, 6/16, 7/16, 8/16, 9/16, 10/16, 11/16, 12/16, 13/16, and 14/16 for the code length N of 17280 bits, and check matrix initial value tables for check matrixes H for LDPC codes having any code lengths N and any code rates r. Moreover, the storage unit 602 temporarily stores data necessary for processing performed by the encoding unit 601.

FIG. 19 is a flowchart for explaining an example of a process performed by the LDPC encoder 115 in FIG. 18.

In step S201, the code rate setting unit 611 sets a code length N and a code rate r for LDPC encoding and other identification information for identifying an LDPC code.

In step S202, the initial value table reading unit 612 reads from the storage unit 602 a check matrix initial value table determined beforehand and identified by the code length N, the code rate r, and the like as identification information set by the code rate setting unit 611.

In step S203, the check matrix generation unit 613 obtains (generates) a check matrix H for the LDPC code having the code length N and the code rate r set by the code rate setting unit 611, with use of the check matrix initial value table read by the initial value table reading unit 612 from the storage unit 602, supplies the check matrix H to the storage unit 602, and stores the check matrix H in the storage unit 602.

In step S204, the information bit reading unit 614 reads, from LDPC target data supplied to the LDPC encoder 115, information bits having an information length K (= N × r) corresponding to the code length N and the code rate r set by the code rate setting unit 611, reads from the storage unit 602 the check matrix H obtained by the check matrix generation unit 613, and supplies the information bits and the check matrix H to the encoding parity arithmetic unit 615.

In step S205, the encoding parity arithmetic unit 615 sequentially calculates a parity bit of a code word c meeting equation (8), by using the information bits and the check matrix H received from the information bit reading unit 614.

$$Hc^T = 0 \quad \dots \quad (8)$$

In equation (8), c represents a row vector as a code word (LDPC code), while $c^T$ represents a transposition of the row vector c.

As described above, in a case where a portion of the information bits and a portion of the parity bits in the row vector c as the LDPC code (one code word) are herein represented as a row vector A and a row vector T, respectively, the row vector c can be expressed as an equation c = [A|T] by using the row vector A as the information bits and the row vector T as the parity bits.

The check matrix H and the row vector c = [A|T] as the LDPC code are each required to meet an equation $Hc^T = 0$. In a case where the parity matrix $H_T$ of the check matrix H = [$H_A|H_T$] has a stepped structure illustrated in FIG. 11, the row vector T as the parity bits constituting the row vector c = [A|T] meeting this equation $Hc^T = 0$ can be obtained sequentially by converting the elements in the respective rows into 0 from the element in the first row of the column vector $Hc^T$ under the equation $Hc^T = 0$.

The encoding parity arithmetic unit 615 obtains parity bits T for information bits A received from the information bit reading unit 614, and outputs, as a result of LDPC encoding of the information bits A, a code word c = [A|T] expressed using the information bits A and the parity bits T.

Thereafter, in step S206, the control unit 616 determines whether or not to end the LDPC encoding. In a case of determination that LDPC encoding is not to be ended in step S206, i.e., in a case where LDPC target data for LDPC encoding still remains, for example, the process returns to step S201 (or step S204), and the processing from step S201 (or step S204) to S206 is subsequently repeated.

Meanwhile, in a case of determination that LDPC encoding is to be ended in step S206, i.e., in a case where no LDPC target data for LDPC encoding remains, for example, the LDPC encoder 115 ends the process.

Check matrix initial value tables for LDPC codes having various code lengths N and code rates r (tables indicating check matrixes for these LDPC codes) may be prepared beforehand for the LDPC encoder 115. The LDPC encoder 115 is capable of performing LDPC encoding for LDPC codes having various code lengths N and code rates r, by using check matrixes H generated from the check matrix initial value tables prepared beforehand.

<Example of check matrix initial value table>

For example, a check matrix initial value table is a table which indicates, for each set of 360 columns (parallel factor P), positions of elements 1 in an information matrix $H_A$ (FIG. 10) that is included in a check matrix H and that corresponds to an information length K given according to a code length N and a code rate r of an LDPC code (an LDPC code defined by the check matrix H), and is created beforehand for each check matrix H for respective code lengths N and code rates r.

Accordingly, the check matrix initial value table indicates the positions of the elements 1 in the information matrix $H_A$ at least for each set of 360 columns (parallel factor P).

Moreover, the check matrix H includes such a type of check matrix which has a stepped structure for all parity matrixes $H_T$ and such a type of check matrix which has a stepped structure for a part of parity matrixes $H_T$ and diagonal matrixes (unit matrixes) for the remaining part.

A system for expressing such a check matrix initial value table indicating a check matrix which has a stepped structure for a part of parity matrixes $H_T$ and diagonal matrixes for the remaining part will hereinafter also be referred to as a type A system. Meanwhile, a system for expressing such a check matrix initial value table indicating a check matrix which has a stepped structure for all of parity matrixes $H_T$ will hereinafter also be referred to as a type B system.

In addition, an LDPC code corresponding to a check matrix indicated by the check matrix initial value table of the type A system will also be referred to as a type A code, while an LDPC code corresponding to a check matrix indicated by a check matrix initial value table of the type B system will also be referred to as a type B code.

The names "type A" and "type B" are names in conformity with standards of ATSC3.0. For example, ATSC3.0 adopts both the type A codes and the type B codes.

Note that DVB-T.2 and the like adopt the type B codes.

FIG. 20 is a diagram illustrating an example of a check matrix initial value table of the type B system.

Specifically, FIG. 20 illustrates a check matrix initial value table (indicating a check matrix H) for a type B code that is specified in standards of DVB-T.2 and that has a code length N of 16200 bits and a code rate (a code rate under expressions of DBV-T.2) r of 1/4.

The check matrix generation unit 613 (FIG. 18) obtains a check matrix H in the following manner by using the check matrix initial value table of the type B system.

FIG. 21 is a diagram explaining a method for obtaining a check matrix H from the check matrix initial value table of the type B system.

Specifically, FIG. 21 illustrates a check matrix initial value table of a type B code that is specified in standards of DVB-T.2 and that has a code length N of 16200 bits and a code rate r of 2/3.

The check matrix initial value table of the type B system is a table which indicates, for each set of 360 columns (parallel factor P), positions of elements 1 in an entire information matrix $H_A$ corresponding to an information length K given according to a code length N and a code rate r of an LDPC code. In this table, the same number of row numbers of elements 1 in the $(1 + 360 \times (i - 1))$th column of the check matrix H (row numbers each corresponding to a row number of 0 in the first row of the check matrix H) as the number of a column weight given to the $(1 + 360 \times (i - 1))$th column are arranged in the ith row of the table.

Note herein that a parity matrix $H_T$ (FIG. 10) corresponding to a parity length M of the check matrix H for the type B system is determined to have a stepped structure as illustrated in FIG. 15. Accordingly, if the information matrix $H_A$ (FIG. 10) corresponding to the information length K can be obtained from the check matrix initial value table, the check matrix H is derivable.

A row number (K + 1) of the check matrix initial value table of the type B system is variable according to the information length K.

A relation in equation (9) holds between the information length K and the row number (k + 1) of the check matrix initial value table.

$$K = (k + 1) \ 360 \ \ldots \ (9)$$

Note herein that 360 in equation (9) is a parallel factor P explained with reference to FIG. 16.

In the check matrix initial value table in FIG. 21, 13 numerical values are arranged from the first row to the third row, while three numerical values are arranged from the fourth row to the (k + 1)th row (30th row in FIG. 21).

Accordingly, a column weight of the check matrix H obtained from the check matrix initial value table in FIG. 21 is 13 from the first column to the $(1 + 360 \times (3 - 1) - 1)$th column, and is 3 from the $(1 + 360 \times (3 - 1))$th column to the Kth column.

The first row of the check matrix initial value table in FIG. 21 is given 0, 2084, 1613, 1548, 1286, 1460, 3196, 4297, 2481, 3369, 3451, 4620, and 2622. This indicates that elements in rows corresponding to row numbers of 0, 2084, 1613, 1548, 1286, 1460, 3196, 4297, 2481, 3369, 3451, 4620, and 2622 are "1" in the first column of the check matrix H (and other elements are "0") .

Moreover, the second row of the check matrix initial value table in FIG. 21 is given 1, 122, 1516, 3448, 2880, 1407, 1847, 3799, 3529, 373, 971, 4358, and 3108. This indicates that elements in rows corresponding to row numbers of 1, 122, 1516, 3448, 2880, 1407, 1847, 3799, 3529, 373, 971, 4358, and 3108 are "1" in row numbers in the 361st $(= 1 + 360 \times (2 - 1))$ column of the check matrix H.

As described above, the check matrix initial value table indicates the positions of the elements 1 in the information matrix $H_A$ of the check matrix H for each set of 360 columns.

For columns other than the $(1 + 360 \times (i - 1))$th column in the check matrix H, i.e., for each of columns from the $(2 + 360 \times (i - 1))$th column to the $(360 \times i)$th column, elements 1 in the $(1 + 360 \times (i - 1))$th column determined by the check matrix initial value table are cyclically shifted in a downward direction (downward direction of columns) and arranged according to the parity length M.

Specifically, for example, the $(2 + 360 \times (i - 1))$th column is a column obtained by cyclically shifting the $(1 + 360 \times (i - 1))$th column downward by M/360 (= q). The subsequent $(3 + 360 \times (i - 1))$th column is a column obtained by cyclically shifting the $(1 + 360 \times (i - 1))$th column downward by $2 \times$ M/360 $(= 2 \times q)$ (a column obtained by cyclically shifting the $(2 + 360 \times (i - 1))$th column downward by M/360 (= q)).

Assuming herein that the numerical value in the jth column (jth from the left) of the ith row (ith from the top) in the check matrix initial value table is expressed as $h_{i,j}$, and that the row number of the jth element 1 of the wth column in the check matrix H is expressed as $H_{w-j}$, the row number $H_{w-j}$ of the element 1 in the wth column as a column other than the $(1 + 360 \times (i - 1))$th column of the check matrix H can be obtained from equation (10).

$$H_{w-j} = \mathrm{mod}(h_{i,j} + \mathrm{mod}((w - 1), P) \times q, M) \ ... \ (10)$$

In this equation, mod(x, y) indicates a remainder of x divided by y.

Moreover, P is the parallel factor described above, and is set to 360 in the present embodiment as in standards of DVB-T.2 and the like and ATSC3.0, for example. Further, q is a value M/360 obtained by dividing the parity length M by the parallel factor P (= 360).

The check matrix generation unit 613 (FIG. 18) identifies the row numbers of the elements 1 in the $(1 + 360 \times (i - 1))$th column of the check matrix H by the check matrix initial value table.

Moreover, the check matrix generation unit 613 (FIG. 18) obtains the row number $H_{w-j}$ of the element 1 in the wth column which is a column other than the $(1 + 360 \times (i - 1))$th column in the check matrix H, on the basis of equation (10), and generates a check matrix H designating the elements in the row numbers thus obtained as "1."

FIG. 22 is a diagram illustrating a structure of a check matrix H for the type A system.

The check matrix for the type A system includes an A matrix, a B matrix, a C matrix, a D matrix, and a Z matrix.

The A matrix is an upper left matrix of the check matrix H, and is a matrix having an M1 row and a K column expressed using a predetermined value M1 and an information length K = (code length N × code rate r) of an LDPC code.

The B matrix is a matrix having an M1 row and an M1 column, is located adjacent to the right side of the A matrix, and has a stepped structure.

The C matrix is a matrix having an (N - K - M1) row and a (K + M1) column and is located adjacent to the lower side of the A matrix and the B matrix.

The D matrix is a unit matrix having an (N - K - M1) row and (N - K - M1) column and is located adjacent to the right side of the C matrix.

The Z matrix is a zero matrix (0 matrix) having an M1 row and an (N - K - M1) column and is located adjacent to the right side of the B matrix.

According to the check matrix H for the type A system including the A matrix to the D matrix and the Z matrix described above, the A matrix and a part of the C matrix constitute an information matrix, while the B matrix, the remaining part of the C matrix, the D matrix, and the Z matrix constitute a parity matrix.

Note that the B matrix is a matrix having a stepped structure, and that the D matrix is a unit matrix. Accordingly, the parity matrix of the check matrix H for the type A system has a stepped structure for a part (the part corresponding to the B matrix), and has a diagonal matrix (unit matrix) for the remaining part (the part corresponding to the D matrix).

As in the information matrix of the check matrix H for the type B system, the A matrix and the C matrix each have a cyclic structure for each set of columns (e.g., 360 columns) corresponding to the parallel factor P. The check matrix initial value table of the type A system indicates positions of elements 1 of the A matrix and the C matrix for each set of 360 columns.

As described above, the A matrix and a part of the C matrix constitute the information matrix. Accordingly, it is considered herein that the check matrix initial value table of the type A system which indicates positions of elements 1 of the A matrix and the C matrix for each set of 360 columns indicates at least positions of elements 1 of the information matrix for each set of 360 columns.

Note that the check matrix initial value table of the type A system which indicates positions of elements 1 of the A matrix and the C matrix for each set of 360 columns is also considered to indicate positions of elements 1 of a part of the check matrix (the remaining part of the C matrix) for each set of 360 columns.

FIG. 23 is a diagram illustrating an example of a check matrix initial value table of the type A system.

Specifically, FIG. 23 illustrates an example of a check matrix initial value table of a check matrix H having a code length N of 35 bits and a code rate r of 2/7.

The check matrix initial value table of the type A system is a table which indicates positions of elements 1 in the A matrix and the C matrix for each parallel factor P. In this table, the same number of row numbers of elements 1 in the $(1 + P \times (i - 1))$th column of the check matrix H (row numbers each corresponding to a row number of 0 in the first row of the check matrix H) as the number of a column weight given to the $(1 + P \times (i - 1))$th column are arranged in the ith row of the table.

Note that the parallel factor P herein is set to 5, for example, for simplifying the explanation.

Parameters M1, M2, Q1, and Q2 are provided for the check matrix H for the type A system.

M1 (FIG. 22) is a parameter which determines the size of the B matrix, and has a value of a multiple of the parallel factor P. Performance of the LDPC code is changeable by controlling M1, and adjusted to a predetermined value when the check matrix H is determined. It is assumed herein that adopted as M1 is 15 which is the triple of the parallel factor P = 5.

M2 (FIG. 22) has a value (M - M1) calculated by subtracting M1 from the parity length M.

The information length K herein is N × r = 35 × 2/7 = 10, while the parity length M is N - K = 35 - 10 = 25.

Accordingly, M2 is M - M1 = 25 - 15 = 10.

Q1 is calculated on the basis of an equation Q1 = M1/P, and represents a shift number (row number) of a cyclic shift in the A matrix.

Specifically, in columns other than the $(1 + P \times (i - 1))$th column in the A matrix of the check matrix H for the type A system, i.e., in respective columns from the $(2 + P \times (i - 1))$th column to the $(P \times i)$th column, elements 1 in the $(1 + P \times (i - 1))$th column determined by the check matrix initial value table are cyclically shifted in a downward direction (downward direction of columns) and arranged. Q1 indicates the shift number of this cyclic shift in the A matrix.

Q2 is calculated on the basis of an equation Q2 = M2/P, and represents a shift number (row number) of a cyclic shift in the C matrix.

Specifically, in columns other than the $(1 + P \times (i-1))$th column in the C matrix of the check matrix H for the type A system, i.e., in respective columns from the $(2 + P \times (i - 1))$th column to the $(P \times i)$th column, elements 1 in the $(1 + P \times (i - 1))$th column determined by the check matrix initial value table are cyclically shifted in a downward direction (downward direction of columns) and arranged. Q2 indicates the shift number of the cyclic shifts in the C matrix.

In this example, Q1 is M1/P = 15/5 = 3, while Q2 is M2/P = 10/5 = 2.

In the check matrix initial value table in FIG. 23, three numerical values are arranged in each of the first and second rows, and one numerical value is arranged in each of the third to fifth rows. According to this arrangement of numerical values, the column weight of the A matrix and a part of the C matrix of the check matrix H obtained from the check matrix initial value table in FIG. 23 is 3 from the 1st $(= 1 + 5 \times (1 - 1))$ column to the 10th $(= 5 \times 2)$ column, and is 1 from the 11th $(= 1 + 5 \times (3 - 1))$ column to the 25th $(= 5 \times 5)$ column.

Specifically, the first row of the check matrix initial value table in FIG. 23 is given 2, 6, and 18. This indicates that elements in the row numbers of 2, 6, and 18 are "1" (and other elements are "0") in the first column of the check matrix H.

In the case of this example herein, the A matrix (FIG. 22) is a matrix having 15 rows and ten columns (M1 rows and K columns), while the C matrix (FIG. 22) is a matrix having ten rows and 25 columns ((N - K - M1) rows and (K + M1) columns). Accordingly, rows corresponding to the row numbers 0 to 14 of the check matrix H are rows of the A matrix, while rows corresponding to the row numbers 15 to 24 of the check matrix H are rows of the C matrix.

Therefore, in the rows having the row numbers 2, 6, and 18 (hereinafter expressed as rows #2, #6, and #18), the rows #2 and #6 are rows of the A matrix, while the row #18 is a row of the C matrix.

The second row of the check matrix initial value table in FIG. 23 is given 2, 10, and 19. This indicates that elements in the rows of #2, #10, and #19 are "1" in the 6th $(= 1 + 5 \times (2 - 1))$ column of the check matrix H.

In this case, the rows #2 and #10 in the rows #2, #10, and #19 in the 6th $(= 1 + 5 \times (2 - 1))$ column of the check matrix H are rows of the A matrix, while the row #19 is a row of the C matrix.

The third row of the check matrix initial value table in FIG. 23 is given 22. This indicates that an element in the row #22 is "1" in the 11th $(= 1 + 5 \times (3 - 1))$ column of the check matrix H.

In this case, the row #22 in the 11th $(= 1 + 5 \times (3 - 1))$ column of the check matrix H is a row of the C matrix.

A similar manner applies to the following, i.e., 19 in the fourth row of the check matrix initial value table in FIG. 23 indicates that an element in the row #19 is "1" in the 16th $(= 1 + 5 \times (4 - 1))$ column of the check matrix H, while 17 in the fifth row of the check matrix initial value table in FIG. 23 indicates that an element in the row #17 is "1" in the 21st $(= 1 + 5 \times (5 - 1))$ column of the check matrix H.

As described above, the check matrix initial value table indicates the positions of the elements 1 in the A matrix and the C matrix of the check matrix H for each parallel factor P = 5 of columns.

In columns other than the $(1 + 5 \times (i - 1))$th column in the A matrix and the C matrix of the check matrix H, i.e., in respective columns from the $(2 + 5 \times (i - 1))$th column to the $(5 \times i)$th column, elements 1 in the $(1 + 5 \times (i - 1))$th column determined by the check matrix initial value table are cyclically shifted in a downward direction (downward direction of columns) and arranged according to the parameters Q1 and Q2.

Specifically, for example, the $(2 + 5 \times (i - 1))$th column of the A matrix is a column obtained by cyclically shifting the $(1 + 5 \times (i - 1))$th column downward by Q1 $(= 3)$. The subsequent $(3 + 5 \times (i - 1))$th column is a column obtained by cyclically shifting the $(1 + 5 \times (i - 1))$th column downward by $2 \times$ Q1 $(= 2 \times 3)$ (a column obtained by cyclically shifting the $(2 + 5 \times (i - 1))$th column downward by Q1).

Moreover, for example, the $(2 + 5 \times (i - 1))$th column of the C matrix is a column obtained by cyclically shifting the $(1 + 5 \times (i - 1))$th column downward by Q2 $(= 2)$. The subsequent $(3 + 5 \times (i - 1))$th column is a column obtained by cyclically shifting the $(1 + 5 \times (i - 1))$th column downward by $2 \times$ Q2 $(= 2 \times 2)$ (a column obtained by cyclically shifting the $(2 + 5 \times (i - 1))$th column downward by Q2).

FIG. 24 is a diagram illustrating the A matrix generated from the check matrix initial value table in FIG. 23.

In the A matrix in FIG. 24, elements of the rows #2 and #6 in the 1st $(= 1 + 5 \times (1 - 1))$ column are "1" according to the first row in the check matrix initial value table in FIG. 23.

Moreover, respective columns from the 2nd $(= 2 + 5 \times (1 - 1))$ column to the 5th $(= 5 + 5 \times (1 - 1))$ column are columns obtained by cyclically shifting columns located immediately before by Q1 = 3 downward.

In addition, in the A matrix in FIG. 24, elements of the rows #2 and #10 in the 6th $(= 1 + 5 \times (2 - 1))$ column are "1" according to the second row in the check matrix initial value table in FIG. 23.

Moreover, respective columns from the 7th (= 2 + 5 × (2 - 1)) column to the 10th (= 5 + 5 × (2 - 1)) column are columns obtained by cyclically shifting columns located immediately before by Q1 = 3 downward.

FIG. 25 is a diagram illustrating parity interleaving of the B matrix.

The check matrix generation unit 613 (FIG. 18) generates the A matrix with use of the check matrix initial value table, and arranges the B matrix having a stepped structure, on the right side of the A matrix. Thereafter, the check matrix generation unit 613 regards the B matrix as a parity matrix, and performs parity interleaving such that adjoining elements 1 in the B matrix having a stepped structure are away from each other in the row direction by the parallel factor P = 5.

FIG. 25 illustrates the A matrix and the B matrix obtained after parity interleaving is applied to the B matrix in FIG. 24.

FIG. 26 is a diagram illustrating the C matrix generated from the check matrix initial value table in FIG. 23.

In the C matrix in FIG. 26, an element of the row #18 in the 1st (= 1 + 5 × (1 - 1)) column of the check matrix H is "1" according to the first row in the check matrix initial value table in FIG. 23.

Moreover, respective columns from the 2nd (= 2 + 5 × (1 - 1)) column to the 5th (= 5 + 5 × (1 - 1)) column of the C matrix are columns obtained by cyclically shifting columns located immediately before by Q2 = 2 downward.

Further, in the C matrix in FIG. 26, elements of the row #19 in the 6th (= 1 + 5 × (2 - 1)) column, the row #22 in the 11th (= 1 + 5 × (3 - 1)) column, the row #19 in the 16th (= 1 + 5 × (4 - 1)) column, and the row #17 in the 21st (= 1 + 5 × (5 - 1)) column in the check matrix H are "1" according to the second row to the fifth row in the check matrix initial value table in FIG. 23.

Moreover, respective columns from the 7th (=2 + 5 × (2 - 1)) column to 1 the 0th (= 5 + 5 × (2 - 1)) column, respective columns from the 12th (= 2 + 5 × (3 - 1)) column to the 15th (= 5 + 5 × (3 - 1)) column, respective columns from the 17th (= 2 + 5 × (4 - 1)) column to the 20th (= 5 + 5 × (4 - 1)) column, and respective columns from the 22nd (= 2 + 5 × (5 - 1)) column to the 25th (= 5 + 5 × (5 - 1)) column are columns obtained by cyclically shifting columns located immediately before by Q2 = 2 downward.

The check matrix generation unit 613 (FIG. 18) generates the C matrix with use of the check matrix initial value table, and arranges the C matrix below the A matrix and the B matrix (that has undergone parity interleaving).

Moreover, the check matrix generation unit 613 arranges the Z matrix on the right side of the B matrix, and arranges the D matrix on the right side of the C matrix to generate the check matrix H illustrated in FIG. 26.

FIG. 27 is a diagram illustrating parity interleaving of the D matrix.

The check matrix generation unit 613 generates the check matrix in FIG. 26, then regards the D matrix as a parity matrix, and performs parity interleaving (for only the D matrix) such that elements 1 in odd-numbered rows and subsequent even-numbered rows of the D matrix as a unit matrix are away from each other in the row direction by the parallel factor P = 5.

FIG. 27 illustrates the check matrix H obtained after parity interleaving of the D matrix is performed for the check matrix H in FIG. 26.

For example, the LDPC encoder 115 (the encoding parity arithmetic unit 615 (FIG. 18) thereof) performs LDPC encoding (generation of LDPC codes) by using the check matrix H in FIG. 27.

The LDPC codes generated using the check matrix H in FIG. 27 herein are parity-interleaved LDPC codes. Accordingly, the parity interleaver 23 (FIG. 9) need not perform parity interleaving for the LDPC codes generated using the check matrix H in FIG. 27. In other words, the LDPC codes that are generated using the check matrix H and have the parity-interleaved D matrix become parity-interleaved LDPC codes. Accordingly, parity interleaving by the parity interleaver 23 is skipped for these LDPC codes.

FIG. 28 is a diagram illustrating a check matrix H obtained after column permutation is applied to the B matrix, a part of the C matrix (a part included in the C matrix and arranged below the B matrix), and the D matrix of the check matrix H in FIG. 27, as parity deinterleaving for restoring the parity interleaved state to the original state.

The LDPC encoder 115 is capable of performing LDPC encoding (generation of LDPC codes) by using the check matrix H in FIG. 28.

In a case where LDPC encoding is performed using the check matrix H in FIG. 28, LDPC codes not parity-interleaved are obtained by this LDPC encoding. Accordingly, in the case where LDPC encoding is performed using the check matrix H in FIG. 28, parity interleaving is carried out by the parity interleaver 23 (FIG. 9).

FIG. 29 is a diagram illustrating a transformed check matrix H obtained by applying row permutation to the check matrix H in FIG. 27.

As will be described below, the transformed check matrix is a matrix expressed using a combination of a P × P unit matrix, a semi-unit matrix having an element (elements) 0 in place of one or more elements 1 in this unit matrix, a shift matrix obtained by cyclically shifting the unit matrix or the semi-unit matrix, a sum matrix as a sum of two or more of the unit matrix, the semi-unit matrix, and the shift matrix, and P × P 0 matrix.

As will be described below, architecture capable of simultaneously performing P operations of check node operation and variable node operation is adoptable for LDPC code decoding by use of the transformed check matrix for LDPC code decoding.

<New LDPC codes>

A method using high-performance LDPC codes is one of methods for reliably achieving preferable communication quality in data transfer using LDPC codes.

A new high-performance LDPC code (hereinafter also referred to as a new LDPC code) will hereinafter be described.

For example, adoptable as the new LDPC code is a type A code or a type B code, each having a parallel factor P of 360 as in DVB-T.2, ATSC3.0, and the like and being compatible with a check matrix H having a cyclic structure.

The LDPC encoder 115 (FIGS. 8 and 18) is capable of achieving LDPC encoding for encoding into LDPC codes by using a check matrix initial value table (a check matrix H obtained from this table) for an LDPC code having a code length N longer than 64k bits, such as 69120 bits, and any one of code rates r of 2/16, 3/16, 4/16, 5/16, 6/16, 7/16, 8/16, 9/16, 10/16, 11/16, 12/16, 13/16, and 14/16, for example.

Moreover, the LDPC encoder 115 is capable of achieving LDPC encoding for encoding into new LDPC codes on the basis of a check matrix initial value table (a check matrix H obtained from this table) for a new LDPC code having a code length N shorter than 64k bits, such as 17280 bits (17k bits), and any one of code rates r of 2/16, 3/16, 4/16, 5/16, 6/16, 7/16, 8/16, 9/16, 10/16, 11/16, 12/16, 13/16, and 14/16 as will be described below, for example.

In a case of LDPC encoding for encoding into new LDPC codes having a code length N of 17280 bits, the storage unit 602 of the LDPC encoder 115 (FIG. 8) stores a check matrix initial value table for new LDPC codes.

FIG. 30 is a diagram illustrating an example of a check matrix initial value table (for the type A system) indicating a check matrix H for a type A code (hereinafter also referred to as a type A code of r = 2/16) as a new LDPC code having a code length N of 17280 bits and a code rate r of 2/16.

FIG. 31 is a diagram illustrating an example of a check matrix initial value table indicating a check matrix H for a type A code (hereinafter also referred to as a type A code of r = 3/16) as a new LDPC code having a code length N of 17280 bits and a code rate r of 3/16.

FIG. 32 is a diagram illustrating an example of a check matrix initial value table indicating a check matrix H for a type A code (hereinafter also referred to as a type A code of r = 4/16) as a new LDPC code having a code length N of 17280 bits and a code rate r of 4/16.

FIG. 33 is a diagram illustrating an example of a check matrix initial value table indicating a check matrix H for a type A code (hereinafter also referred to as a type A code of r = 5/16) as a new LDPC code having a code length N of 17280 bits and a code rate r of 5/16.

FIG. 34 is a diagram illustrating an example of a check matrix initial value table indicating a check matrix H for a type A code (hereinafter also referred to as a type A code of r = 6/16) as a new LDPC code having a code length N of 17280 bits and a code rate r of 6/16.

FIG. 35 is a diagram illustrating an example of a check matrix initial value table indicating a check matrix H for a type A code (hereinafter also referred to as a type A code of r = 7/16) as a new LDPC code having a code length N of 17280 bits and a code rate r of 7/16.

FIG. 36 is a diagram illustrating an example of a check matrix initial value table (for the type B system) indicating a check matrix H for a type B code (hereinafter also referred to as a type B code of r = 7/16) as a new LDPC code having a code length N of 17280 bits and a code rate r of 7/16.

FIG. 37 is a diagram illustrating an example of a check matrix initial value table indicating a check matrix H for a type B code (hereinafter also referred to as a type B code of r = 8/16) as a new LDPC code having a code length N of 17280 bits and a code rate r of 8/16.

FIG. 38 is a diagram illustrating an example of a check matrix initial value table indicating a check matrix H for a type B code (hereinafter also referred to as a type B code of r = 9/16) as a new LDPC code having a code length N of 17280 bits and a code rate r of 9/16.

FIG. 39 is a diagram illustrating an example of a check matrix initial value table indicating a check matrix H for a type B code (hereinafter also referred to as a type B code of r = 10/16) as a new LDPC code having a code length N of 17280 bits and a code rate r of 10/16.

FIG. 40 is a diagram illustrating an example of a check matrix initial value table indicating a check matrix H for a type B code (hereinafter also referred to as a type B code of r = 11/16) as a new LDPC code having a code length N of 17280 bits and a code rate r of 11/16.

FIG. 41 is a diagram illustrating an example of a check matrix initial value table indicating a check matrix H for a type B code (hereinafter also referred to as a type B code of r = 12/16) as a new LDPC code having a code length N of 17280 bits and a code rate r of 12/16.

FIG. 42 is a diagram illustrating an example of a check matrix initial value table indicating a check matrix H for a type B code (hereinafter also referred to as a type B code of r = 13/16) as a new LDPC code having a code length N of 17280 bits and a code rate r of 13/16.

FIG. 43 is a diagram illustrating an example of a check matrix initial value table indicating a check matrix H for a type B code (hereinafter also referred to as a type B code of r = 14/16) as a new LDPC code having a code length N of 17280 bits and a code rate r of 14/16.

The new LDPC codes are high-performance LDPC codes.

Note herein that the high-performance LDPC codes are LDPC codes obtained from an appropriate check matrix H.

For example, the appropriate check matrix H is a check matrix which meets predetermined conditions and reduces a BER (bit error rate) (and an FER (frame error rate)) at the time of transmission of LDPC codes obtained from the check matrix H at low $E_s/N_0$ or $E_b/N_0$ (a ratio of signal power to noise power per bit).

For example, the appropriate check matrix H is derivable from simulation which measures a BER available at the time of transmission, at low $E_s/N_0$, of LDPC codes obtained from various check matrixes each meeting the predetermined conditions.

Examples of the predetermined conditions to be met by the appropriate check matrix H include a preferable analysis result obtained by a code performance analysis method called density evolution, absence of a loop of elements 1 called cycle 4, and others.

It is known herein that LDPC code decoding performance deteriorates if elements 1 are dense in an information matrix $H_A$ like cycle 4. Accordingly, it is preferable that cycle 4 be absent in the check matrix H.

A minimum value of a length of a loop (loop length) constituted by elements 1 in the check matrix H is called girth. The absence of cycle 4 indicates that girth is larger than 4.

Note that the predetermined conditions to be met by the appropriate check matrix H can appropriately be determined from such viewpoints as improvement of LDPC code decoding performance and facilitation (simplification) of a decoding process for LDPC codes.

FIGS. 44 and 45 are diagrams explaining density evolution for obtaining an analysis result corresponding to the predetermined conditions to be met by the appropriate check matrix H.

Density evolution is a code analysis method which calculates an expected value of an error probability for an entire LDPC code (ensemble) that has a code length N of $\infty$ and that is characterized by a degree sequence (degree sequence) described below.

For example, with a rapid increase in a variance value of noise from 0 in an AWGN channel, an expected value of an error probability of a certain ensemble, which has been initially 0, becomes a value other than 0 when the variance value of noise reaches a certain threshold or higher.

Density evolution can determine whether or not an ensemble has high performance (appropriateness of check matrix) by comparing a threshold of a variance value of noise at which an expected value of an error probability of this ensemble becomes a value other than 0 (hereinafter also referred to as a performance threshold).

Note that rough performance of a specific LDPC code can be predicted by determining an ensemble to which the LDPC code belongs and applying density evolution to this ensemble.

Accordingly, for obtaining a high-performance LDPC code, a high-performance ensemble is identified to search for the corresponding LDPC code from LDPC codes belonging to this ensemble.

Note herein that the degree sequence described above represents ratios of variable nodes and check nodes having weights of respective values to a code length N of an LDPC code.

For example, a regular (3,6) LDPC code having a code rate of 1/2 belongs to an ensemble characterized by a degree sequence having a weight of 3 for all variable nodes (column weight) and a weight of 6 for all check nodes (row weight).

FIG. 44 illustrates a Tanner graph of such an ensemble.

The Tanner graph in FIG. 44 includes the same number of variable nodes as the code length N, i.e., N variable nodes indicated by circles (circular marks) in the figure, and the same number of check nodes as a value calculated by multiplying the code length N by the code rate of 1/2, i.e., N/2 check nodes indicated by squares (square marks) in the figure.

The same number of edges as a column weight, i.e., three edges, are connected to each of the variable nodes. Accordingly, 3N edges in total are connected to the N variable nodes.

Moreover, the same number of edges as a row weight, i.e., six edges, are connected to each of the check nodes. Accordingly, 3N edges in total are connected to the N/2 check nodes.

Moreover, the Tanner graph in FIG. 44 includes one interleaver.

The interleaver randomly rearranges the 3N edges connected to the N variable nodes, and connects each of the rearranged edges to any one of the 3N edges connected to the N/2 check nodes.

There are (3N)! (= (3N) × (3N - 1) · · · × 1) rearrangement patterns for rearranging, by the interleaver, the 3N edges connected to the N variable nodes. Accordingly, an ensemble characterized by such a degree sequence that a weight of 3 is given to all variable nodes and that a weight of 6 is given to all check nodes is a set of (3N)! LDPC codes.

A simulation which obtains a high-performance LDPC code (appropriate check matrix) uses a multi-edge type ensemble in density evolution.

According to the multi-edge type, an interleaver through which edges connected to variable nodes and edges connected to check nodes pass is divided into multiple parts (multi edges). In this manner, characterization of the ensemble is more precisely achieved.

FIG. 45 illustrates an example of a Tanner graph of a multi-edge type ensemble.

The Tanner graph in FIG. 45 includes two interleavers, i.e., a first interleaver and a second interleaver.

Moreover, the Tanner graph in FIG. 45 includes v1 variable nodes each having one edge connected to the first interleaver and no edge connected to the second interleaver, v2 variable nodes each having one edge connected to the first interleaver and two edges connected to the second interleaver, and v3 variable nodes each having no edge connected to the first interleaver and two edges connected to the second interleaver.

Further, the Tanner graph in FIG. 45 includes c1 check nodes each having two edges connected to the first interleaver and no edge connected to the second interleaver, c2 check nodes each having two edges connected to the first interleaver and two edges connected to the second interleaver, and c3 check nodes each having no edge connected to the first interleaver and three edges connected to the second interleaver.

Note herein that density evolution and implementation thereof are described in "On the Design of Low-Density Parity-Check Codes within 0.0045 dB of the Shannon Limit," S. Y. Chung, G. D. Forney, T. J. Richardson, R. Urbanke, IEEE Communications Leggers, VOL. 5, NO. 2, Feb 2001, for example.

In the simulation for obtaining a new LDPC code (check matrix thereof), an ensemble having a predetermined value of a performance threshold or lower, which threshold is $E_b/N_0$ (a ratio of signal power to noise power per bit) at which a BER starts lowering (decreasing), was identified by multi-edge type density evolution, and an LDPC code reducing a BER obtained in a case of use of one or more quadrature modulations, such as QPSK, was selected from LDPC codes belonging to the identified ensemble, and designated as a high-performance LDPC code.

The new LDPC code (a check matrix initial value table indicating a check matrix for the new LDPC code) was obtained by the foregoing simulation.

Accordingly, preferable communication quality in data transfer is reliably achievable by use of the new LDPC code.

FIG. 46 is a diagram explaining a column weight of a check matrix H for a type A code as a new LDPC code.

As illustrated in FIG. 46, for the check matrix H for the type A code, it is assumed that a column weight for K1 columns from the first column in the A matrix and the C matrix is expressed as X1, that a column weight for subsequent K2 columns of the A matrix and the C matrix is expressed as X2, that a column weight for further subsequent K3 columns of the A matrix and the C matrix is expressed as X3, and that a column weight for further subsequent M1 columns of the C matrix is expressed as XM1.

Note that (K1 + K2 + K3) is equivalent to an information length K, while (M1 + M2) is equivalent to a parity length M. Accordingly, (K1 + K2 + K3 + M1 + M2) is equivalent to a code length N = 17280 bits.

Moreover, for the check matrix H for the type A code, a column weight for the (M1 - 1) columns from the first column in the B matrix is 2, while a column weight for the M1th column (final column) in the B matrix is 1. Further, a column weight for the D matrix is 1, while a column weight for the Z matrix is 0.

FIG. 47 is a diagram illustrating parameters of the check matrixes H for type A codes (indicated by the check matrix initial value tables) in FIGS. 30 to 35.

FIG. 47 illustrates K, X1, K1, X2, K2, X3, K3, XM1, M1, and M2 as parameters of the check matrixes H for the type A codes having r of 2/16, 3/16, 4/16, 5/16, 6/16, and 7/16.

The parameters K, X1, K1, X2, K2, X3, K3, XM1, and M1 (or M2) are set to such values at which further improvement of performance (e.g., error rate, etc.) of LDPC codes is achievable.

FIG. 48 is a diagram explaining column weights of a check matrix H for a type B code as a new LDPC code.

As illustrated in FIG. 48, for the check matrix H for the type B code, it is assumed that a column weight for KX1 columns from the first column is expressed as X1, that a column weight for subsequent KX2 columns is expressed as X2, that a column weight for further subsequent KX3 columns is expressed as X3, that a column weight for further subsequent KX4 columns is expressed as X4, and that a column weight for further subsequent KY1 columns is expressed as Y1.

Note that (KX1 + KX2 + KX3 + KX4 + KY1) is equivalent to an information length K, while (KX1 + KX2 + KX3 + KX4 + KY1 + M) is equivalent to a code length N = 17280 bits.

Moreover, for the check matrix H for the type B code, a column weight for the (M - 1) columns in the final M columns except for the final one column is 2, while a column weight for the final one column is 1.

FIG. 49 is a diagram illustrating parameters of the check matrixes H for type B codes (indicated by the check matrix initial value tables) in FIGS. 36 to 43.

FIG. 49 illustrates K, X1, KX1, X2, KX2, X3, KX3, X4, KX4, Y1, KY1, and M as parameters of the check matrixes H for the type B codes having r of 7/16, 8/16, 9/16, 10/16, 11/16, 12/16, 13/16, and 14/16.

The parameters X1, KX1, X2, KX2, X3, KX3, X4, KX4, Y1, and KY1 are set to such values at which further improvement of performance of LDPC codes is achievable.

New LDPC codes achieve preferable BER/FER, and also provide a capacity (communication path capacity) close to the Shannon limit.

FIGS. 50 to 53 are diagrams explaining different examples of new LDPC codes.

Specifically, FIG. 50 is a diagram illustrating an example of a check matrix initial value table indicating a check matrix H for type A codes (hereinafter also referred to as new type A codes of r = 4/16) as new LDPC codes having a code length N of 17280 bits and a code rate r of 4/16, provided by Japan Broadcasting Corporation.

FIG. 51 is a diagram illustrating parameters of a check matrix H for the new type A code having r = 7/16, provided by Japan Broadcasting Corporation.

Parameters K, X1, K1, X2, K2, X3, K3, XM1, M1, and M2 are the parameters described in FIG. 46, and the parameters K, X1, K1, X2, K2, X3, K3, XM1, M1, and M2 of the check matrix H for the new type A code having r = 4/16 are as described in FIG. 51.

FIG. 52 is a diagram illustrating an example of a check matrix initial value table indicating a check matrix H for type B codes (hereinafter also referred to as new type B codes of r = 9/16) as new LDPC codes having a code length N of 17280 bits and a code rate r of 4/16, provided by Japan Broadcasting Corporation.

FIG. 53 is a diagram illustrating parameters of a check matrix H for the new type B code having r = 9/16, provided by Japan Broadcasting Corporation.

Parameters K, X1, KX1, X2, KX2, X3, KX3, X4, KX4, Y1, KY1, and M are the parameters described in FIG. 48, and the parameters K, X1, KX1, X2, KX2, X3, KX3, X4, KX4, Y1, KY1, and M of the check matrix H for the new type B code having r = 9/16 are as described in FIG. 53.

<Constellation>

FIGS. 54 to 78 are diagrams illustrating examples of constellations adoptable by the transfer system in FIG. 7.

For example, the transfer system in FIG. 7 can set a constellation adopted for a MODCOD which is a combination of a modulation system (MODulation) and an LDPC code (CODe).

One or more constellations can be set for one MODCOD.

Constellations are classified into UCs (Uniform Constellations) where signal points are uniformly arranged and NUCs (Non Uniform Constellations) where signal points are not uniformly arranged.

Moreover, for example, NUCs include constellations called 1D-NUCs (1-dimensional ($M^2$-QAM) non-uniform constellations), constellations called 2D-NUC (2-dimensional QQAM) non-uniform constellations), and others.

In general, a 1D-NUC more improves a BER than a UC, and a 2D-NUC more improves a BER than a 1D-NUC.

A constellation formed by QPSK as a modulation system is a UC. For example, a UC or a 2D-NUD is adoptable as a constellation formed by 16QAM, 64QAM, 256QAM, or the like as a modulation system. For example, a UC or a 1D-NUD is adoptable as a constellation formed by 1024QAM, 4096QAM, or the like as a modulation system.

For the transfer system in FIG. 7, a constellation specified by ATSC3.0, DVB-C.2, or the like, or various other constellations improving an error rate are available, for example.

Specifically, in a case where QPSK is adopted as a modulation system, an identical UC is available for respective code rates r of LDPC codes, for example.

Moreover, in a case where 16QAM, 64QAM, or 256QAM is adopted as a modulation system, an identical UC is available for respective code rates r of LDPC codes, for example. In addition, in a case where 16QAM, 64QAM, or 256QAM is adopted as a modulation system, a different 2D-NUC can be used for each of code rates r of LDPC codes, for example.

Further, in a case where 1024QAM or 4096QAM is adopted as a modulation system, an identical UC is available for respective code rates r of LDPC codes, for example. In addition, in a case where 1024QAM or 4096QAM is adopted as a modulation system, a different 1D-NUC code can be used for each of code rates r of respective LDPC codes, for example.

Here, a UC corresponding to QPSK is also expressed as a QPSK-UC, and a UC corresponding to $2^m$QAM is also expressed as a $2^m$QAM-UC. Moreover, a 1D-NUC and a 2D-NUC corresponding to $2^m$QAM are also expressed as a $2^m$QAM-1D-NUC and a $2^m$QAM-2D-NUC, respectively.

Several constellations specified by ATSC3.0 will hereinafter be explained.

FIG. 54 is a diagram illustrating coordinates of signal points of a QPSK-UC used for all code rates of LDPC codes specified by ATSC3.0 in a case where QPSK is adopted as a modulation system.

In FIG. 54, "Input Data cell y" represents a two-bit symbol mapped to the QPSK-UC, while "Constellation point $z_s$" represents a coordinate of a signal point $Z_s$. Note that an index s of the signal point $z_s$ represents a discrete time between symbols (a time interval between a certain symbol and a subsequent symbol) (this applies to an index q of a signal point $z_q$ described below).

In FIG. 54, the coordinate of the signal point $z_s$ is expressed in the form of a complex number, while j represents an imaginary number unit ($\sqrt{(-1)}$).

FIG. 55 is a diagram illustrating coordinates of signal points of 16QAM-2D-NUCs used for code rates r(CR) = 2/15, 3/15, 4/15, 5/15, 6/15, 7/15, 8/15, 9/15, 10/15, 11/15, 12,15, and 13/15 of LDPC codes specified by ATSC3.0 in a case where 16QAM is adopted as a modulation system.

In FIG. 55, the coordinate of the signal point $z_s$ is expressed in the form of a complex number, while j represents an imaginary number unit, as in FIG. 54.

In FIG. 55, w#k represents a coordinate of a signal point in a first quadrant of the constellation.

In the 2D-NUC, a signal point in a second quadrant of the constellation is located at a position corresponding to the symmetrically shifted position of the signal point in the first quadrant with respect to a Q-axis, while a signal point in a third quadrant of the constellation is located at a position corresponding to the symmetrically shifted position of the signal point in the first quadrant with respect to the origin. In addition, a signal point in a fourth quadrant of the constellation is located at a position corresponding to the symmetrically shifted position of the signal point in the first quadrant with respect to an I-axis.

Here, in a case where $2^m$QAM is adopted as a modulation system, one m-bit symbol is mapped at a signal point corresponding to this symbol.

For example, the m-bit symbol can be expressed as an integer value ranging from 0 to $2^m - 1$, for example. Assuming herein that b is equal to $2^m/4$, symbols y(0), y(1), and up to y($2^m - 1$) represented as integer values ranging from 0 to $2^m - 1$ can be classified into four types, i.e., symbols y(0) to y(b - 1), y(b) to y (2b - 1), y(2b) to y(3b - 1), and y(3b) to y(4b - 1).

In FIG. 55, a suffix k of w#k has an integer value ranging from 0 to (b - 1), while w#k represents a coordinate of a signal point corresponding to a symbol y(k) ranging from symbols y(0) to y(b - 1).

In addition, a coordinate of a signal point corresponding to a symbol y(k + b) ranging from symbols y(b) to y(2b - 1) is expressed as -conj(w#k), while a coordinate of a signal point corresponding to a symbol y(k + 2b) ranging from symbols y(2b) to y(3b - 1) is expressed as conj (w#k). Moreover, a coordinate of a signal point corresponding to a symbol y(k + 3b) ranging from symbols y(3b) to y(4b - 1) is expressed as -w#k.

In this case, conj(w#k) represents a complex conjugate of w#k.

For example, in a case where 16QAM is adopted as a modulation system, b is set to $2^4/4 = 4$, and m = 4-bit symbols y(0), y(1), and up to y(15) are classified into four groups, i.e., symbols y(0) to y(3), y(4) to y(7), y(8) to y(11), and y(12) to y(15).

In addition, the symbol y(12) included in the symbols y(0) to y(15), for example, is a symbol y(k + 3b) = y(0 + 3 × 4) in a range of symbols y(3b) to y(4b - 1), and k is equal to 0. Accordingly, a coordinate of a signal point corresponding to the symbol y(12) is -w#k = -w0.

Assuming herein that the code rate r(CR) of the LDPC code is 9/15, for example, w0 for the modulation system of 16QAM and the code rate r of 9/15 is 0.2386 + j0.5296. Accordingly, -w0 as the coordinate of the signal point corresponding to the symbol y(12) is -(0.2386 + j0.5296) according to FIG. 55.

FIG. 56 is a diagram illustrating an example of coordinates of signal points of 1024QAM-1D-NUCs used for code rates r(CR) = 2/15, 3/15, 4/15, 5/15, 6/15, 7/15, 8/15, 9/15, 10/15, 11/15, 12,15, and 13/15 of LDPC codes specified by ATSC3.0 in a case where 1024QAM is adopted as a modulation system.

In FIG. 56, u#k represents a real part $Re(z_s)$ and an imaginary part $Im(z_s)$ of a complex number as a coordinate of a signal point $Z_s$ of a 1D-NUC, and is a component of a vector u = (u0, u1, and up to u#V - 1) called a position vector. A number V of the component u#k of the position vector u is calculated on the basis of an equation V = $\sqrt{(2^m)}/2$.

FIG. 57 is a diagram illustrating a relation between the symbol y of 1024QAM and the position vector u (component u#k thereof).

It is assumed herein that a 10-bit symbol y of 1024QAM is expressed as $y_{0,s}$, $y_{1,s}$, $y_{2,s}$, $y_{3,s}$, $y_{4,s}$, $y_{5,s}$, $y_{6,s}$, $y_{7,s}$, $y_{8,s}$, and $y_{9,s}$ from the head bit (highest-order bit) of the symbol y.

A of FIG. 57 illustrates a correlation between the even-numbered 5 bits $y_{1,s}$, $y_{3,s}$, $y_{5,s}$, $y_{7,s}$, and $y_{9,s}$ of the symbol y and u#k representing the real part $Re(z_s)$ of the signal point $z_s$ (the coordinate thereof) corresponding to this symbol y.

B of FIG. 57 illustrates a correlation between the odd-numbered 5 bits $y_{0,s}$, $y_{2,s}$, $y_{4,s}$, $y_{6,s}$, and $y_{8,s}$ of the symbol y and u#k representing the imaginary part $Im(z_s)$ of the signal point $z_s$ corresponding to this symbol y.

For example, in a case where the 10-bit symbol y = ($y_{0,s}$, $y_{1,s}$, $y_{2,s}$, $y_{3,s}$, $y_{4,s}$, $y_{5,s}$, $y_{8,s}$, $y_{7,s}$, $y_{8,s}$, and $y_{9,s}$) of 1024QAM is (0,0,1,0,0,1,1,1,0,0), the odd-numbered 5 bits ($y_{0,s}$, $y_{2,s}$, $y_{4,s}$, $y_{6,s}$, and $y_{8,s}$) are (0,1,0,1,0), while the even-numbered 5 bits ($y_{1,s}$, $y_{3,s}$, $y_{5,s}$, $y_{7,s}$, and $y_{9,s}$) are (0,0,1,1,0).

In A of FIG. 57, the even-numbered 5 bits (0,0,1,1,0) are associated with u11. Accordingly, the real part $Re(z_s)$ of the signal point $z_s$ corresponding to the symbol y = (0,0,1,0,0,1,1,1,0,0) is u11.

In B of FIG. 57, the odd-numbered 5 bits (0,1,0,1,0) are associated with u3. Accordingly, the imaginary part $Im(z_s)$ of the signal point $z_s$ corresponding to the symbol y = (0,0,1,0,0,1,1,1,0,0) is u3.

Meanwhile, assuming that the code rate r of the LDPC code is 6/15, for example, u3 is 0.1295 and u11 is 0.7196 for the 1D-NUC used for the modulation system of 1024QAM and the code rate r(CR) of 6/15 for the LDPC code, according to FIG. 56 described above.

Accordingly, the real part $Re(z_s)$ of the signal point $z_s$ corresponding to the symbol y = (0,0,1,0,0,1,1,1,0,0) is u11 = 0.7196, while the imaginary part $Im(z_s)$ is u3 = 0.1295. As a result, the coordinate of the signal point $z_s$ corresponding to

the symbol y = (0,0,1,0,0,1,1,1,0,0) is expressed as 0.7196 + j0.1295.

Note that signal points of a 1D-NUC are arranged in a grid shape on a straight line parallel with the I-axis or a straight line parallel with the Q-axis in a constellation. However, intervals between the signals are not uniform. Moreover, for transmission of signal points (data mapped at the signal points), average power of signal points on a constellation can be normalized. Assuming that a mean squared value of absolute values of all signal points (coordinates thereof) on a constellation is expressed as $P_{ave}$, normalization can be achieved by multiplying a reciprocal $1/(\sqrt{P_{ave}})$ of a square root $\sqrt{P_{ave}}$ of this mean squared value $P_{ave}$ by the respective signal points $z_s$ on the constellation.

The foregoing constellations specified by ATSC3.0 are available for the transfer system in FIG. 7.

FIGS. 58 to 69 are diagrams illustrating coordinates of signal points of UCs specified by DVB-C.2.

Specifically, FIG. 58 is a diagram illustrating a real part $Re(z_q)$ of a coordinate $z_q$ of a signal point of a QPSK-UC (UC of QPSK) specified by DVB-C.2. FIG. 59 is a diagram illustrating an imaginary part $Im(z_q)$ of the coordinate $z_q$ of the signal point of the QPSK-UC specified by DVB-C.2.

FIG. 60 is a diagram illustrating a real part $Re(z_q)$ of a coordinate $z_q$ of a signal point of a 16QAM-UC (UC of 16QAM) specified by DVB-C.2. FIG. 61 is a diagram illustrating an imaginary part $Im(z_q)$ of the coordinate $z_q$ of the signal point of the 16QAM-UC specified by DVB-C.2.

FIG. 62 is a diagram illustrating a real part $Re(z_q)$ of a coordinate $z_q$ of a signal point of a 64QAM-UC (UC of 64QAM) specified by DVB-C.2. FIG. 63 is a diagram illustrating an imaginary part $Im(z_q)$ of the coordinate $z_q$ of the signal point of the 64QAM-UC specified by DVB-C.2.

FIG. 64 is a diagram illustrating a real part $Re(z_q)$ of a coordinate $z_q$ of a signal point of a 256QAM-UC (UC of 256QAM) specified by DVB-C.2. FIG. 65 is a diagram illustrating an imaginary part $Im(z_q)$ of the coordinate $z_q$ of the signal point of the 256QAM-UC specified by DVB-C.2.

FIG. 66 is a diagram illustrating a real part $Re(z_q)$ of a coordinate $z_q$ of a signal point of a 1024QAM-UC (UC of 1024QAM) specified by DVB-C.2. FIG. 67 is a diagram illustrating an imaginary part $Im(z_q)$ of the coordinate $z_q$ of the signal point of the 1024QAM-UC specified by DVB-C.2.

FIG. 68 is a diagram illustrating a real part $Re(z_q)$ of a coordinate $z_q$ of a signal point of a 4096QAM-UC (UC of 4096QAM) specified by DVB-C.2. FIG. 69 is a diagram illustrating an imaginary part $Im(z_q)$ of the coordinate $z_q$ of the signal point of the 4096QAM-UC specified by DVB-C.2.

Note that $y_{i,q}$ in FIGS. 58 to 69 represents the head to the (i + 1)th bit of an m-bit symbol (e.g., 2 bits in QPSK) of $2^m$QAM. Moreover, for transmission of signal points (data mapped at the signal points) of the UC, average power of the signal points on the constellation can be normalized. Assuming that a mean squared value of absolute values of all signal points (coordinates thereof) on the constellation is expressed as $P_{ave}$, normalization can be achieved by multiplying a reciprocal $1/(\sqrt{P_{ave}})$ of a square root $\sqrt{P_{ave}}$ of this mean squared value $P_{ave}$ by the respective signal points $z_q$ on the constellation.

The foregoing UCs specified by DVB-C.2 are available for the transfer system in FIG. 7.

Specifically, the UCs illustrated in FIGS. 58 to 69 are available for the respective new LDPC codes (corresponding to check matrix initial value tables) having the code length N of 17280 bits and the code rate r of 2/16, 3/16, 4/16, 5/16, 6/16, 7/16, 8/16, 9/16, 10/16, 11/16, 12/16, 13/16, and 14/16 illustrated in FIGS. 30 to 43, 50, and 52.

FIGS. 70 to 78 illustrate examples of coordinates of signal points of NUCs available for the respective new LDPC codes having the code length N of 17280 bits and the code rate r of 2/16, 3/16, 4/16, 5/16, 6/16, 7/16, 8/16, 9/16, 10/16, 11/16, 12/16, 13/16, and 14/16 illustrated in FIGS. 30 to 43, 50, and 52.

Specifically, FIG. 70 is a diagram illustrating an example of coordinates of signal points of 16QAM-2D-NUCs available for new LDPC codes.

FIG. 71 is a diagram illustrating an example of coordinates of signal points of 64QAM-2D-NUCs available for new LDPC codes.

Each of FIGS. 72 and 73 is a diagram illustrating an example of coordinates of signal points of 256AM-2D-NUCs available for new LDPC codes.

Note that FIG. 73 is a diagram continuing from FIG. 72.

In FIGS. 70 to 73, a coordinate of a signal point $z_s$ is expressed in the form of a complex number, while j represents an imaginary number unit, as in FIG. 55.

In FIGS. 70 to 73, w#k represents a coordinate of a signal point in a first quadrant of a constellation, as in FIG. 55.

As explained with reference to FIG. 55, assuming that an m-bit symbol herein is expressed as an integer value ranging from 0 to $2^m - 1$, and that b is equal to $2^m/4$, symbols y(0), y(1), and up to y($2^m - 1$) expressed as integer values ranging from 0 to $2^m - 1$ can be classified into four types, i.e., symbols y(0) to y(b - 1), y(b) to y (2b - 1), y(2b) to y(3b - 1), and y(3b) to y(4b - 1).

In FIGS. 70 to 73, a suffix k of w#k has an integer value ranging from 0 to (b - 1), while w#k represents a coordinate of a signal point corresponding to a symbol y(k) ranging from symbols y(0) to y(b - 1), as in FIG. 55.

Moreover, in FIGS. 70 to 73, a coordinate of a signal point corresponding to a symbol y(k + 3b) ranging from symbols y(3b) to y(4b - 1) is expressed as -w#k, as in FIG. 55.

However, while FIG. 55 indicates a coordinate of a signal point corresponding to a symbol y(k + b) ranging from symbols y(b) to y(2b - 1) as -conj(w#k) and a coordinate of a signal point corresponding to a symbol y(k + 2b) ranging from symbols y(2b) to y(3b - 1) as conj(w#k), FIGS. 70 to 73 each indicate the opposite sign of each conj.

Specifically, in FIGS. 70 to 73, a coordinate of a signal point corresponding to a symbol y(k + b) ranging from symbols y(b) to y(2b - 1) is expressed as conj(w#k), while a coordinate of a signal point corresponding to a symbol y(k + 2b) ranging from symbols y(2b) to y(3b - 1) is expressed as -conj(w#k).

FIG. 74 is a diagram illustrating an example of coordinates of signal points of 1024QAM-1D-NUCs available for new LDPC codes.

Specifically, FIG. 74 is a diagram illustrating a relation between a real part $Re(z_s)$ as well as an imaginary part $Im(z_s)$ of a complex number as a coordinate of a signal point $z_s$ of a 1024QAM-1D-NUC and a position vector u (a component u#k thereof).

FIG. 75 is a diagram illustrating a relation between a symbol y of 1024QAM and the position vector u (component u#k thereof) in FIG. 74.

Specifically, it is assumed herein that the 10-bit symbol y of 1024QAM is expressed as $y_{0,s}$, $y_{1,s}$, $y_{2,s}$, $y_{3,s}$, $y_{4,s}$, $y_{5,s}$, $y_{6,s}$, $y_{7,3}$, $y_{8,s}$, and $y_{9,s}$ from the head bit (highest-order bit) of the symbol y.

A of FIG. 75 illustrates a correlation between the odd-numbered 5 bits $y_{0,s}$, $y_{2,s}$, $y_{4,s}$, $y_{2,3}$, and $y_{8,s}$ of the 10-bit symbol y (from the head) and a position vector u#k representing a real part $Re(z_s)$ of a signal point $z_s$ (the coordinate thereof) corresponding to this symbol y.

B of FIG. 75 illustrates a correlation between the even-numbered 5 bits $y_{1,s}$, $y_{3,s}$, $Y_{5,s}$, $y_{7,s}$, and $y_{9,s}$ of the 10-bit symbol y and the position vector u#k representing the imaginary part $Im(z_s)$ of the signal point $z_s$ corresponding to this symbol y.

The coordinate of the signal point $z_s$ when the 10-bit symbol y of 1024QAM is mapped at the signal point $z_s$ of the 1024QAM-1D-NUC specified in FIGS. 74 and 75 is obtained in a manner similar to the manner described with reference to FIGS. 56 and 57. Accordingly, explanation of this method is omitted.

FIG. 76 is a diagram illustrating an example of coordinates of signal points of 4096QAM-1D-NUCs available for new LDPC codes.

Specifically, FIG. 76 is a diagram illustrating a relation between a real part $Re(z_s)$ as well as an imaginary part $Im(z_s)$ of a complex number as a coordinate of a signal point $z_s$ of a 4096QAM-1D-NUC and a position vector u (u#k).

FIGS. 77 and 78 are each a diagram illustrating a relation between a symbol y of 4096QAM and a position vector u (component u#k thereof) in FIG. 76.

Specifically, it is assumed herein that a 12-bit symbol y of 4096QAM is expressed as $y_{0,s}$, $y_{1,s}$, $y_{2,s}$, $y_{3,s}$, $y_{4,s}$, $y_{5,s}$, $y_{6,s}$, $y_{7,s}$, $y_{8,s}$, $y_{9,s}$, $y_{10,s}$, and $y_{11,s}$ from the head bit (highest-order bit) of the symbol y.

FIG. 77 illustrates a correlation between the odd-numbered 6 bits $y_{0,s}$, $y_{2,s}$, $y_{4,s}$, $y_{6,s}$, $y_{8,s}$, and $y_{10,s}$ of the 12-bit symbol y and the position vector u#k representing the real part $Re(z_s)$ of the signal point $z_s$ corresponding to this symbol y.

FIG. 78 illustrates a correlation between the even-numbered 6 bits $y_{1,s}$, $y_{3,s}$, $y_{5,s}$, $y_{7,s}$, $y_{9,s}$, and $y_{11,s}$ of the 12-bit symbol y and the position vector u#k representing the imaginary part $Im(z_s)$ of the signal point $z_s$ corresponding to this symbol y.

The coordinate of the signal point $z_s$ when the 12-bit symbol y of 4096QAM is mapped at the signal point $z_s$ of the 4096QAM-1D-NUC specified in FIGS. 76 to 78 is obtained in a manner similar to the manner described with reference to FIGS. 56 and 57. Accordingly, explanation of this method is omitted.

In addition, for transmission of signal points (data mapped at the signal points) of the NUCs in FIGS. 70 to 78, average power of the signal points on the constellation can be normalized. Assuming that a mean squared value of absolute values of all signal points (coordinates thereof) on the constellation is expressed as $P_{ave}$, normalization can be achieved by multiplying a reciprocal $1/(\sqrt{P_{ave}})$ of a square root $\sqrt{P_{ave}}$ of this mean squared value $P_{ave}$ by the respective signal points $z_s$ on the constellation. Moreover, in FIG. 57 described above, the odd-numbered bits of the symbol y are associated with the position vector u#k representing the imaginary part $Im(z_s)$ of the signal point $z_s$, while the even-numbered bits of the symbol y are associated with the position vector u#k representing the real part $Re(z_s)$ of the signal point $z_s$. Conversely, in FIG. 75 and FIGS. 77 and 78, the odd-numbered bits of the symbol y are associated with the position vector u#k representing the real part $Re(z_s)$ of the signal point $z_s$, while the even-numbered bits of the symbol y are associated with the position vector u#k representing the imaginary part $Im(z_s)$ of the signal point $z_s$.

<Block interleaver 25>

FIG. 79 is a diagram explaining block interleaving performed by the block interleaver 25 in FIG. 9.

Block interleaving for an LDPC code of one code word is performed separately for a portion called a part 1 and for a part called a part 2 from the head of the LDPC code.

Assuming that a length (number of bits) of the part 1 is expressed as Npart 1, and that a length of the part 2 is expressed Npart 2, (Npart 1 + Npart 2) is equivalent to a code length N.

Conceptually, block interleaving arranges the same number m of columns which are storage regions for storing Npart1/m bits as the number of bits m of a symbol in a row direction perpendicular to a column (vertical) direction as one direction, and divides the respective columns into small units of 360 bits as a parallel factor P from the top. These small units of columns are also referred to as column units.

As illustrated in FIG. 79, in the block interleaving, writing of the part 1 of the LDPC code of one code word to the first column unit of the columns downward from the top (column direction) is performed for the columns from the left to the right.

Thereafter, at the time of completion of writing to the first column unit at the right end column, writing returns to the left end column as illustrated in FIG. 79, and writing to the second column unit of the column downward from the top is performed for the columns from the left to the right. In a similar manner, the following writing of the part 1 of the LDPC code of one code word is achieved.

At the time of completion of writing of the part 1 of the LDPC code of one code word, the part 1 of the LDPC code is read in units of m bits in the row direction from the first columns of all the m columns as illustrated in FIG. 79.

These units of m bits of the part 1 are supplied from the block interleaver 25 to the mapper 117 (FIG. 8) as m-bit symbols.

Reading of the part 1 in units of m bits is sequentially performed for the lower rows of the m columns. When reading of the part 1 is completed, the part 2 is divided into units of m bits from the head, and supplied from the block interleaver 25 to the mapper 117 as m-bit symbols.

Accordingly, the part 1 is symbolized while undergoing interleaving, but the part 2 is sequentially divided into units of m bits and symbolized without undergoing interleaving.

Npart1/m as the length of each column is a multiple of 360 corresponding to a parallel factor P. The LDPC code of one code word is divided into the part 1 and the part 2 such that Npart1/m becomes a multiple of 360 as noted herein.

FIG. 80 is a diagram illustrating an example of a part 1 and a part 2 of an LDPC code having a code length N of 17280 bits in a case where QPSK, 16QAM, 64QAM, and 256QAM are adopted as a modulation system.

In a case where QPSK, 16QAM, 64QAM, and 256QAM are adopted as a modulation system, the part 1 has 17280 bits, and the part 2 has 0 bits in each of the modulation system.

<Groupwise interleaving>

FIG. 81 is a diagram explaining groupwise interleaving performed by the groupwise interleaver 24 in FIG. 9.

In the groupwise interleaving, as illustrated in FIG. 81, an LDPC code of one code word is interleaved according to a predetermined pattern (hereinafter also referred to as a GW pattern) in units of a bit group having 360 bits of one division formed by dividing the LDPC code of one code word by units of 360 bits equivalent to a parallel factor P from the head of the LDPC code.

Note herein that the head bit group to the (i + 1)th bit group formed by dividing the LDPC code of one code word into bit groups will hereinafter also be referred to as a bit group i.

In a case where the parallel factor P is 360, an LDPC code having a code length N of 1800 bits is divided into five (= 1800/360) bit groups of 0, 1, 2, 3, and 4, for example. Moreover, for example, an LDPC code having a code length N of 69120 bits is divided into 192 (= 69120/360) bit groups of 0, 1, and up to 191. Further, for example, an LDPC code having a code length N of 17280 bits is divided into 48 (= 17280/360) bit groups of 0, 1, and up to 47.

It is assumed hereinafter that the GW patterns are expressed as arrangements of numerals representing bit groups. For example, for an LDPC code having a code length N of 1800 bits and having five bit groups 0, 1, 2, 3, and 4, a GW pattern 4, 2, 0, 3, 1 indicates that the arrangement of the bit groups 0, 1, 2, 3, and 4, is interleaved (rearranged) into the arrangement of the bit groups 4, 2, 0, 3, and 1, for example. Note that each of the arrangements of the bit groups and the GW patterns is expressed as an arrangement with comma separated numbers indicating the bit groups (e.g., 4, 2, 0, 3, 1), and also an arrangement with space separated numbers indicating the bit groups (e.g., 4 2 0 3 1).

For example, it is assumed herein that each sign bit from the head to the (i + 1)th sign bit of an LDPC code having a code length N of 1800 bits is expressed as $X_i$.

In this case, in groupwise interleaving of the GW pattern 4, 2, 0, 3, 1, the 1800-bit LDPC code $\{x_0, x_1,$ and up to $x_{1799}\}$ is interleaved into an arrangement of $\{x_{1440}, x_{1441},$ and up to $x_{1799}\}$, $\{x_{720}, x_{721},$ and up to $x_{1079}\}$, $\{x_0, x_1,$ and up to $x_{359}\}$, $\{x_{1080}, x_{1081},$ and up to $x_{1439}\}$, and $\{x_{360}, x_{361},$ and up to $x_{719}\}$.

The GW pattern may be set for each code length N and each code rate r of LDPC codes, each modulation system, and each constellation, and further for each combination of two or more of a code length N, a code rate r, a modulation system, and a constellation.

<Examples of GW pattern for LDPC code>

FIG. 82 is a diagram illustrating a first example of a GW pattern for an LDPC code having a code length N of 17280 bits.

According to the GW pattern in FIG. 82, an arrangement of bit groups of 0 to 47 of the 17280-bit LDPC code is interleaved into the following bit groups.

0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47

FIG. 83 is a diagram illustrating a second example of the GW pattern for the LDPC code having the code length N of 17280 bits.

According to the GW pattern in FIG. 83, an arrangement of bit groups of 0 to 47 of the 17280-bit LDPC code is interleaved into the following bit groups.

19 33 45 22 43 23 46 32 11 40 13 34 14 47 0 12 6 26 37 4 5 17 25 30 39 29 27 28 10 21 36 9 3 20 24 42 7 41 44 38 15 8 31 16 2 1 35 18

FIG. 84 is a diagram illustrating a third example of the GW pattern for the LDPC code having the code length N of 17280 bits.

According to the GW pattern in FIG. 84, an arrangement of bit groups of 0 to 47 of the 17280-bit LDPC code is interleaved into the following bit groups.

0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47

FIG. 85 is a diagram illustrating a fourth example of the GW pattern for the LDPC code having the code length N of 17280 bits.

According to the GW pattern in FIG. 85, an arrangement of bit groups of 0 to 47 of the 17280-bit LDPC code is interleaved into the following bit groups.

0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47

FIG. 86 is a diagram illustrating a fifth example of the GW pattern for the LDPC code having the code length N of 17280 bits.

According to the GW pattern in FIG. 86, an arrangement of bit groups of 0 to 47 of the 17280-bit LDPC code is interleaved into the following bit groups.

0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47

FIG. 87 is a diagram illustrating a sixth example of the GW pattern for the LDPC code having the code length N of 17280 bits.

According to the GW pattern in FIG. 87, an arrangement of bit groups of 0 to 47 of the 17280-bit LDPC code is interleaved into the following bit groups.

0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47

FIG. 88 is a diagram illustrating a seventh example of the GW pattern for the LDPC code having the code length N of 17280 bits.

According to the GW pattern in FIG. 88, an arrangement of bit groups of 0 to 47 of the 17280-bit LDPC code is interleaved into the following bit groups.

0 34 30 6 11 35 5 24 4 13 15 16 3 31 39 40 37 47 28 12 36 42 33 22 20 8 9 44 29 18 25 21 23 10 14 26 45 7 27 46 1 2 17 41 19 43 38 32

FIG. 89 is a diagram illustrating an eighth example of the GW pattern for the LDPC code having the code length N of 17280 bits.

According to the GW pattern in FIG. 89, an arrangement of bit groups of 0 to 47 of the 17280-bit LDPC code is interleaved into the following bit groups.

33 16 0 26 35 31 21 34 42 43 32 29 7 47 37 28 5 9 30 25 3 17 23 24 41 45 20 12 27 39 8 4 1 6 2 38 10 40 18 19 46 11 36 13 22 14 15 44

FIG. 90 is a diagram illustrating a ninth example of the GW pattern for the LDPC code having the code length N of 17280 bits.

According to the GW pattern in FIG. 90, an arrangement of bit groups of 0 to 47 of the 17280-bit LDPC code is interleaved into the following bit groups.

41 10 21 37 9 8 11 27 16 23 25 2 34 7 29 28 5 15 31 45 4 43 33 22 18 13 35 30 6 12 44 1 20 40 42 39 19 17 36 38 26 0 32 3 47 14 24 46

FIG. 91 is a diagram illustrating a tenth example of the GW pattern for the LDPC code having the code length N of 17280 bits.

According to the GW pattern in FIG. 91, an arrangement of bit groups of 0 to 47 of the 17280-bit LDPC code is interleaved into the following bit groups.

15 21 29 10 12 32 1 9 31 47 23 30 26 18 0 28 7 20 43 44 3 45 5 17 16 46 40 39 6 38 34 36 22 33 27 24 25 13 14 37 19 8 42 11 4 2 35 41

FIG. 92 is a diagram illustrating an eleventh example of the GW pattern for the LDPC code having the code length N of 17280 bits.

According to the GW pattern in FIG. 92, an arrangement of bit groups of 0 to 47 of the 17280-bit LDPC code is interleaved into the following bit groups.

0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47

FIG. 93 is a diagram illustrating a twelfth example of the GW pattern for the LDPC code having the code length N of 17280 bits.

According to the GW pattern in FIG. 93, an arrangement of bit groups of 0 to 47 of the 17280-bit LDPC code is interleaved into the following bit groups.

31 23 1 42 36 25 47 3 12 30 32 8 11 27 21 40 16 13 34 4 26 35 46 20 29 28 5 43 18 39 24 14 0 10 7 41 37 9 38 33 2 6 19 45 17 15 22 44

FIG. 94 is a diagram illustrating a thirteenth example of the GW pattern for the LDPC code having the code length N of 17280 bits.

According to the GW pattern in FIG. 94, an arrangement of bit groups of 0 to 47 of the 17280-bit LDPC code is interleaved into the following bit groups.

46 11 23 33 10 0 17 47 20 5 38 29 28 16 41 27 2 31 43 37 34 12 35 24 21 44 40 36 32 39 4 19 26 6 30 9 42 1 22 8 3 45 14 15 13 7 25 18

FIG. 95 is a diagram illustrating a fourteenth example of the GW pattern for the LDPC code having the code length N of 17280 bits.

According to the GW pattern in FIG. 95, an arrangement of bit groups of 0 to 47 of the 17280-bit LDPC code is interleaved into the following bit groups.

16 32 33 43 3 29 0 22 40 24 44 8 20 13 15 45 7 34 39 42 25 28 18 26 38 10 11 41 47 23 6 1 14 4 12 31 21 19 37 36 30 5 46 27 35 2 9 17

FIG. 96 is a diagram illustrating a fifteenth example of the GW pattern for the LDPC code having the code length N of 17280 bits.

According to the GW pattern in FIG. 96, an arrangement of bit groups of 0 to 47 of the 17280-bit LDPC code is interleaved into the following bit groups.

23 42 33 17 37 2 22 14 21 0 12 44 30 1 25 35 46 13 10 24 20 15 45 31 41 43 28 36 16 4 32 18 3 6 34 11 40 5 38 27 29 8 26 7 39 9 47 19

FIG. 97 is a diagram illustrating a sixteenth example of the GW pattern for the LDPC code having the code length N of 17280 bits.

According to the GW pattern in FIG. 97, an arrangement of bit groups of 0 to 47 of the 17280-bit LDPC code is interleaved into the following bit groups.

7 0 8 39 17 3 32 2 13 19 16 14 5 10 27 35 45 26 44 43 11 24 28 34 20 29 22 41 18 9 37 12 21 4 46 33 15 36 42 1 40 25 23 30 6 38 31 47

FIG. 98 is a diagram illustrating a seventeenth example of the GW pattern for the LDPC code having the code length N of 17280 bits.

According to the GW pattern in FIG. 98, an arrangement of bit groups of 0 to 47 of the 17280-bit LDPC code is interleaved into the following bit groups.

1 28 12 35 23 36 24 17 10 14 15 37 18 13 41 38 33 29 16 21 27 4 9 31 45 40 0 46 7 43 30 34 8 44 47 2 20 6 42 3 22 39 5 32 11 19 25 26

FIG. 99 is a diagram illustrating an eighteenth example of the GW pattern for the LDPC code having the code length N of 17280 bits.

According to the GW pattern in FIG. 99, an arrangement of bit groups of 0 to 47 of the 17280-bit LDPC code is interleaved into the following bit groups.

9 8 3 40 27 4 7 45 28 29 14 41 20 6 21 5 36 12 31 39 30 15 37 10 34 25 1 47 26 13 32 43 44 24 33 16 42 2 22 19 18 35 23 46 11 17 38 0

FIG. 100 is a diagram illustrating a nineteenth example of the GW pattern for the LDPC code having the code length N of 17280 bits.

According to the GW pattern in FIG. 100, an arrangement of bit groups of 0 to 47 of the 17280-bit LDPC code is interleaved into the following bit groups.

12 42 40 41 20 18 27 24 39 6 0 15 8 31 10 3 13 46 4 37 33 25 44 2 16 23 28 14 17 43 45 1 35 38 26 21 36 22 47 11 34 29 30 32 19 7 5 9

FIG. 101 is a diagram illustrating a twentieth example of the GW pattern for the LDPC code having the code length N of 17280 bits.

According to the GW pattern in FIG. 101, an arrangement of bit groups of 0 to 47 of the 17280-bit LDPC code is interleaved into the following bit groups.

33 18 21 29 14 4 35 32 26 15 11 6 1 47 38 17 45 27 2 5 16 12 23 25 3 0 42 13 41 46 9 24 40 43 7 31 39 34 30 20 8 36 22 10 19 28 37 44

FIG. 102 is a diagram illustrating a twenty-first example of the GW pattern for the LDPC code having the code length N of 17280 bits.

According to the GW pattern in FIG. 102, an arrangement of bit groups of 0 to 47 of the 17280-bit LDPC code is interleaved into the following bit groups.

7 28 41 8 6 12 14 47 4 38 32 37 23 33 15 46 22 0 34 24 40 45 27 19 43 11 36 9 17 21 31 44 2 1 26 13 42 30 35 5 29 25 16 20 39 10 18 3

FIG. 103 is a diagram illustrating a twenty-second example of the GW pattern for the LDPC code having the code length N of 17280 bits.

According to the GW pattern in FIG. 103, an arrangement of bit groups of 0 to 47 of the 17280-bit LDPC code is interleaved into the following bit groups.

30 14 40 26 21 5 12 3 18 17 11 38 4 46 7 31 0 1 27 36 8 10 2 22 13 9 37 42 41 32 15 39 23 25 34 24 35 28 20 16 19 33 6 43 29 45 47 44

FIG. 104 is a diagram illustrating a twenty-third example of the GW pattern for the LDPC code having the code length N of 17280 bits.

According to the GW pattern in FIG. 104, an arrangement of bit groups of 0 to 47 of the 17280-bit LDPC code is interleaved into the following bit groups.

23 20 14 9 44 41 19 36 38 13 16 28 0 8 2 39 31 29 21 10 11 33 32 27 46 7 5 35 26 1 43 40 37 17 47 30 6 18 15 42 3 25 4 22 24 12 45 34

FIG. 105 is a diagram illustrating a twenty-fourth example of the GW pattern for the LDPC code having the code length N of 17280 bits.

According to the GW pattern in FIG. 105, an arrangement of bit groups of 0 to 47 of the 17280-bit LDPC code is interleaved into the following bit groups.

37 30 14 13 2 31 27 9 46 41 47 18 23 28 43 10 39 42 16 22 36 8 33 32 4 1 45 19 12 6 35 0 24 25 15 38 44 7 26 21 34 40 29 20 11 5 17 3

FIG. 106 is a diagram illustrating a twenty-fifth example of the GW pattern for the LDPC code having the code length N of 17280 bits.

According to the GW pattern in FIG. 106, an arrangement of bit groups of 0 to 47 of the 17280-bit LDPC code is interleaved into the following bit groups.

6 28 25 38 43 11 21 31 47 8 17 39 23 27 30 32 3 35 12 7 1 16 18 36 10 24 41 4 44 22 5 33 46 29 0 26 9 42 37 45 15 40 2 19 14 20 34 13

FIG. 107 is a diagram illustrating a twenty-sixth example of the GW pattern for the LDPC code having the code length N of 17280 bits.

According to the GW pattern in FIG. 107, an arrangement of bit groups of 0 to 47 of the 17280-bit LDPC code is interleaved into the following bit groups.

39 11 12 7 3 1 40 31 27 0 45 42 6 5 24 36 46 19 34 22 29 13 35 2 17 33 20 14 15 25 38 9 41 30 44 18 8 28 37 4 32 47 16 43 21 23 26 10

FIG. 108 is a diagram illustrating a twenty-seventh example of the GW pattern for the LDPC code having the code length N of 17280 bits.

According to the GW pattern in FIG. 108, an arrangement of bit groups of 0 to 47 of the 17280-bit LDPC code is interleaved into the following bit groups.

7 19 31 20 36 35 2 4 46 12 28 21 39 43 26 23 32 5 37 3 11 34 18 45 24 1 13 47 10 27 0 9 33 25 8 40 6 16 22 29 42 38 14 44 41 17 30 15

FIG. 109 is a diagram illustrating a twenty-eighth example of the GW pattern for the LDPC code having the code length N of 17280 bits.

According to the GW pattern in FIG. 109, an arrangement of bit groups of 0 to 47 of the 17280-bit LDPC code is interleaved into the following bit groups.

12 7 39 31 30 44 14 33 35 17 37 27 2 28 9 26 32 3 46 0 34 6 43 25 21 47 18 45 5 20 13 38 11 29 16 36 8 40 15 41 10 23 1 19 4 22 42 24

FIG. 110 is a diagram illustrating a twenty-ninth example of the GW pattern for the LDPC code having the code length N of 17280 bits.

According to the GW pattern in FIG. 110, an arrangement of bit groups of 0 to 47 of the 17280-bit LDPC code is interleaved into the following bit groups.

20 19 13 25 32 9 5 24 39 4 29 40 14 18 43 46 21 44 10 15 35 3 23 47 37 12 30 33 27 36 8 28 38 7 42 22 2 0 6 16 45 26 17 11 31 34 41 1

FIG. 111 is a diagram illustrating a thirtieth example of the GW pattern for the LDPC code having the code length N of 17280 bits.

According to the GW pattern in FIG. 111, an arrangement of bit groups of 0 to 47 of the 17280-bit LDPC code is interleaved into the following bit groups.

19 20 44 3 6 28 13 15 16 24 9 34 39 8 17 40 29 31 22 10 11 7 35 42 23 2 14 37 33 1 26 45 38 12 47 30 5 18 46 0 41 27 4 21 43 25 36 32

FIG. 112 is a diagram illustrating a thirty-first example of the GW pattern for the LDPC code having the code length N of 17280 bits.

According to the GW pattern in FIG. 112, an arrangement of bit groups of 0 to 47 of the 17280-bit LDPC code is interleaved into the following bit groups.

4 26 7 21 43 42 33 17 35 19 10 39 27 13 18 34 38 3 28 36 1 5 44 37 16 30 14 9 32 47 29 2 31 23 0 24 11 8 6 46 40 45 15 22 25 20 12 41

FIG. 113 is a diagram illustrating a thirty-second example of the GW pattern for the LDPC code having the code length N of 17280 bits.

According to the GW pattern in FIG. 113, an arrangement of bit groups of 0 to 47 of the 17280-bit LDPC code is interleaved into the following bit groups.

8 28 33 21 1 39 34 7 0 17 5 41 23 2 14 10 29 25 13 18 35 38 27 44 20 32 31 11 40 30 24 3 36 22 15 37 16 6 42 45 19 47 12 26 43 9 46 4

FIG. 114 is a diagram illustrating a thirty-third example of the GW pattern for the LDPC code having the code length N of 17280 bits.

According to the GW pattern in FIG. 114, an arrangement of bit groups of 0 to 47 of the 17280-bit LDPC code is interleaved into the following bit groups.

0 39 23 44 19 21 35 13 36 27 47 3 31 11 9 41 43 8 14 26 6 5 15 16 38 7 32 22 30 33 37 40 28 45 12 24 17 42 20 29 1 4 10 2 25 18 46 34

FIG. 115 is a diagram illustrating a thirty-fourth example of the GW pattern for the LDPC code having the code length N of 17280 bits.

According to the GW pattern in FIG. 115, an arrangement of bit groups of 0 to 47 of the 17280-bit LDPC code is interleaved into the following bit groups.

11 0 42 24 46 27 25 3 1 41 22 40 19 18 14 36 33 4 47 12 39 30 13 5 2 7 31 9 38 35 15 43 45 44 28 20 32 21 26 23 6 10 8 37 17 34 29 16

FIG. 116 is a diagram illustrating a thirty-fifth example of the GW pattern for the LDPC code having the code length N of 17280 bits.

According to the GW pattern in FIG. 116, an arrangement of bit groups of 0 to 47 of the 17280-bit LDPC code is interleaved into the following bit groups.

5 45 42 35 13 41 2 29 15 11 16 0 8 1 33 34 44 7 43 22 24 19 9 38 18 12 26 20 28 21 10 30 40 6 46 37 47 17 3 32 4 39 23 25 36 14 31 27

FIG. 117 is a diagram illustrating a thirty-sixth example of the GW pattern for the LDPC code having the code length N of 17280 bits.

According to the GW pattern in FIG. 117, an arrangement of bit groups of 0 to 47 of the 17280-bit LDPC code is interleaved into the following bit groups.

18 16 21 2 43 10 44 42 19 15 20 26 1 38 46 28 17 29 6 22 7 32 31 30 24 3 8 9 12 37 47 40 39 5 35 11 25 45 34 33 23 4 14 27 13 41 36 0

FIG. 118 is a diagram illustrating a thirty-seventh example of the GW pattern for the LDPC code having the code length N of 17280 bits.

According to the GW pattern in FIG. 118, an arrangement of bit groups of 0 to 47 of the 17280-bit LDPC code is interleaved into the following bit groups.

28 9 4 27 17 10 12 6 19 30 1 23 39 14 38 34 46 8 15 43 13 47 0 44 7 24 45 18 25 29 37 42 22 31 11 36 20 32 41 33 2 26 21 5 3 16 40 35

FIG. 119 is a diagram illustrating a thirty-eighth example of the GW pattern for the LDPC code having the code length N of 17280 bits.

According to the GW pattern in FIG. 119, an arrangement of bit groups of 0 to 47 of the 17280-bit LDPC code is interleaved into the following bit groups.

5 37 36 38 16 21 41 44 10 18 26 27 15 1 43 2 33 14 9 30 8 12 23 4 13 35 31 3 34 19 42 47 46 29 0 25 20 17 39 45 28 6 22 11 32 40 24 7

FIG. 120 is a diagram illustrating a thirty-ninth example of the GW pattern for the LDPC code having the code length N of 17280 bits.

According to the GW pattern in FIG. 120, an arrangement of bit groups of 0 to 47 of the 17280-bit LDPC code is interleaved into the following bit groups.

11 1 12 21 13 15 24 36 34 0 37 9 14 39 19 16 17 28 40 29 23 46 30 38 33 3 6 18 26 7 27 45 10 25 4 42 31 43 35 32 5 8 44 41 47 22 20 2

FIG. 121 is a diagram illustrating a fortieth example of the GW pattern for the LDPC code having the code length N of 17280 bits.

According to the GW pattern in FIG. 121, an arrangement of bit groups of 0 to 47 of the 17280-bit LDPC code is interleaved into the following bit groups.

3 41 6 42 21 2 25 45 8 39 34 26 47 43 23 20 13 16 38 24 5 40 0 11 7 31 32 15 36 33 9 12 10 30 29 14 18 35 46 4 28 19 1 44 37 27 17 22

FIG. 122 is a diagram illustrating a forty-first example of the GW pattern for the LDPC code having the code length N of 17280 bits.

According to the GW pattern in FIG. 122, an arrangement of bit groups of 0 to 47 of the 17280-bit LDPC code is interleaved into the following bit groups.

40 42 11 10 15 6 34 37 16 45 25 47 32 8 17 26 29 7 18 21 46 44 28 27 20 38 43 36 33 5 24 9 13 2 0 4 39 31 1 22 30 12 14 41 23 3 19 35

FIG. 123 is a diagram illustrating a forty-second example of the GW pattern for the LDPC code having the code length N of 17280 bits.

According to the GW pattern in FIG. 123, an arrangement of bit groups of 0 to 47 of the 17280-bit LDPC code is interleaved into the following bit groups.

6 0 20 18 37 27 39 3 1 2 46 11 24 36 14 15 4 16 10 13 35 23 26 30 19 42 7 9 33 40 12 34 22 5 28 21 32 38 44 25 17 41 29 45 8 47 31 43

FIG. 124 is a diagram illustrating a forty-third example of the GW pattern for the LDPC code having the code length N of 17280 bits.

According to the GW pattern in FIG. 124, an arrangement of bit groups of 0 to 47 of the 17280-bit LDPC code is interleaved into the following bit groups.

8 25 12 9 26 37 35 28 14 5 6 2 29 38 22 31 11 21 17 33 42 43 36 45 20 27 44 13 16 46 10 30 3 32 19 1 15 4 18 40 47 7 34 24 41 23 39 0

FIG. 125 is a diagram illustrating a forty-fourth example of the GW pattern for the LDPC code having the code length N of 17280 bits.

According to the GW pattern in FIG. 125, an arrangement of bit groups of 0 to 47 of the 17280-bit LDPC code is interleaved into the following bit groups.

7 17 26 27 9 39 46 47 32 12 35 25 14 11 22 23 16 29 38 33 34 4 40 10 5 18 37 1 24 44 30 3 0 45 28 13 15 20 6 21 31 19 2 8 41 36 42 43

FIG. 126 is a diagram illustrating a forty-fifth example of the GW pattern for the LDPC code having the code length N of 17280 bits.

According to the GW pattern in FIG. 126, an arrangement of bit groups of 0 to 47 of the 17280-bit LDPC code is interleaved into the following bit groups.

11 14 32 27 44 43 0 47 1 8 35 33 7 2 41 15 13 4 23 30 16 42 46 24 9 17 21 20 18 5 19 12 3 34 28 40 39 37 31 38 45 36 6 22 26 10 25 29

The first to forty-fifth examples of the GW patterns described above for the LDPC code having the code length N of 17280 bits are applicable to any combinations of LDPC codes having the code length N of 17280 bits and any code rate r, any modulation system, and any constellation.

Note that, in groupwise interleaving, error rates can further improve for respective combinations by setting the applied GW pattern for each combination of the code length N of the LDPC code, the code rate r of the LDPC code, the modulation system, and the constellation.

For example, the GW pattern in FIG. 82 can particularly achieve a preferable error rate when applied to a combination of the type A code of r = 3/16 (corresponding to the check matrix initial value table) in FIG. 31, QPSK, and the QPSK-UC in FIGS. 58 and 59.

For example, the GW pattern in FIG. 83 can particularly achieve a preferable error rate when applied to a combination of the type A code of r = 5/16 in FIG. 33, QPSK, and the QPSK-UC in FIGS. 58 and 59.

For example, the GW pattern in FIG. 84 can particularly achieve a preferable error rate when applied to a combination of the type B code of r = 7/16 in FIG. 36, QPSK, and the QPSK-UC in FIGS. 58 and 59.

For example, the GW pattern in FIG. 85 can particularly achieve a preferable error rate when applied to a combination of the new type B code of r = 9/16 in FIG. 52, QPSK, and the QPSK-UC in FIGS. 58 and 59.

For example, the GW pattern in FIG. 86 can particularly achieve a preferable error rate when applied to a combination of the type B code of r = 11/16 in FIG. 40, QPSK, and the QPSK-UC in FIGS. 58 and 59.

For example, the GW pattern in FIG. 87 can particularly achieve a preferable error rate when applied to a combination of the type B code of r = 13/16 in FIG. 42, QPSK, and the QPSK-UC in FIGS. 58 and 59.

For example, the GW pattern in FIG. 88 can particularly achieve a preferable error rate when applied to a combination of the type A code of r = 3/16 in FIG. 31, 16QAM, and the 16QAM-UC in FIGS. 60 and 61.

For example, the GW pattern in FIG. 89 can particularly achieve a preferable error rate when applied to a combination of the type A code of r = 5/16 in FIG. 33, 16QAM, and the 16QAM-UC in FIGS. 60 and 61.

For example, the GW pattern in FIG. 90 can particularly achieve a preferable error rate when applied to a combination of the type B code of r = 7/16 in FIG. 36, 16QAM, and the 16QAM-UC in FIGS. 60 and 61.

For example, the GW pattern in FIG. 91 can particularly achieve a preferable error rate when applied to a combination of the new type B code of r = 9/16 in FIG. 52, 16QAM, and the 16QAM-UC in FIGS. 60 and 61.

For example, the GW pattern in FIG. 92 can particularly achieve a preferable error rate when applied to a combination of the type B code of r = 11/16 in FIG. 40, 16QAM, and the 16QAM-UC in FIGS. 60 and 61.

For example, the GW pattern in FIG. 93 can particularly achieve a preferable error rate when applied to a combination of the type B code of r = 13/16 in FIG. 42, 16QAM, and the 16QAM-UC in FIGS. 60 and 61.

For example, the GW pattern in FIG. 94 can particularly achieve a preferable error rate when applied to a combination of the type A code of r = 2/16 in FIG. 30, 16QAM, and the 16QAM-2D-NUC in FIG. 70.

For example, the GW pattern in FIG. 95 can particularly achieve a preferable error rate when applied to a combination of the new type A code of r = 4/16 in FIG. 50, 16QAM, and the 16QAM-2D-NUC in FIG. 70.

For example, the GW pattern in FIG. 96 can particularly achieve a preferable error rate when applied to a combination of the type A code of r = 6/16 in FIG. 34, 16QAM, and the 16QAM-2D-NUC in FIG. 70.

For example, the GW pattern in FIG. 97 can particularly achieve a preferable error rate when applied to a combination of the type B code of r = 8/16 in FIG. 37, 16QAM, and the 16QAM-2D-NUC in FIG. 70.

For example, the GW pattern in FIG. 98 can particularly achieve a preferable error rate when applied to a combination of the type B code of r = 10/16 in FIG. 39, 16QAM, and the 16QAM-2D-NUC in FIG. 70.

For example, the GW pattern in FIG. 99 can particularly achieve a preferable error rate when applied to a combination of the type B code of r = 12/16 in FIG. 41, 16QAM, and the 16QAM-2D-NUC in FIG. 70.

For example, the GW pattern in FIG. 100 can particularly achieve a preferable error rate when applied to a combination of the type B code of r = 14/16 in FIG. 43, 16QAM, and the 16QAM-2D-NUC in FIG. 70.

For example, the GW pattern in FIG. 101 can particularly achieve a preferable error rate when applied to a combination of the type A code of r = 2/16 in FIG. 30, 64QAM, and the 64QAM-UC in FIGS. 62 and 63.

For example, the GW pattern in FIG. 102 can particularly achieve a preferable error rate when applied to a combination of the new type A code of r = 4/16 in FIG. 50, 64QAM, and the 64QAM-UC in FIGS. 62 and 63.

For example, the GW pattern in FIG. 103 can particularly achieve a preferable error rate when applied to a combination of the type A code of r = 6/16 in FIG. 34, 64QAM, and the 64QAM-UC in FIGS. 62 and 63.

For example, the GW pattern in FIG. 104 can particularly achieve a preferable error rate when applied to a combination of the type B code of r = 8/16 in FIG. 37, 64QAM, and the 64QAM-UC in FIGS. 62 and 63.

For example, the GW pattern in FIG. 105 can particularly achieve a preferable error rate when applied to a combination of the type B code of r = 10/16 in FIG. 39, 64QAM, and the 64QAM-UC in FIGS. 62 and 63.

For example, the GW pattern in FIG. 106 can particularly achieve a preferable error rate when applied to a combination of the type B code of r = 12/16 in FIG. 41, 64QAM, and the 64QAM-UC in FIGS. 62 and 63.

For example, the GW pattern in FIG. 107 can particularly achieve a preferable error rate when applied to a combination of the type B code of r = 14/16 in FIG. 43, 64QAM, and the 64QAM-UC in FIGS. 62 and 63.

For example, the GW pattern in FIG. 108 can particularly achieve a preferable error rate when applied to a combination of the type A code of r = 3/16 in FIG. 31, 64QAM, and the 64QAM-2D-NUC in FIG. 71.

For example, the GW pattern in FIG. 109 can particularly achieve a preferable error rate when applied to a combination of the type A code of r = 5/16 in FIG. 33, 64QAM, and the 64QAM-2D-NUC in FIG. 71.

For example, the GW pattern in FIG. 110 can particularly achieve a preferable error rate when applied to a combination of the type B code of r = 7/16 in FIG. 36, 64QAM, and the 64QAM-2D-NUC in FIG. 71.

For example, the GW pattern in FIG. 111 can particularly achieve a preferable error rate when applied to a combination of the new type B code of r = 9/16 in FIG. 52, 64QAM, and the 64QAM-2D-NUC in FIG. 71.

For example, the GW pattern in FIG. 112 can particularly achieve a preferable error rate when applied to a combination of the type B code of r = 11/16 in FIG. 40, 64QAM, and the 64QAM-2D-NUC in FIG. 71.

For example, the GW pattern in FIG. 113 can particularly achieve a preferable error rate when applied to a combination of the type B code of r = 13/16 in FIG. 42, 64QAM, and the 64QAM-2D-NUC in FIG. 71.

For example, the GW pattern in FIG. 114 can particularly achieve a preferable error rate when applied to a combination of the type A code of r = 3/16 in FIG. 31, 256QAM, and the 256QAM-UC in FIGS. 64 and 65.

For example, the GW pattern in FIG. 115 can particularly achieve a preferable error rate when applied to a combination of the type A code of r = 5/16 in FIG. 33, 256QAM, and the 256QAM-UC in FIGS. 64 and 65.

For example, the GW pattern in FIG. 116 can particularly achieve a preferable error rate when applied to a combination of the type B code of r = 7/16 in FIG. 36, 256QAM, and the 256QAM-UC in FIGS. 64 and 65.

For example, the GW pattern in FIG. 117 can particularly achieve a preferable error rate when applied to a combination of the new type B code of r = 9/16 in FIG. 52, 256QAM, and the 256QAM-UC in FIGS. 64 and 65.

For example, the GW pattern in FIG. 118 can particularly achieve a preferable error rate when applied to a combination of the type B code of r = 11/16 in FIG. 40, 256QAM, and the 256QAM-UC in FIGS. 64 and 65.

For example, the GW pattern in FIG. 119 can particularly achieve a preferable error rate when applied to a combination of the type B code of r = 13/16 in FIG. 42, 256QAM, and the 256QAM-UC in FIGS. 64 and 65.

For example, the GW pattern in FIG. 120 can particularly achieve a preferable error rate when applied to a combination of the type A code of r = 2/16 in FIG. 30, 256QAM, and the 256QAM-2D-NUC in FIGS. 72 and 73.

For example, the GW pattern in FIG. 121 can particularly achieve a preferable error rate when applied to a combination of the new type A code of r = 4/16 in FIG. 50, 256QAM, and the 256QAM-2D-NUC in FIGS. 72 and 73.

For example, the GW pattern in FIG. 122 can particularly achieve a preferable error rate when applied to a combination of the type A code of r = 6/16 in FIG. 34, 256QAM, and the 256QAM-2D-NUC in FIGS. 72 and 73.

For example, the GW pattern in FIG. 123 can particularly achieve a preferable error rate when applied to a combination of the type B code of r = 8/16 in FIG. 37, 256QAM, and the 256QAM-2D-NUC in FIGS. 72 and 73.

For example, the GW pattern in FIG. 124 can particularly achieve a preferable error rate when applied to a combination of the type B code of r = 10/16 in FIG. 39, 256QAM, and the 256QAM-2D-NUC in FIGS. 72 and 73.

For example, the GW pattern in FIG. 125 can particularly achieve a preferable error rate when applied to a combination of the type B code of r = 12/16 in FIG. 41, 256QAM, and the 256QAM-2D-NUC in FIGS. 72 and 73.

For example, the GW pattern in FIG. 126 can particularly achieve a preferable error rate when applied to a combination of the type B code of r = 14/16 in FIG. 43, 256QAM, and the 256QAM-2D-NUC in FIGS. 72 and 73.

<Other examples of GW pattern>

FIG. 127 is a diagram illustrating a forty-sixth example of the GW pattern for the LDPC code having the code length N of 17280 bits.

According to the GW pattern in FIG. 127 (hereinafter also referred to as a new GW pattern), an arrangement of bit groups of 0 to 47 of the 17280-bit LDPC code is interleaved into the following bit groups.
3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27

For example, the new GW pattern can achieve a preferable error rate when applied to a combination of the type B code having the code length N of 17280 bits and r of 14/16 in FIG. 43, 16QAM, and the 16QAM-2D-NUC in FIG. 70.

Specifically, for the combination of the type B code having the code length N of 17280 bits and r of 14/16 and the 16QAM-2D-NUC, a preferable BER can reliably be achieved particularly in an AWGN communication path (channel) by applying the GW pattern in FIG. 100 (hereinafter also referred to as an old GW pattern). However, a preferable BER can be further achieved in a Rayleigh fading communication path by applying the new GW pattern.

FIG. 128 is a diagram illustrating BER simulation results of combinations of the type B code having the code length N of 17280 bits and r of 14/16, the 16QAM-2D-NUC, and the old and new GW patterns.

In FIG. 128, the horizontal axis represents the $E_s/N_0$ (a ratio of signal power to noise power per symbol), while the vertical axis represents the BER.

FIG. 128 illustrates simulation results of a BER (dotted line) obtained in a case where the old GW pattern in FIG. 100 is adopted as the GW pattern applied to a combination of the type B code having the code length N of 17280 bits and r of 14/16 in FIG. 43 and the 16QAM-2D-NUC in FIG. 70, and a BER (solid line) obtained in a case where the new GW pattern in FIG. 127 is adopted for this combination.

In the simulation, the number of times of repetitive decoding of LDPC codes (it) is set to 50 times, and a Rayleigh fading communication path is adopted as the communication path 13.

The Rayleigh fading communication path is similar to a multipath environment. Accordingly, gains in a case of use of the transfer system in FIG. 7 under a multipath environment can improve according to improvement of the BER in the Rayleigh fading communication path.

It is recognizable from FIG. 128 that a preferable BER is reliably achievable in the Rayleigh fading communication path, i.e., a lower BER is obtained at the same $E_s/N_0$, in the case of adoption of the new GW pattern than in the case of adoption of the old GW pattern.

FIG. 129 is a diagram illustrating necessary CNR simulation results of combinations of the type B code having the code length N of 17280 bits and r of 14/16, the 16QAM-2D-NUC, and the old and new GW patterns.

The necessary CNR is a minimum CNR required for achieving a certain BER. For example, the necessary CNR herein is a CNR achieving a BER = 1E - 7.

FIG. 129 illustrates simulation results of the necessary CNR obtained in a case where the old GW pattern is applied to the combination of the type B code having the code length N of 17280 bits and r of 14/16 in FIG. 43 and the 16QAM-2D-NUC in FIG. 70 and the necessary CNR obtained in a case where the new GW pattern is applied to the above-described combination.

As can be seen from FIG. 129, the necessary CNR can improve by 0.146 dB indicated as a difference in the case of adoption of the new GW pattern in comparison with the case of adoption of the old GW pattern.

<Configuration example of reception device 12>

FIG. 130 is a block diagram illustrating a configuration example of the reception device 12 in FIG. 7.

An OFDM processing unit (OFDM operation) 151 receives an OFDM signal from the transmission device 11 (FIG. 7), and performs signal processing for the OFDM signal. Data obtained after signal processing by the OFDM processing unit 151 is supplied to a frame management unit 152.

The frame management unit 152 performs processing (frame interpretation) for a frame having data supplied from the OFDM processing unit 151, and supplies signals of target data obtained by this processing and signals of control data to frequency deinterleavers 161 and 153, respectively.

The frequency deinterleaver 153 performs frequency-deinterleaving for the data received from the frame management unit 152, in units of a symbol, and supplies resultant data to a demapper 154.

The demapper 154 demaps (achieves signal point arrangement decoding of) the data received from the frequency deinterleaver 153 (data on a constellation), on the basis of an arrangement (constellation) of signal points determined by quadrature modulation performed on the transmission device 11 side, to achieve quadrature decoding, and supplies data thus obtained (LDPC code (likelihood thereof)) to an LDPC decoder (LDPC decoder) 155.

The LDPC decoder 155 (decoding unit) performs LDPC decoding for the LDPC code received from the demapper 154, and supplies LDPC target data thus obtained (BCH code herein) to a BCH decoder 156.

The BCH decoder 156 performs BCH decoding for the LDPC target data received from the LDPC decoder 155, and outputs control data thus obtained (signaling).

Meanwhile, the frequency deinterleaver 161 performs frequency-deinterleaving for the data received from the frame management unit 152, in units of a symbol, and supplies resultant data to an SISO/MISO decoder 162.

The SISO/MISO decoder 162 performs space-time decoding for the data received from the frequency deinterleaver 161, and supplies resultant data to a time deinterleaver 163.

The time deinterleaver 163 performs time-deinterleaving for the data received from the SISO/MISO decoder 162, in units of a symbol, and supplies resultant data to a demapper 164.

The demapper 164 demaps (achieves signal point arrangement decoding of) the data received from the time deinterleaver 163 (data on a constellation), on the basis of an arrangement (constellation) of signal points determined by quadrature modulation performed on the transmission device 11 side, to achieve quadrature decoding, and supplies data thus obtained to a bit deinterleaver 165.

The bit deinterleaver 165 bit-deinterleaves the data received from the demapper 164, and supplies an LDPC code (likelihood thereof) as data that has undergone bit deinterleaving to an LDPC decoder 166.

The LDPC decoder 166 performs LDPC decoding for the LDPC code received from the bit deinterleaver 165, and supplies LDPC target data (BCH code herein) thus obtained to a BCH decoder 167.

The BCH decoder 167 performs BCH decoding for the LDPC target data received from the LDPC decoder 155, and supplies data thus obtained to a BB descrambler 168.

The BB descrambler 168 performs BB-descrambling for the data received from the BCH decoder 167, and supplies data thus obtained to a null deletion unit (Null Deletion) 169.

The null deletion unit 169 deletes nulls inserted by the padder 112 in FIG. 8, from the data received from the BB descrambler 168, and supplies resultant data to a demultiplexer 170.

The demultiplexer 170 separates 1 or more streams (target data) multiplexed on the data received from the null deletion unit 169 from each other, performs necessary processing, and outputs resultant data as output streams.

Note that a part of the blocks illustrated in FIG. 130 can be eliminated from the configuration of the reception device 12. Specifically, for example, in a case where the time interleaver 118, the SISO/MISO encoder 119, the frequency interleaver 120, and the frequency interleaver 124 are eliminated from the configuration of the transmission device 11 (FIG. 8), the time deinterleaver 163, the SISO/MISO decoder 162, the frequency deinterleaver 161, and the frequency deinterleaver 153 as blocks corresponding to the time interleaver 118, the SISO/MISO encoder 119, the frequency interleaver 120, and the frequency interleaver 124 of the transmission device 11, respectively, may be eliminated from the configuration of the reception device 12.

<Configuration example of bit deinterleaver 165>

FIG. 131 is a block diagram illustrating a configuration example of the bit deinterleaver 165 in FIG. 130.

The bit deinterleaver 165 includes a block deinterleaver 54 and a groupwise deinterleaver 55, and (bit-) deinterleaves symbol bits of a symbol as data received from the demapper 164 (FIG. 130).

Specifically, the block deinterleaver 54 performs block deinterleaving (reverse processing of block interleaving) corresponding to block interleaving achieved by the block interleaver 25 in FIG. 9 for the symbol bits of the symbol received from the demapper 164, i.e., block deinterleaving which restores positions of sign bits (likelihood thereof) of an LDPC code rearranged by block interleaving to original positions, and supplies an LDPC code thus obtained to the groupwise deinterleaver 55.

The groupwise deinterleaver 55 achieves groupwise deinterleaving for restoring to the original arrangement, by performing groupwise deinterleaving (reverse processing of groupwise interleaving) corresponding to groupwise interleaving achieved by the groupwise interleaver 24 in FIG. 9 for the LDPC code received from the block deinterleaver 54, i.e., by rearranging, in units of a bit group, sign bits of the LDPC code obtained after a change of arrangement in units of a bit group according to the groupwise interleaving explained with reference to FIG. 81, for example.

In a case where the LDPC code supplied from the demapper 164 to the bit deinterleaver 165 is parity-interleaved, groupwise-interleaved, and block-interleaved herein, the bit deinterleaver 165 is capable of performing all of parity deinterleaving corresponding to parity interleaving (reverse processing of parity interleaving, i.e., parity deinterleaving for restoring sign bits of the LDPC code obtained after an arrangement change by parity interleaving to the original arrangement), block deinterleaving corresponding to block interleaving, and groupwise deinterleaving corresponding to groupwise interleaving.

However, the bit deinterleaver 165 in FIG. 131 includes the block deinterleaver 54 performing block deinterleaving corresponding to block interleaving and the groupwise deinterleaver 55 performing groupwise deinterleaving corresponding to groupwise interleaving, but does not include a block for performing parity deinterleaving corresponding to parity interleaving. In this case, the bit deinterleaver 165 does not carry out parity deinterleaving.

Accordingly, the LDPC code block-deinterleaved and groupwise-deinterleaved but not parity-deinterleaved is supplied from the bit deinterleaver 165 (groupwise deinterleaver 55 thereof) to the LDPC decoder 166.

The LDPC decoder 166 performs LDPC decoding for the LDPC code received from the bit deinterleaver 165, on the basis of a transformed check matrix obtained by performing at least column permutation corresponding to parity interleaving for the check matrix H for the type B system used by the LDPC encoder 115 in FIG. 8 for LDPC encoding, or a transformed check matrix (FIG. 29) obtained by performing row permutation for the check matrix (FIG. 27) of the type A system, and outputs data thus obtained as a decoding result of the LDPC target data.

FIG. 132 is a flowchart explaining a process performed by the demapper 164, the bit deinterleaver 165, and the LDPC decoder 166 in FIG. 131.

In step S111, the demapper 164 demaps data (data mapped at signal points on a constellation) received from the time deinterleaver 163, to achieve quadrature decoding, and supplies resultant data to the bit deinterleaver 165. Thereafter, the process proceeds to step S112.

In step S112, the bit deinterleaver 165 deinterleaves (bit-deinterleaves) the data received from the demapper 164. Thereafter, the process proceeds to

step S113.

Specifically, in step S112, the block deinterleaver 54 in the bit deinterleaver 165 performs block-deinterleaving for data (symbol) received from the demapper 164, and supplies sign bits of an LDPC code thus obtained to the groupwise deinterleaver 55.

The groupwise deinterleaver 55 performs groupwise deinterleaving for the LDPC code received from the block deinterleaver 54, and supplies the LDPC code (likelihood thereof) thus obtained to the LDPC decoder 166.

In step S113, the LDPC decoder 166 performs LDPC decoding for the LDPC code received from the groupwise deinterleaver 55, on the basis of a check matrix H used for LDPC encoding by the LDPC encoder 115 in FIG. 8, i.e., on the basis of a transformed check matrix obtained from the check matrix H, for example, and outputs data thus obtained to the BCH decoder 167 as a decoding result of the LDPC target data.

Note that, while the block deinterleaver 54 performing block deinterleaving and the groupwise deinterleaver 55 performing groupwise deinterleaving are separately configured in FIG. 131 as in the configuration in FIG. 9 for convenience of explanation, the block deinterleaver 54 and the groupwise deinterleaver 55 can be integrally formed.

Moreover, in a case where the transmission device 11 does not perform groupwise interleaving, the groupwise deinterleaver 55 performing groupwise deinterleaving can be eliminated from the configuration of the reception device 12.

<LDPC decoding>

The LDPC decoding performed by the LDPC decoder 166 in FIG. 130 will be further explained.

As described above, the LDPC decoder 166 in FIG. 130 performs LDPC decoding for the LDPC code received from the groupwise deinterleaver 55 as the LDPC code block-deinterleaved and groupwise-deinterleaved but not parity-deinterleaved, on the basis of a transformed check matrix obtained by performing at least column permutation corresponding to parity interleaving for the check matrix H for the type B system used by the LDPC encoder 115 in FIG. 8 for LDPC encoding, or on the basis of a transformed check matrix (FIG. 29) obtained by performing row permutation for the check matrix for the type A system (FIG. 27).

Note herein that there has previously been proposed such a type of LDPC decoding which is capable of reducing an operation frequency of LDPC decoding to a sufficiently practical range by using a transformed check matrix, along with reduction of a circuit scale (e.g., see Japanese Patent No. 4224777).

Accordingly, the LDPC decoding previously proposed and achieved using a transformed check matrix will be initially described with reference to FIGS. 133 to 136.

FIG. 133 is a diagram illustrating an example of a check matrix H for an LDPC code having a code length N of 90 and a code rate of 2/3.

Note that 0 is expressed as a period (.) in FIG. 133 (this similarly applies to FIGS. 134 and 135 referred to below).

In FIG. 133, a parity matrix of a check matrix H has a stepped structure.

FIG. 134 is a diagram illustrating a check matrix H' obtained by applying row permutation in equation (11) and column permutation in equation (12) to the check matrix H in FIG. 133.

Row permutation: 6s + t + 1st row $\to$ 5t + s + 1st row　　　　　　　　　　　　　　　　　　　(11)

Column permutation: 6x + y + 61st column $\to$ 5y + x + 61st column　　　　　　　　　　　　　(12)

Note that s, t, x, and y in equations (11) and (12) are integers in ranges of $0 \leq s < 5$, $0 \leq t < 6$, $0 \leq x < 5$, and $0 \leq y < 6$, respectively.

According to the row permutation in equation (11), permutation is performed such that the 1st, 7th, 13th, 19th, and 25th rows each corresponding to a value having a remainder of 1 by division by 6 are permutated with the 1st, 2nd, 3rd, 4th, and 5th rows, and that the 2nd, 8th, 14th, 20th, and 26th rows each corresponding to a value having a remainder of 2 by division by 6 are permutated with the 6th, 7th, 8th, 9th, and 10th rows.

Moreover, according to the column permutation in equation (12), permutation is performed for the 61st and the subsequent columns (parity matrix) such that the 61st, 67th, 73th, 79th, and 85th columns each corresponding to a value having a remainder of 1 by division by 6 are permutated with the 61st, 62nd, 63rd, 64th, and 65th columns, and that the 62nd, 68th, 74th, 80th, and 86th columns each corresponding to a value having a remainder of 2 by division by 6 are permutated with the 66th, 67th, 68th, 69th, and 70th columns.

The matrix thus obtained by performing row and column permutation for the check matrix H in FIG. 133 corresponds to the check matrix H' in FIG. 134.

Row permutation performed for the check matrix H herein does not affect the arrangement of the sign bits of the LDPC code.

In addition, the column permutation in equation (12) corresponds to the above-described parity interleaving which interleaves the (K + qx + y + 1)th sign bit into the position of the (K + Py + x + 1)th sign bit and designates the information length K, the parallel factor P, and the divisor q (= M/P) of the parity length M (30 in this example) as 60, 5, and 6, respectively.

Accordingly, the check matrix H' in FIG. 134 is a transformed check matrix obtained by performing at least column permutation which permutates the (K + qx + y + 1)th column of the check matrix H in FIG. 133 (hereinafter referred to as the original check matrix where appropriate) with the (K + Py + x + 1)th column.

When the transformed check matrix H' in FIG. 134 is multiplied by an LDPC code which corresponds to the original check matrix H in FIG. 133 and which is permutated in the same manner as in equation (12), 0 vector is output. Specifically, assuming that a row vector c' is a row vector obtained by applying column permutation in equation (12) to a row vector c which is an LDPC code (one code word) corresponding to the original check matrix H, $Hc^T$ becomes 0 vector due to characteristics of check matrixes. Accordingly, $H'c'^T$ also obviously becomes 0 vector.

As apparent from above, the transformed check matrix H' in FIG. 134 is a check matrix for an LDPC code c' obtained by applying column permutation in equation (12) to the LDPC code c corresponding to the original check matrix H.

As described above, column permutation in equation (12) is applied to the LDPC code c corresponding to the original check matrix H. The LDPC code c' obtained after the column permutation is decoded (LDPC-decoded) by use of the transformed check matrix H' in FIG. 134. Inverse permutation of the column permutation in equation (12) is performed for the obtained decoding result. In this manner, a decoding result which is similar to that of the LDPC code generated from the original check matrix H and decoded using this check matrix H is derivable.

FIG. 135 is a diagram illustrating the transformed check matrix H' in FIG. 134 given spaces between each unit of 5 $\times$ 5 matrixes.

In FIG. 135, the transformed check matrix H' is expressed as combinations of a 5 $\times$ 5 (= P $\times$ P) unit matrix corresponding to a parallel factor P, a matrix having an element (elements) 0 in place of one or more elements 1 in the unit matrix (hereinafter referred to as a semi-unit matrix where appropriate), a matrix obtained by cyclically shifting (cyclic shift) the unit matrix or the semi-unit matrix (hereinafter referred to as a shift matrix where appropriate), a sum of two or more of the unit matrix, the semi-unit matrix, and the shift matrix (hereinafter referred to as a sum matrix where appropriate), and a 5 $\times$ 5 0 matrix.

The configuration of the transformed check matrix H' in FIG. 135 is considered to have the unit matrixes, the semi-unit matrixes, the shift matrixes, the sum matrixes, and the 0 matrixes, each of which is a 5 $\times$ 5 matrix. Accordingly, these 5 $\times$ 5 matrixes constituting the transformed check matrix H' (unit matrixes, semi-unit matrixes, shift matrixes, sum matrixes, and 0 matrixes) will hereinafter be referred to as constituent matrixes where appropriate.

For LDPC code decoding by a check matrix expressed as the P $\times$ P constituent matrixes, such architecture that simultaneously performs P operations of check node operation and variable node operation is adoptable.

FIG. 136 is a block diagram illustrating a configuration example of a decoding device performing such decoding.

Specifically, FIG. 136 illustrates a configuration example of a decoding device which achieves decoding of LDPC codes by using the transformed check matrix H' in FIG. 135 obtained by applying at least column permutation in equation (12) to the original check matrix H in FIG. 133.

The decoding device in FIG. 136 includes an edge data storage memory 300 including six FIFO $300_1$ to FIFO $300_6$, a selector 301 selecting the FIFO $300_1$ to the FIFO $300_6$, a check node calculation unit 302, two cyclic shift circuits 303 and 308, an edge data storage memory 304 including 18 FIFO $304_1$ to FIFO $304_{18}$, a selector 305 selecting the FIFO $304_1$ to the FIFO $304_{18}$, a received data memory 306 for storing received data, a variable node calculation unit 307, a decoded word calculation unit 309, a received data rearrangement unit 310, and a decoded data rearrangement unit 311.

A method for storing data in the edge data storage memories 300 and 304 will be initially described.

The edge data storage memory 300 includes the six FIFO $300_1$ to FIFO $300_6$. This number is calculated by dividing 30, which is the number of rows of the transformed check matrix H' in FIG. 135, by 5 which is the number of rows of the constituent matrix (parallel factor P). The FIFO $300_y$ (y = 1, 2, and up to 6) includes multiple stages of storage regions. Messages corresponding to the five edges, which number is equivalent to the number of rows and the number of columns of the constituent matrix (parallel factor P), can simultaneously be read and written from and to the storage regions in the respective stages. Moreover, the number of the stages of the storage regions of the FIFO $300_y$ is set to 9, which is the maximum number of the elements 1 (Hamming weight) in the row direction of the transformed check matrix in FIG. 135.

Data (the message $v_i$ from the variable node) corresponding to positions of 1 from the first row to the fifth row of the transformed check matrix H' in FIG. 135 is stored in the FIFO $300_1$ with the respective rows closed up in the horizontal direction (0 ignored). Specifically, assuming that a position of the jth row and the ith column is expressed as (j,i), data corresponding to positions of 1 in the 5 $\times$ 5 unit matrix from (1,1) to (5,5) in the transformed check matrix H' is stored in the storage region in the first stage of the FIFO $300_1$. Data corresponding to positions of 1 in the shift matrix from (1,21) to (5,25) (the shift matrix as the 5 $\times$ 5 unit matrix cyclically shifted by three to the right) of the transformed check matrix H' is stored in the storage region in the second stage. Similarly, data is stored in the storage regions in the third to eighth stages in association with the transformed check matrix H'. In addition, data corresponding to positions of 1 in the shift matrix from (1,86) to (5,90) (the shift matrix as the 5 $\times$ 5 unit matrix with replacement of 1 in the first row with 0 and cyclically shifted by one to the left) of the transformed check matrix H' is stored in the storage region in the ninth stage.

Data corresponding to positions of 1 from the sixth row to the tenth row of the transformed check matrix H' in FIG. 135 is stored in the FIFO $300_2$. Specifically, data corresponding to positions of 1 in a first shift matrix constituting a sum matrix from (6,1) to (10,5) (a sum matrix corresponding to the sum of the first shift matrix as the 5 $\times$ 5 unit matrix cyclically shifted by one to the right and a second shift matrix cyclically shifted by two to the right) of the transformed check matrix H' is stored in the storage region in the first stage of the FIFO $300_2$. Moreover, data corresponding to positions of 1 in the second shift matrix constituting the sum matrix from (6,1) to (10,5) in the transformed check matrix H' is stored in the storage region in the second stage.

Specifically, for a constituent matrix having a weight of 2 or larger, on an assumption that this constituent matrix is expressed as a sum of multiple matrixes selected from a P $\times$ P unit matrix having a weight of 1, a semi-unit matrix having an element (elements) 0 in place of one or more elements 1 in the unit matrix, and a shift matrix as the cyclically shifted unit matrix or semi-unit matrix, data corresponding to positions of 1 in the unit matrix having the weight of 1, the semi-unit matrix, or the shift matrix (messages corresponding to edges belonging to the unit matrix, the semi-unit matrix, or the shift matrix) is stored in the same address (the same FIFO in the FIFO $300_1$ to the FIFO $300_6$).

Similarly, data is stored in the storage regions of the following third to ninth stages in association with the transformed check matrix H'.

Similarly, data is stored in the FIFO $300_3$ to FIFO $300_6$ in association with the transformed check matrix H'.

The edge data storage memory 304 includes the 18 FIFO $304_1$ to FIFO $304_{18}$. This number is calculated by dividing 90, which is the number of columns of the transformed check matrix H', by 5 which is the number of columns of the constituent matrix (parallel factor P). The FIFO $304_x$ (x = 1, 2, and up to 18) includes multiple stages of storage regions. Messages corresponding to the five edges, which number is equivalent to the number of rows and the number of columns of the constituent matrix (parallel factor P), can simultaneously be read and written from and to the storage regions in the respective stages.

Data (the message $u_j$ from the check node) corresponding to positions of 1 from the first column to the fifth column of the transformed check matrix H' in FIG. 135 is stored in the FIFO $304_1$ with the respective columns closed up in the vertical direction (0 ignored). Specifically, data corresponding to positions of 1 in the $5 \times 5$ unit matrix from (1,1) to (5,5) in the transformed check matrix H' is stored in the storage region in the first stage of the FIFO $304_1$. Data corresponding to positions of 1 in a first shift matrix constituting a sum matrix from (6,1) to (10,5) (a sum matrix corresponding to the sum of the first shift matrix as the $5 \times 5$ unit matrix cyclically shifted by one to the right and a second shift matrix cyclically shifted by two to the right) of the transformed check matrix H' is stored in the storage region in the second stage. Moreover, data corresponding to positions of 1 in the second shift matrix constituting the sum matrix from (6,1) to (10,5) in the transformed check matrix H' is stored in the storage region in the third stage.

Specifically, for a constituent matrix having a weight of 2 or larger, on an assumption that this constituent matrix is expressed as a sum of multiple matrixes selected from a $P \times P$ unit matrix having a weight of 1, a semi-unit matrix having an element (elements) 0 in place of one or more elements 1 in the unit matrix, and a shift matrix as the cyclically shifted unit matrix or semi-unit matrix, data corresponding to positions of 1 in the unit matrix having the weight of 1, the semi-unit matrix, or the shift matrix (messages corresponding to edges belonging to the unit matrix, the semi-unit matrix, or the shift matrix) is stored in the same address (the same FIFO in the FIFO $304_1$ to the FIFO $304_{18}$).

Similarly, data is stored in the storage regions of the following fourth and fifth stages in association with the transformed check matrix H'. The number of the stages of the storage regions of the FIFO $304_1$ is set to 5, which is the maximum number of the elements 1 (Hamming weight) in the row direction in the first column to the fifth column of the transformed check matrix H'.

Similarly, data is stored in the FIFO $304_2$ and the FIFO $304_3$ in association with the transformed check matrix H'. Each of the lengths (each number of stages) is 5. Similarly, data is stored in the FIFO $304_4$ to the FIFO $304_{12}$ in association with the transformed check matrix H'. Each of the lengths is 3. Similarly, data is stored in the FIFO $304_{13}$ to FIFO $304_{18}$ in association with the transformed check matrix H'. Each of the lengths is 2.

Operation of the decoding device in FIG. 136 will be subsequently described.

The edge data storage memory 300 including the six FIFO $300_1$ to FIFO $300_6$ selects one of the FIFO $300_1$ to FIFO $300_6$ as the data storing FIFO, according to information (Matrix data) D312 indicating to which row of the transformed check matrix H' in FIG. 135 five messages D311 supplied from the cyclic shift circuit 308 in the previous stage belong, and collectively and sequentially stores the five messages D311 in the selected FIFO. Moreover, at the time of data reading, the edge data storage memory 300 sequentially reads five messages $D300_1$ from the FIFO $300_1$, and supplies the messages $D300_1$ to the selector 301 in the subsequent stage. After completion of reading of the messages from the FIFO $300_2$, the edge data storage memory 300 also sequentially reads messages from the FIFO $300_2$ to the FIFO $300_6$, and supplies the read messages to the selector 301.

The selector 301 selects five messages received from one of the FIFO $300_1$ to the FIFO $300_6$ as the FIFO from which data is currently read, according to a select signal D301, and supplies the selected five messages to the check node calculation unit 302 as messages D302.

The check node calculation unit 302 including five check node calculators $302_1$ to $302_5$ performs check node operation according to equation (7) with use of the messages D302 ($D302_1$ to $D302_5$) (message $v_i$ in equation (7)) supplied via the selector 301, and supplies five messages D303 ($D303_1$ to $D303_5$) (message $u_j$ in equation (7)) obtained by the check node operation to the cyclic shift circuit 303.

The cyclic shift circuit 303 cyclically shifts the five messages $D303_1$ to $D303_5$ obtained by the check node calculation unit 302, on the basis of information indicating how many times the original unit matrix (or semi-unit matrix) is cyclically shifted in the transformed check matrix H' to constitute the corresponding edges, and supplies obtained results to the edge data storage memory 304 as messages D304.

The edge data storage memory 304 including the 18 FIFO $304_1$ to FIFO $304_{18}$ selects one of the FIFO $304_1$ to FIFO $304_{18}$ as the data storing FIFO according to information (Matrix data) D305 indicating to which row of the transformed check matrix H' five messages D304 supplied from the cyclic shift circuit 303 in the previous stage belong, and collectively and sequentially stores the five messages D304 in the selected FIFO. Moreover, at the time of data reading, the edge data storage memory 304 sequentially reads five messages $D306_1$ from the FIFO $304_1$, and supplies the messages $D306_1$ to the selector 305 in the subsequent stage. After completion of reading of the data from the FIFO $304_1$, the edge data storage memory 304 also sequentially reads messages from the FIFO $304_2$ to the FIFO $304_{18}$, and supplies the read messages to the selector 305.

The selector 305 selects five messages received from one of the FIFO $304_8$ to $304_{18}$ as the FIFO from which data is currently read, according to a select signal D307, and supplies the selected five messages to the variable node calculation unit 307 and the decoded word calculation unit 309 as messages D308.

Meanwhile, the received data rearrangement unit 310 rearranges an LDPC code D313 that is received via the communication path 13 and that corresponds to the check matrix H in FIG. 133, by performing column permutation in equation (12), and supplies the rearranged LDPC code D313 to the received data memory 306 as received data D314. The received data memory 306 calculates a received LLR (log-likelihood ratio) from the received data D314 supplied from the received data rearrangement unit 310, stores the received LLR, and supplies sets of the five received LLRs to the variable node calculation unit 307 and the decoded word calculation unit 309 as received values D309. Note that the received data memory 306 need not calculate the received LLR in a case where the received data D314 is already the received LLR.

The variable node calculation unit 307 including five variable node calculators $307_1$ to $307_5$ performs variable node operation according to equation (1) by using messages D308 ($D308_1$ to $D308_5$) (message $u_j$ in equation (1)) supplied via the selector 305 and the five received values D309 (received value $u_{0i}$ in equation (1)) supplied from the received data memory 306, and supplies messages D310 ($D310_1$ to $D310_5$) (message $v_i$ in equation (1)) obtained by this operation to the cyclic shift circuit 308.

The cyclic shift circuit 308 cyclically shifts the messages $D310_1$ to $D310_5$ calculated by the variable node calculation unit 307, on the basis of information indicating how many times the original unit matrix (or semi-unit matrix) is cyclically shifted in the transformed check matrix H' to constitute the corresponding edges, and supplies obtained results to the edge data storage memory 300 as messages D311.

By completing one set of all the foregoing operations, one set of LDPC code decoding (variable node operation and check node operation) can be achieved. The decoding device in FIG. 136 decodes LDPC codes a predetermined number of times. Thereafter, the decoding device obtains final decoding results by using the decoded word calculation unit 309 and the decoded data rearrangement unit 311, and outputs the final decoding results.

Specifically, the decoded word calculation unit 309 including five decoded word calculators $309_1$ to $309_5$ calculates decoded results (decoded words) as a final stage of decoding performed multiple times, on the basis of equation (5) by using the five messages D308 ($D308_1$ to $D308_5$) output from the selector 305 (message $u_j$ in equation (5)) and the five received values D309 (received value $u_{0i}$ in equation (5)) supplied from the received data memory 306, and supplies decoded data D315 thus obtained to the decoded data rearrangement unit 311.

The decoded data rearrangement unit 311 performs inverse permutation of column permutation in equation (12) for the decoded data D315 supplied from the decoded word calculation unit 309, to achieve an order rearrangement of the decoded data D315, and outputs the rearranged decoded data D315 as final decoding results D316.

As described above, one of or both row permutation and column permutation is applied to a check matrix (original check matrix) to transform the check matrix into a check matrix (transformed check matrix) expressed as a combination of a $P \times P$ unit matrix, a semi-unit matrix having an element (elements) 0 in place of one or more elements 1 in the unit matrix, a shift matrix obtained by cyclically shifting the unit matrix or the semi-unit matrix, a sum matrix as a sum of multiple matrixes selected from the unit matrix, the semi-unit matrix, and the shift matrix, and $P \times P$ 0 matrix, i.e., a combination of constituent matrixes. In this manner, such architecture which simultaneously performs P operations of check node operation and variable node operation for LDPC code decoding is adoptable. This number P is a smaller than each number of rows and columns of the check matrix. In a case of adoption of the architecture which simultaneously performs P operations of node operation (check node operation and variable node operation), which number P is smaller than each number of rows or columns of the check matrix, a larger number of times of repetitive decoding is achievable while an operation frequency is reduced to a practical range in comparison with a case of simultaneously performing the same number of operations of the node operation as each number of the rows and columns of the check matrix.

For example, the LDPC decoder 166 constituting the reception device 12 in FIG. 130 is configured to simultaneously perform P operations of the check node operation and the variable node operation to achieve LDPC decoding similarly to the decoding device in FIG. 136.

Specifically, suppose herein that a check matrix for an LDPC code output from the LDPC encoder 115 constituting the transmission device 11 in FIG. 8 is a check matrix H including a parity matrix having a stepped structure as illustrated in FIG. 133, for example, for simplifying the description, the parity interleaver 23 of transmission device 11 sets an information length K, a parallel factor P, and a divisor q (= M/P) of the parity length M to 60, 5, and 6, respectively, and performs parity interleaving which interleaves the (K + qx + y + 1)th sign bit into the position of the (K + Py + x + 1)th sign bit.

As described above, this parity interleaving corresponds to column permutation in equation (12). Accordingly, the LDPC decoder 166 need not perform column permutation in equation (12).

Accordingly, as described above, the reception device 12 in FIG. 130 performs processing similarly to the decoding device in FIG. 136 except that an LDPC code not parity-interleaved, i.e., an LDPC code obtained after column permutation in equation (12) is applied, is supplied from the groupwise deinterleaver 55 to the LDPC decoder 166, and that the LDPC decoder 166 does not perform column permutation in equation (12).

Specifically, FIG. 137 is a diagram illustrating a configuration example of the LDPC decoder 166 in FIG. 130.

The LDPC decoder 166 in FIG. 137 has a configuration similar to that of the decoding device in FIG. 136 except that the received data rearrangement unit 310 in FIG. 136 is eliminated, and performs processing similarly to the decoding device in FIG. 136 except that column permutation in equation (12) is not included in the processing of the LDPC decoder 166. Accordingly, the same explanation is not repeated.

As apparent from above, the received data rearrangement unit 310 can be eliminated from the configuration of the LDPC decoder 166. Accordingly, scale reduction is achievable in comparison with the decoding device in FIG. 136.

Note that, while the code length N, the information length K, the parallel factor (each number of rows and columns of the constituent matrix) P, and the divisor q (= M/P) of the parity length M of the LDPC code are designated as 90, 60, 5, and 6, respectively, in FIGS. 133 to 137, for simplifying the explanation, each of the code length N, the information length K, the parallel factor P, and the divisor q (= M/P) is not limited to the values described above.

Specifically, for example, the LDPC encoder 115 of the transmission device 11 in FIG. 8 outputs LDPC codes having the code lengths N of 64800, 16200, 69120, 17280, and others, the information length K of N - Pq (= N - M), the parallel factor P of 360, and the divisor q of M/P. The LDPC decoder 166 in FIG. 137 is applicable to LDPC decoding of such LDPC codes by simultaneously performing P operations of the check node operation and the variable node operation.

Moreover, in a case where only information bits are output as a decoding result without outputting unnecessary parity parts included in a decoding result obtained after decoding of LDPC codes by the LDPC decoder 166, the decoded data rearrangement unit 311 can be eliminated from the configuration of the LDPC decoder 166.

<Configuration example of block deinterleaver 54>

FIG. 138 is a diagram explaining block deinterleaving performed by the block deinterleaver 54 in FIG. 131.

Block deinterleaving is reverse processing of block interleaving performed by the block interleaver 25 explained with reference to FIG. 79, to restore (reinstate) an arrangement of sign bits of an LDPC code to an original arrangement.

Specifically, for example, block deinterleaving restores an arrangement of sign bits of an LDPC code to an original arrangement by writing and reading the LDPC code to and from m columns, which is the same number as the number of bits m of a symbol, as in block interleaving.

However, in the case of block deinterleaving, writing of an LDPC code is performed in an order of reading of the LDPC code in block interleaving. Moreover, in the case of block deinterleaving, reading of an LDPC code is performed in an order of writing of the LDPC code in block interleaving.

Specifically, concerning a part 1 of an LDPC code, the part 1 of the LDPC code including m-bit symbol units is written in the row direction from the first column of all the m columns as illustrated in FIG. 138. In other words, sign bits of the LDPC code including the m-bit symbols are written in the row direction.

Writing of the part 1 in units of m bits is sequentially performed toward lower rows of the m columns. After completion of writing of the part 1, reading of the part 1 of the first column unit of the columns downward from the top is performed from the left columns to the right columns as illustrated in FIG. 138.

After completion of reading of the right end column, reading returns to the left end column as illustrated in FIG. 138, and reading of the part 1 of the second column unit of the columns downward from the top is performed for the left columns to the right columns. In a similar manner, the following reading of the part 1 of the LDPC code of one code word is achieved.

After completion of reading of the part 1 of the LDPC code of one code word, m-bit symbol units constituting a part 2 are sequentially connected to the end of the part 1. In this manner, an arrangement of the LDPC code in units of symbols is restored to an arrangement of sign bits of the LDPC code of original one code word (LDPC code before block interleaving).

<Another configuration example of bit deinterleaver 165>

FIG. 139 is a block diagram illustrating another configuration example of the bit deinterleaver 165 in FIG. 130.

Note that parts similar to corresponding parts in FIG. 131 are given identical reference signs, and will not be explained in the following description where appropriate.

Specifically, the bit deinterleaver 165 in FIG. 139 is configured similarly to the bit deinterleaver 165 in FIG. 131 except that a parity deinterleaver 1011 is additionally provided.

The bit deinterleaver 165 in FIG. 139 includes the block deinterleaver 54, the groupwise deinterleaver 55, and the parity deinterleaver 1011, and bit-deinterleaves sign bits of an LDPC code received from the demapper 164.

Specifically, the block deinterleaver 54 performs block deinterleaving (reverse processing of block interleaving) corresponding to block interleaving achieved by the block interleaver 25 of the transmission device 11 for an LDPC code received from the demapper 164, i.e., block deinterleaving which restores positions of sign bits changed by block interleaving to original positions, and supplies the LDPC code thus obtained to the groupwise deinterleaver 55.

The groupwise deinterleaver 55 performs groupwise deinterleaving for the LDPC code received from the block deinterleaver 54, as a process corresponding to groupwise interleaving which is a rearrangement process performed by the groupwise interleaver 24 of the transmission device 11.

The LDPC code obtained by groupwise deinterleaving is supplied from the groupwise deinterleaver 55 to the parity deinterleaver 1011.

The parity deinterleaver 1011 performs, for sign bits obtained after groupwise deinterleaving by the groupwise deinterleaver 55, parity deinterleaving (reverse processing of parity interleaving) corresponding to parity interleaving performed by the parity interleaver 23 of the transmission device 11, i.e., parity deinterleaving which restores, to an original arrangement, sign bits of the LDPC code whose arrangement has been changed by parity interleaving.

The LDPC code obtained by parity deinterleaving is supplied from the parity deinterleaver 1011 to the LDPC decoder 166.

Accordingly, the bit deinterleaver 165 in FIG. 139 supplies the LDPC code block-deinterleaved, groupwise-deinterleaved, and parity-deinterleaved, i.e., the LDPC code obtained by LDPC encoding according to a check matrix H, to the LDPC decoder 166.

The LDPC decoder 166 performs LDPC decoding of the LDPC code received from the bit deinterleaver 165, by using a check matrix H used by the LDPC encoder 115 of the transmission device 11 for LDPC encoding.

Specifically, for the type B system, the LDPC decoder 166 performs LDPC decoding for the LDPC code received from the bit deinterleaver 165, by using a check matrix H (of the type B system) used for LDPC encoding by the LDPC encoder 115 of the transmission device 11 without change, or by using a transformed check matrix obtained by applying at least column permutation corresponding to parity interleaving to this check matrix H. Moreover, for the type A system, the LDPC decoder 166 performs LDPC decoding for the LDPC code received from the bit deinterleaver 165, by using a check matrix (FIG. 28) obtained by applying column permutation to a check matrix (of the type A system) (FIG. 27) used for LDPC encoding by the LDPC encoder 115 of the transmission device 11, or by using a transformed check matrix (FIG. 29) obtained by applying row permutation to the check matrix (FIG. 27) used for LDPC encoding.

Note herein that the LDPC code obtained by LDPC encoding according to the check matrix H is supplied from the bit deinterleaver 165 (parity deinterleaver 1011 thereof) to the LDPC decoder 166 in FIG. 139. Accordingly, in a case where the LDPC decoding of this LDPC code is performed using the type B system check matrix H used by the LDPC encoder 115 of the transmission device 11 for LDPC encoding without change, or using the check matrix (FIG. 28) obtained by applying column permutation to the type A system check matrix (FIG. 27) used for LDPC encoding, the LDPC decoder 166 can include a decoding device which performs LDPC decoding by a full serial decoding system for sequentially performing operation of a message (check node message, variable node message) for each node, or can include a decoding device which performs LDPC decoding by a full parallel decoding system for simultaneously (in parallel) performing operation of messages for all nodes, for example.

Moreover, in a case where the LDPC decoder 166 performs LDPC decoding of the LDPC code by using the transformed check matrix obtained by applying at least column permutation corresponding to parity interleaving to the type B system check matrix H used by the LDPC encoder 115 of the transmission device 11 for LDPC encoding, or by using the transformed check matrix (FIG. 29) obtained by applying row permutation to the type A system check matrix (FIG. 27) used for LDPC encoding, the LDPC decoder 166 can include a decoding device (FIG. 136) which has architecture for simultaneously performing P (or a divisor of P other than 1) operations of check node operation and variable node operation and which has the received data rearrangement unit 310 applying, to the LDPC code, column permutation similar to column permutation (parity interleaving) for obtaining the transformed check matrix, to rearrange sign bits of the LDPC code.

While the block deinterleaver 54 performing block deinterleaving, the groupwise deinterleaver 55 performing groupwise deinterleaving, and the parity deinterleaver 1011 performing parity deinterleaving are separately configured in FIG. 139 for convenience of explanation, two or more of the block deinterleaver 54, the groupwise deinterleaver 55, and the parity deinterleaver 1011 can be integrally formed similarly to the parity interleaver 23, the groupwise interleaver 24, and the block interleaver 25 of the transmission device 11.

<Configuration example of reception system>

FIG. 140 is a block diagram illustrating a first configuration example of a reception system to which the reception device 12 is applicable.

The reception system in FIG. 140 includes an acquisition unit 1101, a transfer path decoding unit 1102, and an information source decoding unit 1103.

The acquisition unit 1101 acquires signals containing LDPC codes obtained by performing at least LDPC encoding for LDPC target data, such as image data and audio data of programs, via a not-illustrated transfer path (communication path), such as terrestrial digital broadcasting, satellite digital broadcasting, a CATV network, the Internet, and other networks, for example, and supplies the acquired signals to the transfer path decoding unit 1102.

In a case where the signals acquired by the acquisition unit 1101 herein are broadcasted from a broadcasting station via a ground wave, a satellite wave, a CATV (Cable Television) network, or others, for example, the acquisition unit 1101 includes a tuner, an STB (Set Top Box), or the like. Moreover, in a case where the signals acquired by the acquisition unit 1101 are transmitted by multicasting from a web server, such as IPTV (Internet Protocol Television), for example, the acquisition unit 1101 includes a network I/F (Inter face) such as an NIC (Network Interface Card), for example.

The transfer path decoding unit 1102 corresponds to the reception device 12. The transfer path decoding unit 1102 performs a transfer path decoding process for signals acquired by the acquisition unit 1101 via the transfer path. This process contains at least a process of correcting errors caused in the transfer path. The transfer path decoding unit 1102 supplies signals thus obtained to the information source decoding unit 1103.

Specifically, the signals acquired by the acquisition unit 1101 via the transfer path are signals resulted from at least error correction encoding for correcting errors caused in the transfer path. The transfer path decoding unit 1102 performs a transfer path decoding process such as an error correction process for these signals, for example.

For example, the error correction encoding herein includes LDPC encoding, BCH encoding, and others. At least LDPC encoding is carried out as the error correction encoding herein.

Moreover, the transfer path decoding process contains demodulation of modulation signals or the like in some cases.

The information source decoding unit 1103 performs an information source decoding process containing at least a process for decompressing compressed information to original information for the signals to which the transfer path decoding process has been applied.

Specifically, compression encoding for compressing information is applied to some signals acquired by the acquisition unit 1101 via the transfer path, in order to reduce a volume of data such as images and sounds as information. In this case, the information source decoding unit 1103 performs the information source decoding process such as a process for decompressing the compressed information to original information (decompression process) for the signals to which the transfer path decoding process has been applied.

Note that the information source decoding unit 1103 does not perform the process for decompressing compressed information to original information, in a case where compression encoding is not applied to the signals acquired by the acquisition unit 1101 via the transfer path.

The decompression process herein includes MPEG decoding and the like, for example. Moreover, the transfer path decoding process contains descrambling or the like in addition to the decompression process in some cases.

According to the reception system configured as above, the acquisition unit 1101 acquires, via the transfer path, signals of data such as images and sounds, for example, to which compression encoding, such as MPEG encoding, has been applied and error correction encoding, such as LDPC encoding, has also been applied, and supplies the acquired signals to the transfer path decoding unit 1102.

The transfer path decoding unit 1102 performs processing similar to processing carried out by the reception device 12, for example, as the transfer path decoding process for the signals received from the acquisition unit 1101, and supplies signals thus obtained to the information source decoding unit 1103.

The information source decoding unit 1103 performs the information source decoding process, such as MPEG decoding, for the signals received from the transfer path decoding unit 1102, and outputs images or sounds thus obtained.

For example, the reception system in FIG. 140 described above is applicable to TV tuners or the like receiving television broadcasting as digital broadcasting.

Note that each of the acquisition unit 1101, the transfer path decoding unit 1102, and the information source decoding unit 1103 can be constituted by one independent device (hardware (IC (Integrated Circuit), etc.) or software module).

Moreover, concerning the acquisition unit 1101, the transfer path decoding unit 1102, and the information source decoding unit 1103, a set of the acquisition unit 1101 and the transfer path decoding unit 1102, a set of the transfer path decoding unit 1102 and the information source decoding unit 1103, or a set of the acquisition unit 1101, the transfer path decoding unit 1102, and the information source decoding unit 1103 can be provided as one independent device.

FIG. 141 is a block diagram illustrating a second configuration example of the reception system to which the reception device 12 is applicable.

Note that parts similar to corresponding parts in FIG. 140 are given identical reference signs, and will not be explained in the following description where appropriate.

The reception system in FIG. 141 is similar to the reception system in FIG. 140 in a point that the acquisition unit 1101, the transfer path decoding unit 1102, and the information source decoding unit 1103 are provided, but is different in a point that an output unit 1111 is additionally provided.

For example, the output unit 1111 is a display device which display images or a speaker which outputs sounds, and outputs images, sounds, or the like as signals output from the information source decoding unit 1103. In other words, the output unit 1111 displays images or outputs sounds.

For example, the reception system in FIG. 141 configured as above is applicable to TV (television receiver) which receives television broadcasting as digital broadcasting, a radio receiver which receives radio broadcasting, or the like.

Note that signals output from the transfer path decoding unit 1102 are supplied to the output unit 1111 in a case where compression encoding is not applied to signals acquired by the acquisition unit 1101.

FIG. 142 is a block diagram illustrating a third configuration example of the reception system to which the reception device 12 is applicable.

Note that parts similar to corresponding parts in FIG. 140 are given identical reference signs, and will not be explained in the following description where appropriate.

The reception system in FIG. 142 is similar to the reception system in FIG. 140 in a point that the acquisition unit 1101 and the transfer path decoding unit 1102 are provided.

However, the reception system in FIG. 142 is different from the reception system in FIG. 140 in points that the information source decoding unit 1103 is not provided, and that a recording unit 1121 is additionally provided.

The recording unit 1121 records (stores) signals output from the transfer path decoding unit 1102 (e.g., TS packet of TS in MPEG) in a recording (storage) medium such as an optical disk, a hard disk (magnetic disk), and a flash memory.

The reception system in FIG. 142 configured as above is applicable to recorders for recording television broadcasting, for example.

Note that the reception system in FIG. 142 can include the information source decoding unit 1103, and record signals to which the information source decoding process has been applied by the information source decoding unit 1103, i.e., images and sounds obtained by decoding, in the recording unit 1121.

<Computer according to one embodiment>

Next, a series of the processes described above can be conducted by either hardware or software. In a case where the series of processes are conducted by software, a program constituting this software is installed in a general-purpose computer or the like.

With regard to this aspect, FIG. 143 illustrates a configuration example of a computer according to one embodiment. The program executing the series of processes described above is installed in this computer.

The program may be recorded beforehand in a hard disk 705 or a ROM 703, each of which is a recording medium built in the computer.

Alternatively, the program may be temporarily or permanently stored (recorded) in a removable recording medium 711 such as a flexible disk, a CD-ROM (Compact Disc Read Only Memory), an MO (Magneto Optical) disk, a DVD (Digital Versatile Disc), a magnetic disk, and a semiconductor memory. The removable recording medium 711 of the abovementioned type may be provided as what is generally called package software.

Note that, other than being installed in the computer from the removable recording medium 711 described above, the program may be wirelessly transferred to the computer from a download site via an artificial satellite for digital satellite broadcasting, or transferred by wire to the computer via a network such as a LAN (Local Area Network) and the Internet. The computer may receive the program transferred in such a manner via a communication unit 708, and install the program in the built-in hard disk 705.

The computer has a built-in CPU (Central Processing Unit) 702. An input/output interface 710 is connected to the CPU 702 via a bus 701. When a command is input to the CPU 702 from a user via the input/output interface 710 according to operation of an input unit 707 including a keyboard, a mouse, a microphone, or the like, for example, the CPU 702 executes a program stored in the ROM (Read Only Memory) 703 according to the command. Alternatively, the CPU 702 loads into a RAM (Random Access Memory) 704 a program stored in the hard disk 705, a program transferred from a satellite or a network, received via the communication unit 708, and installed in the hard disk 705, or a program that is read from the removable recording medium 711 attached to a drive 709 and that is installed in the hard disk 705, and executes the loaded program. In this manner, the CPU 702 conducts the processes following the flowcharts described above or the processes carried out by the configurations in the block diagrams referred to above. Thereafter, for example, the CPU 702 causes, via the input/output interface 710, an output unit 706 including an LCD (Liquid Crystal Display), a speaker, or the like to output processing results, causes the communication unit 708 to transmit the processing results, or causes the hard disk 705 to record the processing results as necessary.

Here, processing steps describing programs causing the computer to perform various processes in the present description are not necessarily required to be processed in time series in the orders described in the flowcharts, and include processes executed in parallel or individually (e.g., parallel processes or processes by objects).

Moreover, programs may be processed by one computer, or may be distributed and processed by multiple computers. Further, programs may be transferred to and executed by a remote computer.

Note that embodiments according to the present technology are not limited to the embodiment described above, and may be modified in various manners without departing from the subject matters of the present technology.

For example, the new LDPC codes (the check matrix initial value tables thereof) and the GW patterns described above are applicable to the communication path 13 (FIG. 7) for satellite lines, ground waves, cables (wired lines), and others. Moreover, the new LDPC codes and the GW patterns are available for data transfer other than digital broadcasting.

Further, while the LDPC encoder 115 (FIG. 8) performs encoding into LDPC codes on the basis of a check matrix for easy understanding of the explanation in the present description, a check matrix is information equivalent to a check matrix initial value table. Accordingly, encoding into LDPC codes based on a check matrix includes encoding into LDPC codes based on a check matrix initial value table. Similarly, decoding of LDPC codes by the LDPC decoder 166 (FIG. 130) on the basis a check matrix includes decoding of LDPC codes on the basis of a check matrix initial value table.

Note that advantageous effects described in the present description are presented only as examples and not by way of limitation. Accordingly, other advantageous effects may be produced.

[Reference Signs List]

11: Transmission device
12: Reception device
23: Parity interleaver
24: Groupwise interleaver
25: Block interleaver
54: Block deinterleaver
55: Groupwise deinterleaver
111: Mode adaptation and multiplexer
112: Padder
113: BB scrambler
114: BCH encoder
115: LDPC encoder
116: Bit interleaver
117: Mapper
118: Time interleaver
119: SISO/MISO encoder
120: Frequency interleaver
121: BCH encoder
122: LDPC encoder
123: Mapper
124: Frequency interleaver
131: Frame builder and resource allocation unit
132: OFDM generation unit
151: OFDM processing unit
152: Frame management unit
153: Frequency deinterleaver
154: Demapper
155: LDPC decoder
156: BCH decoder
161: Frequency deinterleaver
162: SISO/MISO decoder
163: Time deinterleaver
164: Demapper
165: Bit deinterleaver
166: LDPC decoder
167: BCH decoder
168: BB descrambler
169: Null deletion unit
170: Demultiplexer
300: Edge data storage memory
301: Selector
302: Check node calculation unit
303: Cyclic shift circuit
304: Edge data storage memory
305: Selector
306: Received data memory
307: Variable node calculation unit
308: Cyclic shift circuit
309: Decoded word calculation unit
310: Received data rearrangement unit
311: Decoded data rearrangement unit
601: Encoding unit
602: Storage unit
611: Code rate setting unit

612: Initial value table reading unit
613: Check matrix generation unit
614: Information bit reading unit
615: Encoding parity arithmetic unit
616: Control unit
701: Bus
702: CPU
703: ROM
704: RAM
705: Hard disk
706: Output unit
707: Input unit
708: Communication unit
709: Drive
710: Input/output interface
711: Removable recording medium
1001: Reverse replacement unit
1002: Memory
1011: Parity deinterleaver
1101: Acquisition unit
1101: Transfer path decoding unit
1103: Information source decoding unit
1111: Output unit
1121: Recording unit

**Claims**

1. A transmission device comprising:

an encoding unit that performs LDPC encoding on a basis of a check matrix for an LDPC code having a code length N of 17280 bits and a code rate r of 14/16;
a groupwise interleaving unit that performs groupwise interleaving for interleaving the LDPC code for each unit of a 360-bit bit group; and
a mapping unit that maps the LDPC code at any one of 16 signal points of a 2D-NUC (Non-Uniform Constellation) of 16QAM for each unit of four bits, wherein,
on an assumption that a (i + 1)th bit group from a head of the LDPC code is a bit group i, the groupwise interleaving interleaves an arrangement of bit groups of 0 to 47 of the LDPC code having 17280 bits into an arrangement of 3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27,
the LDPC code contains an information bit and a parity bit,
the check matrix contains an information matrix portion corresponding to the information bit and a parity matrix portion corresponding to the parity bit,
the information matrix portion is represented in a form of a check matrix initial value table, and
the check matrix initial value table includes a table indicating a position of an element 1 in the information matrix portion for each set of 360 columns, and indicates
337 376 447 504 551 864 872 975 1136 1225 1254 1271 1429 1478 1870 2122
58 121 163 365 515 534 855 889 1083 1122 1190 1448 1476 1635 1691 1954
247 342 395 454 479 665 674 1033 1041 1198 1300 1484 1680 1941 2096 2121
80 487 500 513 661 970 1038 1095 1109 1133 1416 1545 1696 1992 2051 2089
32 101 205 413 568 712 714 944 1329 1669 1703 1826 1904 1908 2014 2097
142 201 491 838 860 954 960 965 997 1027 1225 1488 1502 1521 1737 1804
453 1184 1542
10 781 1709
497 903 1546
1080 1640 1861
1198 1616 1817
771 978 2089

369 1079 1348
980 1788 1987
1495 1900 2015
27 540 1070
200 1771 1962
863 988 1329
674 1321 2152
807 1458 1727
844 867 1628
227 546 1027
408 926 1413
361 982 2087
1247 1288 1392
1051 1070 1281
325 452 467
1116 1672 1833
21 236 1267
504 856 2123
398 775 1912
1056 1529 1701
143 930 1186
553 1029 1040
303 653 1308
877 992 1174
1083 1134 1355
298 404 709
970 1272 1799
296 1017 1873
105 780 1418
682 1247 1867.

2. A transmission method comprising:

an encoding step of performing LDPC encoding on a basis of a check matrix for an LDPC code having a code length N of 17280 bits and a code rate r of 14/16;
a groupwise interleaving step of performing groupwise interleaving for interleaving the LDPC code for each unit of a 360-bit bit group; and
a mapping step of mapping the LDPC code at any one of 16 signal points of a 2D-NUC (Non-Uniform Constellation) of 16QAM for each unit of four bits, wherein,
on an assumption that a (i + 1)th bit group from a head of the LDPC code is a bit group i, the groupwise interleaving interleaves an arrangement of bit groups of 0 to 47 of the LDPC code having 17280 bits into an arrangement of 3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27,
the LDPC code contains an information bit and a parity bit,
the check matrix contains an information matrix portion corresponding to the information bit and a parity matrix portion corresponding to the parity bit,
the information matrix portion is represented in a form of a check matrix initial value table, and
the check matrix initial value table includes a table indicating a position of an element 1 in the information matrix portion for each set of 360 columns, and indicates
337 376 447 504 551 864 872 975 1136 1225 1254 1271 1429 1478 1870 2122
58 121 163 365 515 534 855 889 1083 1122 1190 1448 1476 1635 1691 1954
247 342 395 454 479 665 674 1033 1041 1198 1300 1484 1680 1941 2096 2121
80 487 500 513 661 970 1038 1095 1109 1133 1416 1545 1696 1992 2051 2089
32 101 205 413 568 712 714 944 1329 1669 1703 1826 1904 1908 2014 2097
142 201 491 838 860 954 960 965 997 1027 1225 1488 1502 1521 1737 1804
453 1184 1542
10 781 1709
497 903 1546

1080 1640 1861
1198 1616 1817
771 978 2089
369 1079 1348
980 1788 1987
1495 1900 2015
27 540 1070
200 1771 1962
863 988 1329
674 1321 2152
807 1458 1727
844 867 1628
227 546 1027
408 926 1413
361 982 2087
1247 1288 1392
1051 1070 1281
325 452 467
1116 1672 1833
21 236 1267
504 856 2123
398 775 1912
1056 1529 1701
143 930 1186
553 1029 1040
303 653 1308
877 992 1174
1083 1134 1355
298 404 709
970 1272 1799
296 1017 1873
105 780 1418
682 1247 1867.

3. A reception device comprising:

a groupwise deinterleaving unit that performs groupwise deinterleaving for restoring an arrangement of an LDPC code obtained from data transmitted by a transmission method and groupwise-interleaved to an original arrangement,
the transmission method including

an encoding step of performing LDPC encoding on a basis of a check matrix for the LDPC code having a code length N of 17280 bits and a code rate r of 14/16,
a groupwise interleaving step of performing groupwise interleaving for interleaving the LDPC code for each unit of a 360-bit bit group, and
a mapping step of mapping the LDPC code at any one of 16 signal points of a 2D-NUC (Non-Uniform Constellation) of 16QAM for each unit of four bits, wherein,
on an assumption that a (i + 1)th bit group from a head of the LDPC code is a bit group i, the groupwise interleaving interleaves an arrangement of bit groups of 0 to 47 of the LDPC code having 17280 bits into an arrangement of
3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27,
the LDPC code contains an information bit and a parity bit,
the check matrix contains an information matrix portion corresponding to the information bit and a parity matrix portion corresponding to the parity bit,
the information matrix portion is represented in a form of a check matrix initial value table, and
the check matrix initial value table includes a table indicating a position of an element 1 in the information matrix portion for each set of 360 columns, and indicates

337 376 447 504 551 864 872 975 1136 1225 1254 1271 1429 1478 1870 2122
58 121 163 365 515 534 855 889 1083 1122 1190 1448 1476 1635 1691 1954
247 342 395 454 479 665 674 1033 1041 1198 1300 1484 1680 1941 2096 2121
80 487 500 513 661 970 1038 1095 1109 1133 1416 1545 1696 1992 2051 2089
32 101 205 413 568 712 714 944 1329 1669 1703 1826 1904 1908 2014 2097
142 201 491 838 860 954 960 965 997 1027 1225 1488 1502 1521 1737 1804
453 1184 1542
10 781 1709
497 903 1546
1080 1640 1861
1198 1616 1817
771 978 2089
369 1079 1348
980 1788 1987
1495 1900 2015
27 540 1070
200 1771 1962
863 988 1329
674 1321 2152
807 1458 1727
844 867 1628
227 546 1027
408 926 1413
361 982 2087
1247 1288 1392
1051 1070 1281
325 452 467
1116 1672 1833
21 236 1267
504 856 2123
398 775 1912
1056 1529 1701
143 930 1186
553 1029 1040
303 653 1308
877 992 1174
1083 1134 1355 298 404 709
970 1272 1799
296 1017 1873
105 780 1418
682 1247 1867.

4. A reception method comprising:

a groupwise deinterleaving step of performing groupwise deinterleaving for restoring an arrangement of an LDPC code obtained from data transmitted by a transmission method and groupwise-interleaved to an original arrangement,
the transmission method including

an encoding step of performing LDPC encoding on a basis of a check matrix for the LDPC code having a code length N of 17280 bits and a code rate r of 14/16,
a groupwise interleaving step of performing groupwise interleaving for interleaving the LDPC code for each unit of a 360-bit bit group, and
a mapping step of mapping the LDPC code at any one of 16 signal points of a 2D-NUC (Non-Uniform Constellation) of 16QAM for each unit of four bits, wherein,
on an assumption that a (i + 1)th bit group from a head of the LDPC code is a bit group i, the groupwise interleaving interleaves an arrangement of bit groups of 0 to 47 of the LDPC code having 17280 bits into an arrangement of

3 35 16 36 41 32 7 20 39 38 1 47 5 24 14 17 0 34 2 6 13 43 9 15 31 37 21 46 25 26 11 42 30 40 44 10 23 18 8 22 29 28 45 4 33 19 12 27,

the LDPC code contains an information bit and a parity bit,

the check matrix contains an information matrix portion corresponding to the information bit and a parity matrix portion corresponding to the parity bit,

the information matrix portion is represented in a form of a check matrix initial value table, and

the check matrix initial value table includes a table indicating a position of an element 1 in the information matrix portion for each set of 360 columns, and indicates

337 376 447 504 551 864 872 975 1136 1225 1254 1271 1429 1478 1870 2122
58 121 163 365 515 534 855 889 1083 1122 1190 1448 1476 1635 1691 1954
247 342 395 454 479 665 674 1033 1041 1198 1300 1484 1680 1941 2096 2121
80 487 500 513 661 970 1038 1095 1109 1133 1416 1545 1696 1992 2051 2089
32 101 205 413 568 712 714 944 1329 1669 1703 1826 1904 1908 2014 2097
142 201 491 838 860 954 960 965 997 1027 1225 1488 1502 1521 1737 1804
453 1184 1542
10 781 1709
497 903 1546
1080 1640 1861
1198 1616 1817
771 978 2089
369 1079 1348
980 1788 1987
1495 1900 2015
27 540 1070
200 1771 1962
863 988 1329
674 1321 2152
807 1458 1727
844 867 1628
227 546 1027
408 926 1413
361 982 2087
1247 1288 1392
1051 1070 1281
325 452 467
1116 1672 1833
21 236 1267
504 856 2123
398 775 1912
1056 1529 1701
143 930 1186
553 1029 1040
303 653 1308
877 992 1174
1083 1134 1355
298 404 709
970 1272 1799
296 1017 1873
105 780 1418
682 1247 1867.

# FIG.1

# FIG.2

# F I G . 3

$$
H = \begin{bmatrix}
1 & 1 & 1 & 0 & 0 & 0 & 1 & 0 & 1 & 1 & 0 & 0 \\
1 & 1 & 0 & 1 & 1 & 0 & 0 & 0 & 0 & 0 & 1 & 1 \\
0 & 0 & 1 & 1 & 1 & 1 & 1 & 0 & 0 & 1 & 0 & 0 \\
0 & 0 & 0 & 1 & 1 & 1 & 0 & 1 & 1 & 0 & 0 & 1 \\
1 & 1 & 0 & 0 & 0 & 1 & 0 & 1 & 0 & 1 & 1 & 0 \\
0 & 0 & 1 & 0 & 0 & 0 & 1 & 1 & 1 & 0 & 1 & 1
\end{bmatrix}
$$

# FIG.4

CHECK NODE

VARIABLE NODE

# FIG.5

# FIG.6

# FIG.7

TRANSFER SYSTEM

F I G . 8

TRANSMISSION DEVICE  11

Input streams →

Mode Adaptation/ Multiplexer  111

padder  112

BB Scrambler  113

BCH encoder  114

LDPC encoder  115

Bit Interleaver  116

Mapper  117

Time Interleaver  118

SISO/ MISO encoder  119

Frequency Interleaver  120

signalling →

BCH encoder  121

LDPC encoder  122

Mapper  123

Frequency Interleaver  124

131 → Frame Builder & Resource Allocation

OFDM generation  132

FIG.9

# FIG.10

INFORMATION LENGTH K

PARITY LENGTH M

$H=$

INFORMATION MATRIX $H_A$

PARITY MATRIX $H_T$

PARITY LENGTH M

CODE LENGTH N

CHECK MATRIX

# FIG.11

$$H_T =$$

PARITY MATRIX $H_T$

# FIG.12

INFORMATION MATRIX $H_A$     PARITY MATRIX $H_T$

CHECK MATRIX

| X | COLUMN WEIGHT 3 | COLUMN WEIGHT 2 | 1 |

KX    K3    M−1    1

M

# FIG.13

| Nominal CODE RATE | N=64800 | | | | N=16200 | | | |
|---|---|---|---|---|---|---|---|---|
| | X | KX | K3 | M | X | KX | K3 | M |
| 1/4 | 12 | 5400 | 10800 | 48600 | 12 | 1440 | 1800 | 12960 |
| 1/3 | 12 | 7200 | 14400 | 43200 | 12 | 1800 | 3600 | 10800 |
| 2/5 | 12 | 8640 | 17280 | 38880 | 12 | 2160 | 4320 | 9720 |
| 1/2 | 8 | 12960 | 19440 | 32400 | 8 | 1800 | 5400 | 9000 |
| 3/5 | 12 | 12960 | 25920 | 25920 | 12 | 3240 | 6480 | 6480 |
| 2/3 | 13 | 4320 | 38880 | 21600 | 13 | 1080 | 9720 | 5400 |
| 3/4 | 12 | 5400 | 43200 | 16200 | 12 | 360 | 11520 | 4320 |
| 4/5 | 11 | 6480 | 45360 | 12960 | – | 0 | 12600 | 3600 |
| 5/6 | 13 | 5400 | 48600 | 10800 | 13 | 360 | 12960 | 2880 |
| 8/9 | 4 | 7200 | 50400 | 7200 | 4 | 1800 | 12600 | 1800 |
| 9/10 | 4 | 6480 | 51840 | 6480 | —— | —— | —— | —— |

NUMBER OF COLUMNS FOR EACH COLUMN WEIGHT

FIG.14

SIGN BIT

Erasure          Erasure

VARIABLE NODE

CHECK NODE

# FIG.15

STEPPED STRUCTURE
OF PARITY MATRIX

A

SIGN BIT

Erasure   Erasure

VARIABLE NODE

CHECK NODE

STEPPED STRUCTURE
PORTION OF Tanner Graph

B

# FIG.16

ADJOINING NODES
ARE SEPARATED BY
360 COLUMNS.

360  360  360  360

360
360
360
360

M=q × 360 ROWS

※ THIS EXAMPLE ALSO PERFORMS
ROW PERMUTATION, BUT ONLY
COLUMN PERMUTATION IS
SIGNIFICANT IN "interleave."

PARITY MATRIX

Parity BIT HAS HIGHER RESISTANCE TO Burst ERROR
ONLY BY THIS SEPARATION.

EP 4 478 616 A1

# F I G . 1 7

```
          ( START )
              │
              ▼
      ┌─────────────────┐
      │  LDPC-ENCODE    │ S101
      └─────────────────┘
              │
              ▼
┌──────────────────────────────────────────────────────┐
│                  BIT INTERLEAVE                        │ S102
│ (PARITY INTERLEAVE, GROUPWISE INTERLEAVE, AND BLOCK INTERLEAVE) │
└──────────────────────────────────────────────────────┘
              │
              ▼
      ┌─────────────────┐
      │ MAP AND MODULATE │ S103
      └─────────────────┘
              │
              ▼
          ( END )
```

# FIG. 18

# FIG.19

```
                          ┌─────────┐
                          │  START  │
                          └─────────┘
                               │
                               ▼
S201    ┌────────────────────────────────────────────────┐
        │         SET CODE RATE OF CHECK MATRIX           │◄──┐
        └────────────────────────────────────────────────┘   │
                               │                              │
                               ▼                              │
S202    ┌────────────────────────────────────────────────┐   │
        │     READ CHECK MATRIX INITIAL VALUE TABLE       │   │
        │         CORRESPONDING TO CODE RATE              │   │
        └────────────────────────────────────────────────┘   │
                               │                              │
                               ▼                              │
S203    ┌────────────────────────────────────────────────┐   │
        │      DETERMINE CHECK MATRIX H FOR LDPC CODE     │   │
        └────────────────────────────────────────────────┘   │
                               │                              │
                               ▼                              │
S204    ┌────────────────────────────────────────────────┐   │
        │           READ INFORMATION BIT STREAM           │   │
        └────────────────────────────────────────────────┘   │
                               │                              │
                               ▼                              │
S205    ┌────────────────────────────────────────────────┐   │
        │   LDPC-ENCODE INFORMATION BIT STREAM BY CHECK   │   │
        │   MATRIX H, AND PERFORM PARITY CALCULATION      │   │
        └────────────────────────────────────────────────┘   │
                               │                              │
                               ▼                              │
S206            ◄ ENCODING END? ►─────No──────────────────────┘
                          │ Yes
                          ▼
                     ┌─────────┐
                     │   END   │
                     └─────────┘
```

# FIG.20

```
┌─r1/4  16K ──────────────────────────────────────────────────┐
│  6295  9626  304  7695  4839  4936  1660  144  11203  5567  6347  12557
│  10691  4988  3859  3734  3071  3494  7687  10313  5964  8069  8296  11090
│  10774  3613  5208  11177  7676  3549  8746  6583  7239  12265  2674  4292
│  11869  3708  5981  8718  4908  10650  6805  3334  2627  10461  9285  11120
│  7844  3079  10773
│  3385  10854  5747
│  1360  12010  12202
│  6189  4241  2343
│  9840  12726  4977
└──────────────────────────────────────────────────────────────┘
```

# FIG.21

EP 4 478 616 A1

DISPLAY ROW NUMBERS OF CHECK MATRIX (INFORMATION
MATRIX $H_A$) FROM FIRST COLUMN FOR EACH SET OF 360 COLUMNS
ROW NUMBERS OF CHECK MATRIX

1ST COLUMN IN $H_A$ ⟶

361ST COLUMN IN $H_A$ ⟶

721ST COLUMN IN $H_A$ ⟶

1081ST COLUMN IN $H_A$ ⟶

```
0   2084  1613  1548  1286  1460  3196  4297  2481  3369  3451  4620  2622
1   122   1516  3448  2880  1407  1847  3799  3529  373   971   4358  3108
2   259   3399  929   2650  864   3996  3833  107   5287  164   3125  2350
3   342   3529
4   4198  2147
5   1880  4836
6   3864  4910
7   243   1542
8   3011  1436
9   2167  2512
10  4606  1003
11  2835  705
12  3426  2365
13  3848  2474
14  1360  1743
0   163   2536
1   2583  1180
2   1542  509
3   4418  1005
4   5212  5117
5   2155  2922
6   347   2696
7   226   4296
8   1560  487
9   3926  1640
10  149   2928
11  2364  563
12  635   688
13  231   1684
14  1129  3894
```

$h_{3,5}$

CHECK MATRIX
INITIAL VALUE TABLE

# FIG.22

# FIG.23

2 6 18
2 10 19
22
19
17

# FIG.24

EP 4 478 616 A1

FIG. 2 5

FIG.26

FIG.27

FIG.28

ROW NUMBER

# F I G . 2 9

ROW NUMBER

EP 4 478 616 A1

# FIG.30

Rate 2/16 17k Type A CODE TABLE
```
 485  1444  1737  3762  7283  10663
 181  1563  1623  3902  12647
1077  1216  1709  11264  13865
 303  1225  1369  13470  14991
1067  1226  1795  2169  2507  2677  2727  2773  3609  3926  3996  4192  5004  5921  6134
6385  7419  7595  7821  8996  9413  10318  10557  10886  11307  11599  12641  13430
 101  1264  1427  1860  2032  2063  3143  3156  4227  4554  4732  5165  5447  5902  6145
6721  7170  8660  8833  9081  9643  9800  10233  11723  12547  13124  14196  14723
3403  3678  5842  7967  8991  9220  9663  10299  10343  10550
1951  2354  3899  4774  7602  9120  9666  11048  14327  15089
2588  3047  4252  4831  5220  5487  5626  6380  9410  10618
2261  2295  5693  6711  6789  8342  11569  11943  12826  14312
3441  5287  7665  7864  8134  8446  10920  11625  12710  13309
```

# FIG.31

Rate 3/16 17k Type A CODE TABLE
```
  10  1155  1332  1608  8228  8253  11662
 483  1297  1433  4678  5776  10410  13553
 862  967  1036  1842  2950  10129  12042
 258  872  1037  7129  9442  9491  10644
 215  260  590  6003  7554  10499
 197  521  1190  1670  3696  4410  4436  4686  5350  5651  7397  7503  8553  9844  10729
11421  11605  11742  11835  12338  12422
 288  560  1427  1492  1932  3255  4508  4628  5259  5881  6136  8019  8152  8192  8230  8669
8880  10289  11160  11665  12374
 694  1175  1205  2363  2756  2962  3097  3374  4268  4811  6072  6393  6942  9514  9733
10681  11081  11360  12386  13467  13980
  25  1200  1266  3036  3441  4940  5161  5254  7231  7585  8088  9414  10217  10349  10409
11177  12151  12497  12934  13123  14029
2599  5475  6890  7755  8567  9088  11980
2708  2836  6062  6328  8890  9831  11173
2522  2634  4989  6831  9523  10731  12107
4738  5653  7862  11986  12773  12839  13045
```

# F I G . 3 2

Rate 4/16 17k Type A CODE TABLE

478 512 714 1103 3052 4701 6654 7690 7824 11154 11948 12493

73 155 855 1758 2467 4962 5168 5785 7323 11891 12232

41 433 636 1280 2182 2342 2768 3511 7654 8802 9938

196 434 672 5407 6013 7349 8268 8640 9257 9675 11987

23 543 562 1355 2157 3037 6464 8139 10004 10047 12628

743 900 982 3188 5095 7926 8936 10387 10419 11190 12422

102 647 1000 3957 4826 5892 8640 8655 11125 11210 12955

273 652 788 1958 2647 4003 5015 6364 9191 9966 10147

372 566 772 7093 7353 8285 8592 9651 11787 12190 12376

33 257 943 3805 5647

196 681 983 9412 11567

59 720 1009 2814 12177

1148 1691 2098 2308 2328 3860 4055 6680 6822 7271 8041 8748 9723 10748 12636 12730 12865

1827 2104 3047 3338 5151 5312 5452 6563 8783 8998 9056 10576 10679 10817 12032 12681 12822

1948 2778 3225 4292 5260 5874 6550 6773 7369 7627 8500 9799 10247 11775 12207 12324 12891

# FIG.33

Rate 5/16 17k Type A CODE TABLE

301 342 350 1797 7970 8230 10820 11305

139 530 615 1566 6290 6425 9185 9466

48 419 444 1773 3213 4793 8594 10480

246 455 531 3011 5845 7383 8393 10709

39 262 290 3282 5208 9539 10955 11204

234 267 623 1033 1537 8766 11527 11557

494 661 671 1123 4497 6601 6715 10473

164 425 436 3259 4505 5614 8192 10221

326 377 477 7699 10162 11174 11878

206 360 557 891 930 1847 2427 3888 4491 6494 6911 8084 8945 9549

402 588 657 888 3271 4858 5257 6398 6631 6972 9678 11140 11159 11398

39 111 168 1192 1879 3121 3127 5987 8385 8488 9302 9884 10891 11879

639 640 693 1477 1790 2442 3388 3547 4622 6890 7315 7478 7905 11518

337 544 604 1184 1238 1334 2434 5239 6832 7770 9123 9397 9646 10254

32 77 604 762 1428 2756 2758 6854 7193 7311 7517 9105 10765 11173

910 1918 2342 3280 3362 3913 4586 6316 7693 8878 10922 11145 11863

790 1177 1386 1961 2437 3571 5179 5961 8222 9195 9569 10414 11498

# F I G . 3 4

Rate 6/16 17k Type A CODE TABLE

416 437 444 1657 2662 4109 4405 6308 8251

75 498 687 3903 4582 7035 7650 7871 10382

394 419 474 3515 6708 7277 8703 9969 10489

167 289 612 1847 5277 5900 8326 8508 9462

196 439 620 2128 2375 2501 6902 9308 9552

154 495 623 5024 6241 8364 9996 10104 10346

230 329 661 879 1474 3222 4109 8079 8865

97 172 692 1018 1629 1752 3170 5930

359 377 712 6273 7131 7278 8292 10457

368 551 708 787 2891 6140 7195 9555

44 512 655 2196 6692 7975 8410 10727

27 94 611 5585 7258 8091 9867 10714

608 639 691 3560 6819 7492 7754 7916

46 115 214 2175 5986 7177 8589 10757

282 589 604 969 1856 2433 5742 8900

243 262 669 1330 1366 3339 5517 7517

62 392 651 4175 8349 8557 9192 10015

206 375 697 1449 2015 2390 3926 4428 5084 5236 5872 8486 9398 9997 10469

1079 1384 1664 2936 4618 5359 5455 5537 5726 5875 8044 8521 9746

791 1106 1497 1885 2682 3473 3716 4506 5671 5829 8388 8641 9454

# FIG.35

Rate 7/16 17k Type A CODE TABLE

512 531 598 3235 3447 5630 5765 6208 7026 9012

88 486 926 1714 5140 5725 6006 6506 7619 8191

200 447 460 1088 2612 3297 4001 4275 4992 8638

106 434 618 5357 5713 9045 9335 9429 9696

23 192 661 1220 2962 3867 5783 6410 6790

311 744 934 1267 1428 1959 2462 2865 5461

69 494 991 1278 4441 5620 5705 5936 8872

297 637 1031 2346 2946 4519 7235 7264 9243

330 599 790 3674 5457 6535 6660 7398 8110

263 630 826 1978 3384 4259 5159 5588 5885

196 648 983 1529 1821 2312 2428 7249 7359

59 774 1036 1427 2005 5811 6998 7987 8222

454 474 986 1633 4040 6880 7786 8518 9039

433 443 849 2517 3617 5477 6294 7914 9456

175 242 906 2924 3412 4063 7737 9084 9338

385 624 1004 3218 5225 6479 7684 7933 8875

233 622 807 2302 3315 3898 4079 7109 9201

3 877 1070 1331 2607 3552 4672 7549 8083

247 753 806

12 242 598

221 561 643

1135 1424 2228 9426

4998 5209 7742 8652

2042 5925 6236 9405

# F I G . 3 6

Rate 7/16 17k Type B CODE TABLE

193 217 530 596 789 1340 1569 1662 1887 1889 2299 2610 2629 2790 3464 3607 3935 4439 5460 5721 5758 6094 6280 6350 6449 6613 6682 6826 6906 7048 7425 8229 8627 8679 8735 8814 9079 9146

435 572 815 903 1063 1962 1989 2215 2417 2862 2914 3182 3980 4414 4566 4895 4950 5163 5336 5388 5642 5764 6586 6719 6787 7262 7609 8000 8561 8790 9027 9334 9358 9420 9444 9553 9614

250 3557 3865 4350 4394 4644 5303 6590 8377 8497 9655

21 602 1038 1212 1243 3938 4136 5620 6516 6777 8226

134 214 1550 1554 1615 3178 5113 5163 5201 7168 7574

134 2692 3810 4954 6766

2394 4734 5731 7427 7653

509 1009 3867 5069 9121

540 2975 6248

4 831 3592

503 1385 7170

348 7774 8897

67 3553 5134

623 6525 8314

2871 7545 8960

4330 4839 7689

4793 5327 8046

2877 3422 8836

2069 7584 9102

1376 3862 4352

4693 7147 9461

# FIG.37

```
Rate 8/16 17k Type B CODE TABLE
  516 1070 1128 1352 1441 1482 2437 5049 5157 5266 5585 5716 6907 8094
  299 4342 4520 4988 5163 5453 5731 5752 6985 7155 8031 8407 8519 8618
  178 181 743 814 1188 1313 1384 1769 1838 1930 1968 2123 2487 2497 2829 2852
3220 3245 3936 4054 4358 4397 4482 4514 4567 4711 4785 5217 6030 6747 7127 7254
7845 8552
  125 430 594 628 641 740 1895 2007 2148 2363 2790 2920 3158 3493 3768 3805
3896 5067 5103 5121 5292 5764 5857 5948 6338 6523 6578 6880 7303 7557 8242 8371
8387 8634
  1631 2139 2453 2544 5442 6255
  127 2676 3774 4289 5764 7450
  1270 1856 2025 2065 3259 7787
  645 1648 5077 6644 6650 8198
  485 904 4510
  624 4137 7388
  724 4865 8587
  1247 4729 6266
  5604 6147 6898
  63 4763 6319
  930 6174 7453
  981 2960 8486
  4286 4304 8058
  1460 6205 7561
  2339 2998 8002
  1824 6660 8286
  4264 5378 7779
  4145 6343 8515
  5007 6959 7845
  1853 6196 8289
```

# FIG.38

Rate 9/16 17k Type B CODE TABLE

291 817 1023 1118 1168 1195 1419 1763 2507 3005 3886 3952 4046 4924 5372 5586
5742 5925 6080 6157 6301 6600 6644 7052 7093 7105 7487
133 565 957 1018 1150 1196 1210 1224 1361 1484 2330 2448 2525 2583 2639 3198
3407 3504 4272 4383 5133 5399 5421 5545 6972 7156
129 365 541 1026 1199 1527 2467 3386 3458 4215 4438 4778 5176 5484 5521 5540
5788 6103 6287 6360 6605 6745 6973 7251 7329 7336
996 1392 2493 2910 3048 3281 4969 5189 5632 6236 6983
165 2521 2650 2824 3493 4637 5670 6470
266 345 390 2365 2843 3274 4321 5165
245 2173 2274 2687 3763 4284 5562 6564
2787 2970 3503
691 3718 5047
593 969 3593
331 3809 6269
1627 2886 5935
1046 2976 4457
4725 6028 6458
6172 6610 7530
1536 7102 7148
233 2463 4955
826 4319 6969
3073 6675 6774
407 4251 7087
1380 3802 4937
1911 4360 6306
4027 6219 7292
398 1190 1936
250 830 7241
5500 5828 7478
1261 4649 7237

# FIG.39

Rate 10/16 17k Type B CODE TABLE

579 608 613 760 795 839 910 1895 2239 2535 2670 2871 3127 3316 3779 3829 3936 4454 4772 4926 6048 6166 6352

263 291 694 1172 1232 1925 2657 3037 3057 3400 3550 3812 4185 4325 5202 5441 5479 5640 5864 5892 6154 6157 6227

527 601 1254 1476 1760 2070 2099 2725 2961 3529 3591 4324 4393 4462 4841 5070 5480 5698 5856 5865 6087 6446

235 319 480 2036 2188 2358 2423 2510 2911 3225 3472 3677 3840 4409 4574 4892 5119 5548 5805 5901 6290 6477

1809 2974 3464 5295 5490 5671

2148 3629 4304 4854 4876 6037

2031 2246 3358 4679 6125 6331

874 2483 2964 3872 4509 4904

4001 4303 5079

1652 4524 5263

2551 3381 5524

713 1908 6304

2722 3347 6201

433 923 5564

2181 4242 6202

51 2711 4435

414 708 5539

2222 5036 5974

784 3588 5125

4256 5004 5540

1761 2781 6037

1547 2266 4377

4109 5836 6337

767 2468 4764

2528 5457 5872

884 4651 4807

161 3582 5164

744 2624 4852

239 1740 5807

33 3595 5121

# FIG.40

Rate 11/16 17k Type B CODE TABLE

91 382 494 654 681 695 1643 2171 2576 3027 3115 3390 3633 3644 3812 3883 4474 4607 4674

384 396 982 988 1053 1867 2215 2345 2472 3323 3503 3573 3883 4159 4576 4917 5104 5130

456 580 1590 1715 1786 1843 1934 2251 2261 2466 2525 2958 3467 4334 4530 4779 4885 5021

227 381 394 502 1059 1108 1480 1508 1523 1620 1840 1996 2436 2989 3716 3957 4072 4243 4482 4517 4717 4910 5105 5220 5238 5279

376 957 1706 2028 2228 2439 2552 4249 5234

89 676 1098 1103 1127 1449 1605 2362 4640

66 613 1692 1901 2247 3025 3244 4864 5050

1628 2015 2596

521 802 3804

3178 4080 5057

344 3486 3948

595 2538 2964

300 1355 3476

1292 2761 4819

462 773 3996

133 3494 4342

37 3698 4382

345 3624 4745

124 4197 4978

873 2686 4266

989 2966 4180

1468 1932 4913

1140 4164 5060

3361 4952 5287

2584 4646 5260

809 2481 4893

1201 1532 3877

128 2430 4279

621 4810 5249

200 717 5066

2283 2998 4164

704 2587 4736

106 2080 3279

# ＦＩＧ．４１

Rate 12/16 17k Type B CODE TABLE

137 199 292 423 527 694 798 2233 2339 2948 2986 3261 3284 3410 3612 3866 4296

633 691 1035 1038 1250 1476 1885 2332 2871 3064 3186 3785 4114 4205 4213 4280 4291

136 166 369 677 878 1119 1360 1401 1501 1823 1950 2492 2760 2843 3151 3168 3189

23 27 74 90 779 1085 1204 1364 1846 2594 2971 3075 3373 3486 4030 4037 4044

286 789 1412 1513 2388 2407 2725 2757 2790 2839 3111 3227 3292 3596 3665 3710 4147

79 178 389 447 608 625 672 786 965 1258 1605 1677 1816 1910 3027 3815 4292

208 2694 3685

480 770 791

261 3447 3751

1271 2122 3312

134 352 1592

517 1877 2106

173 693 1792

1975 2062 3529

734 1035 1136

546 863 4212

817 2712 3692

415 3771 4305

646 1514 3870

1481 2675 4276

454 2248 2517

1073 1754 2107

1170 1472 3699

841 2243 3804

2485 3636 3894

1961 2302 3591

225 2704 3938

487 1067 3992

2747 3054 3661

2476 2885 3456

242 487 4018

2037 2511 4232

1278 1636 3609

1099 1450 3842

1299 1632 1717

545 4160 4295

# FIG.42

Rate 13/16 17k Type B CODE TABLE

225 274 898 916 1020 1055 1075 1179 1185 1343 1376 1569 1828 1972 2852 2957 3183

548 602 628 928 1077 1474 1557 1598 1935 1981 2110 2472 2543 2594 2721 2884 2981

59 69 518 900 1158 1325 1367 1480 1744 2069 2119 2406 2757 2883 2914 2966 3232

1330 1369 1712 2133 2206 2487 2596 2606 2612 2666 2726 2733 2754 2811 2948 3030

391 542 689 748 810 1716 1927 2006 2296 2340 2357 2514 2797 2887 2896 3226

256 410 799 1126 1377 1409 1518 1619 1829 2037 2303 2324 2472 2475 2874 2992

862 1522 1905

809 842 945

561 1001 2857

2132 2592 2905

217 401 1894

11 30 1860

210 1188 2418

1372 2273 2455

407 2537 2962

939 2401 2677

2521 3077 3173

1374 2250 2423

23 188 1320

472 714 2144

2727 2755 2887

1814 2824 2852

148 1695 1845

595 1059 2702

1879 2480 2578

17 411 559

146 783 2154

951 1391 1979

1507 1613 3106

642 882 2356

1008 1324 3125

196 1794 2474

1129 1544 2931

765 1681 2591

1550 1936 3048

1596 1607 2794

156 1053 2926

1246 1996 3179

348 752 1943

# FIG.43

Rate 14/16 17k Type B CODE TABLE

```
337  376  447  504  551  864  872  975  1136 1225 1254 1271 1429 1478 1870 2122
58   121  163  365  515  534  855  889  1083 1122 1190 1448 1476 1635 1691 1954
247  342  395  454  479  665  674  1033 1041 1198 1300 1484 1680 1941 2096 2121
80   487  500  513  661  970  1038 1095 1109 1133 1416 1545 1696 1992 2051 2089
32   101  205  413  568  712  714  944  1329 1669 1703 1826 1904 1908 2014 2097
142  201  491  838  860  954  960  965  997  1027 1225 1488 1502 1521 1737 1804
453  1184 1542
10   781  1709
497  903  1546
1080 1640 1861
1198 1616 1817
771  978  2089
369  1079 1348
980  1788 1987
1495 1900 2015
27   540  1070
200  1771 1962
863  988  1329
674  1321 2152
807  1458 1727
844  867  1628
227  546  1027
408  926  1413
361  982  2087
1247 1288 1392
1051 1070 1281
325  452  467
1116 1672 1833
21   236  1267
504  856  2123
398  775  1912
1056 1529 1701
143  930  1186
553  1029 1040
303  653  1308
877  992  1174
1083 1134 1355
298  404  709
970  1272 1799
296  1017 1873
105  780  1418
682  1247 1867
```

# FIG.44

EP 4 478 616 A1

# FIG.45

v1 PIECES　　　　v2 PIECES　　　　v3 PIECES

VARIABLE NODE

EDGE

FIRST INTERLEAVER　　　SECOND INTERLEAVER

EDGE

CHECK NODE

c1 PIECES　　　c2 PIECES　　　c3 PIECES

EP 4 478 616 A1

# FIG.46

EP 4 478 616 A1

FIG.47

EP 4 478 616 A1

| Rate | K | X1 | K1 | X2 | K2 | X3 | K3 | XM1 | M1 | M2 |
|------|------|----|------|----|------|----|------|-----|------|-------|
| 2/16 | 2160 | 6  | 360  | 5  | 1080 | 28 | 720  | 10  | 1800 | 13320 |
| 3/16 | 3240 | 7  | 1440 | 6  | 360  | 21 | 1440 | 7   | 1440 | 12600 |
| 4/16 | 4320 | 12 | 360  | 11 | 2880 | 5  | 1080 | 17  | 1080 | 12240 |
| 5/16 | 5400 | 8  | 2880 | 7  | 360  | 14 | 2160 | 13  | 720  | 11160 |
| 6/16 | 6480 | 9  | 2520 | 8  | 3600 | 15 | 360  | 13  | 720  | 10080 |
| 7/16 | 7560 | 10 | 1080 | 9  | 5400 | 3  | 1080 | 4   | 1080 | 8640  |

FIG.48

EP 4 478 616 A1

# FIG.49

| Rate | K | X1 | KX1 | X2 | KX2 | X3 | KX3 | X4 | KX4 | Y1 | KY1 | M |
|------|------|----|------|----|------|----|------|----|------|----|-------|------|
| 7/16 | 7560 | 38 | 360 | 37 | 360 | 11 | 1080 | 5 | 1080 | 3 | 4680 | 9720 |
| 8/16 | 8640 | 14 | 720 | 34 | 720 | 6 | 1440 | 0 | 0 | 3 | 5760 | 8640 |
| 9/16 | 9720 | 27 | 360 | 26 | 720 | 11 | 360 | 8 | 1080 | 3 | 7200 | 7560 |
| 10/16 | 10800 | 23 | 720 | 22 | 720 | 6 | 1440 | 0 | 0 | 3 | 7920 | 6480 |
| 11/16 | 11880 | 19 | 360 | 18 | 720 | 26 | 360 | 9 | 1080 | 3 | 9360 | 5400 |
| 12/16 | 12960 | 17 | 2160 | 0 | 0 | 0 | 0 | 0 | 0 | 3 | 10800 | 4320 |
| 13/16 | 14040 | 17 | 1080 | 16 | 1080 | 0 | 0 | 0 | 0 | 3 | 11880 | 3240 |
| 14/16 | 15120 | 16 | 2160 | 0 | 0 | 0 | 0 | 0 | 0 | 3 | 12960 | 2160 |

EP 4 478 616 A1

# FIG.50

┌─ Rate 4/16 17k Type A CODE TABLE ─────────────────────────

159 211 356 1078 1219 1447 1562 2945 4040 4307 7300 11950 12663

163 385 518 669 2137 3537 3738 7393 7668 9235 10263 12293 12959

413 477 747 974 1995 3998 4078 4848 5642 8968 10356 10596 11451

450 538 767 1245 1354 1957 3497 5179 8925 9959 11385 11844

370 381 884 1627 2289 3654 4510 4949 5307 7959 8789 10552

9 146 1045 2160 3696 6477 6509 7297 9854 10704 12493 12533

110 136 327 4780 4841 5818 6642 7015 7594 8053 8882 9916

771 806 928 1281 2049 3065 4006 6536 6818 8041 8548 9357

256 506 939 1176 3954 4207 5143 7352 7620 8473 8534 11045

459 470 916 2393 3302 3371 3572 4732 5492 10845 12327 12767

270 302 754 1105 1430 1916 3788

144 706 1013 7424 7893 9436 10402

1899 3105 11835 12241

1400 7777 10094 10848

8098 10061 10435 12570

# FIG.51

| Rate | K | X1 | K1 | X2 | K2 | X3 | K3 | XM1 | M1 | M2 |
|------|------|----|------|----|------|----|-----|-----|------|-------|
| 4/16 | 4320 | 13 | 1080 | 12 | 2520 | 7 | 720 | 4 | 1080 | 11880 |

# FIG.52

Rate 9/16 17k Type B CODE TABLE

42 549 1187 1203 1694 1741 2290 2776 2839 2886 3435 3503 3697 4031 4580 4627 5176 5223 5539 5772 6368 6917 6964 7513

13 192 415 563 699 934 1176 1484 1855 2426 3147 3369 3389 4068 4380 4578 4618 4937 4989 5381 5910 6281 6831 7202

1319 1687 2423 3518 3737 4273 5242 6209 6535 6966 7397

1273 2244 2896 3018 3949 4065 4414 4763 5461 5673 7555

344 735 1706 2320 2669 3367 3800 5112 6201 6857 7248

33 1088 1439 2013 2881 3774 3936 5447 5810 6697 7368

615 1580 2410 2698 3801 4182 4991 5483 6046 6292 6538

4564 4745 6784

550 3081 7463

950 2455 2786

1218 2118 6232

3475 4980 6548

4769 5585 6837

450 1681 3707

4038 4889 7174

1432 5762 6265

60 2951 6848

2766 3597 4872

140 2141 4243

874 4142 7054

807 2368 5619

3391 6408 6657

2073 2609 6079

1558 4944 5690

276 875 4345

3273 3767 7300

2695 6102 6743

# FIG.53

| Rate | K | X1 | KX1 | X2 | KX2 | X3 | KX3 | X4 | KX4 | Y1 | KY1 | M |
|------|------|----|-----|----|------|----|-----|----|-----|----|------|------|
| 9/16 | 9720 | 24 | 720 | 11 | 1800 | 0 | 0 | 0 | 0 | 3 | 7200 | 7560 |

FIG.54

| Input Data Cell y | Constellation Point $z_s$ |
|---|---|
| 00 | $(1+j1)/\sqrt{2}$ |
| 01 | $(-1+j1)/\sqrt{2}$ |
| 10 | $(+1-j1)/\sqrt{2}$ |
| 11 | $(-1-j1)/\sqrt{2}$ |

# FIG.55

| w/CR | 2/15 | 3/15 | 4/15 | 5/15 | 6/15 | 7/15 |
|------|------|------|------|------|------|------|
| w0 | 0.7062+j0.7075 | 0.3620+j0.5534 | 0.3412+j0.5241 | 0.3192+j0.5011 | 0.5115+j1.2092 | 0.2592+j0.4888 |
| w1 | 0.7075+j0.7062 | 0.5534+j0.3620 | 0.5241+j0.3412 | 0.5011+j0.3192 | 1.2092+j0.5115 | 0.4888+j0.2592 |
| w2 | 0.7072+j0.7077 | 0.5940+j1.1000 | 0.5797+j1.1282 | 0.5575+j1.1559 | 0.2663+j0.4530 | 0.5072+j1.1980 |
| w3 | 0.7077+j0.7072 | 1.1000+j0.5940 | 1.1282+j0.5797 | 1.1559+j0.5575 | 0.4530+j0.2663 | 1.1980+j0.5072 |

| w/CR | 8/15 | 9/15 | 10/15 | 11/15 | 12/15 | 13/15 |
|------|------|------|------|------|------|------|
| w0 | 0.2535+j0.4923 | 0.2386+j0.5296 | 0.4487+j1.1657 | 0.9342+j0.9847 | 0.9555+j0.9555 | 0.9517+j0.9511 |
| w1 | 0.4923+j0.2535 | 0.5296+j0.2386 | 1.2080+j0.5377 | 0.9866+j0.2903 | 0.9555+j0.2949 | 0.9524+j0.3061 |
| w2 | 0.4927+j1.2044 | 0.4882+j1.1934 | 0.2213+j0.4416 | 0.2716+j0.9325 | 0.2949+j0.9555 | 0.3067+j0.9524 |
| w3 | 1.2044+j0.4927 | 1.1934+j0.4882 | 0.6186+j0.2544 | 0.2901+j0.2695 | 0.2949+j0.2949 | 0.3061+j0.3067 |

EP 4 478 616 A1

# FIG.56

| u/CR | 2/15 | 3/15 | 4/15 | 5/15 | 6/15 | 7/15 |
|------|------|------|------|------|------|------|
| u0 | 0. 3317 | 0. 2382 | 0. 1924 | 0. 1313 | 0. 1275 | 0. 0951 |
| u1 | 0. 3321 | 0. 2556 | 0. 1940 | 0. 1311 | 0. 1276 | 0. 0949 |
| u2 | 0. 3322 | 0. 2749 | 0. 2070 | 0. 1269 | 0. 1294 | 0. 1319 |
| u3 | 0. 3321 | 0. 2558 | 0. 2050 | 0. 1271 | 0. 1295 | 0. 1322 |
| u4 | 0. 3327 | 0. 2748 | 0. 3056 | 0. 3516 | 0. 3424 | 0. 3170 |
| u5 | 0. 3328 | 0. 2949 | 0. 3096 | 0. 3504 | 0. 3431 | 0. 3174 |
| u6 | 0. 3322 | 0. 2749 | 0. 2890 | 0. 3569 | 0. 3675 | 0. 3936 |
| u7 | 0. 3322 | 0. 2558 | 0. 2854 | 0. 3581 | 0. 3666 | 0. 3921 |
| u8 | 0. 9369 | 0. 9486 | 0. 7167 | 0. 6295 | 0. 6097 | 0. 5786 |
| u9 | 0. 9418 | 0. 8348 | 0. 7362 | 0. 6301 | 0. 6072 | 0. 5789 |
| u10 | 0. 9514 | 0. 7810 | 0. 7500 | 0. 6953 | 0. 7113 | 0. 7205 |
| u11 | 0. 9471 | 0. 8348 | 0. 7326 | 0. 6903 | 0. 7196 | 0. 7456 |
| u12 | 0. 9448 | 0. 9463 | 0. 9667 | 0. 9753 | 0. 9418 | 0. 9299 |
| u13 | 0. 9492 | 0. 8336 | 0. 9665 | 1. 0185 | 1. 0048 | 1. 0084 |
| u14 | 0. 9394 | 0. 9459 | 1. 1332 | 1. 2021 | 1. 2286 | 1. 2349 |
| u15 | 0. 9349 | 1. 4299 | 1. 4761 | 1. 4981 | 1. 5031 | 1. 5118 |

| u/CR | 8/15 | 9/15 | 10/15 | 11/15 | 12/15 | 13/15 |
|------|------|------|-------|-------|-------|-------|
| u0 | 0. 0773 | 0. 0638 | 0. 0592 | 0. 0502 | 0. 0354 | 0. 0325 |
| u1 | 0. 0773 | 0. 0638 | 0. 0594 | 0. 0637 | 0. 0921 | 0. 0967 |
| u2 | 0. 1614 | 0. 1757 | 0. 1780 | 0. 1615 | 0. 1602 | 0. 1623 |
| u3 | 0. 1614 | 0. 1756 | 0. 1790 | 0. 1842 | 0. 2185 | 0. 2280 |
| u4 | 0. 3086 | 0. 3069 | 0. 2996 | 0. 2760 | 0. 2910 | 0. 2957 |
| u5 | 0. 3085 | 0. 3067 | 0. 3041 | 0. 3178 | 0. 3530 | 0. 3645 |
| u6 | 0. 4159 | 0. 4333 | 0. 4241 | 0. 4040 | 0. 4264 | 0. 4361 |
| u7 | 0. 4163 | 0. 4343 | 0. 4404 | 0. 4686 | 0. 4947 | 0. 5100 |
| u8 | 0. 5810 | 0. 5765 | 0. 5561 | 0. 5535 | 0. 5763 | 0. 5878 |
| u9 | 0. 5872 | 0. 5862 | 0. 6008 | 0. 6362 | 0. 6531 | 0. 6696 |
| u10 | 0. 7213 | 0. 7282 | 0. 7141 | 0. 7293 | 0. 7417 | 0. 7566 |
| u11 | 0. 7604 | 0. 7705 | 0. 8043 | 0. 8302 | 0. 8324 | 0. 8497 |
| u12 | 0. 9212 | 0. 9218 | 0. 9261 | 0. 9432 | 0. 9386 | 0. 9498 |
| u13 | 1. 0349 | 1. 0364 | 1. 0639 | 1. 0704 | 1. 0529 | 1. 0588 |
| u14 | 1. 2281 | 1. 2234 | 1. 2285 | 1. 2158 | 1. 1917 | 1. 1795 |
| u15 | 1. 4800 | 1. 4646 | 1. 4309 | 1. 3884 | 1. 3675 | 1. 3184 |

EP 4 478 616 A1

# FIG.57

**A**

| | | | | | | | | | | | | | | | | |
|---|---|---|---|---|---|---|---|---|---|---|---|---|---|---|---|---|
| $y_{1,s}$ | 1 | 1 | 1 | 1 | 1 | 1 | 1 | 1 | 1 | 1 | 1 | 1 | 1 | 1 | 1 | 1 |
| $y_{3,s}$ | 0 | 0 | 0 | 0 | 0 | 0 | 0 | 0 | 1 | 1 | 1 | 1 | 1 | 1 | 1 | 1 |
| $y_{5,s}$ | 0 | 0 | 0 | 0 | 1 | 1 | 1 | 1 | 1 | 1 | 1 | 1 | 0 | 0 | 0 | 0 |
| $y_{7,s}$ | 0 | 0 | 1 | 1 | 1 | 1 | 0 | 0 | 0 | 0 | 1 | 1 | 1 | 1 | 0 | 0 |
| $y_{9,s}$ | 0 | 1 | 1 | 0 | 0 | 1 | 1 | 0 | 0 | 1 | 1 | 0 | 0 | 1 | 1 | 0 |
| $Re(z_s)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-u_0$ |
| $y_{1,s}$ | 0 | 0 | 0 | 0 | 0 | 0 | 0 | 0 | 0 | 0 | 0 | 0 | 0 | 0 | 0 | 0 |
| $y_{3,s}$ | 1 | 1 | 1 | 1 | 1 | 1 | 1 | 1 | 0 | 0 | 0 | 0 | 0 | 0 | 0 | 0 |
| $y_{5,s}$ | 0 | 0 | 0 | 0 | 1 | 1 | 1 | 1 | 1 | 1 | 1 | 1 | 0 | 0 | 0 | 0 |
| $y_{7,s}$ | 0 | 0 | 1 | 1 | 1 | 1 | 0 | 0 | 0 | 0 | 1 | 1 | 1 | 1 | 0 | 0 |
| $y_{9,s}$ | 0 | 1 | 1 | 0 | 0 | 1 | 1 | 0 | 0 | 1 | 1 | 0 | 0 | 1 | 1 | 0 |
| $Re(z_s)$ | $u_0$ | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

**B**

| | | | | | | | | | | | | | | | | |
|---|---|---|---|---|---|---|---|---|---|---|---|---|---|---|---|---|
| $y_{0,s}$ | 1 | 1 | 1 | 1 | 1 | 1 | 1 | 1 | 1 | 1 | 1 | 1 | 1 | 1 | 1 | 1 |
| $y_{2,s}$ | 0 | 0 | 0 | 0 | 0 | 0 | 0 | 0 | 1 | 1 | 1 | 1 | 1 | 1 | 1 | 1 |
| $y_{4,s}$ | 0 | 0 | 0 | 0 | 1 | 1 | 1 | 1 | 1 | 1 | 1 | 1 | 0 | 0 | 0 | 0 |
| $y_{6,s}$ | 0 | 0 | 1 | 1 | 1 | 1 | 0 | 0 | 0 | 0 | 1 | 1 | 1 | 1 | 0 | 0 |
| $y_{8,s}$ | 0 | 1 | 1 | 0 | 0 | 1 | 1 | 0 | 0 | 1 | 1 | 0 | 0 | 1 | 1 | 0 |
| $Im(z_s)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-u_0$ |
| $y_{0,s}$ | 0 | 0 | 0 | 0 | 0 | 0 | 0 | 0 | 0 | 0 | 0 | 0 | 0 | 0 | 0 | 0 |
| $y_{2,s}$ | 1 | 1 | 1 | 1 | 1 | 1 | 1 | 1 | 0 | 0 | 0 | 0 | 0 | 0 | 0 | 0 |
| $y_{4,s}$ | 0 | 0 | 0 | 0 | 1 | 1 | 1 | 1 | 1 | 1 | 1 | 1 | 0 | 0 | 0 | 0 |
| $y_{6,s}$ | 0 | 0 | 1 | 1 | 1 | 1 | 0 | 0 | 0 | 0 | 1 | 1 | 1 | 1 | 0 | 0 |
| $y_{8,s}$ | 0 | 1 | 1 | 0 | 0 | 1 | 1 | 0 | 0 | 1 | 1 | 0 | 0 | 1 | 1 | 0 |
| $Im(z_s)$ | $u_0$ | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

# FIG.58

| $y_{0,q}$ | 1 | 0 |
|---|---|---|
| $Re(z_q)$ | −1 | 1 |

# FIG.59

| $y_{1,q}$ | 1 | 0 |
|---|---|---|
| $Im(z_q)$ | −1 | 1 |

# FIG.60

| $y_{0,q}$ $y_{2,q}$ | 1 0 | 1 1 | 0 1 | 0 0 |
|---|---|---|---|---|
| $Re(z_q)$ | −3 | −1 | 1 | 3 |

# FIG.61

| $y_{1,q}$ $y_{3,q}$ | 1 0 | 1 1 | 0 1 | 0 0 |
|---|---|---|---|---|
| $Im(z_q)$ | −3 | −1 | 1 | 3 |

# FIG.62

EP 4 478 616 A1

| $y_{0,q}$ $y_{2,q}$ $y_{4,q}$ | 1 0 0 | 1 0 1 | 1 1 1 | 1 1 0 | 0 1 0 | 0 1 1 | 0 0 1 | 0 0 0 |
|---|---|---|---|---|---|---|---|---|
| $\mathrm{Re}(z_q)$ | $-7$ | $-5$ | $-3$ | $-1$ | 1 | 3 | 5 | 7 |

EP 4 478 616 A1

# FIG.63

| $y_{1,q}$ | 1 | 1 | 1 | 1 | 0 | 0 | 0 | 0 |
|---|---|---|---|---|---|---|---|---|
| $y_{3,q}$ | 0 | 0 | 1 | 1 | 1 | 1 | 0 | 0 |
| $y_{5,q}$ | 0 | 1 | 1 | 0 | 0 | 1 | 1 | 0 |
| $\mathrm{Im}(z_q)$ | −7 | −5 | −3 | −1 | 1 | 3 | 5 | 7 |

# FIG.64

| | | | | | | | | | | | | | | | | |
|---|---|---|---|---|---|---|---|---|---|---|---|---|---|---|---|---|
| $y_{0,q}$ | 0 | 0 | 0 | 0 | 0 | 0 | 0 | 0 | 1 | 1 | 1 | 1 | 1 | 1 | 1 | 1 |
| $y_{2,q}$ | 0 | 0 | 0 | 0 | 1 | 1 | 1 | 1 | 1 | 1 | 1 | 1 | 0 | 0 | 0 | 0 |
| $y_{4,q}$ | 0 | 0 | 1 | 1 | 1 | 1 | 0 | 0 | 0 | 0 | 1 | 1 | 1 | 1 | 0 | 0 |
| $y_{6,q}$ | 0 | 1 | 1 | 0 | 0 | 1 | 1 | 0 | 0 | 1 | 1 | 0 | 0 | 1 | 1 | 0 |
| $\mathrm{Re}(z_q)$ | 15 | 13 | 11 | 9 | 7 | 5 | 3 | 1 | -1 | -3 | -5 | -7 | -9 | -11 | -13 | -15 |

## F I G . 6 5

| | | | | | | | | | | | | | | | | |
|---|---|---|---|---|---|---|---|---|---|---|---|---|---|---|---|---|
| $y_{1,q}$ | 1 | 1 | 1 | 1 | 1 | 1 | 1 | 1 | 0 | 0 | 0 | 0 | 0 | 0 | 0 | 0 |
| $y_{3,q}$ | 0 | 0 | 0 | 0 | 1 | 1 | 1 | 1 | 1 | 1 | 1 | 1 | 0 | 0 | 0 | 0 |
| $y_{5,q}$ | 0 | 0 | 1 | 1 | 1 | 1 | 0 | 0 | 0 | 0 | 1 | 1 | 1 | 1 | 0 | 0 |
| $y_{7,q}$ | 0 | 1 | 1 | 0 | 0 | 1 | 1 | 0 | 0 | 1 | 1 | 0 | 0 | 1 | 1 | 0 |
| $\mathrm{Im}(z_q)$ | -15 | -13 | -11 | -9 | -7 | -5 | -3 | -1 | 1 | 3 | 5 | 7 | 9 | 11 | 13 | 15 |

# FIG.66

EP 4 478 616 A1

| | | | | | | | | | | | | | | | | |
|---|---|---|---|---|---|---|---|---|---|---|---|---|---|---|---|---|
| $y_{0,q}$ | 1 | 1 | 1 | 1 | 1 | 1 | 1 | 1 | 1 | 1 | 1 | 1 | 1 | 1 | 1 | 1 |
| $y_{2,q}$ | 0 | 0 | 0 | 0 | 0 | 0 | 0 | 0 | 1 | 1 | 1 | 1 | 1 | 1 | 1 | 1 |
| $y_{4,q}$ | 0 | 0 | 0 | 0 | 1 | 1 | 1 | 1 | 1 | 1 | 1 | 0 | 0 | 0 | 0 | 0 |
| $y_{6,q}$ | 0 | 0 | 1 | 1 | 1 | 1 | 0 | 0 | 0 | 0 | 1 | 1 | 1 | 1 | 0 | 0 |
| $y_{8,q}$ | 0 | 1 | 1 | 0 | 0 | 1 | 1 | 0 | 0 | 1 | 1 | 0 | 0 | 1 | 1 | 0 |
| $Re(z_q)$ | −31 | −29 | −27 | −25 | −23 | −21 | −19 | −17 | −15 | −13 | −11 | −9 | −7 | −5 | −3 | −1 |
| $y_{0,q}$ | 0 | 0 | 0 | 0 | 0 | 0 | 0 | 0 | 0 | 0 | 0 | 0 | 0 | 0 | 0 | 0 |
| $y_{2,q}$ | 1 | 1 | 1 | 1 | 1 | 1 | 1 | 1 | 0 | 0 | 0 | 0 | 0 | 0 | 0 | 0 |
| $y_{4,q}$ | 0 | 0 | 0 | 0 | 1 | 1 | 1 | 1 | 1 | 1 | 1 | 1 | 0 | 0 | 0 | 0 |
| $y_{6,q}$ | 0 | 0 | 1 | 1 | 1 | 1 | 0 | 0 | 0 | 0 | 1 | 1 | 1 | 1 | 0 | 0 |
| $y_{8,q}$ | 0 | 1 | 1 | 0 | 0 | 1 | 1 | 0 | 0 | 1 | 1 | 0 | 0 | 1 | 1 | 0 |
| $Re(z_q)$ | 1 | 3 | 5 | 7 | 9 | 11 | 13 | 15 | 17 | 19 | 21 | 23 | 25 | 27 | 29 | 31 |

# FIG.67

EP 4 478 616 A1

| | | | | | | | | | | | | | | | | |
|---|---|---|---|---|---|---|---|---|---|---|---|---|---|---|---|---|
| $y_{1,q}$ | 1 | 1 | 1 | 1 | 1 | 1 | 1 | 1 | 1 | 1 | 1 | 1 | 1 | 1 | 1 | 1 |
| $y_{3,q}$ | 0 | 0 | 0 | 0 | 0 | 0 | 0 | 0 | 1 | 1 | 1 | 1 | 1 | 1 | 1 | 1 |
| $y_{5,q}$ | 0 | 0 | 0 | 0 | 1 | 1 | 1 | 1 | 1 | 1 | 1 | 0 | 0 | 0 | 0 | 0 |
| $y_{7,q}$ | 0 | 0 | 1 | 1 | 1 | 1 | 0 | 0 | 0 | 0 | 1 | 1 | 1 | 1 | 0 | 0 |
| $y_{9,q}$ | 0 | 1 | 1 | 0 | 0 | 1 | 1 | 0 | 0 | 1 | 1 | 0 | 0 | 1 | 1 | 0 |
| $Im(z_q)$ | -31 | -29 | -27 | -25 | -23 | -21 | -19 | -17 | -15 | -13 | -11 | -9 | -7 | -5 | -3 | -1 |
| $y_{1,q}$ | 0 | 0 | 0 | 0 | 0 | 0 | 0 | 0 | 0 | 0 | 0 | 0 | 0 | 0 | 0 | 0 |
| $y_{3,q}$ | 1 | 1 | 1 | 1 | 1 | 1 | 1 | 1 | 0 | 0 | 0 | 0 | 0 | 0 | 0 | 0 |
| $y_{5,q}$ | 0 | 0 | 0 | 0 | 1 | 1 | 1 | 1 | 1 | 1 | 1 | 1 | 0 | 0 | 0 | 0 |
| $y_{7,q}$ | 0 | 0 | 1 | 1 | 1 | 1 | 0 | 0 | 0 | 0 | 1 | 1 | 1 | 1 | 0 | 0 |
| $y_{9,q}$ | 0 | 1 | 1 | 0 | 0 | 1 | 1 | 0 | 0 | 1 | 1 | 0 | 0 | 1 | 1 | 0 |
| $Im(z_q)$ | 1 | 3 | 5 | 7 | 9 | 11 | 13 | 15 | 17 | 19 | 21 | 23 | 25 | 27 | 29 | 31 |

# FIG.68

| $y_{0,q}$ | 1 | 1 | 1 | 1 | 1 | 1 | 1 | 1 | 1 | 1 | 1 | 1 | 1 | 1 | 1 | 1 |
|---|---|---|---|---|---|---|---|---|---|---|---|---|---|---|---|---|
| $y_{2,q}$ | 0 | 0 | 0 | 0 | 0 | 0 | 0 | 0 | 0 | 0 | 0 | 0 | 0 | 0 | 0 | 0 |
| $y_{4,q}$ | 0 | 0 | 0 | 0 | 0 | 0 | 0 | 0 | 1 | 1 | 1 | 1 | 1 | 1 | 1 | 1 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $Re(z_q)$ | −63 | −61 | −59 | −57 | −55 | −53 | −51 | −49 | −47 | −45 | −43 | −41 | −39 | −37 | −35 | −33 |
| $y_{0,q}$ | 1 | 1 | 1 | 1 | 1 | 1 | 1 | 1 | 1 | 1 | 1 | 1 | 1 | 1 | 1 | 1 |
| $y_{2,q}$ | 1 | 1 | 1 | 1 | 1 | 1 | 1 | 1 | 1 | 1 | 1 | 1 | 1 | 1 | 1 | 1 |
| $y_{4,q}$ | 1 | 1 | 1 | 1 | 1 | 1 | 1 | 1 | 0 | 0 | 0 | 0 | 0 | 0 | 0 | 0 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $Re(z_q)$ | −31 | −29 | −27 | −25 | −23 | −21 | −19 | −17 | −15 | −13 | −11 | −9 | −7 | −5 | −3 | −1 |
| $y_{0,q}$ | 0 | 0 | 0 | 0 | 0 | 0 | 0 | 0 | 0 | 0 | 0 | 0 | 0 | 0 | 0 | 0 |
| $y_{2,q}$ | 1 | 1 | 1 | 1 | 1 | 1 | 1 | 1 | 1 | 1 | 1 | 1 | 1 | 1 | 1 | 1 |
| $y_{4,q}$ | 0 | 0 | 0 | 0 | 0 | 0 | 0 | 0 | 1 | 1 | 1 | 1 | 1 | 1 | 1 | 1 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $Re(z_q)$ | 1 | 3 | 5 | 7 | 9 | 11 | 13 | 15 | 17 | 19 | 21 | 23 | 25 | 27 | 29 | 31 |
| $y_{0,q}$ | 0 | 0 | 0 | 0 | 0 | 0 | 0 | 0 | 0 | 0 | 0 | 0 | 0 | 0 | 0 | 0 |
| $y_{2,q}$ | 0 | 0 | 0 | 0 | 0 | 0 | 0 | 0 | 0 | 0 | 0 | 0 | 0 | 0 | 0 | 0 |
| $y_{4,q}$ | 1 | 1 | 1 | 1 | 1 | 1 | 1 | 1 | 0 | 0 | 0 | 0 | 0 | 0 | 0 | 0 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $Re(z_q)$ | 33 | 35 | 37 | 39 | 41 | 43 | 45 | 47 | 49 | 51 | 53 | 55 | 57 | 59 | 61 | 63 |

EP 4 478 616 A1

FIG.69

| | | | | | | | | | | | | | | | | |
|---|---|---|---|---|---|---|---|---|---|---|---|---|---|---|---|---|
| $y_{1,q}$ | 1 | 1 | 1 | 1 | 1 | 1 | 1 | 1 | 1 | 1 | 1 | 1 | 1 | 1 | 1 | 1 |
| $y_{3,q}$ | 0 | 0 | 0 | 0 | 0 | 0 | 0 | 0 | 0 | 0 | 0 | 0 | 0 | 0 | 0 | 0 |
| $y_{5,q}$ | 0 | 0 | 0 | 0 | 0 | 0 | 0 | 0 | 1 | 1 | 1 | 1 | 1 | 1 | 1 | 1 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $Im(z_q)$ | −63 | −61 | −59 | −57 | −55 | −53 | −51 | −49 | −47 | −45 | −43 | −41 | −39 | −37 | −35 | −33 |

| | | | | | | | | | | | | | | | | |
|---|---|---|---|---|---|---|---|---|---|---|---|---|---|---|---|---|
| $y_{1,q}$ | 1 | 1 | 1 | 1 | 1 | 1 | 1 | 1 | 1 | 1 | 1 | 1 | 1 | 1 | 1 | 1 |
| $y_{3,q}$ | 1 | 1 | 1 | 1 | 1 | 1 | 1 | 1 | 1 | 1 | 1 | 1 | 1 | 1 | 1 | 1 |
| $y_{5,q}$ | 1 | 1 | 1 | 1 | 1 | 1 | 1 | 1 | 0 | 0 | 0 | 0 | 0 | 0 | 0 | 0 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $Im(z_q)$ | −31 | −29 | −27 | −25 | −23 | −21 | −19 | −17 | −15 | −13 | −11 | −9 | −7 | −5 | −3 | −1 |

| | | | | | | | | | | | | | | | | |
|---|---|---|---|---|---|---|---|---|---|---|---|---|---|---|---|---|
| $y_{1,q}$ | 0 | 0 | 0 | 0 | 0 | 0 | 0 | 0 | 0 | 0 | 0 | 0 | 0 | 0 | 0 | 0 |
| $y_{3,q}$ | 1 | 1 | 1 | 1 | 1 | 1 | 1 | 1 | 1 | 1 | 1 | 1 | 1 | 1 | 1 | 1 |
| $y_{5,q}$ | 0 | 0 | 0 | 0 | 0 | 0 | 0 | 0 | 1 | 1 | 1 | 1 | 1 | 1 | 1 | 1 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $Im(z_q)$ | 1 | 3 | 5 | 7 | 9 | 11 | 13 | 15 | 17 | 19 | 21 | 23 | 25 | 27 | 29 | 31 |

| | | | | | | | | | | | | | | | | |
|---|---|---|---|---|---|---|---|---|---|---|---|---|---|---|---|---|
| $y_{1,q}$ | 0 | 0 | 0 | 0 | 0 | 0 | 0 | 0 | 0 | 0 | 0 | 0 | 0 | 0 | 0 | 0 |
| $y_{3,q}$ | 0 | 0 | 0 | 0 | 0 | 0 | 0 | 0 | 0 | 0 | 0 | 0 | 0 | 0 | 0 | 0 |
| $y_{5,q}$ | 1 | 1 | 1 | 1 | 1 | 1 | 1 | 1 | 0 | 0 | 0 | 0 | 0 | 0 | 0 | 0 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $Im(z_q)$ | 33 | 35 | 37 | 39 | 41 | 43 | 45 | 47 | 49 | 51 | 53 | 55 | 57 | 59 | 61 | 63 |

EP 4 478 616 A1

# FIG.70

| w/CR | 2/16 | 4/16 | 6/16 | 8/16 | 10/16 | 12/16 | 14/16 |
|------|------|------|------|------|-------|-------|-------|
| w0 | 0.707107+j0.707107 | 0.707107+j0.707107 | 0.463340+j0.284191 | 0.457029+j0.264235 | 0.493628+j0.253004 | 0.418917+j0.217263 | 0.297592+j0.297592 |
| w1 | 0.707107+j0.707107 | 0.707107+j0.707107 | 0.284191+j0.463340 | 0.264235+j0.457029 | 0.253004+j0.493628 | 0.257090+j0.657759 | 0.297592+j0.954693 |
| w2 | 0.707107+j0.707107 | 0.707107+j0.707107 | 1.192750+j0.530940 | 1.210202+j0.506671 | 1.204042+j0.492548 | 1.144505+j0.432606 | 0.954693+j0.297592 |
| w3 | 0.707107+j0.707107 | 0.707107+j0.707107 | 0.530940+j1.192750 | 0.506671+j1.210202 | 0.492548+j1.204042 | 0.565917+j1.208827 | 0.954693+j0.954693 |

# FIG.71

| w/CR | 3/16 | 5/16 | 7/16 | 9/16 | 11/16 | 13/16 |
|------|------|------|------|------|-------|-------|
| w0 | 0.587870+j0.405339 | 0.453023+j0.266260 | 0.541390+j0.300280 | 0.608698+j0.346004 | 0.611105+j0.349327 | 0.700327+j0.329907 |
| w1 | 0.587870+j0.405339 | 0.453023+j0.266260 | 0.559889+j0.242973 | 0.673707+j0.196861 | 0.675905+j0.148761 | 0.889256+j0.139511 |
| w2 | 0.587870+j0.405339 | 0.453023+j0.266260 | 0.357657+j0.209444 | 0.301149+j0.169680 | 0.259839+j0.153788 | 0.447469+j0.131347 |
| w3 | 0.587870+j0.405339 | 0.453023+j0.266260 | 0.355882+j0.194677 | 0.302029+j0.151421 | 0.251152+j0.128725 | 0.138015+j0.101309 |
| w4 | 0.405339+j0.587870 | 0.266260+j0.453023 | 0.300280+j0.541390 | 0.346004+j0.608698 | 0.416770+j0.616005 | 0.448992+j0.566892 |
| w5 | 0.405339+j0.587870 | 0.266260+j0.453023 | 0.242973+j0.559889 | 0.196861+j0.673707 | 0.174887+j0.744087 | 0.142663+j0.669940 |
| w6 | 0.405339+j0.587870 | 0.266260+j0.453023 | 0.209444+j0.357657 | 0.169680+j0.301149 | 0.182356+j0.382221 | 0.343126+j0.358344 |
| w7 | 0.405339+j0.587870 | 0.266260+j0.453023 | 0.194677+j0.355882 | 0.151421+j0.302029 | 0.129870+j0.410574 | 0.121210+j0.363416 |
| w8 | 1.056554+j0.611394 | 1.209224+j0.511520 | 0.949854+j0.564434 | 0.885139+j0.562962 | 0.890899+j0.557418 | 0.889124+j0.602821 |
| w9 | 1.056554+j0.611394 | 1.209224+j0.511520 | 1.067076+j0.274552 | 1.019339+j0.225537 | 1.029624+j0.193508 | 1.233619+j0.212708 |
| w10 | 1.056554+j0.611394 | 1.209224+j0.511520 | 1.265348+j0.819022 | 1.259403+j0.843530 | 1.248726+j0.812443 | 1.067496+j0.962512 |
| w11 | 1.056554+j0.611394 | 1.209224+j0.511520 | 1.452799+j0.300853 | 1.486685+j0.292085 | 1.462453+j0.283106 | 1.394097+j0.591196 |
| w12 | 0.611394+j1.056554 | 0.511520+j1.209224 | 0.564434+j0.949854 | 0.562962+j0.885139 | 0.617897+j0.860530 | 0.563858+j0.843483 |
| w13 | 0.611394+j1.056554 | 0.511520+j1.209224 | 0.274552+j1.067076 | 0.225537+j1.019339 | 0.218691+j1.046861 | 0.194790+j0.974535 |
| w14 | 0.611394+j1.056554 | 0.511520+j1.209224 | 0.819022+j1.265348 | 0.843530+j1.259403 | 0.842216+j1.227794 | 0.673475+j1.223631 |
| w15 | 0.611394+j1.056554 | 0.511520+j1.209224 | 0.300853+j1.452799 | 0.292085+j1.486685 | 0.299603+j1.462746 | 0.230654+j1.362914 |

# FIG.72

| w/CR | 2/16 | 4/16 | 6/16 | 8/16 | 10/16 | 12/16 | 14/16 |
|---|---|---|---|---|---|---|---|
| w0 | 0.690825+j0.585349 | 0.457029+j0.264235 | 0.585930+j0.319930 | 0.581805+j0.334988 | 0.550392+j0.290156 | 0.578370+j0.309447 | 0.556205+j0.306313 |
| w1 | 0.690825+j0.585350 | 0.457029+j0.264235 | 0.579831+j0.315654 | 0.585635+j0.330968 | 0.681112+j0.358142 | 0.721702+j0.389496 | 0.698107+j0.361975 |
| w2 | 0.690827+j0.585349 | 0.457029+j0.264235 | 0.629024+j0.217617 | 0.638661+j0.155525 | 0.601303+j0.115783 | 0.660123+j0.174184 | 0.583112+j0.186592 |
| w3 | 0.690826+j0.585349 | 0.457029+j0.264235 | 0.621593+j0.216858 | 0.643156+j0.156558 | 0.768180+j0.154657 | 0.799367+j0.241027 | 0.740611+j0.219107 |
| w4 | 0.690826+j0.585350 | 0.457029+j0.264235 | 0.579831+j0.315654 | 0.582963+j0.340165 | 0.544087+j0.309193 | 0.526085+j0.368822 | 0.497423+j0.421234 |
| w5 | 0.690825+j0.585350 | 0.457029+j0.264235 | 0.574244+j0.311784 | 0.586528+j0.335691 | 0.649801+j0.400611 | 0.630503+j0.500103 | 0.632312+j0.499021 |
| w6 | 0.690827+j0.585349 | 0.457029+j0.264235 | 0.621593+j0.216858 | 0.641671+j0.154211 | 0.602332+j0.106466 | 0.685472+j0.083624 | 0.605376+j0.061678 |
| w7 | 0.690827+j0.585350 | 0.457029+j0.264235 | 0.614800+j0.216139 | 0.645888+j0.155218 | 0.779701+j0.111826 | 0.836826+j0.086747 | 0.761043+j0.074016 |
| w8 | 0.690824+j0.585350 | 0.457029+j0.264235 | 0.313766+j0.177294 | 0.256324+j0.154712 | 0.353588+j0.173948 | 0.421081+j0.189169 | 0.372292+j0.238687 |
| w9 | 0.690824+j0.585350 | 0.457029+j0.264235 | 0.314209+j0.177479 | 0.257740+j0.155093 | 0.142216+j0.108587 | 0.254956+j0.091406 | 0.234548+j0.177704 |
| w10 | 0.690826+j0.585350 | 0.457029+j0.264235 | 0.314479+j0.163373 | 0.253905+j0.133141 | 0.383183+j0.095256 | 0.508228+j0.088452 | 0.438984+j0.152224 |
| w11 | 0.690825+j0.585350 | 0.457029+j0.264235 | 0.314993+j0.163511 | 0.255461+j0.133228 | 0.131151+j0.092101 | 0.086721+j0.072310 | 0.071834+j0.148278 |
| w12 | 0.690825+j0.585350 | 0.457029+j0.264235 | 0.314209+j0.177479 | 0.257989+j0.155663 | 0.353498+j0.175656 | 0.411013+j0.203430 | 0.378135+j0.354399 |
| w13 | 0.690824+j0.585350 | 0.457029+j0.264235 | 0.314645+j0.177662 | 0.259423+j0.156052 | 0.141590+j0.108762 | 0.254446+j0.094768 | 0.234014+j0.058219 |
| w14 | 0.690826+j0.585350 | 0.457029+j0.264235 | 0.314993+j0.163511 | 0.255597+j0.133615 | 0.382409+j0.095366 | 0.515559+j0.071509 | 0.440779+j0.051628 |
| w15 | 0.690826+j0.585350 | 0.457029+j0.264235 | 0.315501+j0.163646 | 0.257175+j0.133701 | 0.130510+j0.092363 | 0.086440+j0.072876 | 0.084467+j0.052398 |
| w16 | 0.585350+j0.690825 | 0.264235+j0.457029 | 0.319930+j0.585930 | 0.379008+j0.600742 | 0.388353+j0.540097 | 0.327555+j0.525982 | 0.338331+j0.660786 |
| w17 | 0.585350+j0.690826 | 0.264235+j0.457029 | 0.315654+j0.579831 | 0.375622+j0.606499 | 0.419487+j0.605548 | 0.382772+j0.675704 | 0.418845+j0.776409 |
| w18 | 0.585351+j0.690825 | 0.264235+j0.457029 | 0.217617+j0.629024 | 0.168779+j0.701232 | 0.183551+j0.653534 | 0.175886+j0.592219 | 0.206352+j0.743684 |
| w19 | 0.585351+j0.690825 | 0.264235+j0.457029 | 0.216858+j0.621593 | 0.176024+j0.703042 | 0.192718+j0.682799 | 0.231337+j0.737121 | 0.278826+j0.886705 |
| w20 | 0.585350+j0.690826 | 0.264235+j0.457029 | 0.315654+j0.579831 | 0.381824+j0.601641 | 0.420548+j0.516710 | 0.406824+j0.473389 | 0.433185+j0.545796 |
| w21 | 0.585350+j0.690826 | 0.264235+j0.457029 | 0.311784+j0.574244 | 0.377966+j0.607168 | 0.478320+j0.574186 | 0.507079+j0.602578 | 0.542935+j0.632044 |
| w22 | 0.585351+j0.690825 | 0.264235+j0.457029 | 0.216858+j0.621593 | 0.162549+j0.708528 | 0.130081+j0.671539 | 0.081174+j0.613265 | 0.065905+j0.768425 |
| w23 | 0.585351+j0.690826 | 0.264235+j0.457029 | 0.216139+j0.614800 | 0.169978+j0.709409 | 0.130631+j0.694278 | 0.083021+j0.767926 | 0.090272+j0.923832 |
| w24 | 0.585349+j0.690826 | 0.264235+j0.457029 | 0.177294+j0.313766 | 0.164033+j0.346721 | 0.254460+j0.369220 | 0.269365+j0.373217 | 0.253830+j0.554022 |
| w25 | 0.585349+j0.690826 | 0.264235+j0.457029 | 0.177479+j0.314209 | 0.164869+j0.347827 | 0.149136+j0.316492 | 0.200539+j0.250430 | 0.176737+j0.283231 |
| w26 | 0.585350+j0.690826 | 0.264235+j0.457029 | 0.163373+j0.314479 | 0.128349+j0.362615 | 0.141602+j0.435973 | 0.109576+j0.442010 | 0.156460+j0.607057 |
| w27 | 0.585350+j0.690826 | 0.264235+j0.457029 | 0.163511+j0.314993 | 0.128793+j0.363810 | 0.099783+j0.370718 | 0.075318+j0.256488 | 0.059053+j0.271040 |
| w28 | 0.585350+j0.690826 | 0.264235+j0.457029 | 0.177479+j0.314209 | 0.165196+j0.349443 | 0.256602+j0.364260 | 0.299438+j0.350712 | 0.295727+j0.448465 |
| w29 | 0.585349+j0.690827 | 0.264235+j0.457029 | 0.177662+j0.314645 | 0.166055+j0.350585 | 0.145729+j0.314336 | 0.205632+j0.245612 | 0.182567+j0.384902 |
| w30 | 0.585351+j0.690826 | 0.264235+j0.457029 | 0.163511+j0.314993 | 0.128552+j0.366258 | 0.131228+j0.437877 | 0.076874+j0.448991 | 0.058840+j0.576445 |
| w31 | 0.585350+j0.690826 | 0.264235+j0.457029 | 0.163646+j0.315501 | 0.129002+j0.367499 | 0.095964+j0.371670 | 0.072444+j0.254884 | 0.061187+j0.420342 |
| w32 | 0.837320+j0.692111 | 1.210202+j0.506671 | 0.915494+j0.562969 | 0.875123+j0.541294 | 1.015975+j0.544514 | 1.010495+j0.556385 | 1.003447+j0.483696 |

# FIG.73

| | | | | | | |
|---|---|---|---|---|---|---|
| w33 | 0.837320+j0.692111 | 1.210202+j0.506671 | 0.899840+j0.548599 | 0.857263+j0.493450 | 0.865222+j0.447394 | 0.861166+j0.469956 | 0.845525+j0.420972 |
| w34 | 0.837322+j0.692111 | 1.210202+j0.506671 | 1.041461+j0.244937 | 1.005452+j0.192113 | 1.128584+j0.334833 | 1.106160+j0.346451 | 1.062454+j0.293134 |
| w35 | 0.837322+j0.692111 | 1.210202+j0.506671 | 1.020188+j0.244325 | 0.959325+j0.208138 | 0.956829+j0.243315 | 0.944992+j0.295093 | 0.896494+j0.255193 |
| w36 | 0.837321+j0.692112 | 1.210202+j0.506671 | 0.899840+j0.548599 | 0.835873+j0.546548 | 0.880528+j0.680980 | 0.875484+j0.737255 | 0.913205+j0.665202 |
| w37 | 0.837320+j0.692112 | 1.210202+j0.506671 | 0.883121+j0.533505 | 0.820382+j0.497932 | 0.787015+j0.549425 | 0.745110+j0.618549 | 0.767362+j0.579003 |
| w38 | 0.837323+j0.692111 | 1.210202+j0.506671 | 1.020188+j0.244325 | 0.978090+j0.164900 | 1.176544+j0.123217 | 1.156123+j0.117857 | 1.090971+j0.098120 |
| w39 | 0.837322+j0.692112 | 1.210202+j0.506671 | 0.997866+j0.243471 | 0.934838+j0.182858 | 0.984649+j0.117137 | 0.989858+j0.099899 | 0.921093+j0.085363 |
| w40 | 0.837319+j0.692112 | 1.210202+j0.506671 | 1.151606+j0.765652 | 1.146306+j0.718300 | 1.215599+j0.699359 | 1.191952+j0.656926 | 1.187342+j0.536796 |
| w41 | 0.837318+j0.692112 | 1.210202+j0.506671 | 1.215021+j0.808778 | 1.291524+j0.653771 | 1.470503+j0.909385 | 1.428402+j0.781680 | 1.372857+j0.669123 |
| w42 | 0.837321+j0.692111 | 1.210202+j0.506671 | 1.352992+j0.268569 | 1.334471+j0.242999 | 1.345613+j0.437140 | 1.302908+j0.407617 | 1.251173+j0.323729 |
| w43 | 0.837320+j0.692112 | 1.210202+j0.506671 | 1.427958+j0.282998 | 1.395846+j0.389207 | 1.641491+j0.562622 | 1.558455+j0.483525 | 1.461132+j0.407370 |
| w44 | 0.837320+j0.692112 | 1.210202+j0.506671 | 1.215021+j0.808778 | 1.124883+j0.844081 | 1.036455+j0.904332 | 1.034030+j0.874552 | 1.088040+j0.742804 |
| w45 | 0.837319+j0.692113 | 1.210202+j0.506671 | 1.479922+j0.989013 | 1.534980+j0.961645 | 1.216171+j1.212947 | 1.241676+j1.044629 | 1.239054+j0.916396 |
| w46 | 0.837322+j0.692112 | 1.210202+j0.506671 | 1.427958+j0.282998 | 1.404319+j0.139223 | 1.412229+j0.146603 | 1.360208+j0.138162 | 1.281447+j0.108014 |
| w47 | 0.837321+j0.692112 | 1.210202+j0.506671 | 1.747630+j0.343683 | 1.784855+j0.324115 | 1.729269+j0.190765 | 1.625172+j0.163628 | 1.504307+j0.136707 |
| w48 | 0.692112+j0.837321 | 0.506671+j1.210202 | 0.562969+j0.915494 | 0.608985+j0.850637 | 0.520270+j0.894599 | 0.523810+j0.993510 | 0.639937+j0.977245 |
| w49 | 0.692111+j0.837321 | 0.506671+j1.210202 | 0.548599+j0.899840 | 0.551777+j0.870592 | 0.483940+j0.849621 | 0.448217+j0.829659 | 0.537002+j0.852344 |
| w50 | 0.692113+j0.837320 | 0.506671+j1.210202 | 0.244937+j1.041461 | 0.190487+j1.082774 | 0.232928+j0.985823 | 0.321209+j1.067223 | 0.455568+j1.065457 |
| w51 | 0.692113+j0.837321 | 0.506671+j1.210202 | 0.244325+j1.020188 | 0.244881+j1.048792 | 0.257181+j0.965383 | 0.276744+j0.893825 | 0.281384+j1.059541 |
| w52 | 0.692112+j0.837321 | 0.506671+j1.210202 | 0.548599+j0.899840 | 0.610952+j0.803882 | 0.694953+j0.796701 | 0.710545+j0.883461 | 0.792733+j0.832232 |
| w53 | 0.692112+j0.837322 | 0.506671+j1.210202 | 0.533506+j0.883121 | 0.555010+j0.811974 | 0.623283+j0.720032 | 0.605159+j0.738080 | 0.662410+j0.724582 |
| w54 | 0.692114+j0.837321 | 0.506671+j1.210202 | 0.244325+j1.020188 | 0.168637+j1.002744 | 0.107976+j0.949083 | 0.108346+j1.104517 | 0.105974+j1.274300 |
| w55 | 0.692113+j0.837321 | 0.506671+j1.210202 | 0.243471+j0.997866 | 0.205501+j0.980310 | 0.122236+j0.924513 | 0.093597+j0.927820 | 0.098152+j1.088542 |
| w56 | 0.692111+j0.837322 | 0.506671+j1.210202 | 0.765652+j1.151606 | 0.811871+j1.077059 | 0.634215+j1.095182 | 0.616510+j1.185736 | 0.775759+j1.106874 |
| w57 | 0.692110+j0.837322 | 0.506671+j1.210202 | 0.808778+j1.215021 | 0.708577+j1.212442 | 0.555938+j1.212930 | 0.741498+j1.425730 | 0.816189+j1.333815 |
| w58 | 0.692112+j0.837321 | 0.506671+j1.210202 | 0.268569+j1.352992 | 0.232238+j1.415900 | 0.134887+j1.326793 | 0.376428+j1.273967 | 0.549851+j1.233599 |
| w59 | 0.692112+j0.837321 | 0.506671+j1.210202 | 0.282998+j1.427958 | 0.447381+j1.368136 | 0.343747+j1.293003 | 0.452484+j1.534369 | 0.549193+j1.472735 |
| w60 | 0.692111+j0.837322 | 0.506671+j1.210202 | 0.808778+j1.215021 | 0.945797+j1.067632 | 0.842609+j1.029273 | 0.838816+j1.052224 | 0.952209+j0.936182 |
| w61 | 0.692111+j0.837322 | 0.506671+j1.210202 | 0.989012+j1.479922 | 1.098653+j1.408274 | 0.867471+j1.388566 | 1.008623+j1.261597 | 1.056456+j1.143504 |
| w62 | 0.692113+j0.837322 | 0.506671+j1.210202 | 0.282998+j1.427958 | 0.188583+j1.727023 | 0.174737+j1.671315 | 0.126520+j1.317668 | 0.319114+j1.324413 |
| w63 | 0.692113+j0.837322 | 0.506671+j1.210202 | 0.343683+j1.747630 | 0.657638+j1.731517 | 0.546701+j1.623153 | 0.151986+j1.588069 | 0.151901+j1.531081 |

# F I G . 7 4

| u/CR | 3/16 | 5/16 | 7/16 | 9/16 | 11/16 | 13/16 |
|------|------|------|------|------|-------|-------|
| u0 | 0.964850 | 0.746358 | 0.682758 | 0.720492 | 0.718420 | 0.741203 |
| u1 | 0.964851 | 0.724327 | 0.689494 | 0.745635 | 0.785950 | 0.837561 |
| u2 | 0.964850 | 0.701244 | 0.614079 | 0.578601 | 0.566863 | 0.571567 |
| u3 | 0.964851 | 0.724852 | 0.608604 | 0.578878 | 0.591711 | 0.652725 |
| u4 | 0.964851 | 1.089143 | 1.229555 | 1.234916 | 1.228615 | 1.196834 |
| u5 | 0.964851 | 1.487807 | 1.519290 | 1.511816 | 1.446265 | 1.354509 |
| u6 | 0.964851 | 1.016430 | 0.952184 | 0.929933 | 0.919117 | 0.944049 |
| u7 | 0.964851 | 0.981269 | 1.010198 | 1.008385 | 1.055715 | 1.062656 |
| u8 | 0.262799 | 0.188668 | 0.119570 | 0.131917 | 0.179189 | 0.158838 |
| u9 | 0.262799 | 0.187756 | 0.119309 | 0.132245 | 0.179229 | 0.216557 |
| u10 | 0.262799 | 0.183302 | 0.122704 | 0.095129 | 0.060071 | 0.034740 |
| u11 | 0.262799 | 0.184133 | 0.122986 | 0.094858 | 0.060040 | 0.089245 |
| u12 | 0.262799 | 0.299163 | 0.361306 | 0.393581 | 0.431407 | 0.422770 |
| u13 | 0.262799 | 0.295502 | 0.360929 | 0.392102 | 0.437930 | 0.493766 |
| u14 | 0.262799 | 0.306233 | 0.349187 | 0.316988 | 0.303511 | 0.286845 |
| u15 | 0.262799 | 0.310441 | 0.349698 | 0.317410 | 0.304552 | 0.350258 |

# FIG.75

**A**

| | | | | | | | | | | | | | | | | |
|---|---|---|---|---|---|---|---|---|---|---|---|---|---|---|---|---|
| $y_{0,s}$ | 1 | 1 | 1 | 1 | 1 | 1 | 1 | 1 | 1 | 1 | 1 | 1 | 1 | 1 | 1 | 1 |
| $y_{2,s}$ | 0 | 0 | 0 | 0 | 0 | 0 | 0 | 0 | 1 | 1 | 1 | 1 | 1 | 1 | 1 | 1 |
| $y_{4,s}$ | 0 | 0 | 0 | 0 | 1 | 1 | 1 | 1 | 1 | 1 | 1 | 1 | 0 | 0 | 0 | 0 |
| $y_{6,s}$ | 0 | 0 | 1 | 1 | 1 | 1 | 0 | 0 | 0 | 0 | 1 | 1 | 1 | 1 | 0 | 0 |
| $y_{8,s}$ | 0 | 1 | 1 | 0 | 0 | 1 | 1 | 0 | 0 | 1 | 1 | 0 | 0 | 1 | 1 | 0 |
| $Re(z_s)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-u_0$ |
| $y_{0,s}$ | 0 | 0 | 0 | 0 | 0 | 0 | 0 | 0 | 0 | 0 | 0 | 0 | 0 | 0 | 0 | 0 |
| $y_{2,s}$ | 1 | 1 | 1 | 1 | 1 | 1 | 1 | 1 | 0 | 0 | 0 | 0 | 0 | 0 | 0 | 0 |
| $y_{4,s}$ | 0 | 0 | 0 | 0 | 1 | 1 | 1 | 1 | 1 | 1 | 1 | 1 | 0 | 0 | 0 | 0 |
| $y_{6,s}$ | 0 | 0 | 1 | 1 | 1 | 1 | 0 | 0 | 0 | 0 | 1 | 1 | 1 | 1 | 0 | 0 |
| $y_{8,s}$ | 0 | 1 | 1 | 0 | 0 | 1 | 1 | 0 | 0 | 1 | 1 | 0 | 0 | 1 | 1 | 0 |
| $Re(z_s)$ | $u_0$ | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

**B**

| | | | | | | | | | | | | | | | | |
|---|---|---|---|---|---|---|---|---|---|---|---|---|---|---|---|---|
| $y_{1,s}$ | 1 | 1 | 1 | 1 | 1 | 1 | 1 | 1 | 1 | 1 | 1 | 1 | 1 | 1 | 1 | 1 |
| $y_{3,s}$ | 0 | 0 | 0 | 0 | 0 | 0 | 0 | 0 | 1 | 1 | 1 | 1 | 1 | 1 | 1 | 1 |
| $y_{5,s}$ | 0 | 0 | 0 | 0 | 1 | 1 | 1 | 1 | 1 | 1 | 1 | 1 | 0 | 0 | 0 | 0 |
| $y_{7,s}$ | 0 | 0 | 1 | 1 | 1 | 1 | 0 | 0 | 0 | 0 | 1 | 1 | 1 | 1 | 0 | 0 |
| $y_{9,s}$ | 0 | 1 | 1 | 0 | 0 | 1 | 1 | 0 | 0 | 1 | 1 | 0 | 0 | 1 | 1 | 0 |
| $Im(z_s)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-u_0$ |
| $y_{1,s}$ | 0 | 0 | 0 | 0 | 0 | 0 | 0 | 0 | 0 | 0 | 0 | 0 | 0 | 0 | 0 | 0 |
| $y_{3,s}$ | 1 | 1 | 1 | 1 | 1 | 1 | 1 | 1 | 0 | 0 | 0 | 0 | 0 | 0 | 0 | 0 |
| $y_{5,s}$ | 0 | 0 | 0 | 0 | 1 | 1 | 1 | 1 | 1 | 1 | 1 | 1 | 0 | 0 | 0 | 0 |
| $y_{7,s}$ | 0 | 0 | 1 | 1 | 1 | 1 | 0 | 0 | 0 | 0 | 1 | 1 | 1 | 1 | 0 | 0 |
| $y_{9,s}$ | 0 | 1 | 1 | 0 | 0 | 1 | 1 | 0 | 0 | 1 | 1 | 0 | 0 | 1 | 1 | 0 |
| $Im(z_s)$ | $u_0$ | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

# F I G . 7 6

| u/CR | 2/16 | 4/16 | 6/16 | 8/16 | 10/16 | 12/16 | 14/16 |
|---|---|---|---|---|---|---|---|
| u0 | 0.951821 | 0.772242 | 0.670816 | 0.720040 | 0.687860 | 0.725026 | 0.776914 |
| u1 | 0.951821 | 0.755105 | 0.671187 | 0.717092 | 0.687453 | 0.682522 | 0.731844 |
| u2 | 0.951821 | 0.733323 | 0.684394 | 0.742371 | 0.784311 | 0.833407 | 0.872060 |
| u3 | 0.951821 | 0.748492 | 0.683930 | 0.746130 | 0.778844 | 0.779595 | 0.823606 |
| u4 | 0.951821 | 0.762565 | 0.601258 | 0.568017 | 0.529234 | 0.542187 | 0.605096 |
| u5 | 0.951821 | 0.741006 | 0.601273 | 0.568434 | 0.529245 | 0.530376 | 0.565319 |
| u6 | 0.951821 | 0.771170 | 0.594244 | 0.571550 | 0.587945 | 0.627093 | 0.688258 |
| u7 | 0.951821 | 0.797312 | 0.594239 | 0.571162 | 0.588065 | 0.601059 | 0.646057 |
| u8 | 0.951821 | 1.144458 | 1.253351 | 1.234492 | 1.288591 | 1.273237 | 1.213263 |
| u9 | 0.951821 | 1.153922 | 1.197825 | 1.174495 | 1.172818 | 1.182640 | 1.148415 |
| u10 | 0.951821 | 1.658369 | 1.695168 | 1.675628 | 1.610570 | 1.491684 | 1.361829 |
| u11 | 0.951821 | 1.306308 | 1.431932 | 1.433385 | 1.432017 | 1.374447 | 1.283388 |
| u12 | 0.951821 | 0.910861 | 0.932278 | 0.907903 | 0.905961 | 0.956192 | 0.974968 |
| u13 | 0.951821 | 0.864684 | 0.935172 | 0.914425 | 0.885027 | 0.892801 | 0.922447 |
| u14 | 0.951821 | 0.903549 | 0.990523 | 1.005079 | 1.064442 | 1.100380 | 1.087536 |
| u15 | 0.951821 | 0.940034 | 0.989938 | 0.980523 | 1.006622 | 1.025215 | 1.029882 |
| u16 | 0.306654 | 0.215961 | 0.115733 | 0.153556 | 0.169392 | 0.148680 | 0.177357 |
| u17 | 0.306654 | 0.220732 | 0.115734 | 0.153554 | 0.169393 | 0.148677 | 0.145054 |
| u18 | 0.306654 | 0.224176 | 0.115606 | 0.153573 | 0.172311 | 0.209035 | 0.243373 |
| u19 | 0.306654 | 0.219360 | 0.115605 | 0.153576 | 0.172310 | 0.209018 | 0.210474 |
| u20 | 0.306654 | 0.196638 | 0.116628 | 0.075094 | 0.056177 | 0.029660 | 0.047926 |
| u21 | 0.306654 | 0.200750 | 0.116629 | 0.075095 | 0.056177 | 0.029660 | 0.016211 |
| u22 | 0.306654 | 0.197697 | 0.116766 | 0.075098 | 0.057134 | 0.088798 | 0.112331 |
| u23 | 0.306654 | 0.193649 | 0.116765 | 0.075098 | 0.057134 | 0.088798 | 0.080421 |
| u24 | 0.306654 | 0.263498 | 0.361114 | 0.411488 | 0.400665 | 0.399082 | 0.451783 |
| u25 | 0.306654 | 0.268956 | 0.361058 | 0.411542 | 0.400670 | 0.397734 | 0.415679 |
| u26 | 0.306654 | 0.272340 | 0.359367 | 0.411127 | 0.427709 | 0.467702 | 0.526543 |
| u27 | 0.306654 | 0.266958 | 0.359424 | 0.411075 | 0.427698 | 0.463378 | 0.488786 |
| u28 | 0.306654 | 0.299845 | 0.342823 | 0.304005 | 0.283846 | 0.270711 | 0.310792 |
| u29 | 0.306654 | 0.305269 | 0.342769 | 0.303985 | 0.283843 | 0.270625 | 0.277078 |
| u30 | 0.306654 | 0.302366 | 0.344552 | 0.303827 | 0.293434 | 0.333743 | 0.380080 |
| u31 | 0.306654 | 0.296777 | 0.344606 | 0.303847 | 0.293437 | 0.333375 | 0.345309 |

# FIG.77

| $y_{0,s}$ | 1 | 1 | 1 | 1 | 1 | 1 | 1 | 1 | 1 | 1 | 1 | 1 | 1 | 1 | 1 | 1 |
|---|---|---|---|---|---|---|---|---|---|---|---|---|---|---|---|---|
| $y_{2,s}$ | 0 | 0 | 0 | 0 | 0 | 0 | 0 | 0 | 0 | 0 | 0 | 0 | 0 | 0 | 0 | 0 |
| $y_{4,s}$ | 0 | 0 | 0 | 0 | 0 | 0 | 0 | 0 | 1 | 1 | 1 | 1 | 1 | 1 | 1 | 1 |
| $y_{6,s}$ | 0 | 0 | 0 | 0 | 1 | 1 | 1 | 1 | 1 | 1 | 1 | 1 | 0 | 0 | 0 | 0 |
| $y_{8,s}$ | 0 | 0 | 1 | 1 | 1 | 1 | 0 | 0 | 0 | 0 | 1 | 1 | 1 | 1 | 0 | 0 |
| $y_{10,s}$ | 0 | 1 | 1 | 0 | 0 | 1 | 1 | 0 | 0 | 1 | 1 | 0 | 0 | 1 | 1 | 0 |
| $Re(z_s)$ | $-u_{31}$ | $-u_{30}$ | $-u_{29}$ | $-u_{28}$ | $-u_{27}$ | $-u_{26}$ | $-u_{25}$ | $-u_{24}$ | $-u_{23}$ | $-u_{22}$ | $-u_{21}$ | $-u_{20}$ | $-u_{19}$ | $-u_{18}$ | $-u_{17}$ | $-u_{16}$ |
| $y_{0,s}$ | 1 | 1 | 1 | 1 | 1 | 1 | 1 | 1 | 1 | 1 | 1 | 1 | 1 | 1 | 1 | 1 |
| $y_{2,s}$ | 1 | 1 | 1 | 1 | 1 | 1 | 1 | 1 | 1 | 1 | 1 | 1 | 1 | 1 | 1 | 1 |
| $y_{4,s}$ | 1 | 1 | 1 | 1 | 1 | 1 | 1 | 1 | 0 | 0 | 0 | 0 | 0 | 0 | 0 | 0 |
| $y_{6,s}$ | 0 | 0 | 0 | 0 | 1 | 1 | 1 | 1 | 1 | 1 | 1 | 1 | 0 | 0 | 0 | 0 |
| $y_{8,s}$ | 0 | 0 | 1 | 1 | 1 | 1 | 0 | 0 | 0 | 0 | 1 | 1 | 1 | 1 | 0 | 0 |
| $y_{10,s}$ | 0 | 1 | 1 | 0 | 0 | 1 | 1 | 0 | 0 | 1 | 1 | 0 | 0 | 1 | 1 | 0 |
| $Re(z_s)$ | $-u_{15}$ | $-u_{14}$ | $-u_{13}$ | $-u_{12}$ | $-u_{11}$ | $-u_{10}$ | $-u_{9}$ | $-u_{8}$ | $-u_{7}$ | $-u_{6}$ | $-u_{5}$ | $-u_{4}$ | $-u_{3}$ | $-u_{2}$ | $-u_{1}$ | $-u_{0}$ |
| $y_{0,s}$ | 0 | 0 | 0 | 0 | 0 | 0 | 0 | 0 | 0 | 0 | 0 | 0 | 0 | 0 | 0 | 0 |
| $y_{2,s}$ | 1 | 1 | 1 | 1 | 1 | 1 | 1 | 1 | 1 | 1 | 1 | 1 | 1 | 1 | 1 | 1 |
| $y_{4,s}$ | 0 | 0 | 0 | 0 | 0 | 0 | 0 | 0 | 1 | 1 | 1 | 1 | 1 | 1 | 1 | 1 |
| $y_{6,s}$ | 0 | 0 | 0 | 0 | 1 | 1 | 1 | 1 | 1 | 1 | 1 | 1 | 0 | 0 | 0 | 0 |
| $y_{8,s}$ | 0 | 0 | 1 | 1 | 1 | 1 | 0 | 0 | 0 | 0 | 1 | 1 | 1 | 1 | 0 | 0 |
| $y_{10,s}$ | 0 | 1 | 1 | 0 | 0 | 1 | 1 | 0 | 0 | 1 | 1 | 0 | 0 | 1 | 1 | 0 |
| $Re(z_s)$ | $u_{0}$ | $u_{1}$ | $u_{2}$ | $u_{3}$ | $u_{4}$ | $u_{5}$ | $u_{6}$ | $u_{7}$ | $u_{8}$ | $u_{9}$ | $u_{10}$ | $u_{11}$ | $u_{12}$ | $u_{13}$ | $u_{14}$ | $u_{15}$ |
| $y_{0,s}$ | 0 | 0 | 0 | 0 | 0 | 0 | 0 | 0 | 0 | 0 | 0 | 0 | 0 | 0 | 0 | 0 |
| $y_{2,s}$ | 0 | 0 | 0 | 0 | 0 | 0 | 0 | 0 | 0 | 0 | 0 | 0 | 0 | 0 | 0 | 0 |
| $y_{4,s}$ | 1 | 1 | 1 | 1 | 1 | 1 | 1 | 1 | 0 | 0 | 0 | 0 | 0 | 0 | 0 | 0 |
| $y_{6,s}$ | 0 | 0 | 0 | 0 | 1 | 1 | 1 | 1 | 1 | 1 | 1 | 1 | 0 | 0 | 0 | 0 |
| $y_{8,s}$ | 0 | 0 | 1 | 1 | 1 | 1 | 0 | 0 | 0 | 0 | 1 | 1 | 1 | 1 | 0 | 0 |
| $y_{10,s}$ | 0 | 1 | 1 | 0 | 0 | 1 | 1 | 0 | 0 | 1 | 1 | 0 | 0 | 1 | 1 | 0 |
| $Re(z_s)$ | $u_{16}$ | $u_{17}$ | $u_{18}$ | $u_{19}$ | $u_{20}$ | $u_{21}$ | $u_{22}$ | $u_{23}$ | $u_{24}$ | $u_{25}$ | $u_{26}$ | $u_{27}$ | $u_{28}$ | $u_{29}$ | $u_{30}$ | $u_{31}$ |

# FIG.78

| | | | | | | | | | | | | | | | | |
|---|---|---|---|---|---|---|---|---|---|---|---|---|---|---|---|---|
| $y_{1,s}$ | 1 | 1 | 1 | 1 | 1 | 1 | 1 | 1 | 1 | 1 | 1 | 1 | 1 | 1 | 1 | 1 |
| $y_{3,s}$ | 0 | 0 | 0 | 0 | 0 | 0 | 0 | 0 | 0 | 0 | 0 | 0 | 0 | 0 | 0 | 0 |
| $y_{5,s}$ | 0 | 0 | 0 | 0 | 0 | 0 | 0 | 0 | 1 | 1 | 1 | 1 | 1 | 1 | 1 | 1 |
| $y_{7,s}$ | 0 | 0 | 0 | 0 | 1 | 1 | 1 | 1 | 1 | 1 | 1 | 1 | 0 | 0 | 0 | 0 |
| $y_{9,s}$ | 0 | 0 | 1 | 1 | 1 | 1 | 0 | 0 | 0 | 0 | 1 | 1 | 1 | 1 | 0 | 0 |
| $y_{11,s}$ | 0 | 1 | 1 | 0 | 0 | 1 | 1 | 0 | 0 | 1 | 1 | 0 | 0 | 1 | 1 | 0 |
| $Im(z_s)$ | $-u_{31}$ | $-u_{30}$ | $-u_{29}$ | $-u_{28}$ | $-u_{27}$ | $-u_{26}$ | $-u_{25}$ | $-u_{24}$ | $-u_{23}$ | $-u_{22}$ | $-u_{21}$ | $-u_{20}$ | $-u_{19}$ | $-u_{18}$ | $-u_{17}$ | $-u_{16}$ |
| $y_{1,s}$ | 1 | 1 | 1 | 1 | 1 | 1 | 1 | 1 | 1 | 1 | 1 | 1 | 1 | 1 | 1 | 1 |
| $y_{3,s}$ | 1 | 1 | 1 | 1 | 1 | 1 | 1 | 1 | 1 | 1 | 1 | 1 | 1 | 1 | 1 | 1 |
| $y_{5,s}$ | 1 | 1 | 1 | 1 | 1 | 1 | 1 | 1 | 0 | 0 | 0 | 0 | 0 | 0 | 0 | 0 |
| $y_{7,s}$ | 0 | 0 | 0 | 0 | 1 | 1 | 1 | 1 | 1 | 1 | 1 | 1 | 0 | 0 | 0 | 0 |
| $y_{9,s}$ | 0 | 0 | 1 | 1 | 1 | 1 | 0 | 0 | 0 | 0 | 1 | 1 | 1 | 1 | 0 | 0 |
| $y_{11,s}$ | 0 | 1 | 1 | 0 | 0 | 1 | 1 | 0 | 0 | 1 | 1 | 0 | 0 | 1 | 1 | 0 |
| $Im(z_s)$ | $-u_{15}$ | $-u_{14}$ | $-u_{13}$ | $-u_{12}$ | $-u_{11}$ | $-u_{10}$ | $-u_{9}$ | $-u_{8}$ | $-u_{7}$ | $-u_{6}$ | $-u_{5}$ | $-u_{4}$ | $-u_{3}$ | $-u_{2}$ | $-u_{1}$ | $-u_{0}$ |
| $y_{1,s}$ | 0 | 0 | 0 | 0 | 0 | 0 | 0 | 0 | 0 | 0 | 0 | 0 | 0 | 0 | 0 | 0 |
| $y_{3,s}$ | 1 | 1 | 1 | 1 | 1 | 1 | 1 | 1 | 1 | 1 | 1 | 1 | 1 | 1 | 1 | 1 |
| $y_{5,s}$ | 0 | 0 | 0 | 0 | 0 | 0 | 0 | 0 | 1 | 1 | 1 | 1 | 1 | 1 | 1 | 1 |
| $y_{7,s}$ | 0 | 0 | 0 | 0 | 1 | 1 | 1 | 1 | 1 | 1 | 1 | 1 | 0 | 0 | 0 | 0 |
| $y_{9,s}$ | 0 | 0 | 1 | 1 | 1 | 1 | 0 | 0 | 0 | 0 | 1 | 1 | 1 | 1 | 0 | 0 |
| $y_{11,s}$ | 0 | 1 | 1 | 0 | 0 | 1 | 1 | 0 | 0 | 1 | 1 | 0 | 0 | 1 | 1 | 0 |
| $Im(z_s)$ | $u_{0}$ | $u_{1}$ | $u_{2}$ | $u_{3}$ | $u_{4}$ | $u_{5}$ | $u_{6}$ | $u_{7}$ | $u_{8}$ | $u_{9}$ | $u_{10}$ | $u_{11}$ | $u_{12}$ | $u_{13}$ | $u_{14}$ | $u_{15}$ |
| $y_{1,s}$ | 0 | 0 | 0 | 0 | 0 | 0 | 0 | 0 | 0 | 0 | 0 | 0 | 0 | 0 | 0 | 0 |
| $y_{3,s}$ | 0 | 0 | 0 | 0 | 0 | 0 | 0 | 0 | 0 | 0 | 0 | 0 | 0 | 0 | 0 | 0 |
| $y_{5,s}$ | 1 | 1 | 1 | 1 | 1 | 1 | 1 | 1 | 0 | 0 | 0 | 0 | 0 | 0 | 0 | 0 |
| $y_{7,s}$ | 0 | 0 | 0 | 0 | 1 | 1 | 1 | 1 | 1 | 1 | 1 | 1 | 0 | 0 | 0 | 0 |
| $y_{9,s}$ | 0 | 0 | 1 | 1 | 1 | 1 | 0 | 0 | 0 | 0 | 1 | 1 | 1 | 1 | 0 | 0 |
| $y_{11,s}$ | 0 | 1 | 1 | 0 | 0 | 1 | 1 | 0 | 0 | 1 | 1 | 0 | 0 | 1 | 1 | 0 |
| $Im(z_s)$ | $u_{16}$ | $u_{17}$ | $u_{18}$ | $u_{19}$ | $u_{20}$ | $u_{21}$ | $u_{22}$ | $u_{23}$ | $u_{24}$ | $u_{25}$ | $u_{26}$ | $u_{27}$ | $u_{28}$ | $u_{29}$ | $u_{30}$ | $u_{31}$ |

F I G . 7 9

# FIG.80

EP 4 478 616 A1

| Modulation | Rows in Part 1 $N_{part1}$ | Rows in Part 2 $N_{part2}$ | Columns m |
|---|---|---|---|
| QPSK | 17280 | 0 | 2 |
| 16QAM | 17280 | 0 | 4 |
| 64QAM | 17280 | 0 | 6 |
| 256QAM | 17280 | 0 | 8 |

EP 4 478 616 A1

# FIG.81

INFORMATION BITS (K BITS)    PARITY BITS (M BITS)

360    360    360    360    360    360    360

BIT GROUP    BIT GROUP    BIT GROUP    BIT GROUP
0    1    K/360-1    N/360-1

FIG. 82

# FIG.83

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 19 | 33 | 45 | 22 | 43 | 23 | 46 | 32 | 11 | 40 |

| 13 | 34 | 14 | 47 | 0 | 12 | 6 | 26 | 37 | 4 |

| 5 | 17 | 25 | 30 | 39 | 29 | 27 | 28 | 10 | 21 |

| 36 | 9 | 3 | 20 | 24 | 42 | 7 | 41 | 44 | 38 |

| 15 | 8 | 31 | 16 | 2 | 1 | 35 | 18 |

EP 4 478 616 A1

FIG.84

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

EP 4 478 616 A1

# FIG.85

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

EP 4 478 616 A1

FIG.86

EP 4 478 616 A1

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

# FIG.87

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

EP 4 478 616 A1

# FIG.88

EP 4 478 616 A1

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 0 | 34 | 30 | 6 | 11 | 35 | 5 | 24 | 4 | 13 |

| 15 | 16 | 3 | 31 | 39 | 40 | 37 | 47 | 28 | 12 |

| 36 | 42 | 33 | 22 | 20 | 8 | 9 | 44 | 29 | 18 |

| 25 | 21 | 23 | 10 | 14 | 26 | 45 | 7 | 27 | 46 |

| 1 | 2 | 17 | 41 | 19 | 43 | 38 | 32 |

# FIG.89

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 33 | 16 | 0 | 26 | 35 | 31 | 21 | 34 | 42 | 43 |
|----|----|---|----|----|----|----|----|----|----|

| 32 | 29 | 7 | 47 | 37 | 28 | 5 | 9 | 30 | 25 |
|----|----|---|----|----|----|---|---|----|----|

| 3 | 17 | 23 | 24 | 41 | 45 | 20 | 12 | 27 | 39 |
|---|----|----|----|----|----|----|----|----|----|

| 8 | 4 | 1 | 6 | 2 | 38 | 10 | 40 | 18 | 19 |
|---|---|---|---|---|----|----|----|----|----|

| 46 | 11 | 36 | 13 | 22 | 14 | 15 | 44 |
|----|----|----|----|----|----|----|----|

FIG.90

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 41 | 10 | 21 | 37 | 9 | 8 | 11 | 27 | 16 | 23 |
|----|----|----|----|---|---|----|----|----|----|

| 25 | 2 | 34 | 7 | 29 | 28 | 5 | 15 | 31 | 45 |
|----|---|----|---|----|----|---|----|----|----|

| 4 | 43 | 33 | 22 | 18 | 13 | 35 | 30 | 6 | 12 |
|---|----|----|----|----|----|----|----|---|----|

| 44 | 1 | 20 | 40 | 42 | 39 | 19 | 17 | 36 | 38 |
|----|---|----|----|----|----|----|----|----|----|

| 26 | 0 | 32 | 3 | 47 | 14 | 24 | 46 |
|----|---|----|---|----|----|----|----|

EP 4 478 616 A1

FIG.91

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 15 | 21 | 29 | 10 | 12 | 32 | 1 | 9 | 31 | 47 |
|---|---|---|---|---|---|---|---|---|---|

| 23 | 30 | 26 | 18 | 0 | 28 | 7 | 20 | 43 | 44 |
|---|---|---|---|---|---|---|---|---|---|

| 3 | 45 | 5 | 17 | 16 | 46 | 40 | 39 | 6 | 38 |
|---|---|---|---|---|---|---|---|---|---|

| 34 | 36 | 22 | 33 | 27 | 24 | 25 | 13 | 14 | 37 |
|---|---|---|---|---|---|---|---|---|---|

| 19 | 8 | 42 | 11 | 4 | 2 | 35 | 41 |
|---|---|---|---|---|---|---|---|

EP 4 478 616 A1

# FIG.92

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

EP 4 478 616 A1

EP 4 478 616 A1

# FIG.93

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 31 | 23 | 1 | 42 | 36 | 25 | 47 | 3 | 12 | 30 |
|----|----|---|----|----|----|----|---|----|----|

| 32 | 8 | 11 | 27 | 21 | 40 | 16 | 13 | 34 | 4 |
|----|---|----|----|----|----|----|----|----|---|

| 26 | 35 | 46 | 20 | 29 | 28 | 5 | 43 | 18 | 39 |
|----|----|----|----|----|----|---|----|----|----|

| 24 | 14 | 0 | 10 | 7 | 41 | 37 | 9 | 38 | 33 |
|----|----|---|----|---|----|----|---|----|----|

| 2 | 6 | 19 | 45 | 17 | 15 | 22 | 44 |
|---|---|----|----|----|----|----|----|

# FIG.94

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 46 | 11 | 23 | 33 | 10 | 0 | 17 | 47 | 20 | 5 |
|----|----|----|----|----|----|----|----|----|----|

| 38 | 29 | 28 | 16 | 41 | 27 | 2 | 31 | 43 | 37 |
|----|----|----|----|----|----|----|----|----|----|

| 34 | 12 | 35 | 24 | 21 | 44 | 40 | 36 | 32 | 39 |
|----|----|----|----|----|----|----|----|----|----|

| 4 | 19 | 26 | 6 | 30 | 9 | 42 | 1 | 22 | 8 |
|---|----|----|---|----|---|----|---|----|---|

| 3 | 45 | 14 | 15 | 13 | 7 | 25 | 18 |
|---|----|----|----|----|---|----|----|

EP 4 478 616 A1

# FIG.95

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 16 | 32 | 33 | 43 | 3 | 29 | 0 | 22 | 40 | 24 |
|----|----|----|----|---|----|---|----|----|----|

| 44 | 8 | 20 | 13 | 15 | 45 | 7 | 34 | 39 | 42 |
|----|---|----|----|----|----|---|----|----|----|

| 25 | 28 | 18 | 26 | 38 | 10 | 11 | 41 | 47 | 23 |
|----|----|----|----|----|----|----|----|----|----|

| 6 | 1 | 14 | 4 | 12 | 31 | 21 | 19 | 37 | 36 |
|---|---|----|---|----|----|----|----|----|----|

| 30 | 5 | 46 | 27 | 35 | 2 | 9 | 17 |
|----|---|----|----|----|---|---|----|

# FIG.96

EP 4 478 616 A1

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 23 | 42 | 33 | 17 | 37 | 2 | 22 | 14 | 21 | 0 |

| 12 | 44 | 30 | 1 | 25 | 35 | 46 | 13 | 10 | 24 |

| 20 | 15 | 45 | 31 | 41 | 43 | 28 | 36 | 16 | 4 |

| 32 | 18 | 3 | 6 | 34 | 11 | 40 | 5 | 38 | 27 |

| 29 | 8 | 26 | 7 | 39 | 9 | 47 | 19 |

FIG.97

# FIG.98

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 1 | 28 | 12 | 35 | 23 | 36 | 24 | 17 | 10 | 14 |
|---|----|----|----|----|----|----|----|----|----|

| 15 | 37 | 18 | 13 | 41 | 38 | 33 | 29 | 16 | 21 |
|----|----|----|----|----|----|----|----|----|----|

| 27 | 4 | 9 | 31 | 45 | 40 | 0 | 46 | 7 | 43 |
|----|---|---|----|----|----|---|----|---|----|

| 30 | 34 | 8 | 44 | 47 | 2 | 20 | 6 | 42 | 3 |
|----|----|---|----|----|---|----|---|----|---|

| 22 | 39 | 5 | 32 | 11 | 19 | 25 | 26 |
|----|----|---|----|----|----|----|----|

EP 4 478 616 A1

# FIG.99

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 9 | 8 | 3 | 40 | 27 | 4 | 7 | 45 | 28 | 29 |
|---|---|---|---|---|---|---|---|---|---|

| 14 | 41 | 20 | 6 | 21 | 5 | 36 | 12 | 31 | 39 |
|---|---|---|---|---|---|---|---|---|---|

| 30 | 15 | 37 | 10 | 34 | 25 | 1 | 47 | 26 | 13 |
|---|---|---|---|---|---|---|---|---|---|

| 32 | 43 | 44 | 24 | 33 | 16 | 42 | 2 | 22 | 19 |
|---|---|---|---|---|---|---|---|---|---|

| 18 | 35 | 23 | 46 | 11 | 17 | 38 | 0 |
|---|---|---|---|---|---|---|---|

# F I G . 1 0 0

BIT GROUP

| 0 | 1 | 2 | 3 | 4 | 5 | 6 | 7 | 8 | 9 |
|---|---|---|---|---|---|---|---|---|---|
| 10 | 11 | 12 | 13 | 14 | 15 | 16 | 17 | 18 | 19 |
| 20 | 21 | 22 | 23 | 24 | 25 | 26 | 27 | 28 | 29 |
| 30 | 31 | 32 | 33 | 34 | 35 | 36 | 37 | 38 | 39 |
| 40 | 41 | 42 | 43 | 44 | 45 | 46 | 47 | | |

⟺

| 12 | 42 | 40 | 41 | 20 | 18 | 27 | 24 | 39 | 6 |
|---|---|---|---|---|---|---|---|---|---|
| 0 | 15 | 8 | 31 | 10 | 3 | 13 | 46 | 4 | 37 |
| 33 | 25 | 44 | 2 | 16 | 23 | 28 | 14 | 17 | 43 |
| 45 | 1 | 35 | 38 | 26 | 21 | 36 | 22 | 47 | 11 |
| 34 | 29 | 30 | 32 | 19 | 7 | 5 | 9 | | |

# FIG.101

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 33 | 18 | 21 | 29 | 14 | 4 | 35 | 32 | 26 | 15 |
|----|----|----|----|----|----|----|----|----|----|

| 11 | 6 | 1 | 47 | 38 | 17 | 45 | 27 | 2 | 5 |
|----|---|---|----|----|----|----|----|---|---|

| 16 | 12 | 23 | 25 | 3 | 0 | 42 | 13 | 41 | 46 |
|----|----|----|----|---|---|----|----|----|----|

| 9 | 24 | 40 | 43 | 7 | 31 | 39 | 34 | 30 | 20 |
|---|----|----|----|---|----|----|----|----|----|

| 8 | 36 | 22 | 10 | 19 | 28 | 37 | 44 |
|---|----|----|----|----|----|----|----|

# FIG.102

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 7 | 28 | 41 | 8 | 6 | 12 | 14 | 47 | 4 | 38 |

| 32 | 37 | 23 | 33 | 15 | 46 | 22 | 0 | 34 | 24 |

| 40 | 45 | 27 | 19 | 43 | 11 | 36 | 9 | 17 | 21 |

| 31 | 44 | 2 | 1 | 26 | 13 | 42 | 30 | 35 | 5 |

| 29 | 25 | 16 | 20 | 39 | 10 | 18 | 3 |

F I G . 1 0 3

# FIG.104

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 23 | 20 | 14 | 9 | 44 | 41 | 19 | 36 | 38 | 13 |
|----|----|----|----|----|----|----|----|----|----|

| 16 | 28 | 0 | 8 | 2 | 39 | 31 | 29 | 21 | 10 |
|----|----|----|----|----|----|----|----|----|----|

| 11 | 33 | 32 | 27 | 46 | 7 | 5 | 35 | 26 | 1 |
|----|----|----|----|----|----|----|----|----|----|

| 43 | 40 | 37 | 17 | 47 | 30 | 6 | 18 | 15 | 42 |
|----|----|----|----|----|----|----|----|----|----|

| 3 | 25 | 4 | 22 | 24 | 12 | 45 | 34 |
|---|----|---|----|----|----|----|----|

# FIG.105

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 37 | 30 | 14 | 13 | 2 | 31 | 27 | 9 | 46 | 41 |

| 47 | 18 | 23 | 28 | 43 | 10 | 39 | 42 | 16 | 22 |

| 36 | 8 | 33 | 32 | 4 | 1 | 45 | 19 | 12 | 6 |

| 35 | 0 | 24 | 25 | 15 | 38 | 44 | 7 | 26 | 21 |

| 34 | 40 | 29 | 20 | 11 | 5 | 17 | 3 |

EP 4 478 616 A1

# FIG.106

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 6 | 28 | 25 | 38 | 43 | 11 | 21 | 31 | 47 | 8 |
|---|---|---|---|---|---|---|---|---|---|

| 17 | 39 | 23 | 27 | 30 | 32 | 3 | 35 | 12 | 7 |
|---|---|---|---|---|---|---|---|---|---|

| 1 | 16 | 18 | 36 | 10 | 24 | 41 | 4 | 44 | 22 |
|---|---|---|---|---|---|---|---|---|---|

| 5 | 33 | 46 | 29 | 0 | 26 | 9 | 42 | 37 | 45 |
|---|---|---|---|---|---|---|---|---|---|

| 15 | 40 | 2 | 19 | 14 | 20 | 34 | 13 |
|---|---|---|---|---|---|---|---|

# F I G . 1 0 7

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇔

| 39 | 11 | 12 | 7 | 3 | 1 | 40 | 31 | 27 | 0 |
|---|---|---|---|---|---|---|---|---|---|

| 45 | 42 | 6 | 5 | 24 | 36 | 46 | 19 | 34 | 22 |
|---|---|---|---|---|---|---|---|---|---|

| 29 | 13 | 35 | 2 | 17 | 33 | 20 | 14 | 15 | 25 |
|---|---|---|---|---|---|---|---|---|---|

| 38 | 9 | 41 | 30 | 44 | 18 | 8 | 28 | 37 | 4 |
|---|---|---|---|---|---|---|---|---|---|

| 32 | 47 | 16 | 21 | 23 | 26 | 10 |
|---|---|---|---|---|---|---|

FIG.108

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 7 | 19 | 31 | 20 | 36 | 35 | 2 | 4 | 46 | 12 |

| 28 | 21 | 39 | 43 | 26 | 23 | 32 | 5 | 37 | 3 |

| 11 | 34 | 18 | 45 | 24 | 1 | 13 | 47 | 10 | 27 |

| 0 | 9 | 33 | 25 | 8 | 40 | 6 | 16 | 22 | 29 |

| 42 | 38 | 14 | 44 | 41 | 17 | 30 | 15 |

EP 4 478 616 A1

# FIG.109

BIT GROUP

| 0 | 1 | 2 | 3 | 4 | 5 | 6 | 7 | 8 | 9 |
|---|---|---|---|---|---|---|---|---|---|
| 10 | 11 | 12 | 13 | 14 | 15 | 16 | 17 | 18 | 19 |
| 20 | 21 | 22 | 23 | 24 | 25 | 26 | 27 | 28 | 29 |
| 30 | 31 | 32 | 33 | 34 | 35 | 36 | 37 | 38 | 39 |
| 40 | 41 | 42 | 43 | 44 | 45 | 46 | 47 |

⇕

| 12 | 7 | 39 | 31 | 30 | 44 | 14 | 33 | 35 | 17 |
|---|---|---|---|---|---|---|---|---|---|
| 37 | 27 | 2 | 28 | 9 | 26 | 32 | 3 | 46 | 0 |
| 34 | 6 | 43 | 25 | 21 | 47 | 18 | 45 | 5 | 20 |
| 13 | 38 | 11 | 29 | 16 | 36 | 8 | 40 | 15 | 41 |
| 10 | 23 | 1 | 19 | 4 | 22 | 42 | 24 |

EP 4 478 616 A1

# FIG.110

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 20 | 19 | 13 | 25 | 32 | 9 | 5 | 24 | 39 | 4 |
|----|----|----|----|----|---|---|----|----|---|

| 29 | 40 | 14 | 18 | 43 | 46 | 21 | 44 | 10 | 15 |
|----|----|----|----|----|----|----|----|----|----|

| 35 | 3 | 23 | 47 | 37 | 12 | 30 | 33 | 27 | 36 |
|----|---|----|----|----|----|----|----|----|----|

| 8 | 28 | 38 | 7 | 42 | 22 | 2 | 0 | 6 | 16 |
|---|----|----|---|----|----|---|---|---|----|

| 45 | 26 | 17 | 11 | 31 | 34 | 41 | 1 |
|----|----|----|----|----|----|----|---|

# FIG.111

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 19 | 20 | 44 | 3 | 6 | 28 | 13 | 15 | 16 | 24 |

| 9 | 34 | 39 | 8 | 17 | 40 | 29 | 31 | 22 | 10 |

| 11 | 7 | 35 | 42 | 23 | 2 | 14 | 37 | 33 | 1 |

| 26 | 45 | 38 | 12 | 47 | 30 | 5 | 18 | 46 | 0 |

| 41 | 27 | 4 | 21 | 43 | 25 | 36 | 32 |

# FIG.112

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 4 | 26 | 7 | 21 | 43 | 42 | 33 | 17 | 35 | 19 |
|---|---|---|---|---|---|---|---|---|---|

| 10 | 39 | 27 | 13 | 18 | 34 | 38 | 3 | 28 | 36 |
|---|---|---|---|---|---|---|---|---|---|

| 1 | 5 | 44 | 37 | 16 | 30 | 14 | 9 | 32 | 47 |
|---|---|---|---|---|---|---|---|---|---|

| 29 | 2 | 31 | 23 | 0 | 24 | 11 | 8 | 6 | 46 |
|---|---|---|---|---|---|---|---|---|---|

| 40 | 45 | 15 | 22 | 25 | 20 | 12 | 41 |
|---|---|---|---|---|---|---|---|

# FIG.113

EP 4 478 616 A1

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 8 | 28 | 33 | 21 | 1 | 39 | 34 | 7 | 0 | 17 |

| 5 | 41 | 23 | 2 | 14 | 10 | 29 | 25 | 13 | 18 |

| 35 | 38 | 27 | 44 | 20 | 32 | 31 | 11 | 40 | 30 |

| 24 | 3 | 36 | 22 | 15 | 37 | 16 | 6 | 42 | 45 |

| 19 | 47 | 12 | 26 | 43 | 9 | 46 | 4 |

FIG.114

# FIG.115

EP 4 478 616 A1

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 11 | 0 | 42 | 24 | 46 | 27 | 25 | 3 | 1 | 41 |

| 22 | 40 | 19 | 18 | 14 | 36 | 33 | 4 | 47 | 12 |

| 39 | 30 | 13 | 5 | 2 | 7 | 31 | 9 | 38 | 35 |

| 15 | 43 | 45 | 44 | 28 | 20 | 32 | 21 | 26 | 23 |

| 6 | 10 | 8 | 37 | 17 | 34 | 29 | 16 |

# FIG.116

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 5 | 45 | 42 | 35 | 13 | 41 | 2 | 29 | 15 | 11 |

| 16 | 0 | 8 | 1 | 33 | 34 | 44 | 7 | 43 | 22 |

| 24 | 19 | 9 | 38 | 18 | 12 | 26 | 20 | 28 | 21 |

| 10 | 30 | 40 | 6 | 46 | 37 | 47 | 17 | 3 | 32 |

| 4 | 39 | 23 | 25 | 36 | 14 | 31 | 27 |

EP 4 478 616 A1

# FIG.117

BIT GROUP

| 0 | 1 | 2 | 3 | 4 | 5 | 6 | 7 | 8 | 9 |
| 10 | 11 | 12 | 13 | 14 | 15 | 16 | 17 | 18 | 19 |
| 20 | 21 | 22 | 23 | 24 | 25 | 26 | 27 | 28 | 29 |
| 30 | 31 | 32 | 33 | 34 | 35 | 36 | 37 | 38 | 39 |
| 40 | 41 | 42 | 43 | 44 | 45 | 46 | 47 | | |

⟺

| 18 | 16 | 21 | 2 | 43 | 10 | 44 | 42 | 19 | 15 |
| 20 | 26 | 1 | 38 | 46 | 28 | 17 | 29 | 6 | 22 |
| 7 | 32 | 31 | 30 | 24 | 3 | 8 | 9 | 12 | 37 |
| 47 | 40 | 39 | 35 | 11 | 25 | 45 | 34 | 33 | |
| 23 | 4 | 14 | 27 | 13 | 41 | 36 | 0 | | |

# FIG.118

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 28 | 9 | 4 | 27 | 17 | 10 | 12 | 6 | 19 | 30 |
|---|---|---|---|---|---|---|---|---|---|

| 1 | 23 | 39 | 14 | 38 | 34 | 46 | 8 | 15 | 43 |
|---|---|---|---|---|---|---|---|---|---|

| 13 | 47 | 0 | 44 | 7 | 24 | 45 | 18 | 25 | 29 |
|---|---|---|---|---|---|---|---|---|---|

| 37 | 42 | 22 | 31 | 11 | 36 | 20 | 32 | 41 | 33 |
|---|---|---|---|---|---|---|---|---|---|

| 2 | 26 | 21 | 5 | 3 | 16 | 40 | 35 |
|---|---|---|---|---|---|---|---|

EP 4 478 616 A1

# FIG.119

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 5 | 37 | 36 | 38 | 16 | 21 | 41 | 44 | 10 | 18 |
|---|----|----|----|----|----|----|----|----|----|

| 26 | 27 | 15 | 1 | 43 | 2 | 33 | 14 | 9 | 30 |
|----|----|----|---|----|---|----|----|---|----|

| 8 | 12 | 23 | 4 | 13 | 35 | 31 | 3 | 34 | 19 |
|---|----|----|---|----|----|----|---|----|----|

| 42 | 47 | 46 | 29 | 0 | 25 | 20 | 17 | 39 | 45 |
|----|----|----|----|---|----|----|----|----|----|

| 28 | 6 | 22 | 11 | 32 | 40 | 24 | 7 |
|----|---|----|----|----|----|----|---|

EP 4 478 616 A1

# F I G . 1 2 0

BIT GROUP

165

# FIG.121

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|----|----|----|----|----|----|----|----|----|----|

| 20 | 21 | 22 | 23 | 24 | 25 | 26 | 27 | 28 | 29 |
|----|----|----|----|----|----|----|----|----|----|

| 30 | 31 | 32 | 33 | 34 | 35 | 36 | 37 | 38 | 39 |
|----|----|----|----|----|----|----|----|----|----|

| 40 | 41 | 42 | 43 | 44 | 45 | 46 | 47 |
|----|----|----|----|----|----|----|----|

⇕

| 3 | 41 | 6 | 42 | 21 | 2 | 25 | 45 | 8 | 39 |
|---|----|---|----|----|---|----|----|---|----|

| 34 | 26 | 47 | 43 | 23 | 20 | 13 | 16 | 38 | 24 |
|----|----|----|----|----|----|----|----|----|----|

| 5 | 40 | 0 | 11 | 7 | 31 | 32 | 15 | 36 | 33 |
|---|----|---|----|---|----|----|----|----|----|

| 9 | 12 | 10 | 30 | 29 | 14 | 18 | 35 | 46 | 4 |
|---|----|----|----|----|----|----|----|----|---|

| 28 | 19 | 1 | 44 | 37 | 27 | 17 | 22 |
|----|----|---|----|----|----|----|----|

# FIG.122

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 40 | 42 | 11 | 10 | 15 | 6 | 34 | 37 | 16 | 45 |
|---|---|---|---|---|---|---|---|---|---|

| 25 | 47 | 32 | 8 | 17 | 26 | 29 | 7 | 18 | 21 |
|---|---|---|---|---|---|---|---|---|---|

| 46 | 44 | 28 | 27 | 20 | 38 | 43 | 36 | 33 | 5 |
|---|---|---|---|---|---|---|---|---|---|

| 24 | 9 | 13 | 2 | 0 | 4 | 39 | 31 | 1 | 22 |
|---|---|---|---|---|---|---|---|---|---|

| 30 | 12 | 14 | 41 | 23 | 3 | 19 | 35 |
|---|---|---|---|---|---|---|---|

EP 4 478 616 A1

EP 4 478 616 A1

# FIG.123

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 6 | 0 | 20 | 18 | 37 | 27 | 39 | 3 | 1 | 2 |

| 46 | 11 | 24 | 36 | 14 | 15 | 4 | 16 | 10 | 13 |

| 35 | 23 | 26 | 30 | 19 | 42 | 7 | 9 | 33 | 40 |

| 12 | 34 | 22 | 5 | 28 | 21 | 32 | 38 | 44 | 25 |

| 17 | 41 | 29 | 45 | 8 | 47 | 31 | 43 |

# FIG.124

EP 4 478 616 A1

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

$\Updownarrow$

| 8 | 25 | 12 | 9 | 26 | 37 | 35 | 28 | 14 | 5 |
|---|---|---|---|---|---|---|---|---|---|

| 6 | 2 | 29 | 38 | 22 | 31 | 11 | 21 | 17 | 33 |
|---|---|---|---|---|---|---|---|---|---|

| 42 | 43 | 36 | 45 | 20 | 27 | 44 | 13 | 16 | 46 |
|---|---|---|---|---|---|---|---|---|---|

| 10 | 30 | 3 | 32 | 19 | 1 | 15 | 4 | 18 | 40 |
|---|---|---|---|---|---|---|---|---|---|

| 47 | 7 | 34 | 24 | 41 | 23 | 39 | 0 |
|---|---|---|---|---|---|---|---|

FIG.125

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇔

| 7 | 17 | 26 | 27 | 9 | 39 | 46 | 47 | 32 | 12 |
|---|---|---|---|---|---|---|---|---|---|

| 35 | 25 | 14 | 11 | 22 | 23 | 16 | 29 | 38 | 33 |
|---|---|---|---|---|---|---|---|---|---|

| 34 | 4 | 40 | 10 | 5 | 18 | 37 | 1 | 24 | 44 |
|---|---|---|---|---|---|---|---|---|---|

| 30 | 3 | 0 | 45 | 28 | 13 | 15 | 20 | 6 | 21 |
|---|---|---|---|---|---|---|---|---|---|

| 31 | 19 | 2 | 8 | 41 | 36 | 42 | 43 |
|---|---|---|---|---|---|---|---|

# FIG.126

BIT GROUP

| 0 | 1 | 2 | 3 | 4 | 5 | 6 | 7 | 8 | 9 |

| 10 | 11 | 12 | 13 | 14 | 15 | 16 | 17 | 18 | 19 |

| 20 | 21 | 22 | 23 | 24 | 25 | 26 | 27 | 28 | 29 |

| 30 | 31 | 32 | 33 | 34 | 35 | 36 | 37 | 38 | 39 |

| 40 | 41 | 42 | 43 | 44 | 45 | 46 | 47 |

⇕

| 11 | 14 | 32 | 27 | 44 | 43 | 0 | 47 | 1 | 8 |

| 35 | 33 | 7 | 2 | 41 | 15 | 13 | 4 | 23 | 30 |

| 16 | 42 | 46 | 24 | 9 | 17 | 21 | 20 | 18 | 5 |

| 19 | 12 | 3 | 34 | 28 | 40 | 39 | 37 | 31 | 38 |

| 45 | 36 | 6 | 22 | 26 | 10 | 25 | 29 |

EP 4 478 616 A1

FIG.127

BIT GROUP

| 0 | 1 | 2 | 3 | 4 | 5 | 6 | 7 | 8 | 9 |
|---|---|---|---|---|---|---|---|---|---|

| 10 | 11 | 12 | 13 | 14 | 15 | 16 | 17 | 18 | 19 |
|---|---|---|---|---|---|---|---|---|---|

| 20 | 21 | 22 | 23 | 24 | 25 | 26 | 27 | 28 | 29 |
|---|---|---|---|---|---|---|---|---|---|

| 30 | 31 | 32 | 33 | 34 | 35 | 36 | 37 | 38 | 39 |
|---|---|---|---|---|---|---|---|---|---|

| 40 | 41 | 42 | 43 | 44 | 45 | 46 | 47 |
|---|---|---|---|---|---|---|---|

⇕

| 3 | 35 | 16 | 36 | 41 | 32 | 7 | 20 | 39 | 38 |
|---|---|---|---|---|---|---|---|---|---|

| 1 | 47 | 5 | 24 | 14 | 17 | 0 | 34 | 2 | 6 |
|---|---|---|---|---|---|---|---|---|---|

| 13 | 43 | 9 | 15 | 31 | 37 | 21 | 46 | 25 | 26 |
|---|---|---|---|---|---|---|---|---|---|

| 11 | 42 | 30 | 40 | 44 | 10 | 23 | 18 | 8 | 22 |
|---|---|---|---|---|---|---|---|---|---|

| 29 | 28 | 45 | 4 | 33 | 19 | 12 | 27 |
|---|---|---|---|---|---|---|---|

EP 4 478 616 A1

# FIG.128

17k rate 14/16,16QAM-NUC Rayleigh,LDPC only,it=50

EP 4 478 616 A1

FIG.129

| OLD GW PATTERN | NEW GW PATTERN | DIFFERENCE |
|---|---|---|
| 17. 870 | 17. 724 | +0. 146 |

# FIG.130

EP 4 478 616 A1

EP 4 478 616 A1

# FIG.131

# FIG.132

```
          ┌───────────┐
          │   START   │
          └───────────┘
                │
                ▼
        ┌─────────────────┐
        │     DEMAP       │ S111
        └─────────────────┘
                │
                ▼
┌──────────────────────────────────────────────────────┐
│              BIT DEINTERLEAVE                          │ S112
│   (BLOCK DEINTERLEAVE AND GROUPWISE DEINTERLEAVE)      │
└──────────────────────────────────────────────────────┘
                │
                ▼
        ┌─────────────────┐
        │  LDPC-DECODE    │ S113
        └─────────────────┘
                │
                ▼
          ┌───────────┐
          │    END    │
          └───────────┘
```

FIG.133

FIG.134

FIG.135

F I G . 1 3 6

# FIG.137

EP 4 478 616 A1

F I G . 1 3 8

FIG.139

DEMAPPER — BLOCK DEINTERLEAVER — GROUPWISE DEINTERLEAVER — PARITY DEINTERLEAVER — LDPC DECODER — TARGET DATA

164    54    55    1011    166

165

EP 4 478 616 A1

# FIG.140

SIGNAL →

1101 ACQUISITION UNIT

1102 TRANSFER PATH DECODING UNIT

1103 INFORMATION SOURCE DECODING UNIT

→ INFORMATION (DECODED DATA)

RECEPTION SYSTEM

# FIG.141

SIGNAL → **1101** ACQUISITION UNIT → **1102** TRANSFER PATH DECODING UNIT → **1103** INFORMATION SOURCE DECODING UNIT → **1111** OUTPUT UNIT

RECEPTION SYSTEM

EP 4 478 616 A1

# FIG.142

1101 ACQUISITION UNIT
1102 TRANSFER PATH DECODING UNIT
1103 INFORMATION SOURCE DECODING UNIT
1121 RECORDING UNIT

SIGNAL

RECEPTION SYSTEM

EP 4 478 616 A1

# FIG.143

EP 4 478 616 A1

COMPUTER

## INTERNATIONAL SEARCH REPORT

| International application No. |
|---|
| **PCT/JP2023/002351** |

**A.    CLASSIFICATION OF SUBJECT MATTER**

*H03M 13/27*(2006.01)i; *H03M 13/19*(2006.01)i; *H04L 1/00*(2006.01)i
FI:    H03M13/27; H03M13/19; H04L1/00 B; H04L1/00 F

According to International Patent Classification (IPC) or to both national classification and IPC

**B.    FIELDS SEARCHED**

Minimum documentation searched (classification system followed by classification symbols)

H03M13/27; H03M13/19; H04L1/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2019-125951 A (SONY CORP) 25 July 2019 (2019-07-25) | 1-4 |
| A | JP 2019-146146 A (JAPAN BROADCASTING CORP) 29 August 2019 (2019-08-29) | 1-4 |

☐ Further documents are listed in the continuation of Box C.    ☑ See patent family annex.

| | | |
|---|---|---|
| * | Special categories of cited documents: | "T"  later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X"  document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"  document member of the same patent family |

| Date of the actual completion of the international search | Date of mailing of the international search report |
|---|---|
| **07 March 2023** | **20 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/002351**

| Patent document cited in search report | | | Publication date (day/month/year) | Patent family member(s) | | | Publication date (day/month/year) |
|---|---|---|---|---|---|---|---|
| JP | 2019-125951 | A | 25 July 2019 | WO | 2019/142685 | A1 | |
| | | | | EP | 3742618 | A1 | |
| | | | | KR | 10-2020-0107954 | A | |
| JP | 2019-146146 | A | 29 August 2019 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 4224777 B

**Non-patent literature cited in the description**

• **H. JIN** ; **A. KHANDEKAR** ; **R. J. MCELIECE**. Irregular Repeat-Accumulate Codes. *Proceedings of 2nd International Symposium on Turbo codes and Related Topics*, September 2000, 1-8

• **S. Y. CHUNG** ; **G. D. FORNEY** ; **T. J. RICHARDSON** ; **R. URBANKE**. On the Design of Low-Density Parity-Check Codes within 0.0045 dB of the Shannon Limit. *IEEE Communications Leggers*, February 2001, vol. 5 (2)